(19) Europäisches Patentamt
European Patent Office
Office européen des brevets

(11) EP 0 382 764 B1

(12) EUROPEAN PATENT SPECIFICATION

(45) Date of publication and mention of the grant of the patent:
**09.04.1997 Bulletin 1997/15**

(21) Application number: **88908836.5**

(22) Date of filing: **08.09.1988**

(51) Int Cl.[6]: **H04K 7/00**, H04N 7/16

(86) International application number:
**PCT/US88/03000**

(87) International publication number:
**WO 89/02682 (23.03.1989 Gazette 1989/07)**

# (54) SIGNAL PROCESSING APPARATUS AND METHODS

SIGNALBEHANDLUNGSVORRICHTUNG UND VERFAHREN

DISPOSITIF ET PROCEDES DE TRAITEMENT DE SIGNAUX

(84) Designated Contracting States:
**AT BE CH DE FR GB IT LI LU NL SE**

(30) Priority: **11.09.1987 US 96096**

(43) Date of publication of application:
**22.08.1990 Bulletin 1990/34**

(60) Divisional application: **96114935.8**

(73) Proprietor: **PERSONALIZED MEDIA COMMUNICATIONS, L.L.C.**
**New York (US)**

(72) Inventors:
- **HARVEY, John, C.**
  **New York, NY 10022 (US)**
- **CUDDIHY, James, W.**
  **New York, NY 10009 (US)**

(74) Representative:
**MacDougall, Donald Carmichael et al**
**Cruikshank & Fairweather**
**19 Royal Exchange Square**
**Glasgow G1 3AE, Scotland (GB)**

(56) References cited:

| | |
|---|---|
| **EP-A- 0 055 674** | **EP-A- 0 152 251** |
| **EP-A- 0 206 821** | **US-A- 3 845 391** |
| **US-A- 4 025 851** | **US-A- 4 323 922** |
| **US-A- 4 694 490** | **US-A- 4 704 725** |
| **US-A- 4 706 282** | |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 382 764 B1

## Description

### BACKGROUND OF THE INVENTION

The invention relates to an integrated system of programming communication and involves the fields of computer processing, computer communications, television, radio, and other electronic communications; the fields of automating the handling, recording, and retransmitting of television, radio, computer, and other electronically transmitted programming; and the fields of regulating, metering, and monitoring the availability, use, and usage of such programming.

For years, television has been recognized as a powerful medium for communicating ideas. Radio and electronic print services such as so-called "tickers" and "broad tapes" are also powerful mass media. (Hereinafter, the electronic print mass medium is called, "broadcast print.") But television, radio, and broadcast print are only mass media. Program content is the same for every viewer.

For years, computers have been recognized as having unsurpassed capacity for processing and displaying user specific information. But processing is not a mass medium. iComputers operate under control of users.

Today great potential exists for combining the capacity of broadcast media to convey ideas with the capacity of computers to process and output user specific information. New media that result are called "combined" media.

Unlocking this potential is desirable because these new media will add substantial richness and variety to the communication of ideas, information and entertainment. Understanding complex subjects and making informed decisions will become easier.

To unlock this potential fully requires means and methods for combining and controlling receiver systems that are now separate--television and computers, radio and computers, broadcast print and computers, television and computers and broadcast print, etc. It requires capacity for satisfying subscribers who have little apparatus and simple information demands as well as subscribers who have extensive apparatus and complex demands. It requires capacity for transmitting and organizing vastly more information than any one-channel transmission system can possibly convey at one time. It requires capacity for providing reliable audit information to (1) advertisers and others who pay for transmission and (2) copyright holders, pay service operators, and others who demand to be paid. This system must inhibit piracy.

It is the object of this invention to unlock this potential in the fullest measure by means of an integrated system that joins these capacities most efficiently. It is another object to overcome limitations of the prior art.

### SUMMARY OF THE INVENTION

The present invention consists of an integrated system of methods and apparatus for communicating programming. "Programming" refers to everything that is transmitted electronically to entertain, instruct or inform, including television, radio, broadcast print, and computer programming as well as combined medium programming. The system includes capacity for automatically organizing multi-channel communications. Like television and other electronic media, the present invention has capacity for transmitting standardized programming that is simple for subscribers to play and understand. Like computer systems, the present invention has capacity for causing computers to generate and transmit programming and for causing receiver apparatus to operate on the basis of information received at widely separated times.

It is the further purpose of this invention to provide means and methods whereby a point-to-multipoint transmission (such as a television or radio broadcast) can cause simultaneous generation of user specific information at a plurality of subscriber stations. One advantage is ease of use. For example, a subscriber can cause his information to be processed in complex ways by merely turning his television receiver on and tuning to a particular channel. Another advantage is "transparency"--subscribers see none of the complex processing. Another advantage is privacy. No private information is required at transmitting stations, and no subscriber's information is available at any other subscriber's station.

It is the further purpose to provide means and methods whereby a broadcast transmission can cause periodic combining of relevant user specific information and conventional broadcast programming at subscriber stations, thereby integrating the broadcast information with each user's information. One advantage of the present invention is to reveal the meaning of complex processing in ways that appear clear and simple. Another is that receiver stations that lack capacity for combining user information into television or radio programming can continue to receive and display the conventional programming.

It is the further purpose to provide means and methods for automation of intermediate transmission stations that receive and retransmit programming. The programming may be delivered by any means including over-the-air ("broadcast") or hard-wire ("cablecast"). The present invention includes capacity for automatically constructing records for each transmitted channel that duplicate the logs that the Federal Communications Commission requires broadcast station operators to maintain.

It is the further purpose to provide means and methods for automation of ultimate receiver stations; for identifying and recording what television, radio, data, and other programming is transmitted at each transmission station, what programming is received at each receiver station, and how programming is used; for recording combined media and/or multi-channel programming and playing back prerecorded programming of such types; and for restricting the use of transmitted communications to only authorized subscribers. Such means and methods include techniques whereby the pattern of the composition, timing, and location of signals may vary in fashions that only receiving apparatus that are preinformed will be able to process correctly.

The present invention employs signals embedded in programming. Embedded signals cannot become separated inadvertently from the programming and, thereby, inhibit automatic processing. They can be conveniently monitored.

A central objective of the present invention is to provide flexibility in regard to station apparatus. The system must have capacity for wide variation in station apparatus in order to provide individual subscribers the widest range of information options at the least cost in terms of installed equipment. Flexibility must exist for expanding the capacity of installed systems by means of transmitted software and for altering installed systems in a modular fashion by adding or removing components. Flexibility must exist for varying techniques that restrict programming to duly authorized subscribers in order to identify and deter pirates.

Other objects, features and advantages of this invention will appear in the following descriptions and appended claims.

## BRIEF DESCRIPTION OF THE DRAWINGS

Fig. 1 is a diagram of a video/computer combined medium receiver station.

Fig. 1A shows a representative example of a computer generated, user specific graphic as it would appear by itself on the face of a display tube.

Fig. 1B shows a representative example of a studio generated graphic.

Fig. 1C shows a representative example, on the face of a display tube, of a studio graphic combined with a user specific graphic.

Fig. 2 is a diagram of one embodiment of a signal processor.

Fig. 2A is a diagram of a TV signal decoder.

Fig. 2B is a diagram of a radio signal decoder.

Fig. 2C is a diagram of an other signal decoder.

Fig. 2D is a diagram of one embodiment of a signal processing system.

Fig. 2E illustrates the initial binary information of a message.

Fig. 2F shows one instance of a meter-monitor segment.

Fig. 2G shows one instance of a command.

Fig. 2H shows the command of Fig. 2G with three padding bits added to complete the last byte signal word.

Fig. 2I shows one instance of a SPAM message stream.

Fig. 2J shows one instance of a message that fills one byte signal word.

Fig. 2K shows one instance of a message that ends with one full byte signal word of padding bits.

Fig. 3 is a diagram of a video/computer combined medium receiver station with a signal processing system.

Fig. 3A is a diagram of the preferred controller of a SPAM decoder.

Fig. 4 is a diagram of one example of a signal processing regulating system.

Fig. 5 is a diagram of one example of a signal processing monitoring system.

Fig. 6 is a diagram of one example of signal processing apparatus at an intermediate transmission station.

Fig. 7 is a diagram of signal processing apparatus at an ultimate receiver station.

Fig. 7A is a diagram of signal processing apparatus regulating the environment of the local receiver site.

Fig. 7B is a diagram of signal processing apparatus used to control a combined medium, multi-channel presentation and monitor viewership.

Fig. 7C is a diagram of signal processing apparatus selecting information and controlling combined medium, multi-channel presentations.

Fig. 7D is a diagram of a radio/computer combined medium receiver station.

Fig. 7E is a diagram of a television/computer combined medium receiver station.

Fig. 7F is a diagram of an example of controlling television and print combined media.

Fig. 8 is a diagram of selected apparatus of Fig. 7 with a EPROM, 20B, installed.

DESCRIPTION OF THE PREFERRED EMBODIMENTS

ONE COMBINED MEDIUM

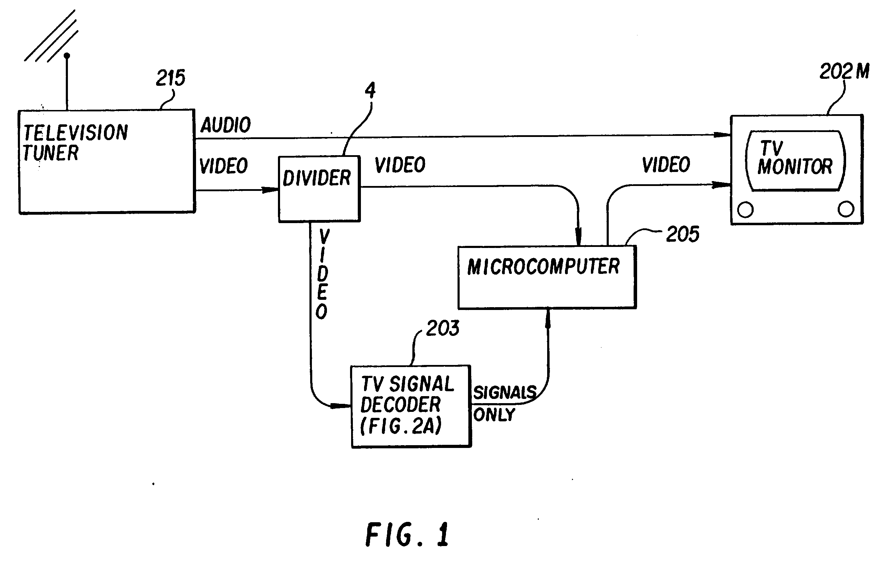

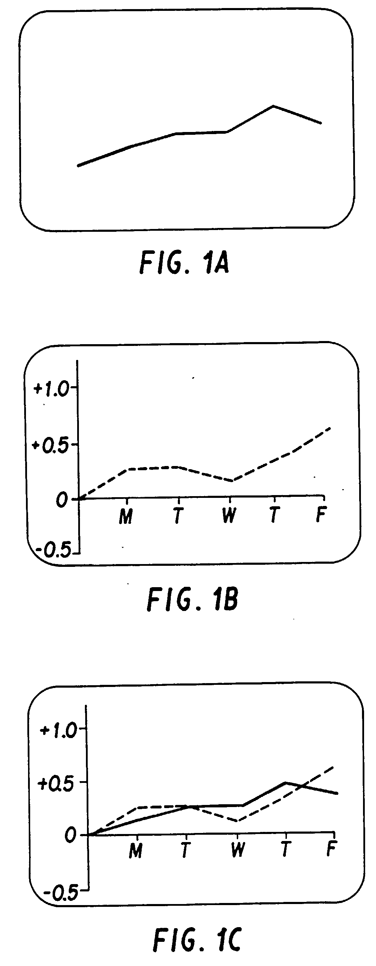

Fig. 1 shows a video/computer combined medium subscriber station. Via conventional antenna, the station receives a conventional television transmission at television tuner, 215. The Model CV510 TV Tuner of Zenith Corporation is one such tuner. This tuner outputs audio and composite video. The audio is inputted to TV monitor, 202M. The video is inputted to divider, 4, which splits the transmission into two paths. One is inputted to TV signal decoder, 203, and the other to microcomputer, 205. TV signal decoder, 203, described below has capacity for receiving a composite video transmission; detecting digital information embedded therein; correcting errors in the received information by means of forward error checking techniques; converting the received information, as may be required, by means of input protocol techniques into digital signals that microcomputer, 205, can receive and process; and transferring said signals to microcomputer, 205. Microcomputer, 205, is a conventional microcomputer system with disk drives that is adapted to have capacity for receiving signals from decoder, 203; for generating computer graphic information; for receiving a composite video transmission; for combining said graphic information onto the video information of said transmission by graphic overlay techniques; and for outputting the resulting combined information to a TV monitor, 202M, in a composite video transmission. One such system is the IBM Personal Computer of IBM Corporation with an IBM Asynchronous Communications Adapter installed in one expansion slot and a PC-MicroKey Model 1300 System with Techmar Graphics Master Card, as supplied together by Video Associates Labs of Austin, Texas, installed in two other slots. Microcomputer, 205, receives digital signals from decoder, 203, at its asynchronous communications adapter and the video transmission from divider, 4, at its PC-MicroKey System. It outputs composite video at its PC-MicroKey System. Microcomputer, 20.5, has all required operating system capacity--eg., the MS/DOS Version 2.0 Disk Operating System with installed device drivers. TV monitor, 202M, has capacity for receiving composite video and audio transmissions and for presenting a conventional television video image and audio sound. One such monitor is the Model CV1950 Color Monitor of Zenith Corporation.

The subscriber station is in New York City and is tuned to the broadcast frequency of channel 13 at 8:30 PM when the station, WNET, commences transmitting a program about stock investing, "Wall Street Week." Said station is an intermediate transmission station for a remote television studio in Maryland. (A station that originates the transmission of programming is called the "program originating studio.") From said studio said program is transmitted by conventional network means to a large number of intermediate transmission stations that retransmit said program to millions of subscribers.

Microprocessor, 205, contains a conventional 5 1/4" floppy disk at a designated disk drive that holds a data file. Said file contains information on the portfolio of the subscriber that identifies the stocks in the portfolio, the number of shares of each stock and closing share prices. Decoder, 203, is preprogrammed to detect digital information on a line or lines (such as line 20) of the vertical interval of its video input; to correct errors; to convert said information into digital signals usable by microcomputer, 205; and to input said signals to microcomputer, 205, at its asynchronous adapter. Microcomputer, 205, is preprogrammed to receive said input and to respond to instruction signals embedded in the "Wall Street Week" program transmission.

Other similarly configured and preprogrammed subscriber stations tune to the transmission of said program. At each subscriber station, the records in the contained financial portfolio file hold, in identical format, information on the particular investments of that station's subscriber.

At said program originating studio, a first series of control instructions is generated, embedded sequentially on said line or lines of the vertical interval, and transmitted on each successive frame of said television transmission until said series has been transmitted in full. The instructions of said series are addressed to and control the microcomputer, 205, of each subscriber station.

In said series--and in any one or more subsequent series of instructions--particular instructions are separated by time periods when no instruction that controls the microcomputer, 205, of any station is transmitted which periods allow sufficient time for the microcomputer, 205, of each and every subscriber station to complete functions controlled by previously transmitted instructions and commence waiting for a subsequent instruction before receiving a subsequent instruction.

Tuner, 215, receives this television transmission and transmits the audio to monitor, 202M, and the video via divider, 4, to microcomputer, 205, and decoder, 203. Decoder, 203, detects the embedded instruction information, corrects it as required, converts it into digital signals usable by microcomputer, 205, and transmits said signals to microcomputer, 205.

With each step occurring in a fashion well known in the art, this first set of instructions commands microcomputer, 205, (and other subscriber station microcomputers simultaneously) to interrupt the operation of its central processor unit ("CPU") and any designated other processors; then to record the contents of the registers of its CPU and any other designated processors at a designated place in random access memory ("RAM"); then to set its PC-MicroKey 1300 to the "GRAPHICS OFF" operating mode in which mode it transmits all received composite video information to monitor, 202M, without modification; then to record information in RAM in an appropriately named file such as "INTERUPT. BAK" on the contained disk; then to clear all RAM (except that portion containing the operating system) and all registers of said CPU; then to wait for further instructions from decoder, 203.

Under control of said first set, microcomputer, 205, reaches a stage at which the subscriber can input information only under control of signals embedded in the broadcast transmission and can reassume control of microcomputer, 205, only by executing a so-called "warm boot". This set is the "control invoking instructions," and the associated steps are "invoking broadcast control."

Microcomputer, 205 is preprogrammed to evaluate particular initial instructions in each distinct series of received input instructions and to operate in response to said initial instructions.

Subsequently, a second series of instructions is embedded and transmitted at said program originating studio. Said second series is detected and inputted to microcomputer, 205, in the same fashion as the first series. Microcomputer, 205, evaluates the initial signal word or words which instruct it to load at RAM (from the input buffer to which decoder, 203, inputs) and run the information of a particular set of instructions that follow said word or words. Such a set of instructions that is loaded and run is a "program instruction set." In a fashion well known in the art, microcomputer, 205, loads the binary information of said set in RAM until, in a predetermined fashion, it detects the end of said set, and it executes said set as an assembled, machine language program.

Under control of said program instruction set and accessing the subscriber's contained portfolio data file, microcomputer, 205, calculates the performance of the subscriber's stock portfolio and constructs a graphic image of that performance at the installed graphics card. The instructions cause the computer, first, to determine the aggregate value of the portfolio at each day's close of business by accumulating, for each day, the sum of the products of the number of shares of each stock held times that stock's closing price. The instructions cause microcomputer, 205, to calculate the percentage change in the portfolio's aggregate value for each business day of the week. Then the instructions cause microcomputer, 205, to enter digital bit information at the video RAM of the graphics card in a pattern that depicts said percentage change as it would be graphed on a graph with a particular origin and set of scaled graph axes. Upon completion, the instructions cause microcomputer, 205, to commence waiting for a subsequent instruction.

If the information at video RAM were to be transmitted alone to the video screen of a TV monitor, it would appear as a line of a designated color, such as red, on a background color that is transparent when overlaid on a separate video image. Black is such a background color, and Fig. 1A shows one such line.

As each subscriber station completes said program instruction set, information of such a line exists at video RAM which information reflects the specific portfolio performance of the user of said station.

While microcomputer, 205, performs these steps, TV monitor, 202M, displays the conventional television image and sound of "Wall Street Week". The host says, "Now as we turn to the graphs, here is what the Dow Jones Industrials did in the week just past," and a studio generated graphic is transmitted. Fig. 1B shows the image of said graphic as it appears on the video screen of TV monitor, 202M. The host says, "And here is what your portfolio did." At this point, an instruction signal is generated at said program originating studio, embedded in the transmission, and transmitted. Said signal is identified by decoder, 203; transferred to and executed by microcomputer, 205, at the system level as the statement, "GRAPHICS ON". Said signal instructs microcomputer, 205, at the PC-MicroKey 1300 to overlay the graphic information in its graphics card onto the received composite video information and transmit the combined information to TV monitor, 202M. TV monitor, 202M, then displays the image shown in Fig. 1C which is the microcomputer generated graphic overlaid on the studio generated graphic. Microcomputer, 205, commences waiting for another instruction from decoder, 203.

Simultaneously, each subscriber in a large audience sees his specific performance information as it relates to the performance of the market as a whole.

(An instruction such as "GRAPHICS ON" that causes subscriber station apparatus to execute a combining operation is called a "combining synch command." Said initial signal word or words that preceded the above program instruction set provide another example of a combining synch command in that said word or words synchronized all computers in commencing loading and running.)

As the program proceeds, a further instruction signal is generated at said studio; transmitted; detected; inputted to microcomputer, 205; and executed as "GRAPHICS OFF." Then said studio ceases transmitting the graphic image, and transmits another image such as the host. Simultaneously, the GRAPHICS OFF command causes microcomputer, 205, to cease overlaying graphic information onto the received composite video and to commence transmitting the received composite video transmission unmodified.

This provides but one of many examples of television based combined medium programming. This television based medium is but one of many combined media.

THE SIGNAL PROCESSOR

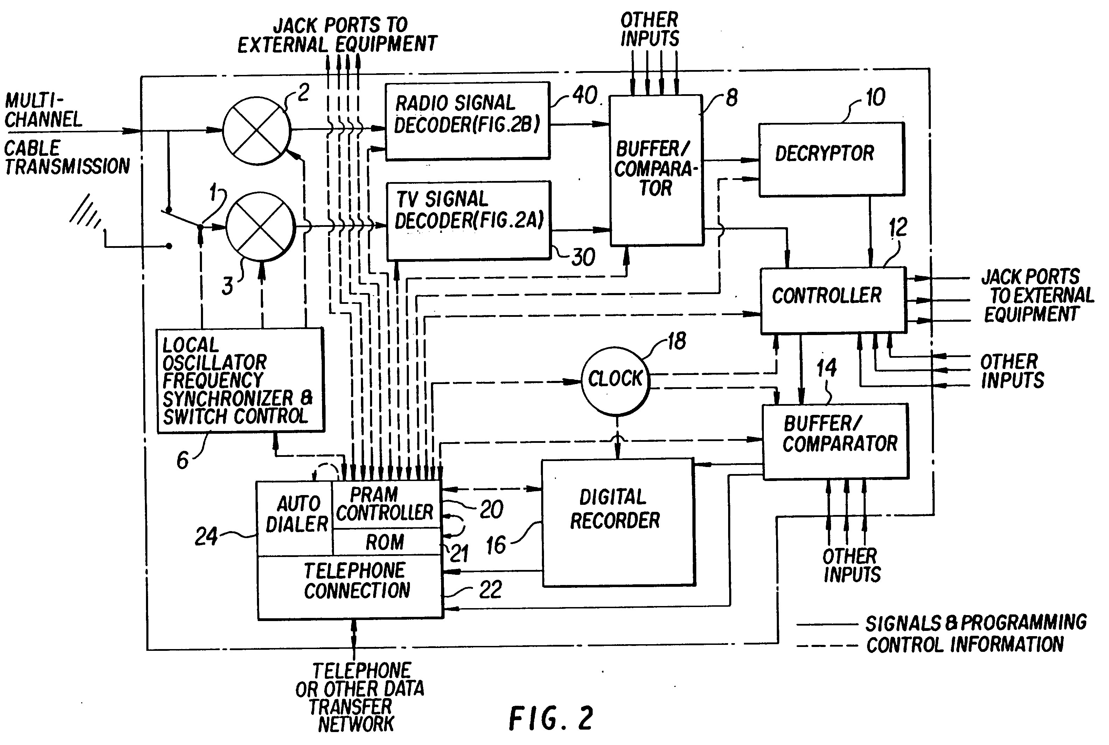

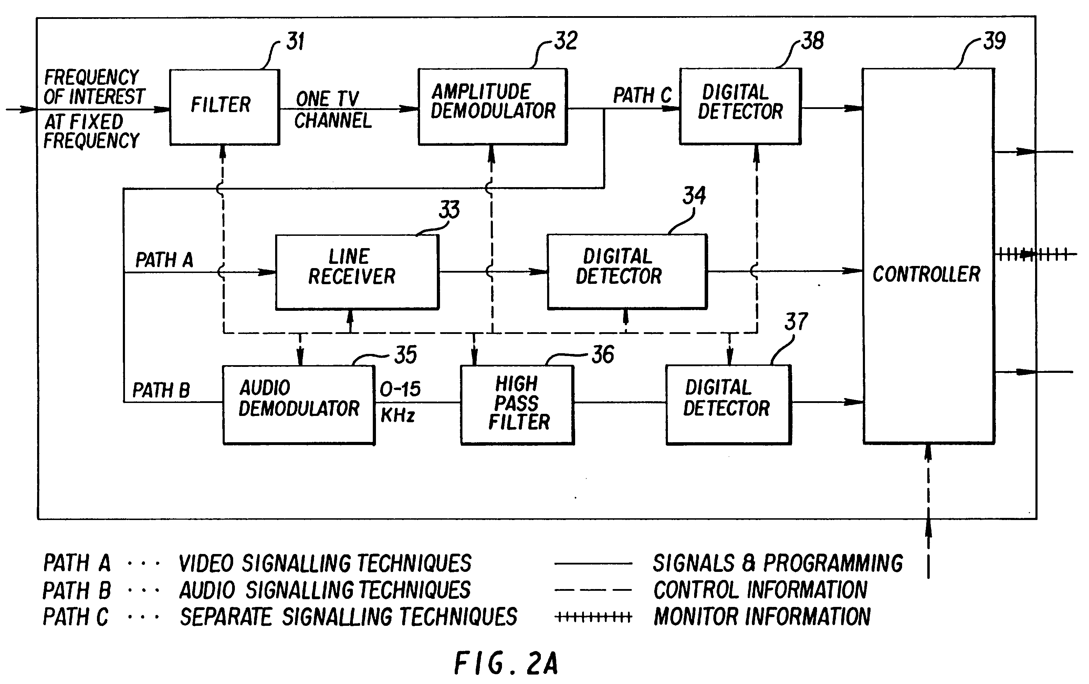

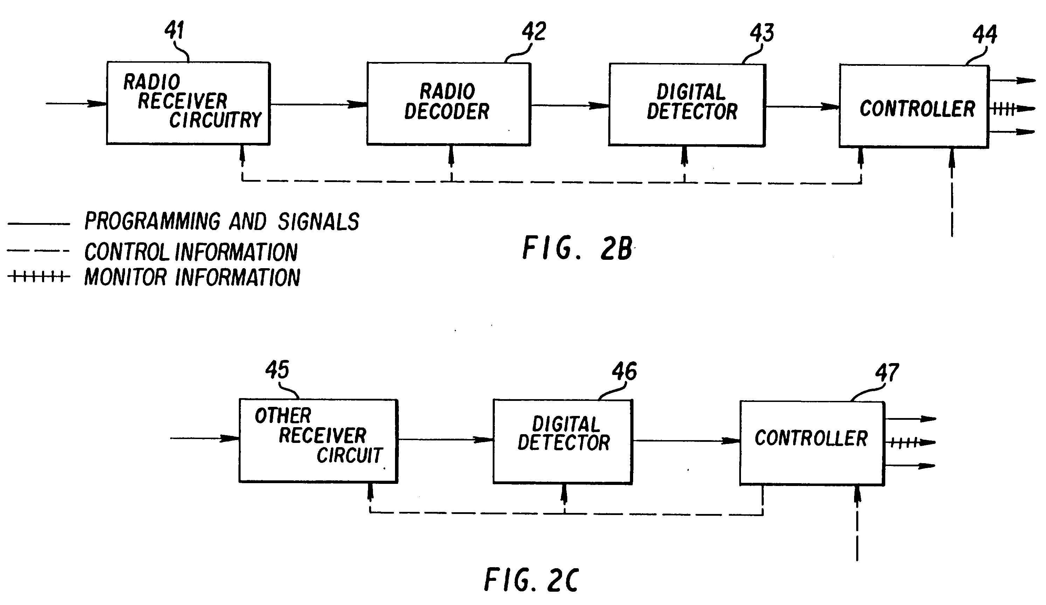

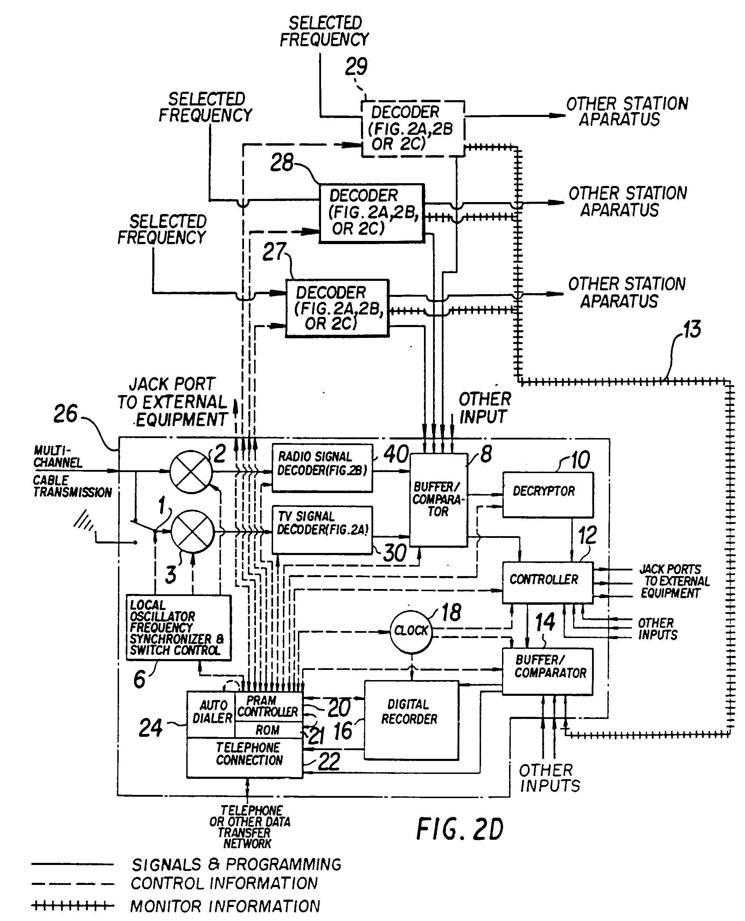

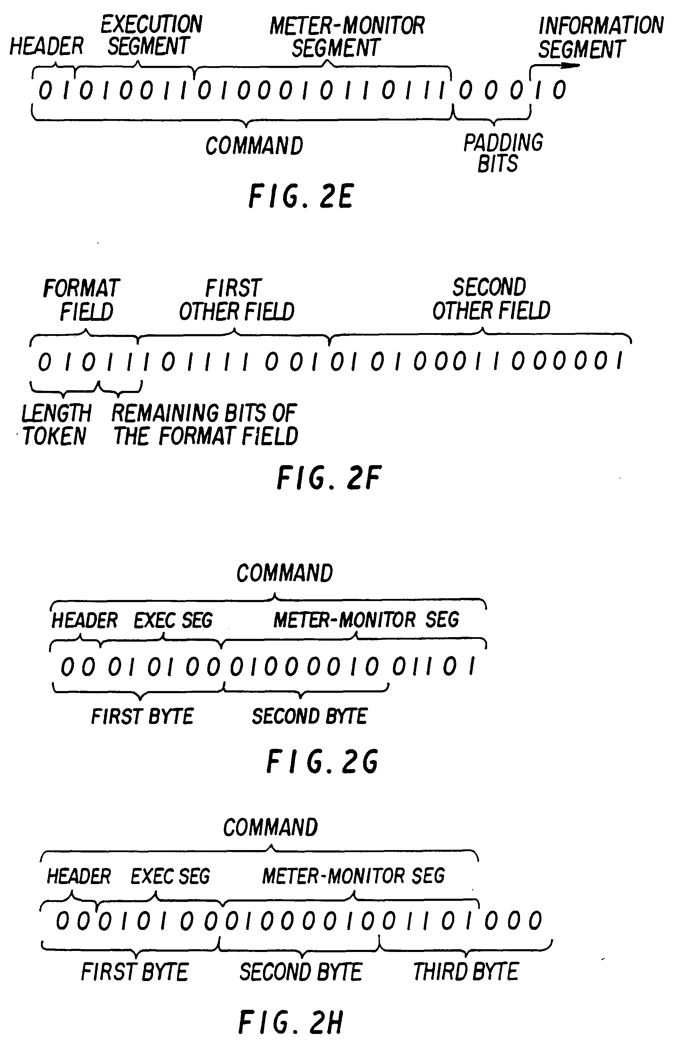

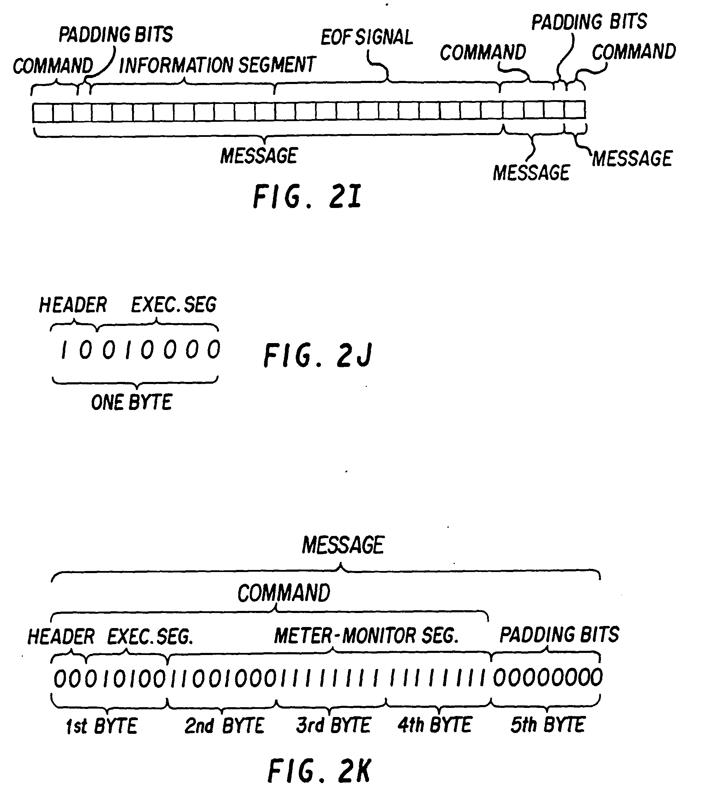

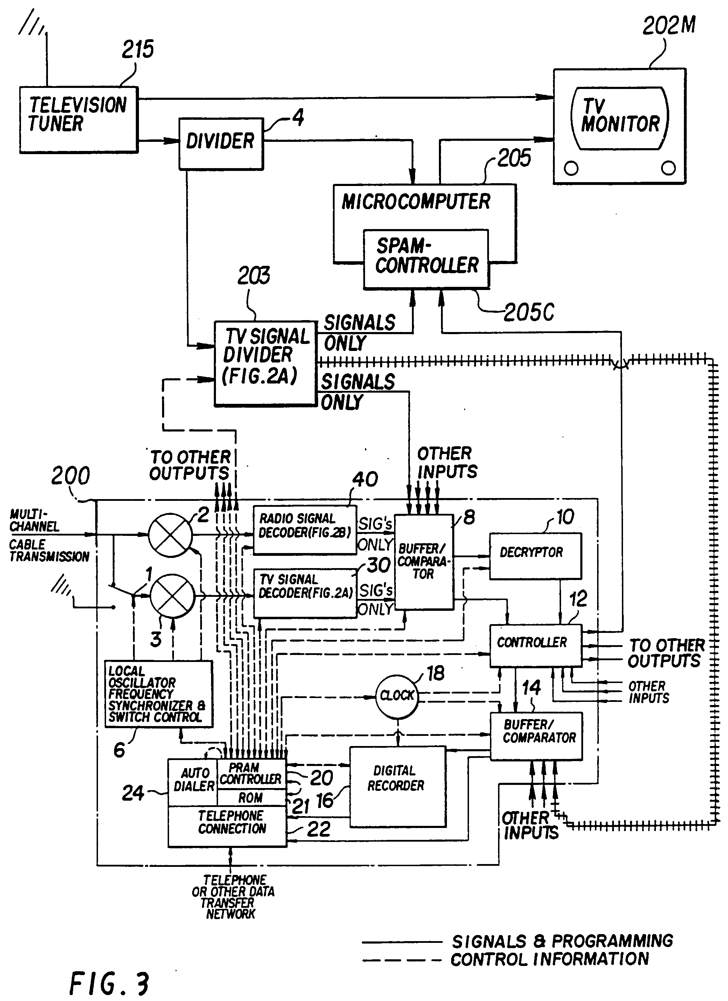

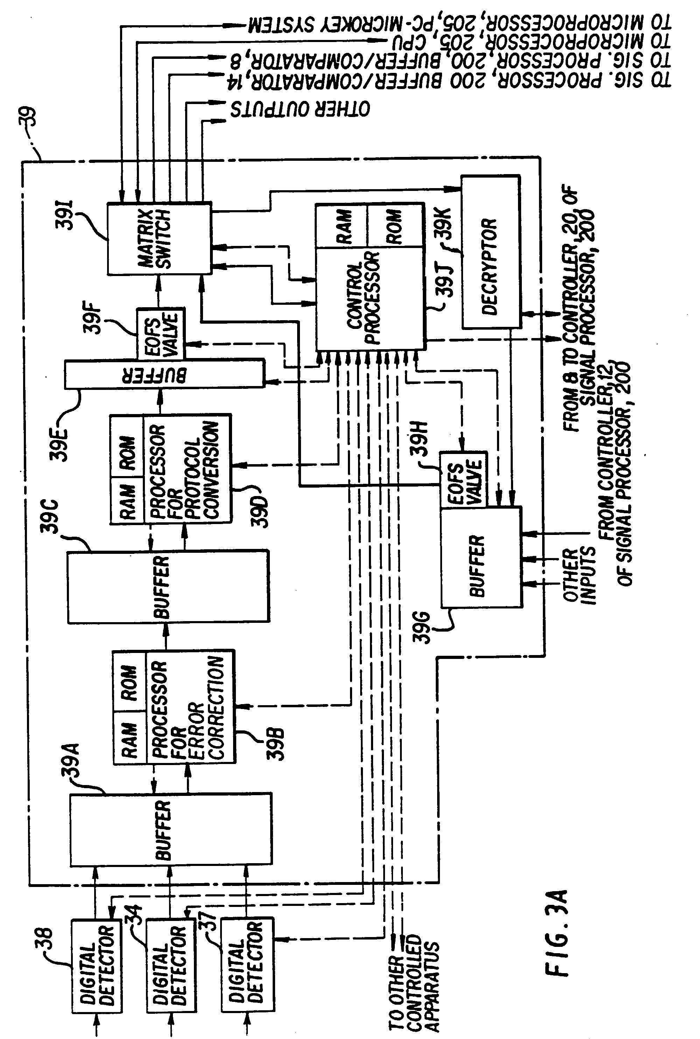

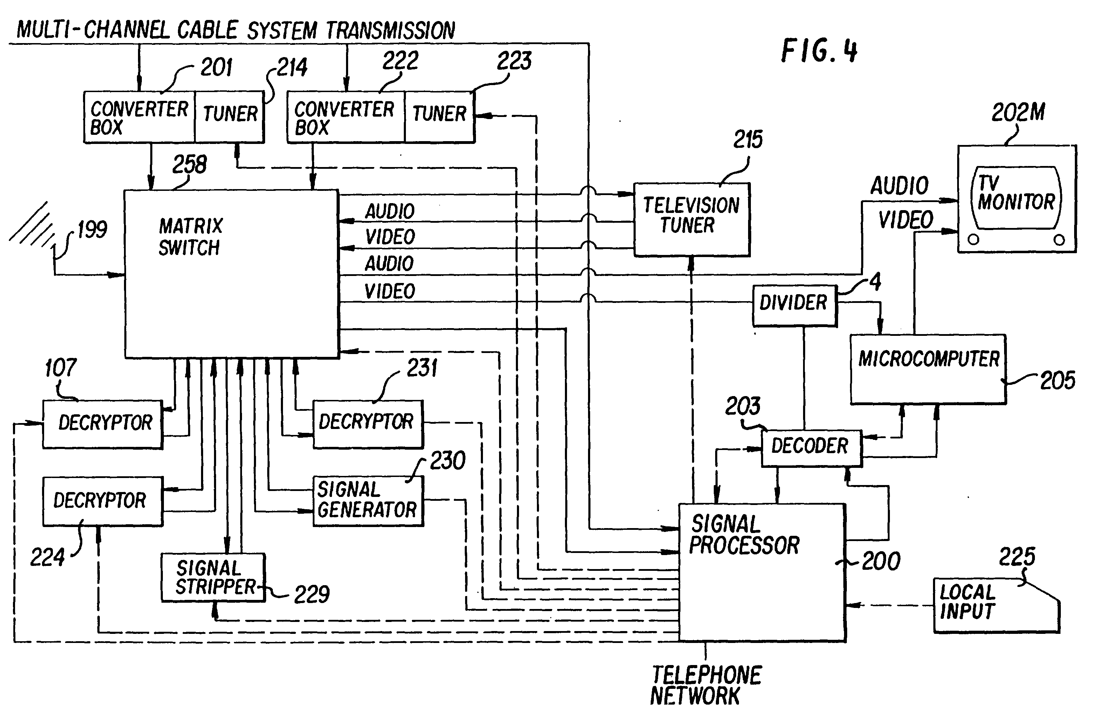

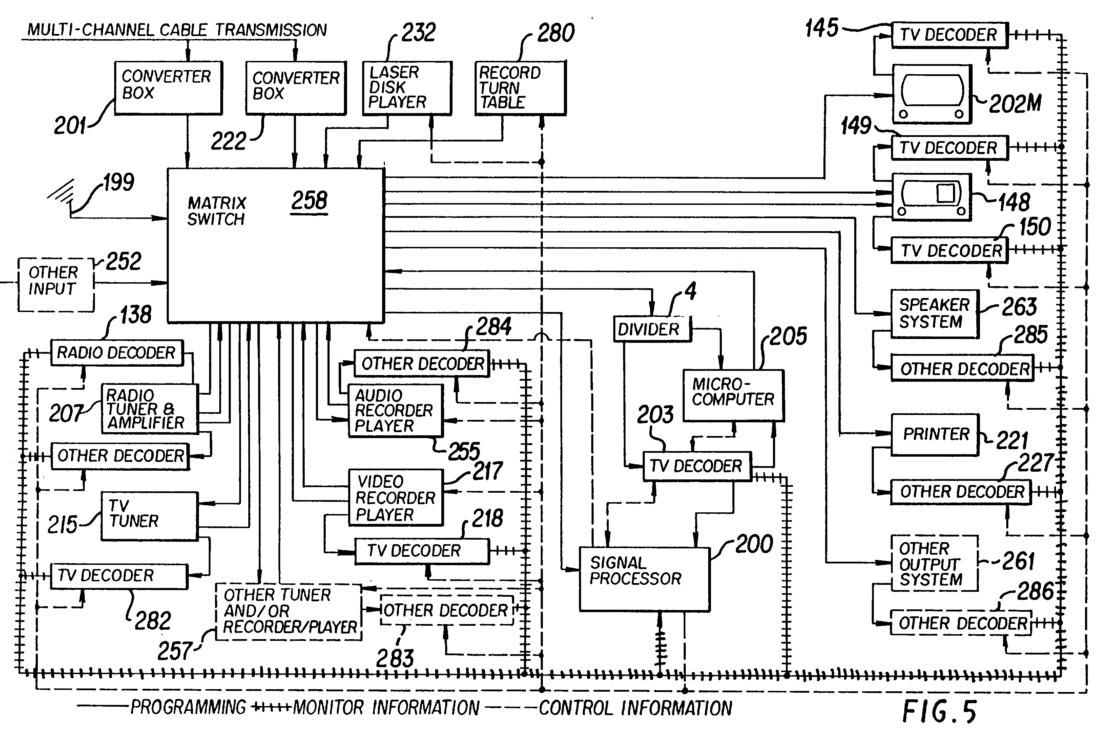

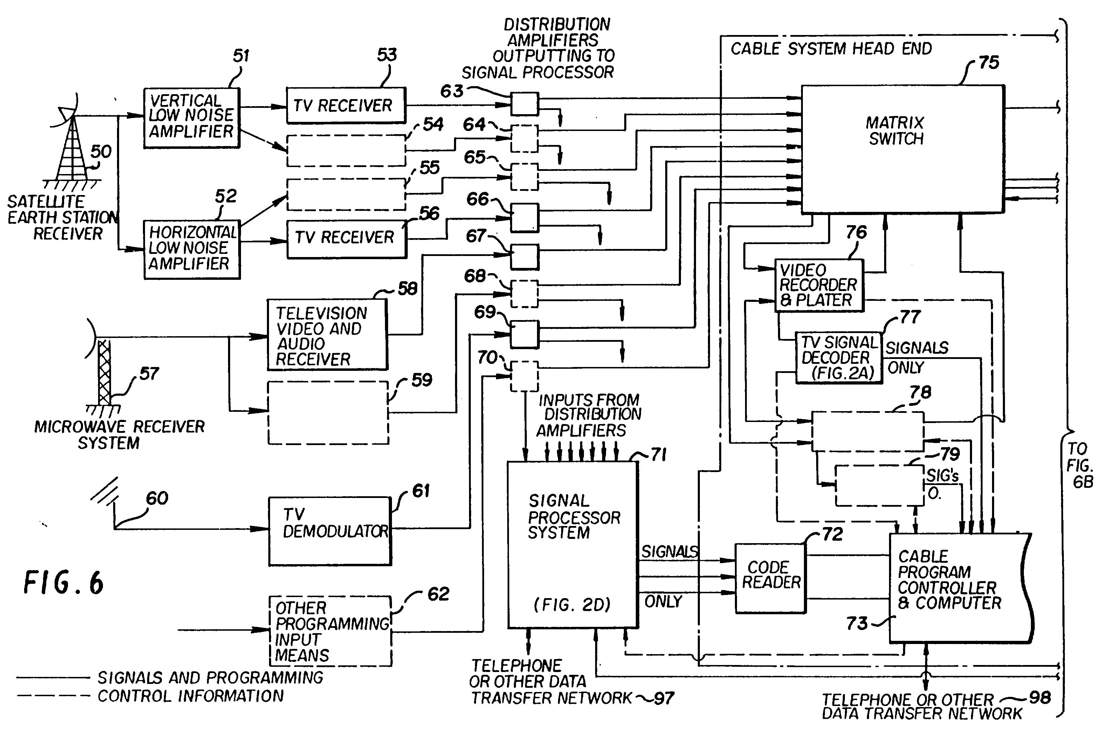

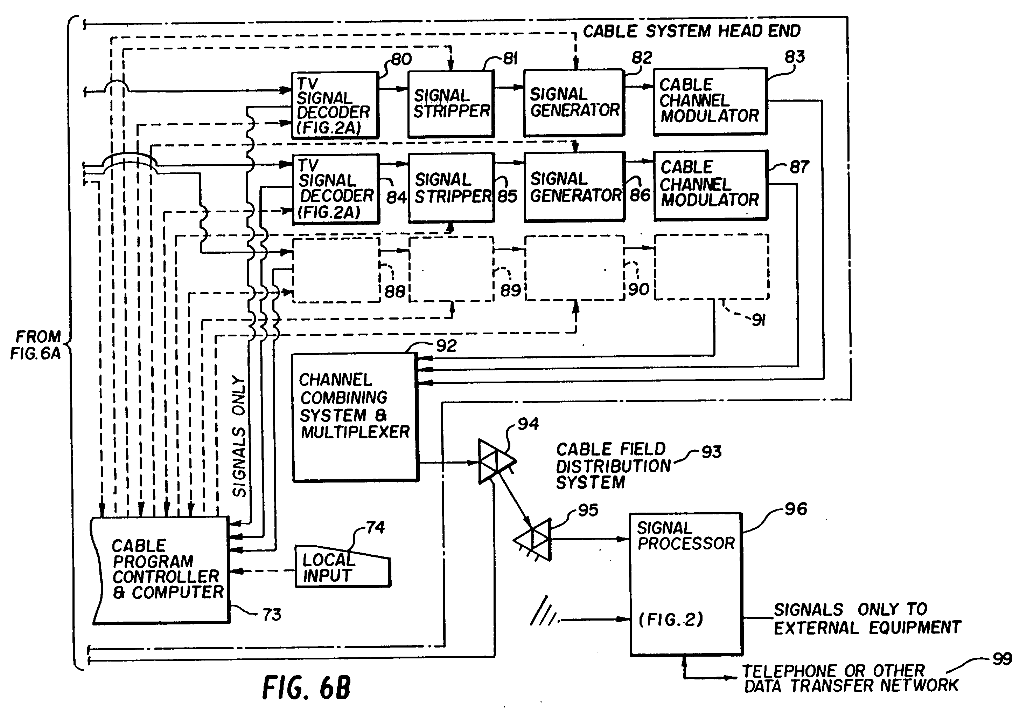

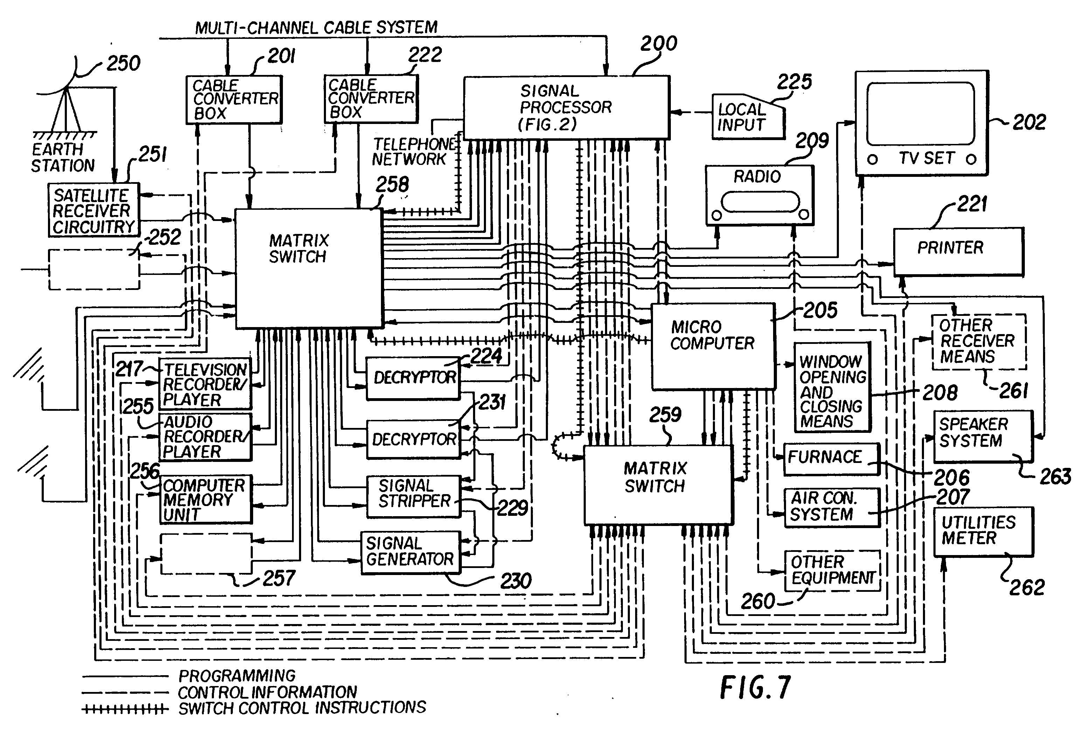

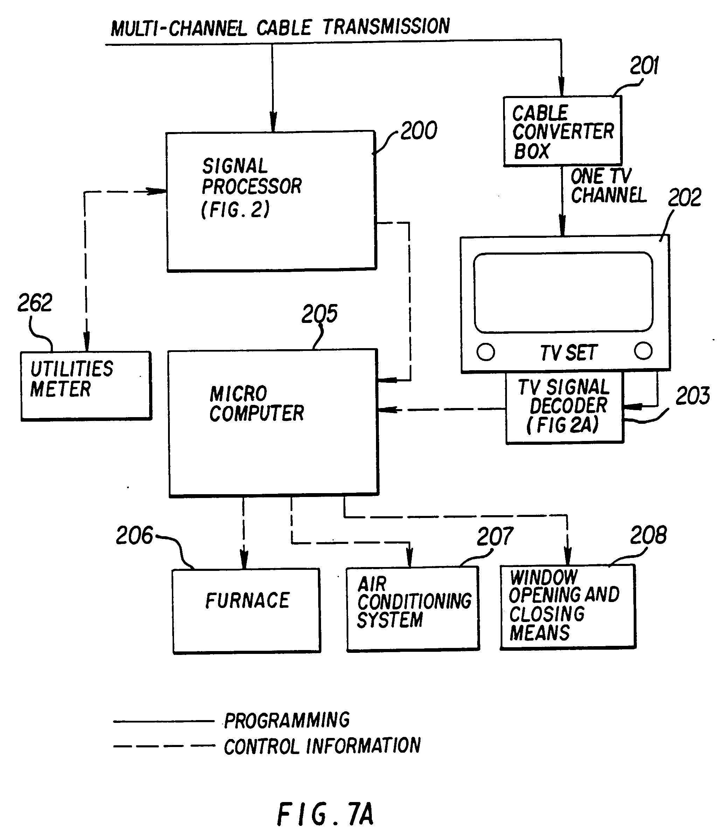

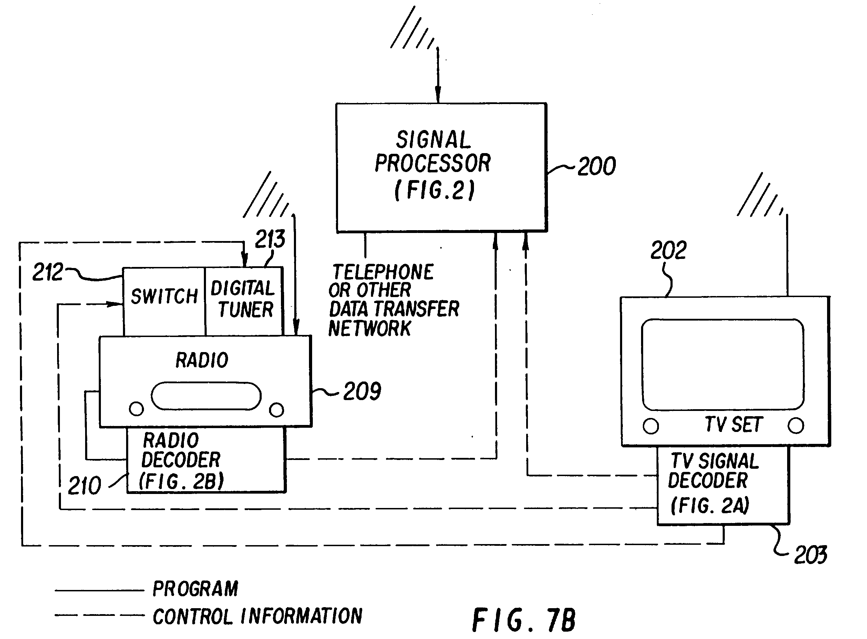

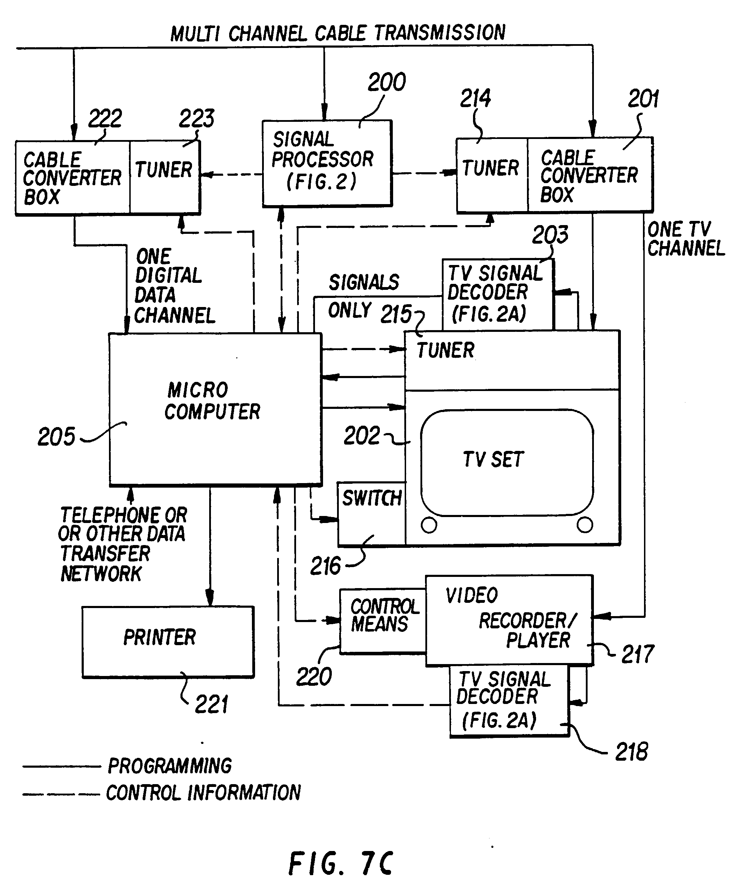

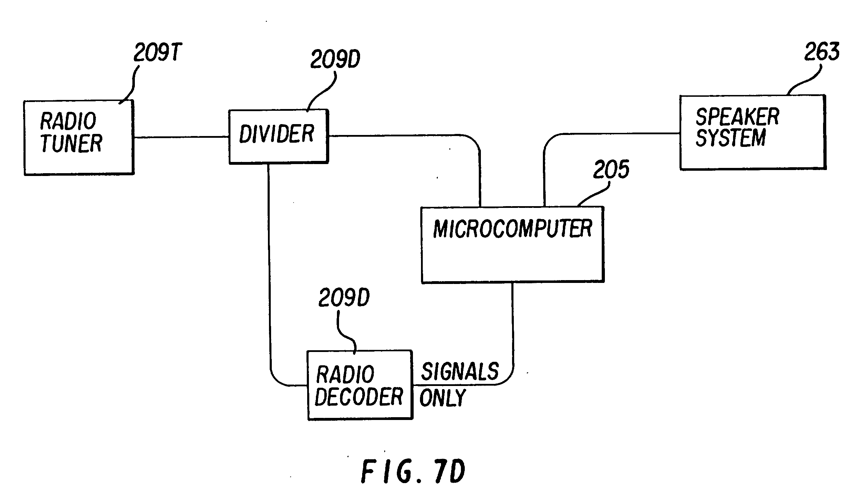

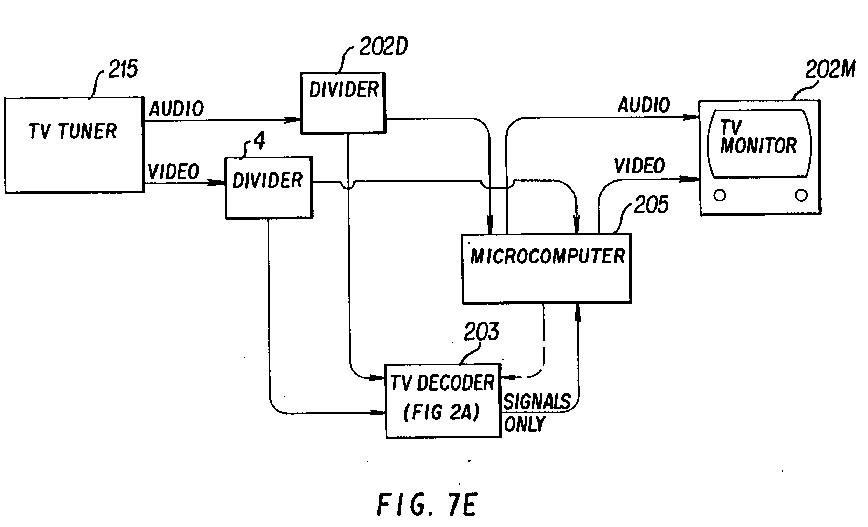

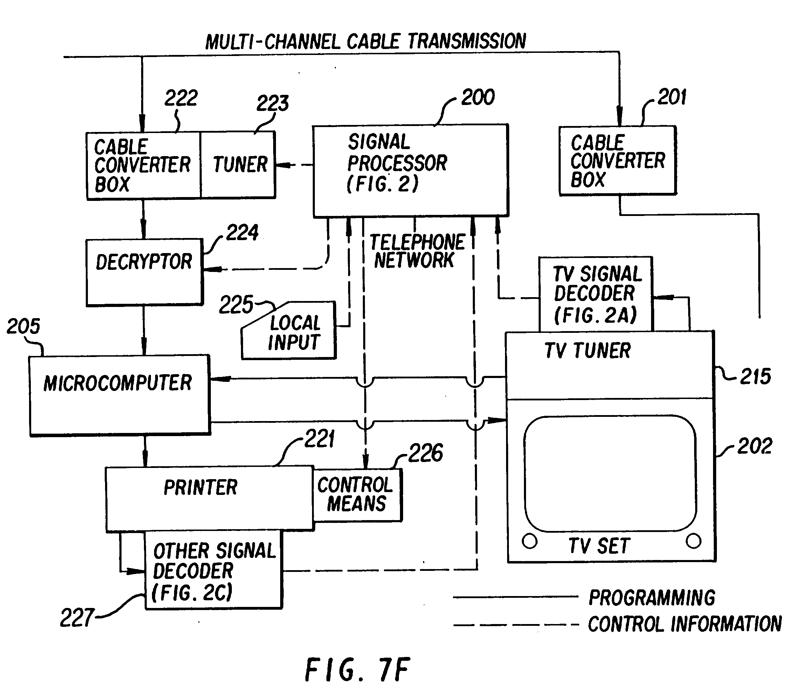

In the present invention, the signal processor--Fig. 2; 26 in Fig. 2D; in system, 71, of Fig. 6; 200 in Fig. 7; and elsewhere--is focal means for controlling and monitoring subscriber station operations. It meters communications and enables owners to offer information to subscribers in many fashions on condition of payment. It has capacity for regulating communications consumption by selectively decrypting programming and/or control signals. It has capacity for identifying subject matter of specific programming on each of many channels which enables subscriber station apparatus to to tune automatically to said programming. It has capacity for transferring records automatically to remote stations that bill subscribers on programming usage. It has capacities for processing in other fashions that become apparent in this full specification.

Fig. 2 shows a signal processor configured with a cablecast and a broadcast input. At switch, 1, and mixers, 2 and 3, signal processor, 26, monitors all frequencies available for reception to identify available programming. The inputted information is the entire range of frequencies transmitted on cable and available to a local television antenna. The cable transmission is inputted simultaneously to switch, 1, and mixer, 2. The broadcast transmission is inputted to switch, 1. Switch, 1, and mixers, 2 and 3, are controlled by local oscillator and switch control, 6. Oscillator, 6, is controlled to provide a number of discrete specified frequencies for the particular radio and television channels required. The switch, 1, acts to select the broadcast or cablecast input and passes transmissions to mixer, 3, which, with the controlled oscillator, 6, acts to select a television frequency of interest that is passed at a fixed frequency to a TV signal decoder, 30. Simultaneously, mixer, 2, and the controlled oscillator, 6, act to select a radio frequency of interest which is inputted to a radio signal decoder, 40.

At decoders, 30 and 40, signal processor, 26, identifies specific programming and subject matter as said programming becomes available for use and/or viewing. Decoder, 30, shown in Fig. 2A, and decoder, 40, shown in Fig. 2B, detect signal information embedded in the respective inputted television and radio frequencies, render said information into digital signals that subscriber station apparatus can process, modify particular signals through the addition and/or deletion of particular information, and output signals to buffer/comparator, 8.

Buffer/comparator, 8, receives signals from said decoders and from other inputs and organizes the received information in a predetermined fashion. Buffer/comparator, 8, has capacity for comparing a portion or portions of inputted information to preprogrammed information and for operating in preprogrammed fashions on the basis of the results of comparing. It has capacity for detecting particular end of file signals. In a predetermined fashion, buffer/comparator, 8, determines whether given signal information requires decryption. Buffer/comparator, 8, and a controller, 20, determine whether signal processor, 26, is enabled to decrypt said information. If signal processor, 26, is so enabled, buffer/comparator, 8, transfers said information to decryptor, 10. If not, buffer/comparator, 8, discards said information. Buffer/comparator, 8, transfers signals that do not require decryption to controller, 12.

Decryptor, 10, is a standard digital decryptor that receives signals from buffer/comparator, 8, and under control of controller, 20, uses conventional techniques to decrypt signals. Decryptor, 10, transfers decrypted signals to controller, 12.

Controller, 12, is a standard controller that has microprocessor and RAM capacities and one or more ports for transmitting information to external apparatus. Controller, 12, may contain read only memory ("ROM"). Controller, 12, receives signals from buffer/comparator, 8, and decryptor, 10; analyzes signals in a predetermined fashion; and determines whether they are to be transferred to external equipment or to buffer/comparator, 14, or both. If signals are to be transferred externally, controller, 12, identifies the external apparatus to which the signals are addressed and transfers them. If they contain meter and/or monitor information, controller, 12, selects and transfers appropriate information to buffer/comparator, 14. Controller, 12, has capacity to modify received signals by adding and/or deleting information. Controller, 12, receives time information from clock, 18, and has means to delay transfer.

Buffer/comparator, 14, receives signal information that is meter and/or monitor information from controller, 12, and from other inputs; organizes said information into meter records and/or monitor records (in aggregate, "signal records") in predetermined fashions; and transmits signal records to a digital recorder, 16, and/or to one or more remote sites. Buffer/comparator, 8, has capacity to initiate or modify signal records and to discard unnecessary information. To avoid duplicate data, buffer/comparator, 14, has means for counting and/or discarding duplicate instances of signal information and for incorporating count information into signal records. Buffer/comparator, 14, receives time information from clock, 18, and has means for incorporating time information into signal records. Buffer/comparator, 14, operates under control of controller, 20, and controller, 20, can cause modification of the formats of and information in signal records at buffer/comparator, 14. (Buffer/comparator, 14, may operate under control of a dedicated "on-board" controller, 14A, which is preprogrammed with appropriate control instructions and is controlled by controller, 20.)

Digital recorder, 16, is a memory storage element of standard design that receives information from buffer/ comparator, 14, and records said information. In a predetermined fashion, recorder, 16, can determine and inform controller, 20, automatically when it reaches a certain level of fullness.

Signal processor, 26, has a controller device which includes programmable RAM controller, 20; ROM, 21, that may contain unique digital code information capable of identifying signal processor, 26, and the subscriber station; an automatic dialing device 24; and a telephone unit, 22. A portion of ROM, 21, is erasable programmable ROM ("EPROM") or other form of programmable nonvolatile memory. Under control particular preprogrammed instructions at that portion of ROM, 21, that is not erasable, signal processor, 26, has capacity to erase and reprogram said EPROM. Controller, 20, has capacity for controlling the operation of all elements of the signal processor and can receive operating information from said elements. Controller, 20, has capacity to turn off any element of controlled subscriber station apparatus, in whole or in part, and erase any or all parts of erasable memory of said controlled apparatus.

The signal processor of Fig. 2 is but one embodiment of a signal processor. Other embodiments can monitor frequencies other than radio and television through addition of other signal decoders such as that of Fig. 2C below. Embodiments can receive fixed frequencies continuously at decoders. One particular embodiment has no oscillator, 6; switch, 1; mixers, 2 and 3; or decoders, 30 or 40. Another embodiment has only buffer/comparator, 14; recorder, 16; clock, 18; and the control device apparatus associated with controller, 20. Other embodiments will become apparent in this full specification.

SIGNAL DECODERS

Signal decoder apparatus are basic in this invention.

Fig. 2A shows a TV signal decoder that detects signal information embedded in an inputted television frequency. Decoder, 203, in Fig. 1 is one such decoder; decoder, 30, in Fig. 2 is another. A selected frequency is inputted at a fixed frequency at filter, 31, which defines the channel to be analyzed. The channel signal passes to a standard amplitude demodulator, 32, to define the television base band signal. This base band signal is transferred through separate paths to detector devices. Path A inputs to a standard line receiver. Said receiver, 33, receives the information of one or more lines normally used to define a television picture. It passes said information to a digital detector, 34, which acts to detect the digital signal information embedded in said information and inputs detected signal information to controller, 39. Path B inputs to a standard audio demodulator, 35, which transfers audio information to high pass filter, 36. Said filter, 36, defines and transfers to digital detector, 37, the portion of said audio information that is of interest. Digital detector, 37, detects signal information embedded in said audio information and inputs detected signal information to controller, 39. Path C inputs to digital detector, 38, which detects signal information embedded in any other portion of said television channel and inputs detected signal information to controller, 39. Line receiver, 33; high pass filter, 36; detectors, 34, 37, and 38; and controller, 39, all operate under control of controller, 39.

Fig. 2B shows a radio signal decoder. Decoder, 40, in Fig. 2 is one such decoder. A selected frequency of interest is inputted at a fixed frequency to standard radio receiver circuitry, 41, which receives the radio information of said frequency and transfers said radio information to radio decoder, 42. Radio decoder, 42, decodes the signal information embedded in said radio information and transfers said decoded information to a standard digital detector, 43. Said detector, 43, detects the binary signal information in said decoded information and inputs said signal information to controller, 44. Circuitry, 41; decoder, 42; and detector, 43, all operate under control of controller, 44.

Fig. 2C shows a signal decoder that detects and processes signal information embedded in a frequency other than television or radio. A selected other frequency (such as a microwave frequency) is inputted to appropriate other receiver circuitry, 45. Said circuitry, 45, receives and transfers information to detector, 46. Said detector, 46, detects binary signal information and inputs said signal information to controller, 47. Circuitry, 45, and detector, 46, operate under control of controller, 47.

Each decoder is controlled by a controller, 39, 44, or 47, that has buffer, microprocessor, ROM, and RAM capacities. The ROM of controller, 39, 44, or 47, include EPROM capacity. Said ROM and/or EPROM may contain digital code capable of identifying its controller, 39, 44, or 47, uniquely. Capacity exists at said controller, 39, 44, or 47, for erasing said EPROM, and said RAM and EPROM are reprogrammable. Controller, 39, 44, or 47, is preprogrammed to process any given instance of signal information automatically. Controller, 39, 44, or 47, controls apparatus of its signal decoder and has means for communicating control information to said apparatus. Said controller, 39, 44, or 47, also has means for communicating control information with a controller, 20, of a signal processor, 26.

THE SIGNAL PROCESSOR SYSTEM

Signal processing apparatus and methods involve an extended system focused on the signal processor. Fig. 2D shows one embodiment of a signal processing system. Said system contains signal processor, 26, and external decoders, 27, 28, and 29. Each external decoder may be a TV signal decoder (Fig. 2A) or a radio signal decoder (Fig. 2B) or an other signal decoder (Fig. 2C) depending on the nature of the frequency input. Each decoder, 27, 28, and 29, receives one selected frequency and has capacity for transferring detected, corrected, converted, and possibly modified signals to buffer/comparator, 8, and to other apparatus. Each decoder, 27, 28, and 29, also has capacity for transferring monitor information to buffer/ comparator, 14. Controller, 20, has capacity to control all decoder apparatus, 27, 28, 29, 30, and 40.

Not every installed decoder requires all the apparatus of Figs. 2A, 2B, and 2C. For example, because a television base band signal is inputted to decoder, 203 of Fig. 1, said decoder does not require filter, 31, and demodulator, 32.

Decoders, 27, 28, and 29, communicate monitor information to buffer/comparator, 14, by means of bus, 13.

THE SIGNALS OF THE INTEGRATED SYSTEM

Signals are the modalities whereby stations that originate transmissions control handling, generating, and displaying of programming at subscriber stations. ("SPAM" refers to signal processing apparatus and methods of the present invention.) SPAM signals control broadcast stations, cable system headends and media centers. Stations that retransmit transmissions are "intermediate transmission stations" and where subscribers view programming are "ultimate receiver stations."

The present invention provides a unified signal system for addressing, controlling, and coordinating all stations and apparatus. One objective is to have capacity to accommodate newly developed hardware while still serving older hardware. This means that the unified system does not consist of one immutable version of signal composition. Rather it is a family of versions. Accordingly, this specification speaks of "simple preferred embodiments" and "the simplest preferred embodiment" rather than just one preferred embodiment.

THE COMPOSITION OF SIGNAL INFORMATION

SPAM signals contain binary information. Fig. 2E shows one example of signal information (excluding bit information required for error correction). The information commences with a header that synchronizes subscriber station apparatus in analysis of the information pattern that follows. Following said header are an execution segment, a meter-monitor segment, and an information segment. The header and execution and meter-monitor segments constitute a command. A command is addressed to particular subscriber station apparatus and causes said apparatus to perform a particular function or functions called "controlled functions." Meter-monitor segments cause subscriber station signal processor systems to assemble, record, and transmit meter records and monitor records to remote stations.

In the simplest preferred embodiment, all headers consist of two bit binary information, and commands are identified by one of three binary headers:

10 - a command with an execution segment,

00 - a command with execution and meter-monitor segments, and

01 - a command with execution and meter-monitor segments that is followed by an information segment.

Execution segment information includes the subscriber station apparatus that the command addresses and the controlled functions said apparatus is to perform. "ITS" refers to intermediate transmission station apparatus, and "URS" to ultimate receiver station apparatus. Examples of addressed apparatus include:

ITS controller/computers (73 in Fig. 6),

URS signal processors (200 in Fig. 7), and

URS microcomputers (205 in Fig. 7).

Examples of controlled functions include:

Load and run the contents of the information segments

Commence the video overlay combining designated in the meter-monitor segment, and

Print the contents of the information segment.

Execution segments invoke preprogrammed operating instructions at subscriber station apparatus. For each appropriate addressed apparatus and controlled function combination a unique binary value is assigned. In the preferred embodiment, every execution segment contains the same number of bits.

The preferred embodiment includes one command called the "pseudo command" that is addressed to no apparatus. By transmitting pseudo command signals, transmission stations cause receiver station apparatus to record meter-monitor segment information without executing controlled functions.

Meter-monitor segments contain meter information and/or monitor information. Examples include:

meter instructions,

origins of transmissions,

unique identifier codes for each program unit (including commercials), and

codes that identify the subject matter.

For each category, a series of binary bits (a "field") exists in the meter-monitor segment to contain the information. In any given category such as origins of transmissions, each distinct item such as each network source, broadcast, or cable head end station has a unique binary information code. Because the number of categories of meter-monitor information varies from one command to the next, the length of meter-monitor segments varies. Each instance of a meter-monitor segment includes a format field that contains information that specifies the format of the meter-monitor segment of said instance. Within said field is a group of binary information bits (the "length token") that identifies the number of bits in a meter-monitor segment of said format. Each distinct meter-monitor format also has a unique binary code. Fig. 2F illustrates one instance of a meter-monitor segment (excluding bit information required for error correction). In the preferred embodiment, the bits of the length token are first in each meter-monitor segment.

Information segments follow commands and can be of any length. An information segment can transmit any information that a processor can process.

In the simplest preferred embodiment, a fourth type of header is:

11 - an additional information segment transmission following a "01" header command and one or more information segments which additional segment is addressed to the same apparatus and invokes the same controlled functions as said "01" command.

An instance of signal information with a "11" header contains no execution segment or meter-monitor segment information.

In the preferred embodiment, "padding bits" render any given SPAM command into a bit length that is complete for communication. Fig. 2H shows three padding bits at the end of the twenty-one bits of the command of Fig 2G. to render the information into eight-bit bytes.

All information transmitted with a given header is called a "message", and a message consists of all the SPAM information from the first bit of one header to the last bit before the next header. The information of any given SPAM transmission consists of a series or stream of messages.

Cadence information which consists of headers, certain length tokens, and "end of file signals" enables subscriber station apparatus to distinguish each instance of header information in message stream and, hence, the individual messages of said stream. Subscriber station apparatus are preprogrammed to process cadence information. Commands with "10" headers are a header+exec constant length. By preprogramming subscriber station apparatus for processing length token information, the present invention enables said apparatus to determine the bit, following a "00" header, that is the next instance of header information. By preprogramming apparatus to detect end of file signals, the present invention enables said apparatus to determine the bit, following a "01" header, that is the next instance of header information. In the preferred embodiment, an end of file signal consists of a sequence of "1" bits (eg. "11111111"). ("1" is an "EOFS bit," and "0" is a "MOVE bit.") The length of said sequence (disregarding error correction information) is the minimum necessary to distinguish said sequence. At any given time alternate lengths exist. One end of file signal is five bytes of EOFS bits. Another is eleven bytes of EOFS bits. Which is used depends on the nature of the transmission in which said signal occurs.

Fig. 2I depicts one instance of a stream of SPAM messages. Each rectangle represents one signal word. Fig. 2I shows a series of three messages. Each is composed in a whole number of signal words. The first consists of a command followed by padding bits followed by an information segment followed by an end of file signal. The second consists of a command followed by padding bits. The third consists of a command alone.

DETECTING END OF FILE SIGNALS

In the present invention, any microprocessor, buffer/comparator, or buffer can be adapted to detect end of file signals. At an apparatus so adapted, particular dedicated capacity exists. Said capacity includes three memory locations for comparison purposes, one to serve as a counter, and three to hold true/false information. Said locations are the "Word Evaluation Location," "Standard Word Location," "Standard Length Location"; "WORD Counter"; "WORD Flag," "Empty Flag," and "Complete Flag" respectively. All operating instructions are preprogrammed as so-called "firmware". Said dedicated capacity is called an "EOFS valve". The Word Evaluation Location and Standard Word Location are conventional dynamic memory locations each capable of holding one signal word. The Standard Length Location and WORD Counter are dynamic memory locations capable of holding, at a minimum, one byte. The WORD Flag, Empty Flag, and Complete Flag are each dynamic memory locations capable of holding, at a minimum, one bit. At said Word Evaluation Location is one signal word of received SPAM information. At said Standard Word Location is one signal word of EOFS bits. One word of EOFS bits is called an "EOFS WORD." At the WORD Counter is information of the number of EOFS WORDs that said valve has received in uninterrupted sequence. Said Flag locations contain "0" or "1" to reflect true or false conditions.

An EOFS valve receives binary information of one SPAM transmission from one external transferring apparatus and outputs information to one external receiving apparatus.

Determining that an end of file signal has been detected causes said valve to inform external apparatus of the presence of an end of file signal. As one example, for apparatus that operates under control of a controller, instructions cause said valve to transmit EOFS-signal-detected information to said controller then to wait for a control instruction from said controller. Said EOFS-signal-detected information causes said controller to determine how to process the information at said valve and to transmit either a transmit-and-wait instruction or a discard-and-wait instruction to said valve. Said transmit-and-wait instruction causes said valve to transfer one complete end of file signal then transmit complete-and-waiting information to said controller. Alternatively, said discard-and-wait instruction causes said valve merely to set the information at said WORD Counter to zero (thereby discarding said end of file signal) and transmit complete-and-waiting information to said controller. In the preferred embodiment, said EOFS-signal-detected information and said complete-and-waiting information are transmitted as interrupts to the CPU of said controller.

In order to define end of file signals precisely, a signal word that contains at least one MOVE bit is always transmitted immediately before the uninterrupted sequence of EOFS WORDs of any given end of file signal.

THE NORMAL TRANSMISSION LOCATION

SPAM signals are generated at transmission stations and embedded in television or radio or other programming. In television, the normal transmission location is in the vertical interval of each frame of the television video. In radio, the normal location is in the audio above the range normally audible to the human ear. In broadcast print or data communications, the normal location is the same as the conventional information.

OPERATING SIGNAL PROCESSOR SYSTEMS

Five examples focus on subscriber stations where the system of Fig. 2D and the apparatus of Fig. 1 operate in common. Fig. 3 shows one such station. SPAM-controller, 205C, is a control unit like controller, 39, of decoder, 203, with capacity for transferring information to and receiving from the CPU of microcomputer, 205; and capacity for transferring information to one or more input buffers of microcomputer, 205. SPAM-controller, 205C, has capacity to control directly the PC-MicroKey 1300 System.

All five examples relate to the Fig. 1C combining of "One Combined Medium." The first focuses on the basic operation of decoder, 203; SPAM-controller, 205C; and microcomputer, 205. Combined information is displayed at each subscriber station. In the second, the combining of Fig. 1C occurs only at selected subscriber stations. The second combining synch command is partially encrypted, and said stations are preprogrammed to decrypt said command. 5Said command causes said stations to retain meter information. In the third, combined information is displayed at each subscriber station. Monitor information is processed at selected stations for one or more so-called "ratings" agencies that collect statistics on viewership and programming usage. The fourth example provides a second illustration of selected decryption and metering. Monitor information is collected at selected stations. The fifth example adds signals identified at decoders, 30 and 40, of signal processor, 200. In the last three examples, the first combining synch command causes selected subscriber stations to transfer recorded meter and monitor information and causes computers at remote agencies to receive and process said information.

Each example focuses on three messages. The first is associated with the first combining synch command. Said command has a "01" header, an execution segment and a meter-monitor segment of six fields followed by a program instruction set and an end of file signal. Said command addresses URS microcomputers, 205. Each meter-monitor field identifies one of the following:

. the origin of said "Wall Street Week" transmission,

. the subject matter of said "Wall Street Week" program,

. the program unit of said program,

. the day of said transmission,

. the supplier of the program instruction set, and

. the format of said segment.

(Meter-monitor information that identifies the unit of a program may be called the "program unit identification code".) The second message is of the second combining synch command. Said command has a "00" header, an execution segment, a meter-monitor segment of five fields and addresses URS microcomputers, 205. Each meter-monitor field contains information of one of the following:

. the subject matter of said "Wall Street Week" program,

. the program unit of said program,

. the unique code of said overlay given said program unit,

. the minute of said transmission, and

. the format of said segment.

The third message is of the third combining synch command. Said command has a "10" header and an execution segment and addresses URS microcomputers, 205. In encrypted commands, meter-monitor segments include an additional field: meter instructions.

All subscriber station apparatus are preprogrammed to perform automatically each step of each example. Receiving SPAM signal information causes subscriber station apparatus to process said information.

At the outset of each example, meter record information of prior programming exists at buffer/comparator, 14. Monitor record information exists at buffer/comparator, 14, associated with the source mark of decoder, 203. Recorder, 16, has reached a level where the next signal record will exceed fullness information.

EXAMPLE #1

The first example begins as divider, 4, starts to transfer, in outputted composite video, the embedded binary information of the first message.

Receiving said information at decoder, 203, (which does not include a filter, 31, or a demodulator, 32, because its input is composite video) causes line receiver, 33, to detect and transfer said embedded information to digital detector, 34, which detects and transfers said binary information with correcting information to controller, 39. Using forward error correction techniques controller, 39, checks said information and corrects it as necessary. Using conversion protocol techniques, controller, 39, converts said corrected information into binary information that receiver station apparatus can receive and process.

(Frequently in this disclosure, specific quantities of bits and bit locations are cited. No attempt is made to account for the presence of parity bits among transmitted SPAM information or at memory locations because techniques for distinguishing and processing bits of communicated information separately from parity bits are well known in the art.)

Said binary information is inputted to the EOFS valve of controller, 39.

Receiving the header and execution segment causes controller, 39, to determine that said message is addressed to URS microcomputers, 205. So transferring said message is the controlled function that said header and execution segment cause controller, 39, to perform. As said valve transfers converted binary information of said message, controller, 39, selects and records at SPAM-header register memory a preprogrammed constant number of the first converted bits. Said constant is the number of bits in a SPAM header and is called "H". Controller, 39, determines that information at SPAM-header memory ("01") does not match "11". Not resulting in a match causes controller, 39, to select a second preprogrammed constant number of bits and record said bits at SPAM-exec register memory. Said second constant is the number of bits in a SPAM execution segment and is called "X". Comparing the information at said SPAM-exec memory (the execution segment) with preprogrammed controlled-function-invoking information, controller, 39, determines that said information matches this-message-addressed-to-205 information that causes controller, 39, to execute preprogrammed transfer-to-205 instructions. Said instructions cause controller, 39, to transfer to SPAM-controller, 205C, the SPAM message associated with the information at SPAM-header memory.

(Whenever comparing execution segment information to controlled-function-invoking information at SPAM apparatus results in a failure to match, said failure causes said apparatus to discard all received information of the message of said execution segment.)

Receiving the header and execution segment causes SPAM-controller, 205C, to determine the controlled functions that said message instructs URS microcomputers, 205, to perform and to execute the instructions of said functions. SPAM-controller, 205C, selects the first H bits and determines that the "01" header does not match "11". Not resulting in a match causes controller, 39, to select the next X bits and compare the execution segment with controlled-function-invoking-@205 information. A match with execute-at-205 information causes SPAM-controller, 205C, to invoke preprogrammed load-run-and-code instructions that control loading, running, and placing of code information at memory. SPAM-controller, 205C, executes said load-run-and-code instructions.

(No change takes place between controller, 39, and SPAM-controller, 205C, in the execution segment of the first combining synch command. This is one of many instances in this specification where a given SPAM command invokes different controlled functions at different apparatus because the apparatus are preprogrammed differently.)

Under control of said instructions, SPAM-controller, 205C, must process the length token of a meter-monitor segment. Said instructions cause SPAM-controller, 205C, to select a third preprogrammed constant number of bits and record said bits at particular memory. Said constant is the number of bits in a length token and is called "L". Beginning with the bit immediately after the last of said X bits, SPAM-controller, 205C, selects L bits and records said bits at SPAM-length-info-@205 register memory. SPAM-controller, 205C, compares the information at said memory with preprogrammed token-comparison-@205 information and determines a match. Said match causes SPAM-controller, 205C, to place bit-length-number information at said memory. Said information is the number of bits, following the last of said L bits, that remain in the meter-monitor segment associated with said length token. Said number is one of several preprogrammed bit-length-number information alternatives. The number of the bit-length-number alternative associated with any given length token is called "MMS-L", and the number of bits in any given meter-monitor segment is called, "MMS".

EXAMPLE #1 (SECOND MESSAGE)

Receiving the second message causes controller, 39, to determine that said message is addressed to URS microcomputers, 205. The execution segment invokes said transfer-to-205 instructions. The header invokes transfer-00-header-message instructions. Controller, 39, executes process-length-token instructions, selects L bits, compares Sand determines that information at memory matches X-token. Controller, 39, selects bit-length-number information associated with said X-token and place said information at SPAM-length-info memory. The numeric value of said information is MMS-L. Said transfer-00-header-message instructions cause controller, 39, to add a preprogrammed constant that is the sum of H plus X plus L to the information at said memory. Said constant is called "H+X+L". In so doing, controller, 39, determines the number of bits in the command information of said message. Controller, 39, transfers complete binary information of the message.

Receiving said second message causes SPAM-controller, 205C, to execute preprogrammed conditional-overlay-at-205 instructions. Said instructions cause SPAM-controller, 205C, to execute "GRAPHICS ON" at the PC-MicroKey System of microcomputer, 205, if particular conditions are satisfied. The image at video RAM (Fig. 1A) must be relevant to the programming in which said message is embedded. More precisely, program unit and overlay number information must match. SPAM-controller, 205C, selects the bits of the meter-monitor format field. Comparing invokes process-specific-format instructions. SPAM-controller, 205C, places at SPAM-mm-format-@205 register memory information that identifies the format of the meter-monitor segment, executes locate-program-unit instructions and places at first-working memory information of the program unit field. SPAM-controller, 205C, compares the information at said memory, which is the program unit identification code of "Wall Street Week", to information at SPAM-first-precondition register memory. A match causes SPAM-controller, 205C, to execute locate-overlay-number instructions. Overwriting the information previously there, SPAM-controller, 205C, records at first-working memory the information of the overlay number field. (The information of said field is "00000001".) SPAM-controller, 205C, compares the information at said memory to "00000001" at SPAM-second-precondition register memory. A match results indicating that microcomputer, 205, has completed placing appropriate Fig. 1A image at video RAM. (At any subscriber station where first-working memory fails to match SPAM-second-precondition memory, the SPAM-controller, 205C, interrupts the operation of the CPU of the microcomputer, 205, and transmits restore-efficiency instructions to said CPU that include information at first-working memory and that cause said microcomputer, 205, in a fashion discussed more fully below, to restore efficient operation.)

EXAMPLE #1 (THIRD MESSAGE)

The third message is transferred to decoder, 203. The execution segment causes controller, 39, to determine that said message is addressed to URS microcomputers, 205. Controller, 39, compares information at SPAM-header memory to header-identification information and executes preprogrammed transfer-10-header-message instructions. At any given time, "10" header command information is of one constant length. The aforementioned header+exec constant is "H+X" and is the sum of H plus X. Controller, 39, transfers complete information of the message.

SPAM-controller, 205C, executes "GRAPHICS OFF" then transmits a clear-and-continue instruction to the CPU of microcomputer, 205, the function of which is described more fully below.

EXAMPLE #1 (A FOURTH MESSAGE)

A fourth message illustrates processing an "11" header message. The program originating studio transmits a fourth message. The first two bits of the first signal word of are an "11" header, and the remaining bits are padding bits. The first signal word of the information segment is immediately after said first word. An end of file ends said message.

Controller, 39, selects and records H bits (the "11" header) at SPAM-header register memory then determines that the information at said memory matches 11-header-invoking information. Said match causes controller, 39, to execute process-11-header-message instructions that cause controller, 39, to execute controlled functions as if the information at SPAM-last-01-header-exec register memory were the execution segment of said message. Said information invokes transfer-to-205 instructions that cause controller, 39, to transfer said message in the same fashion that applied to the first message of example #1. (If no information were to exist at SPAM-last-01-header-exec memory, controller, 39, would discard all message information until an end of file signal were received and discarded.)

At SPAM-controller, 205C, information at SPAM-last-01-header-exec-@205 register memory invokes load-run-and-code instructions. As with said first message, said instructions control the loading, at the main RAM of microcomputer, 205, and running of the information segment information. SPAM-controller, 205C, executes load-11-header-message instructions.

EXAMPLE #2

In example #2, the first and third messages of "Wall Street Week" are transmitted just as in example #1, but the second message is partially encrypted. The execution segment and all of the meter-monitor segment except the length-token are encrypted, using standard techniques that encrypt binary information without altering the number of bits. The cadence information--the "00" header, the length-token, and any padding bits at the end of said message--remain unencrypted. After encryption, the execution segment is identical to an execution segment that addresses URS signal processors, 200, and instructs said processors, 200, to use a decryption key J and decrypt the message in which said segment occurs.

As described above, before any messages of "Wall Street Week" are transmitted, control invoking instructions command URS microcomputers, 205, to set their PC-MicroKey Model 1300 Systems to the "Graphics Off" mode. Thus, at the outset of example #2, no microcomputer, 205, is transmitting combined video to its associated monitor, 202M.

When decoder, 203, receives the second message of example #2, controller, 39, determines that said message is addressed to URS signal processors, 200, and transfers said message to buffer/comparator, 8, of signal processor, 200. Said second message causes buffer/ comparator, 8, to compare a portion of the execution segment to preprogrammed comparison information. A match causes buffer/comparator, 8, to transfer to controller, 20, information that includes information of the header and execution segment. Said information causes controller, 20, to determine a match with decrypt-with-key-J information.

(It is to facilitate processing at stations that are not preprogrammed with necessary decryption key information that the cadence information of an otherwise encrypted message must remain unencrypted. Were the header, lengthtoken or padding bits encrypted, said stations would be unable to locate the header of the following message. Effective SPAM processing would cease until said stations detected an unencrypted end of file signal.)

Said match causes controller, 20, to execute decrypt-with-J instructions and to select and transfer key information of J to decryptor, 10. Information of the header invokes decrypt-a-00-header-message instructions. Controller, 20, transmits to controller, 12, an instruction and mark information that identifies J as the decryption key.

Controller, 12, executes preprogrammed transfer-and-meter instructions then records said mark of key J at decryption-mark-@12 register memory.

Decryptor, 10, commences receiving information, decrypting it using key J and transferring it to controller, 12. Said decrypt-00-header-message instructions cause controller, 20, to cause decryptor, 10, to transfer the first H bits without decrypting said bits, to decrypt and transfer the next X bits, to transfer the next L bits without decrypting said bits, to decrypt and transfer the next MMS-L bits, and finally, to transfer any bits remaining without decrypting said bits.

Controller, 12, determines that said message is addressed to URS microcomputers, 205, and transfers said message. At microcomputer, 205, the second combining synch command executes "GRAPHICS ON", causing microcomputer, 205, to transmit combined programming to monitor, 202M, where Fig. 1C is displayed.

(No second combining synch command reaches microcomputers, 205, at subscriber stations not preprogrammed with decryption key J. When Fig. 1C is displayed at stations preprogrammed with key J, said subscriber stations display Fig. 1B.)

Controller, 12, commences meter instructions and causes buffer/comparator, to add one incrementally to each meter record at buffer/comparator, 14, associated with information that matches the mark of decryption key J.

Subsequently, decoder, 203, receives the third message which conveys the third combining synch command. Said command reaches all URS microcomputers, 205, and executes "GRAPHICS OFF". But only at stations preprogrammed with decryption key J does combining cease. At all other URS microcomputers, 205, "GRAPHICS OFF" has no effect because each of said other URS microcomputers, 205, is already in "Graphics Off" mode when said "GRAPHICS OFF" is executed.

Significant advantages of simplicity and speed are achieved by devising signal processing apparatus and methods that minimize the need for selective processing. With regard to said third combining synch command, for example, no step of decrypting is required to affect only those stations that are preprogrammed with decryption key J. No possibility exists that an error in decrypting may occur. No possibility exists that some station may take longer than proper to perform decrypting causing the image of Fig. 1A to be displayed longer than proper. The time that separates embedding and the ceasing at microcomputers, 205, can be the shortest possible interval.

THE PREFERRED CONTROLLER, 39.

In the preferred embodiment, controller, 39, of decoder, 203, and SPAM-controller, 205C, are one and the same and are called, hereinafter, "controller, 39".

Fig. 3A shows controller, 39. Buffer, 39A, and processor, 39B, perform forward error correcting. Buffer, 39C, and processor, 39D, perform protocol conversion. Controlled functions are invoked at control processor, 39J. Having three processors enables controller, 39, to process information of three words simultaneously.

Each processor, 39B, 39D, and 39J, has RAM and ROM and constitutes a programmable controller in its own right. Each processor, 39B, 39D, and 39J, controls its associated buffer, 39A, 39C, and 39E respectively. Each buffer is a conventional buffer. Each buffer, 39A and 39C, transfers its information to its associated processor, 39B and 39D respectively. Buffer, 39E, transfers information via EOFS Valve, 39F, to matrix switch, 39I.

Buffer, 39G, is a conventional buffer with means for receiving information from external inputs, in particular from controller, 12, of signal processor, 200 (the input from controller, 12, to SPAM-controller, 205C, in Fig. 3). Buffer, 39G, outputs information via EOFS Valve, 39H, to matrix switch, 39I. Buffer, 39G, is configured to identify to control processor, 39J, which input is the source of any given instance of information and capacity to output selectively any given instance of received information.

EOFS Valves, 39F and 39H, operate under control of control processor, 39J, and monitor information continuously for end of file signals.

Matrix switch, 39I, is a digital matrix switch, well known in the art of telephone switching, that is configured for the small number of inputs and outputs required. Matrix switch, 39I, operates under control of control processor, 39J, and has capacity to receive information from a multiplicity of inputs, including EOFS Valves, 39F and 39G, and control processor, 39J, and to transfer formation to a multiplicity of outputs, including control processor, 39J; the CPU of microcomputer, 205; buffer/comparator, 8, of signal processor, 200; buffer/comparator, 14, of signal processor, 200; and other outputs. Among such outputs is one or more "null outputs" with capacity for merely recording information at memory, thereby overwriting information previously recorded. (Examples of other outputs are cited below.) Matrix switch, 39I, transfers information without modification, and a multiplicity of transfers can take place simultaneously.

The register memories of control processor, 39J, include (but are not limited to) SPAM-input-signal register memory whose length in bit locations is sufficient to contain the longest possible instance of SPAM command information with associated padding bits; the aforementioned SPAM-header and SPAM-exec register memories; SPAM-Flag-monitor-info, SPAM-Flag-at-secondary-control-level, [SPAM-Flag-executing-secondary-command,] SPAM-Flag-secondary-level-incomplete, SPAM-Flag-primary-level-2nd-step-incomplete, SPAM-Flag-primary-level-3rd-step-incomplete, SPAM-Flag-[secondary]-level-2nd-step-incomplete, SPAM-Flag-secondary-level-3rd-step-incomplete, SPAM-Flag-first-condition-failed, SPAM-Flag-second-condition-failed, SPAM-Flag-do-not-meter, and SPAM-Flag-working register memories each of which are one bit location in length; SPAM-length-info, SPAM-mm-format, SPAM-first-precondition, SPAM-second-precondition, SPAM-last-01-header-exec register memories; particular SPAM-decryption-mark, SPAM-primary-input-source, SPAM-secondary-input-source, SPAM-next-primary-instruction-address, SPAM-next-secondary-instruction-address, SPAM-executing-secondary-command, SPAM-last-secondary-01-header-exec, SPAM-address-of-next-instruction-upon-primary-interrupt, and SPAM-address-of-next-instruction-upon-secondary-interrupt register memories whose functions are described below; and a plurality of working register memories. All preprogrammed information associated with controlled functions and instructions that control controller, 39, are preprogrammed at the RAM and/or ROM associated with control processor, 39J.

Control processor, 39J, controls all apparatus of decoder, 203, (except decryptor, 39K) and has capacity for transmitting control instructions to and receiving information from such apparatus. In addition, control processor, 39J, controls the CPU and the PC-MicroKey 1300 system of microcomputer, 205, in certain SPAM functions and has capacity, via matrix switch, 39I, to transmit and receive control information from said CPU and said system. In certain functions, controller, 20, of signal processor, 200, controls control processor, 39J, and control processor, 39J, has means for communicating control information directly with controller, 20. The RAM and/or ROM associated with control processor, 39J, are preprogrammed with all information necessary for controlling.

Controller, 39, has a decryptor, 39K, that is identical to decryptor, 10, of signal processor, 200. Decryptor, 39K, receives information from matrix switch, 39I; outputs to buffer, 39H; has means for communicating control information directly with controller, 20, of signal processor, 200; and is controlled by said controller, 20. Decryptor, 39K, is preprogrammed and has capacity for processing SPAM message information if fashions described more fully below.

In the preferred embodiment, to maximize speed all apparatus of controller, 39, are located on one microchip.

EXAMPLE #3

Example #3 focuses on selected subscriber stations where signal processing apparatus and methods collect monitor information for so-called "program ratings" (such as "Nielsen ratings") that estimate sizes of audiences. The subscriber station of Fig. 3 is so preprogrammed. The controller, 39, is the preferred embodiment. In all other respects example #3 is identical to example #1.

When EOFS valve, 39F, commences transferring the SPAM Dinformation of the first message, control processor, 39J, selects the first H bits and compares the information to 11-header-invoking information. No match results.

Because control processor, 39J, is preprogrammed to process monitor information, instructions cause control processor, 39J, to compare the header with invoke-monitor-processing information. A match signifies the presence of meter-monitor information and causes control processor, 39J, to enter "0" at SPAM-Flag-monitor-info register memory.

Control processor, 39J, processes the execution segment. A match causes control processor, 39J, to execute load-run-and-code instructions.

Control processor, 39J, processes the length token then receives all remaining command information and padding bits in said first message. Control processor, 39J, records the information at SPAM-input-signal memory. By receiving all command information and padding bits, control processor, 39J, causes EOFS valve, 39F, to transfer every signal word in said message prior to the first word of the information segment.

Then said load-run-and-code instructions cause control processor, 39J, to commence loading information at the main RAM of microcomputer, 205. Control processor, 39J, causes matrix switch, 39I, to cease transferring information from EOFS valve, 39F, to control processor, 39J, and commence transferring information from control processor, 39J, to the CPU of microcomputer, 205; transmits an instruction to said CPU that causes said CPU to commence receiving information from matrix switch, 39I, and loading said information at main RAM; and causes matrix switch, 39I, to commence transferring information from EOFS valve, 39F, to said CPU.

Then, while EOFS valve, 39F, processes to detect the end of file signal and microcomputer, 205, loads the program instruction set at RAM, said load-run- and-code instructions cause control processor, 39J, to execute the code portion of said instructions. Control processor, 39J, locates the program unit identification code in the information at said SPAM-input-signal memory and records said code at SPAM-first-precondition register memory. Control processor, 39J, places "1" at SPAM-Flag-primary-level-3rd-step-incomplete register memory, signifies completion of the code step.

At stations that are not preprogrammed to collect monitor information, each control processor, 39J, commences waiting for interrupt information of the end of file signal.

At any point where a station so preprogrammed commences waiting, the control processor, 39J, of the station of Fig. 3 is preprogrammed automatically to execute collect-monitor-info instructions. Said instructions cause control processor, 39J, of the station of Fig. 3 to compare SPAM-Flag-monitor-info memory with "0". A match results. Said match causes control processor, 39J, to cause matrix switch, 39I, to commence transferring information from control processor, 39J, to buffer/ comparator, 14, of signal processor, 200, (said switch is simultaneously transferring information to the CPU of microcomputer, 205); to transfer to said buffer/ comparator, 14, header information that identifies a transmission of monitor information then the decoder-203 source mark of said decoder, 203, (which is preprogrammed at control processor, 39J) then received information of said message recorded at said SPAM-input-signal memory. Said received information is the first combining synch command, and said information transmitted to buffer/ comparator, 14, is the "lst monitor information (#3)." Then control processor, 39J, enters "1" at said SPAM-Flag-monitor-info memory, signifying completion of transfer of monitor information.

In due course, EOFS valve, 39F, receives the end of file signal of said message which causes EOFS valve, 39F, to transmit EOFS-detected information to control processor, 39J, as an interrupt signal then commence waiting for an instruction from control processor, 39J.

Receiving an interrupt signal of EOFS-detected information while under control of controlled function instructions causes control processor, 39J, to execute a machine language jump to a predesignated portion of said instructions and execute the instructions of said portion. In the case of said load-run-and-code instructions, an EOFS-detected interrupt signal causes control processor, 39J, to execute the run portion. Control processor, 39J, causes matrix switch, 39I, to cease transferring information from EOFS valve, 39F, to the CPU of microcomputer, 205, and to commence transferring information from control processor, 39J, to said CPU; transmits an instruction to said CPU that causes microcomputer, 205, to cease loading and execute the information so loaded as machine executable code of one job; then transmits the discard-and-wait instruction, via control transmission means, to EOFS valve, 39F.

Said instruction causes EOFS valve, 39F, to set the EOFS WORD Counter to "00000000" and transmit complete-and-waiting information to control processor, 39J.

Said load-run-and-code instructions cause control processor, 39J, to compare the information at said SPAM-Flag-primary-level-3rd-step-incomplete memory with "1". A match results which signifies control processor, 39J, has completed the code portion.

Having completed the controlled functions of said message, control processor, 39J, prepares to receive the next message. Control processor, 39J, causes matrix switch, 39I, to commence transferring information from EOFS valve, 39F, to control processor, 39J; places at SPAM-last-01-header-exec register memory information of said SPAM-exec memory; deletes from memory all information of said first message except information at said SPAM-first-precondition and SPAM-last-01-header-exec memories; causes said valve, 39F, to commence processing inputted signal words and outputting to matrix switch, 39I; and commences waiting to receive information of a header.

As described in "One Combined Medium", running said program instruction set causes microcomputer, 205, to place Fig. 1A image information at video RAM. In addition, said set causes microcomputer, 205, after completing placing information at RAM, to transfer number-of-overlay-completed information and instructions to control processor, 39J, causing control processor, 39J, to place "00000001" at SPAM-second-precondition register memory, signifying that said image information is the first overlay of its program.

Receiving said 1st monitor information (#3) causes buffer/comparator, 14, to input said information to onboard controller, 14A.

Onboard controller, 14A, records the source mark at source-mark-@14A register memory; records at SPAM-input-signal-@14A register memory all of the information of said first message that was recorded at the SPAM-input-signal memory of controller, 39J; and executes process-monitor-info instructions. (Onboard controller, 14A, processes simultaneously with loading at microcomputer, 205, while control processor, 39J, waits to receive an EOFS-detected signal.) Said instructions cause onboard controller, 14A, to locate a record of the prior programming displayed at monitor, 202M, and record said record at recorder, 16. Then said instructions cause onboard controller, 14A, to initiate a new monitor record that reflects the "Wall Street Week" programming. Onboard controller, 14A, deletes all information at the monitor record location of said prior programming except the source mark; records the program unit identification code of "Wall Street Week" at said location; selects particular information at said SPAM-input-signal-@14A memory and records at said location; and selects preprogrammed record format information and places said information at a record location and a comparison location. Onboard controller, 14A, organizes the information of said new monitor record in a particular fashion. The command execution segment of the 1st monitor information (#3) causes signal processor, 200, to assemble the record in the format of a combined video/computer medium display and to include a format field identifying the format of said record. (Were the execution segment of the pseudo command, signal processor, 200, would initiate a record for a conventional television program.) From the command meter-monitor segment, onboard controller, 14A, selects and records information that identifies the program unit, the origin of the "Wall Street Week" transmission, and the day of the transmission. Onboard controller, 14A, records a code that identifies monitor, 202M, as the display apparatus. Signal processor, 200, records date and time information from clock, 18, in first and last particular time field locations that document the date and time respectively of the first and of the last received instances of monitor information of the particular program unit and source mark.

EXAMPLE #3 (SECOND MESSAGE)

The second message of "Wall Street Week" causes control processor, 39J, to enter "0" at SPAM-Flag-monitor-info memory and execute conditional-overlay-at-205 instructions. After executing "GRAPHICS ON", control processor, 39J, compares said memory with "0". A match causes control processor, 39J, to transfer to buffer/comparator, 14, header information that identifies monitor information then the decoder-203 source mark then complete information of the second combining synch command. Said information transmitted to buffer/comparator, 14, is the "2nd monitor information (#3)." Control processor, 39J, enters "1" at said SPAM-Flag-monitor-info memory.

Buffer/comparator, 14, inputs said 2nd monitor information (#3) to onboard controller, 14A.

Onboard controller, 14A, records at SPAM-input-signal-@14A register memory all information of said message that was recorded at SPAM-input-signal memory of controller, 39J, and executes process-monitor-info instructions. Said instructions cause onboard controller, 14A, to record date and time information from clock, 18, at the aforementioned last time field of said new monitor record and to compare the meter-monitor format field at SPAM-input-signal-@14A memory to the record format field associated with said monitor record. No match results which indicates that said 2nd monitor information (#3) contains new information. Onboard controller, 14A, evaluates said new information and modifies the information content of said new monitor record by adding and/or deleting and/or replacing information. One element modified is the record format information which is replaced with new record format information. The meter-monitor information of the minute of the transmission provides new information. By comparing with information from clock, 18, the controller, determines whether "Wall Street Week" is being displayed at the time of its original transmission or has been "time shifted"; that is, recorded at a video tape recorder and played back. If the time is of original transmission, the controller, modifies the record format field with information that distinguishes said new record as a record of a display of an original transmission and enters other information into particular fields of said format. If the original transmission has been time shifted, the controller modifies the format field with information that distinguishes said new record as a record of a time shifted display, enters all previously recorded information within the proper fields of said format, and records the new information of the minute of the transmission. The particular overlay information also provides new information. The controller records in a field of said new monitor record a count, starting with "1" for said first overlay, of the number of overlays processed in the course of said program unit. And it increments by one a separate monitor record count of the aggregate number of overlays displayed at monitor, 202M, over a month period.

EXAMPLE #3 (THIRD MESSAGE)

The embedded information of the third message of "Wall Street Week" is inputted to decoder, 203. Control processor, 39J, selects information of the first X bits after the first H bits, records said information at SPAM-exec memory, and compares the information at said memory with controlled-function-invoking information. A match results with cease-overlay information causing control processor, 39J, to execute cease-overlaying-at-205 instructions. Said instructions cause control processor, 39J, to cause matrix switch, 39I, to commence transferring information from control processor, 39J, to the PC-MicroKey System of microcomputer, 205; to transmit the instruction, "GRAPHICS OFF", to said System; to cause matrix switch, 39I, to cease transferring information to said System and commence transferring information from control processor, 39J, to the CPU of microcomputer, 205; to transmit the clear-and-continue instruction (the function of which is described more fully below) to said CPU; and to cause matrix switch, 39I, to cease transferring information to said CPU.

At the subscriber station of Fig. 3 (and at other stations), said instruction "GRAPHICS OFF" causes said PC-MicroKey System to cease combining the programming of Fig. 1A and Fig. 1B and commence transmitting to monitor, 202M, only the composite video received from divider, 4, (which causes monitor, 202M, to commence displaying only said video.) Said clear-and-continue instruction causes microcomputer, 205, to commence processing in a predetermined fashion (which may be determined by the aforementioned program instruction set).

EXAMPLE #4

In example #4, the first and second messages are both partially encrypted, and the combining of Fig. 1A and Fig. 1B occurs only at selected subscriber stations where the information of said messages causes decrypting and collecting of meter information as well as combining. Said messages also cause collecting of monitor information at selected stations preprogrammed to collect monitor information.

Before the first message is embedded, all of the execution segment, meter-monitor segment, and program instruction set are encrypted, using standard techniques that encrypt binary information without altering the number of bits. The cadence information remains unencrypted. After encryption the execution segment is identical to an execution segment that addresses URS signal processors, 200, and instructs said processors, 200, to use decryption key Z and decrypt the message in which said segment occurs.

Receiving said message causes the station of Fig. 3, to decrypt the encrypted portions of said message; execute the controlled functions of the decrypted information; collect meter information and monitor information relating to said message; and transfer meter information and monitor information to one or more remote processing stations, causing said stations to process said information.

When EOFS valve, 39F, commences transferring said first message, control processor, 39J, accepts the smallest number of signal words that can contain H bits; records the information of said words at SPAM-input-signal register memory; selects information of the first H bits at said memory; records said information at SPAM-header memory; recommences accepting SPAM signal words from EOFS valve, 39F; receives and records words at said SPAM-input-signal memory in sequence after the information already there until the quantity of signal words recorded at said memory equals the smallest number of words that can contain H+X bits; selects information of the first X bits at said SPAM-input-signal memory after the first H bits; records said information at SPAM-exec memory, and compares the information at said memory with controlled-function-invoking information. A match results with this-mssg-addressed-to-200 information. Said match causes control processor, 39J, to execute preprogrammed transfer-header-and-exec-seg-info-to-200 instructions. Said instructions cause control processor, 39J, to transfer to controller, 20, of signal processor, 200, via control transmission means, an interrupt signal then particular process-this-message information then particular at-39J information then information of the header and execution segment of said message.

Receiving said interrupt signal and information causes controller, 20, to compare the information of said execution segment to controlled-function-invoking-@200 information and determine a match with decrypt-with-key-Z information that instructs controller, 20, to cause decryption of said first message with decryption key Z.

(Subscriber stations whose URS signal processors, 200, are not preprogrammed with key Z discard said message.)

The station of Fig. 3 is preprogrammed to decrypt said message. The at-39J information and match cause controller, 20, to execute decrypt-with-Z-at-39K instructions. Said instructions cause controller, 20, to select key information of Z and transfer said information then a particular decrypt-a-01-message instruction to decryptor, 39K.

Receiving said key information and instruction causes decryptor, 39K, to commence using said key information as its key for decryption and decrypting inputted information in a 01-header-message fashion.

Then said decrypt-with-Z-at-39K instructions cause controller, 20, to transmit to control processor, 39J, an instruction and mark information of Z. Said instruction causes control processor, 39J, to execute decrypt-and-meter-01-message instructions. Control processor, 39J, causes matrix switch, 39I, to commence transferring information from control processor, 39J, to decryptor, 39K; transfers all SPAM information at said SPAM-input-signal memory; then causes matrix switch, 39I, to commence transferring SPAM message information from EOFS valve, 39F, to decryptor, 39K. In this fashion, control processor, 39J, causes all information of said message to be transferred to decryptor, 39K.

Then said instructions cause control processor, 39J, to prepare to execute, at secondary control level under primary control of said instructions, controlled functions invoked by decrypted information. Control processor, 39J, places information at SPAM-next-primary-instruction-address register memory which specifies the location of the next decrypt-and-meter-01-message instruction to execute when control reverts to the primary level; places from-39H information at SPAM-secondary-input-source register memory; causes matrix switch, 39I, to commence transferring SPAM message information from EOFS valve, 39H to control processor, 39J; places "0" at SPAM-Flag-executing-secondary-command register memory which signifies information placed subsequently at SPAM-exec memory is secondary command level information; places "0" at SPAM-Flag-at-secondary-level register memory which signifies that control functions are being executed at said secondary level; and commences waiting to receive information of a subsequent SPAM header from switch, 39I.

As decryptor, 39K, receives information from matrix switch, 391, decryptor, 39K, decrypts using key Z and transfers decrypted information to buffer, 39G. The decrypt-a-01-message instruction causes decryptor, 39K, to transfer the first H bits without decrypting said bits then to decrypt and transfer all information following said H bits.

When EOFS valve, 39H, commences transferring decrypted information of the first message, control processor, 39J, selects information of the first X bits after the first H bits, records said information at SPAM-exec memory, and compares the information at said memory with controlled-function-invoking information. A match causes control processor, 39J, to execute load-run-and-code instructions. Said instructions cause control processor, 39J, to receive and process decrypted length token information. Control processor, 39J, records additional signal words at SPAM-input-signal memory, selects information of the first L bits after the first H+X bits, records said information at SPAM-length-info memory, determines a particular number of signal words to receive, records said words in sequence at said SPAM-input-signal memory, and ceases accepting SPAM signal information.

Said load-run-and-code instructions cause control processor, 39J, to commence loading. Control processor, 39J, causes the CPU of microcomputer, 205, to commence receiving information from matrix switch, 39I, and loading said information at main RAM and causes matrix switch, 39I, to commence transferring information from EOFS valve, 39H, to said CPU. Beginning with the first signal word at EOFS valve, 39H, which is the first word of the program instruction set in said message, microcomputer, 205, loads.

Then said load-run-and-code instructions cause control processor, 39J, to locate the program unit identification code information at said SPAM-input-signal memory and record said code at SPAM-first-precondition register memory and to commence waiting for interrupt information of the end of file signal from EOFS valve, 39H.

Whenever control processor, 39J, is instructed to commence waiting, instructions cause said processor, 39J, to compare the information at the aforementioned SPAM-Flag-at-secondary-control-level memory with "0". A match results which means that instructions may exist at the primary control level that control processor, 39J, should execute before commencing to wait. Said match causes control processor, 39J, to place at SPAM-next-secondary-instruction-address register memory the location of the next instruction to execute when control reverts to secondary level instructions; place "1" at the SPAM-Flag-at-secondary-control-level memory; and commence executing control instructions beginning with that instruction whose location is at SPAM-next-primary-instruction-address memory.

The decrypt-and-meter-01-message instructions that begin at said location cause control processor, 39J, to meter. Control processor, 39J, causes matrix switch, 39I, to commence transferring information from control processor, 39J, to buffer/comparator, 14; transfers header information that identifies a meter information then decoder-203 source mark information then information of decryption mark Z then all received information of said message recorded at SPAM-input-signal memory; then causes matrix switch, 39I, to cease transferring information from control processor, 39J, to said buffer/comparator, 14. Said received information is the first combining synch command, and said information transmitted to buffer/comparator, 14, is the "1st meter-monitor information (#4)." Control processor, 39J, enters "1" at SPAM-Flag-primary-level-3rd-step-incomplete register memory signifying completion of the meter step and commences waiting for interrupt information of an end of file signal.

In due course, EOFS valve, 39F, commences receiving the end of file signal. Said signal causes the subscriber station to cease loading; terminate decrypting; execute the program instruction set information as a machine language program; and commence waiting to receive from EOFS valve, 39F, the header of a subsequent SPAM message.

Receiving said end of file signal causes said EOFS valve, 39F, to transmit an interrupt signal of EOFS-signal-detected information to control processor, 39J.

Receiving said interrupt signal causes control processor, 39J, to transmit to controller, 20, of signal processor, 200, via control information transmission means, a preprogramed EOFS-signal-detected interrupt signal and at-39J information.

Receiving said interrupt signal and information causes controller, 20, to execute preprogrammed end-01-or-11-message-decryption instructions. Said instructions cause controller, 20, to cause decryptor, 39K, to discard said key information of decryption key Z, to cease decrypting inputted information and to commence transferring all inputted information to buffer, 39G, without alteration. Next said instructions cause controller, 20, to transmit a particular preprogrammed transmit-EOF-signal instruction to control processor, 39J.

Receiving said transmit-EOF-Signal instruction causes control processor, 39J, to transmit the aforementioned transmit-and-wait instructions to EOFS valve, 39F.

Receiving said transmit-and-wait instructions causes EOFS valve, 39F, to transfer sequentially eleven instances of EOFS WORD information--that is, one complete end of file signal--via switch, 39I, to decryptor, 39K.

Receiving said eleven instances of EOFS WORD information causes decryptor, 39K, to transfer said information, without alteration, via buffer, 39G to EOFS valve, 39H.

Receiving said information--more precisely, receiving the eleventh instance of an EOFS WORD in said information--causes EOFS valve, 39H, to transmit an interrupt signal to control processor, 39J.

Receiving said interrupt signal causes control processor, 39J, to jump and execute the run portion of said load-run-and-code instructions. Automatically, the instructions of said portion cause control processor, 39J to cause microcomputer, 205, to cease loading information-at main RAM and execute the information so loaded as so-called "machine executable code".

Running said program instruction set causes microcomputer, 205, (and URS microcomputers, 205, at other stations) to place Fig. 1A image information at video RAM then cause control processor, 39J, to place "00000001" at SPAM-second-precondition register memory.

Receiving said 1st meter & monitor information (#4) causes buffer/comparator, 14, to compare the header information that identifies a transmission of meter information to preprogrammed header-identification-@14 information. A match results with particular meter-identification information which causes buffer/comparator, 14, to select information of predetermined bit locations which contain the meter instruction field of said 1st meter & monitor information (#4) and to compare said selected information to preprogrammed metering-instruction-comparison information. (Matches invoke simple metering processes that buffer/comparator, 14, has capacity to perform by itself). Not resulting in a match causes buffer/comparator, 14, to transmit to controller, 20, particular preprogrammed instruct-to-meter information then said selected information (the meter instruction of said message).

Receiving said information causes controller, 20, to compare said instruction to preprogrammed instruct-to-meter@20 information and to determine that said information matches particular 1-2-3-meter information that invokes three sets of instructions preprogrammed at controller, 20. The first set initiates assembly of a first meter record based on the program unit information of said first command. ;The second set causes assembly of a second meter record based on the supplier of the program instruction set. Under control of said first set controller, 20, initiates assembly of said first record by selecting and placing at particular record locations at buffer/comparator, 14, particular record format information, then program unit information from a meter-monitor field of said 1st meter & monitor information (#4), origin of transmission information from a second field, date and time of transmission information from a third field, decryption key information from the decryption 5mark of said 1st meter & monitor information (#4), and finally date and time of processing information from clock, 18. Controller, 20, executes said second set. Under control of said set, controller, 20, places at second record locations at buffer/comparator, 14, particular record format information, then information of the supplier of said program instruction set from a meter-monitor field of 1st meter & monitor information (#4), program unit information from a second field, origin of transmission information from a third field, date and time of transmission information from a fourth field, and finally date and time of processing information from clock, 18. Said third set causes controller, 20, to cause buffer/comparator, 14, to transfer said second meter record to recorder, 16, then discard said record from its memory and to cause recorder, 16, to record said meter record.

Completing metering functions causes controller, 20, to cause buffer/comparator, 14, to execute its preprogrammed monitoring functions. These functions proceed in the same fashion that applied to the 1st monitor information (#3). The new monitor record generated by the 1st meter & monitor information (#4) includes decryption key information, not included in the new monitor record generated by the 1st monitor information (#3), and record format field information that reflects the presence of said decryption field information.

EXAMPLE #4 (SECOND MESSAGE)

The meter instruction information of the second message of example #4 instructs subscriber stations to perform certain meter operations that are not performed in example #2. In all other respects the second message of example #4 is identical to the second message of example #2 and is encrypted just as in example #2. Fig. 1A image information exists only at subscriber stations where the first message has been decrypted. Only at said stations does program unit identification code information of "Wall Street Week" exist at SPAM-first-precondition register memories. Only said stations can display Fig. 1C information.

Receiving said second message causes the station of Fig. 3 (and other stations) to decrypt the encrypted portions of said message. Control processor, 39J, records X bits at SPAM-exec memory, determines a match with this-msg-addressed-to-200 information, and executes the aforementioned transfer-header-and-exec-to-200 instructions. Controller, 20, determines a match with decrypt-with-key-J information, selects and transfers key information of J to decryptor, 39K, determines a match with "00" header information, and transmits a preprogrammed process-MMS-L instruction to control processor, 39J. Control processor, 39J, selects information of the first L bits after the first H+X bits, determines the numeric value of MMS-L, and transmits to controller, 20, interrupt information of MMS-L. Controller, 20, transmits to decryptor, 39K, decrypt-a-00-header-message instructions which include information of MMS-L and transmits to control processor, 39J, an instruction and decryption mark information of key J. Control processor, 39J, executes decrypt-and-meter-00-header-message instructions, transfers to decryptor, 39K, complete information of said second message, then prepares to execute at secondary control level controlled functions invoked by decrypted information. Receiving key information of J and decrypt-a-00-header-message instructions and the SPAM information of said second message causes decryptor, 39K, to transfer the first H bits to buffer, 39G, without decrypting said bits, to decrypt and transfer the next X bits, to transfer the next L bits without decrypting said bits, to decrypt and transfer the next MMS-L bits, and to transfer any bits remaining after said MMS-L bits without decrypting said bits remaining. In so doing, decryptor, 39K, inputs complete unencrypted information of said message and causes EOFS valve, 39H, to transfer said information to control processor, 39J.

Receiving said information causes control processor, 39J, to compare SPAM-header memory with invoke-monitor processing information and enter "0" at SPAM-Flag-monitor-info register memory; record information of X bits at SPAM-exec memory; determine a match with execute-conditional-overlay-at-205 information and execute conditional-overlay-at-205 instructions. Said instructions cause control processor, 39J, to receive all remaining information in said second message then locate the program unit field meter-monitor information of said second message (which is the program unit identification code) and compare said 30 information to the information at SPAM-first-precondition register memory, causing a match to result.

(At subscriber stations where program unit field information fails to match information at SPAM-first-precondition register memory--including all stations not preprogrammed with decryption key Z--conditional-overlay-at-205 instructions cause the control processors, 39J, to enter "0" at the SPAM-Flag-first-condition-failed and SPAM-Flag-do-not-meter register memories which are each normally "1"; to cause the main and video RAMs of the microcomputers, 205, to be cleared; and to complete controlled functions.)

Resulting in a match causes control processor, 39J, then to locate the overlay number field meter-monitor information of said second message and compare said information to the information at SPAM-second-precondition register memory, causing a match to result.

(At subscriber stations where the overlay number fails to match SPAM-second-precondition memory, conditional-overlay-at-205 instructions cause control processors, 39J, to interrupt the operation of the CPUs of the microcomputers, 205, to restore efficient operation in a fashion described below; to enter "0" at SPAM-Flag-second-condition-failed register memory which is normally "1"; and to complete all controlled functions invoked by said message at the secondary control level.)

Resulting in a match causes control processor, 39J, (and control processors at other stations where matches result) to transfer to the PC-MicroKey System of microcomputer, 205, the instruction "GRAPHICS ON" and complete all controlled functions invoked at the secondary control level. "GRAPHICS ON" causes said PC-MicroKey System to combine Fig. 1A and Fig. 1B and transmit the combined programming to monitor, 202M, where Fig. 1C is displayed.

Completing all controlled functions invoked at secondary control causes control processor, 39J, (and control processors at other stations) to execute the meter portion of said decrypt-and-meter-00-header-message instructions. Under control said portion, control processor, 39J, compares SPAM-Flag-do-not-meter register memory to "0". No match results.

(At subscriber stations where matches result, the control processors, 39J, complete all controlled functions invoked by said second message without transferring meter information and, at selected stations, without entering "1" at SPAM-Flag-monitor-info memories. Said selected stations are preprogrammed to collect monitor information.)

Not resulting in a match causes control processor, 39J, to compare SPAM-Flag-second-condition-failed register memory to "1". A match results.

(At stations where no matches result, the control processor, 39J, transfers to the buffer/comparator, 14, header information that identifies a transmission of meter information at a station where inefficient operation of a microcomputer, 205, prevented combining, the decoder-203 source mark, the decryption mark of key J, then all received information of said second message recorded at SPAM-input-signal memory. Said transmitted information is the "2nd meter-monitor information--second precondition failed--(#4).")

Resulting in a match causes control processor, 39J, to transfer to buffer/comparator, 14, header information that identifies a transmission of meter information then the decoder-203 source mark then information of decryption mark of key J then the received information of said second message. Said information that is transmitted to buffer/comparator, 14, is the "2nd meter-monitor information (#4)." Control processor, 39J, enters "1" at SPAM-Flag-monitor-info memory and complete all controlled functions of said message.

Completing the controlled functions of said second message causes control processor, 39J, to compare SPAM-Flag-monitor-info memory with "0". No match results.

(At stations where matches result, the control processor, 39J, transfers to the buffer/comparator, 14, header information that identifies a transmission of monitor information at a station where no combining occurred because first precondition program unit information failed to match, the decoder-203 source mark, the decryption mark of key J, then all received information of said second message recorded at the SPAM-input-signal memory. Said information that is transmitted is the "2nd monitor information (#4).")

Not resulting in a match causes control processor, 39J, to delete from memory all information of said second message and commence waiting to receive SPAM header.

Receiving said 2nd meter & monitor information (#4) causes buffer/comparator, 14, to select information of the meter instruction field of said 2nd meter & monitor information (#4) and transmit to controller, 20, instruct-to-meter information then said meter instruction information.

Receiving said information causes controller, 20, to execute update-and-increment instructions. Said instructions cause signal processor, 200, to modify the first meter record initiated by the 1st meter & monitor information (#4). Executing said instructions causes controller, 20, to place information of the overlay number field at a record field associated with said first meter record, signifying the combining of said overlay at the subscriber station; place, at the record location occupied by format information, new format information; to increment by one the meter record associated with each decryption-key-comparison datum that matches the decryption mark of said 2nd meter & monitor information (#4); and to complete said update-and-increment instructions.

Completing the metering functions causes controller, 20, to cause buffer/comparator, 14, to execute monitoring functions. These functions proceed in the fashion of the 2nd monitor information (#3). Onboard controller, 14A, includes decryption key information of J.

(At each station where the aforementioned 2nd meter & monitor information--second precondition failed--(#4) is transmitted, said 2nd information invokes two sets of instructions preprogrammed at controller, 20. The first set causes buffer/comparator, 14, to add one incrementally to each meter record associated with decryption key information that matches the decryption mark of said 2nd information. The second set causes controller, 20, to assemble a record of a failed combining and record said record at recorder, 16. Said record includes information that identifies said record as information of a combining aborted due to inefficient operation of a microcomputer, 205; the unique digital code of the subscriber station; and the program unit identification code and overlay number information of said second message. Each station preprogrammed to collect monitor information executes monitoring functions. These proceed in the fashion of the 2nd meter & monitor information (#4) with exceptions. The onboard controller, 14A, adds information that combining failed to occur because of inefficient microcomputer operation and the information of the overlay number field.)

(At each station where the aforementioned 2nd monitor information (#4) is transmitted, no 1st meter & monitor information (#4) transmission occurred. Accordingly, said 2nd monitor information (#4) causes the station to process information in the fashion of the 1st monitor information (#3). The signal processor, 200, records a record of prior programming at recorder, 16, and initiates a new monitor record that reflects the "Wall Street Week" programming. Signal processor, 200, assembles said monitor record in the format of a combined video/computer medium transmission at a Dstation where no combining occurred because first precondition program unit information failed. At particular record locations are the program unit identification code of the "Wall Street Week"; the overlay number; the minute of "Wall Street Week" program transmission within a one month period; a display unit identification code that identifies monitor, 202M, as the display apparatus; and date and time information from clock, 18.)

EXAMPLE #4 (THIRD MESSAGE)

Subsequently, the embedded information of the third message of "Wall Street Week" is inputted to decoder, 203. Said information is identical to the embedded information of the third message of example #3 and causes the same processing. The third message causes "GRAPHICS OFF" to be executed at the microcomputers, 205, of all subscriber stations tuned to the "Wall Street Week" transmission. But the third message of example #4 causes combining actually to cease only at selected stations where information of the second message previously caused combining to commence; that is, only at those stations preprogrammed not only with information of decryption key J but also information of decryption key Z.

EXAMPLE #5

Example #5 focuses on program unit identification signals detected at decoders, 30 and 40. Signal processor, 200, is preprogrammed with information that identifies each transmission in the locality. Controller, 20, controls oscillator, 6, to sequence in the pattern: cable channel 2, 4, 7, 13, wireless channel 5, 9, then repeat said pattern.

Example #5 begins with broadcast of the first message of "Wall Street Week". Mixer, 3, selects the frequency of channel 13 and inputs said frequency to decoder, 30. Receiving said frequency causes decoder, 30, (which is shown in detail in Fig. 2A and whose controller, 39, is shown in Fig 3A) to receive the first combining synch command and record said command at the SPAM-input-signal memory of control processor, 39J.

Decoder, 30, is preprogrammed to process said information as monitor information and local control information. Receiving said command causes control processor, 39J, to locate monitor information in RAM associated with the channel mark of cable channel 13 and compare the program unit identification code of said command with the program unit information of said information. No match results which indicates cable channel 13 is transmitting a new program unit. Not resulting in a match causes said controller, 39, to transfer said information in RAM which is monitor information of the program transmitted on cable channel 13 prior to "Wall Street Week". Control processor, 39J, transmits a message that consists of a "00" header then the execution segment information of the pseudo command then a meter-monitor segment containing said monitor information. Said message is the "lst-old-program (#5)." Control processor, 39J, determines that said first command contains subject matter meter-monitor information causing control processor, 39J, to transmit a message that consists of a "00" header then execution segment information addressed to microcomputer, 205, then meter-monitor segment information that includes the program unit identification code and subject matter information of said first command and the channel mark of cable channel 13. Said message is the "lst-new-program (#5)". Control processor, 39J, records at RAM, with said mark, meter-monitor information of said first command. Controller, 39J, transmits detection-complete information to controller, 20.

Receiving detection-complete information causes controller, 20, to cause selection of wireless channel 5. The command that follows on wireless channel 5 is addressed to ITS controller/computers, 73. Nevertheless, control processor, 39J, of decoder, 30, has capacity to process the meter-monitor information of said command. Receiving said command causes control processor, 39J, to transfer to buffer/ comparator, 8, a message called the "2nd-old-program (#5)".

When the input of wireless channel 9 to decoder, 30, commences, the remote wireless station is transmitting no signal information in the normal transmission pattern. Determining that a particular period of time has elapsed causes selection of cable channel 13.

While decoder, 30, is processing video transmissions, radio signal decoder, 40, is processing radio transmissions inputted from mixer, 2. (Decoder, 40, is shown in detail in Fig. 2B. Controller, 44, is identical to controller, 39, of Fig. 3A.)

In the example, buffer/comparator, 8, receives from decoder, 30, 1st-, 2nd-, and 3rd-old-program (#5) messages and the 1st-new-program (#5) and from decoder, 40, 1st-old-radio-program (#5) and 1st-new-radio-program (#5) messages. All are commands. The 1st-new-program (#5) informs microcomputer, 205, of new programming to which said microcomputer can tune station apparatus in fashions described below. Said command is a "guide command". The 2nd-old-program (#5) and the 1st-old-program (#5) are addressed to no apparatus. Each is a "transparent command".

Each guide command invokes instructions that cause controller, 12, to input the message of said command to buffer, 39G, of controller, 39, of decoder, 203. Each transparent command invokes no controlled function. In example #5, controller, 12, is preprogrammed to process monitor information. After transmitting or determining that each command invokes no controlled function, controller, 12, transfers to buffer/ comparator, 14, header information that identifies a transmission of monitor information of available programming then all information recorded at said SPAM-input-signal memory. Signal processor, 200, processes the monitor information in a fashion that is similar to examples #3 and #4. Receiving a new programming message causes signal processor, 200, to record a record at recorder, 16.

SIGNAL RECORD TRANSFER

In each example, when recorder, 16, finishes recording signal record information, recorder, 16, measures the quantity of its records and determines that said quantity is greater than particular fullness information. Said determining causes recorder, 16, to transfer an instruct-to-call instruction that causes controller, 20, to activate telephone connection, 22, and transfer information to a computer at a remote station. Controller, 20, transfers the telephone number, 1-800-AUDITOR, and causes dialer, 24, to dial said number. Said computer answers, and controller, 20, transfers the unique digital identifying code of ROM, 21. Controller, 20, causes recorder, 16, to transmit records to said computer then to erase record information.

REGULATING RECEPTION AND USE OF PROGRAMMING

The present invention includes other means and methods for regulating reception and use of programming. The computer system of the present invention has capacity to compute station specific information based on preprogrammed information that exists at each station and differs from station to station. Given this capacity, any central control station can cause subscriber stations to decrypt received SPAM information in different fashions with each station decrypting its received information is its own fashion. A central station can cause stations to compute station specific decryption cipher keys and/or algorithms and/or information that differs from station to station and controls each station in identifying which key and/or algorithm to use for any given step of decrypting. A second feature is that effective processing depends on the correspondence between the transmitted SPAM information that causes processing and the information preprogrammed at the stations that controls processing. In order for an execution segment to invoke an controlled function at any given station, the received binary information of said segment (for example, "010011") must match preprogrammed controlled-function-invoking information ("010011"). This feature permits each station to be preprogrammed with station specific controlled-function-invoking information that differs from station to station. The third feature is an extended system of means and methods for regulating the reception and use of SPAM information--including decryption key and algorithm information--that is illustrated in Fig. 4.

By themselves, the first and second features provide a technique whereby a message can affect selected stations without being decrypted at said stations. This technique is "covert control."

Example #6, which is set in the context of example #4, illustrates covert control. In example #4, the execution segment of the second message, when decrypted, is, for example, "100110". And the execute-conditional-overlay-at-205 information that said segment matches is also "100110". In example #6, the execution segment of said second message is "111111", and no subscriber station is preprogrammed with any controlled-function-invoking information that is "111111". Two messages are transmitted. Each consists of a "01" header; execution, meter-monitor, and information segments; and an end of file signal. Said messages are the "1st supplementary message (#6)" and the "2nd supplementary message (#6)". Each is encrypted prior to transmission in the fashion of the first message of example #4 except that encryption is done with key J.

The "Wall Street Week" program originating studio embeds and transmits the 1st supplementary message (#6) before transmitting said second message. Just as with the first message of example #4, at stations preprogrammed with decryption key J, the 1st supplementary message (#6) causes the station to decrypt said message (using key J) and execute controlled functions invoked by the decrypted execution segment. A match occurs with execute-at-39J information that causes control processor, 39J, to execute load-and-run-at-39J instructions. Control processor, 39J, loads the information segment at RAM associated with control processor, 39J. In due course, the end of file signal causes EOFS valve, 39H, to transmit the interrupt signal of EOFS-signal-detected information. Said signal causes control processor, 39J, to execute the information at RAM as a machine language job. Said information causes control processor, 39J, to locate the location of that instance of controlled-function-invoking information that is "100110" (the execute-conditional-overlay-at-205 information) and modify the information at said location to "111111".

When the second message of the "Wall Street Week" program of example #6 is transmitted with its "111111" execution segment, said message is processed at stations that are preprogrammed with decryption key J precisely as the second message of example #3 is processed. (At all other stations, said message is automatically discarded because "111111" fails to match any controlled-function-invoking information.)

The "Wall Street Week" program originating studio embeds and transmits the 2nd supplementary message (#6) after transmitting said second message. At stations preprogrammed with key J, said message causes control processor, 39J, to locate the controlled-function-invoking information that is "111111" and modify the information at the location of said "111111" to "100110".

Covert control provides significant benefits. One benefit is speed. No time is spent decrypting messages (such as the second message of example #4) that convey combining synch commands. Thus the shortest interval of time can exist between the moment when a combining synch command is embedded and the moment when it causes combining at selected stations. A second benefit arises out of the capacity to repeat. After transmitting said 1st supplementary message (#6), the program originating studio can invoke the aforementioned conditional-overlay-at-205 instructions at said selected stations many times by transmitting execution segments that are "111111" before transmitting said 2nd supplementary message (#6).

Fig. 4 shows the Programming Reception and Use Regulating System of the present invention. The subscriber station has capacity for receiving wireless transmissions at a conventional antenna, 199, and a cable transmission at converter boxes, 201 and 222. Said boxes, 201 and 222, are conventional cable converter boxes with capacity for receiving information of a selected channel of a multi-channel transmission and converting the selected information to a given output frequency. The channels are selected by tuners, 214 and 223 which are conventional tuners. Antenna, 199, and boxes, 201 and 222, transmit to matrix switch, 258, which is a conventional matrix switch. One apparatus that said switch has capacity for outputting to is television tuner, 215. The configuration of Fig. 4 differs from Figs. 1 and 3 in that television tuner, 215, outputs its audio and video to said matrix switch, 258. In Fig. 4, said switch, 258, outputs the input to said monitor, 202M, and divider, 4. Fig. 4 shows five additional devices. Decryptors, 107, 224 and 231, are conventional decryptors with capacity for receiving encrypted digital information, decrypting by means of a selected cipher algorithm and a selected cipher key, and outputting decrypted information. Signal stripper, 229, is a conventional signal stripper with capacity for receiving a transmission of video information, removing embedded signal information selectively, and outputting the transmission absent the removed information. Signal generator, 230, is a conventional signal inserter, with capacity for receiving a transmission of video information, embedding signal information selectively, and outputting the transmission with the embedded information. Matrix switch, 258, has capacity for outputting selected transmissions to each said devices, and each of said devices outputs its information to said switch 258.

As Fig. 4 shows, signal processor, 200, controls all the aforementioned apparatus. Signal processor, 200, controls the tuning of tuners, 214, 215, and 223; controls the switching of switch, 258; supplies cipher algorithm and cipher key information to and controls decryptors, 107, 224 and 230; controls signal stripper, 229, in selecting transmission locations and/or information to strip and in stripping; and controls signal generator, 230, in selecting transmission locations at which to insert signals, in generating specific signals and in inserting.

Fig. 4 also shows divider, 4, monitor, 202M, decoder, 203, and microcomputer, 205, which function and are controlled as in Figs. 1 and 3.

Finally, Fig. 4 shows local input, 225, which has means for generating and transmitting control information to controller, 20, of signal processor, 200. In the preferred embodiment, local input, 225, is actuated by keys that are depressed manually by the subscriber in the fashion of a touch-tone telephone or microcomputer keyboard. As Fig. 4 shows, microcomputer, 205, has capacity for inputting control information via decoder, 203, to said controller, 20.

EXAMPLE #7

Example #7 illustrates operation of the system of Fig. 4. The program originating studio that originates "Wall Street Week" transmits a television signal of video and digital audio in clear to intermediate transmission stations. The intermediate station that retransmits "Wall Street Week" to the subscriber of Fig. 4 is a cable system head end (such as Fig. 6). Prior to retransmission, said station encrypts the digital audio then transmits said program on cable channel 13 at 8:30 PM.

In example #7, controller, 20, of signal processor, 200, is programmed with information that the subscriber wishes to view "Wall Street Week". So programming controller, 20, can occur in several fashions. For example, a subscriber may enter please-fully-enable-WSW-on-CC13-at-particular-8:30 information and cause said information to be inputted to controller, 20, by local input, 225. Alternately, microcomputer, 205, can be programmed with specific-WSW information and, in a fashion described more fully below, caused to input please-fully-enable-WSW-on-CC13-at-particular-8:30 information to controller, 20.

Receiving any given instance of please-enable-WSW-on-CC13-at-8:30 information causes controller, 20, to execute particular receive-authorizing-info instructions. At a particular commence-enabling time, controller, 20, transmits preprogrammed enable-next-CC13 information to the control processor, 39J, of decoder, 30, and causes said control processor, 39J, to place one instance of said information at a particular controlled-function-invoking information location; causes switch, 1, and mixer, 3, to select a particular master cable control channel to input to decoder, 30; causes control processor, 39J, to cause line receiver, 33, and digital detector, 34, to commence inputting to controller, 39, SPAM information detected in the input; and places one instance of said enable-next-CC13 information at a particular controlled-function-invoking-@20 information location.

In the interval between said commence-enabling time and 8:30 PM said head end is caused to transmit a SPAM message that consists of a "01" header, execution segment information that matches said enable-next-CC13 information, information segment information of particular enable-CC13 instructions that include enable-WSW-programming information, and an end of file signal on said master control channel. Said message is the "local-cable-enabling-message (#7)."

Said message causes decoder, 30, to select information of the execution segment and determine that said information matches the enable-next-CC13 information at said controlled-function-invoking information location. Determining a match causes the control processor, 39J, to execute transfer-this-message-to-controller-20 instructions that are associated with said location. The matrix switch, 39I, of decoder, 30, has capacity to transfer information to controller, 20, via control transmission means and executing said instructions causes control processor, 39J, to transfer said message to controller, 20.

Receiving said message causes controller, 20, to load the enable-CC13 instructions at RAM of controller, 20, and execute said instructions.

Said instructions cause controller, 20, to sample selected preprogrammed SPAM information and determine whether unauthorized tampering has occurred. Controller, 20, selects information of the unique digital code at ROM, 21; computes the quotient that results from dividing said information by 65,536; selects the integer portion of said quotient; branches to a selected subroutine of said instructions on the basis of the value of said integer; and executes said subroutine. Said subroutine causes controller, 20, to select information of sixteen contiguous bit locations that contain information of said enable-CC13 instructions and compare said selected information to information of sixteen contiguous bit locations at a signal processing RAM or ROM at the station. A match indicates that said bit locations are preprogrammed properly. A match occurs.

(Simultaneously other stations compare. At each station where a match fails to occur, not resulting in a match causes the controller, 20, to erase particular RAM, then to cause auto dialer, 24, and telephone connection, 22, to establish telephone communications with a remote station, then to transmit information of the unique digital code at ROM, 21, as well as particular appearance-of-tampering information.)

Resulting in a match causes controller, 20, to execute a portion of said enable-CC13 instructions. Said portion causes selected apparatus to receive the cable channel 13 transmission, decrypt the audio, commence waiting to receive further enabling information, and create a meter record. Controller, 20, causes matrix switch, 258, to cease transferring video and audio to monitor, 202M. Then controller, 20, causes tuner, 214, to tune to the frequency of cable channel 13, thereby causing its associated converter box, 201, to convert information of said frequency to a selected output frequency and transfer said information at said frequency to matrix switch, 258. Controller, 20, causes matrix switch, 258, to transfer information from box, 201, to television tuner, 215, and causes tuner, 215, to tune to said selected frequency, thereby causing said tuner, 215, to receive cable channel 13 and output the audio and video portions of said information to matrix switch, 258, on the separate audio and video outputs of tuner, 215. Controller, 20, causes matrix switch, 258, to transfer the audio inputted from tuner, 215, to decryptor, 107, thereby causing decryptor, 107, to receive the encrypted digital audio. Controller, 20, selects information of cipher key Ca; transfers said key information to decryptor, 107; and causes decryptor, 107, to commence decrypting its received audio information, using said key and decryption cipher algorithm C, and outputting decrypted information of the audio of "Wall Street Week" to matrix switch, 258. Controller, 20, causes matrix switch, 258, to transfer information from decryptor, 107, to signal processor, 200, thereby causing signal processor, 200, to receive said information at a particular third contact of switch, 1, (not shown in Fig. 2). Controller, 20, causes switch, 1, to connect to said third contact, and mixer, 3, to transfer said information without modification; causes the control processor, 39J, of decoder, 30, to cause the filter, 31, and demodulator, 32, to transfer said information without modification; causes said control processor, 39J, to cause digital detector, 38, to commence inputting detected information to controller, 39; and causes said control processor, 39J, to commence waiting to receive header information. Then said instructions cause controller, 20, to cause control processor, 39J, to place one instance of said enable-WSW-programming information (that said instructions include) at the controlled-function-invoking information location occupied by said enable-next-CC13 information (thereby overwriting said information) and cause controller, 20, to place one instance of said enable-WSW-programming information at the controlled-function-invoking-@20 information location occupied by enable-next-CC13 information. Finally, in the fashion of the first message of example #4, controller, 20, causes information of the meter-monitor segment to be placed at particular locations of buffer/comparator, 14, thereby creating a meter record that records the decryption of the audio portion of "Wall Street Week".

Subsequently, said program originating studio embeds in the audio and transmits a SPAM message that consists of a "01" header, execution segment information that matches said enable-WSW-programming information, meter-monitor information, 1st-stage-enable-WSW-program instructions as the information segment information, and an end of file signal. Said message is the "lst-WSW-program-enabling-message (#7)."

Signal processor, 200, detects and transfers said message to controller, 20. Controller, 20, executes the 1st-stage-enable-WSW-program instructions a machine language job. Said instructions cause controller, 20, to affect a first stage of decrypting video of "Wall Street Week". Controller, 20, selects the last three significant digits of the unique digital code at ROM, 21; computes that Q quantity that is 16 less than the product of multiplying the numerical information of said digits times 256; and selects information of the sixteen contiguous bit locations at the RAM associated with control processor, 39J, that commence at the first bit location that is said Q locations after a particular first location at said RAM. At the station of Fig. 4, the preprogrammed information of said sixteen contiguous bit locations is decryption cipher key Ba. (In the present invention, the preferred method of preprogramming signal processing apparatus is to vary locations of information from station to station.) Controller, 20, causes decryptor, 224, to commence decrypting received information, using said key information and selected decryption cipher algorithm B. Controller, 20, causes matrix switch, 258, to transfer video from tuner, 215, to decryptor, 224, and from decryptor, 224, to the third contact of switch, 1.

In due course, said studio embeds in the video and transmits a check sequence of binary information called the "1st-WSW-decryption-check (#7)." Then said studio ceases transmitting digital video and digital audio.

Said sequence causes controller, 20, to compare selected information of said sequence to selected information of said Ist-stage-enable-WSW-program instructions. A match occurs, 4, indicating that decryptor, 224, is decrypting correctly.

(Simultaneously other stations compare. Each station where a match fails to occur erases RAM, establishes telephone communications, and transmits appearance-of-tampering information with the unique digital code that identifies said station.)

A match causes controller, 20, to execute a portion of said Ist-stage-enable-WSW-program instructions. Said portion causes the station to cease receiving and decrypting digital video and audio, to commence receiving analog television, and to prepare to receive particular embedded SPAM information at the decoder, 30, of signal processor, 200. Controller, 20, selects the first three of the last four significant digits of the unique digital code at ROM, 21; computes that Q quantity that is the sum of the numerical information of said three digits plus 20; and causes decoder, 30, to commencing receiving information embedded on the line Q (and only on line Q) of the inputted video. (In other words, if the binary information of said three digits is "000", decoder, 30, receives information embedded on line 20; if the binary information of said three digits is "001", decoder, 30, receives information embedded on line 21; etc.)

In due course, said studio commences transmitting analog television and embeds SPAM message information on lines 20, 21, 22, 23, 24, 25, 26, and 27. On each line said station transmits one particular message. Each message consists of a "01" header, execution segment information that matches said enable-WSW-programming information, meter-monitor information, 2nd-stage-enable-WSW-program instructions as the information segment information, and an end of file signal. Each of said messages is identical except as as regards certain differences in said 2nd-stage-enable-WSW-program instructions described below. Prior to being embedded each message is encrypted. Each message is called a "2nd-WSW-program-enabling-message (#7)." Then said program originating studio ceases transmitting analog television.

Decoder, 30, receives the 2nd-WSW-program-enabling-message (#7) embedded on said line Q. Control processor, 39J, causes controller, 20, to cause the decryptor, 39K, of decoder, 30, to decrypt said message. EOFS valve, 39H, inputs said message, unencrypted, to control processor, 39J. Control processor, 39J, transfers said message to controller, 20. Controller, 20, executes the 2nd-stage-enable-WSW-program instructions.

Said 2nd-stage-enable-WSW-program instructions cause controller, 20, to strip information from "Wall Street Week", insert information, and affect a second stage of decrypting. Controller, 20, causes matrix switch, 258, to cease transferring information to said third contact; commence transferring information from decryptor, 224, to signal stripper, 229; transfer from stripper, 229, to signal generator, 230; transfer from generator, 230, to decryptor, 231; and transfer from decryptor, 231, to said third contact of switch, 1. Controller, 20, causes signal stripper, 229, to strip information from a strip-designated portion of the video transmission and transfer the video without said stripped information to matrix switch, 258. (Said stripped information may be information that would cause disabling chips to prevent microcomputer, 205, or monitor, 202M, from processing or displaying the video.) Controller, 20, selects complete information of the unique digital code at ROM, 21, and causes generator, 230, to insert said information in a periodic fashion into a insertion-designated portion of the video transmission and to transfer the video with said inserted information to matrix switch, 258. (If pirated copies are distributed, the station at which decryption occurred can be identified.) Controller, 20, selects the aforementioned first three of the last four significant digits of the unique digital code at ROM, 21 and computes a Q quantity according to a formula in said 2nd-stage-enable-WSW-program instructions. Said Q quantity is the decryption key Aa. (The formulas in the eight different 2nd-WSW-program-enabling-message (#7) messages differ in such a way that when each station computes its own Q quantity according to its own unique digital code digits, the Q quantities computed at all properly preprogrammed and functioning stations are identical.)

In due course, said studio encrypts and transmits in digital video a check sequence of binary information followed by an end of file signal. Said check information is the "2nd-WSW-decryption-check (#7)." Selected information causes controller, 20, to determine that signal stripper, 229, is correctly stripping and signal generator, 230, is correctly inserting.

(Other stations compare selected information. At each station where a match does not result, instructions cause said station to establish telephone communications then transmit appearance-of-tampering information with the unique digital code that identifies said station.)

Determining that stripper, 229, and generator, 230, are stripping and inserting correctly causes the station (and at other stations where so determining occurs) to transfer television information of "Wall Street Week" to microcomputer, 205, and monitor, 202M. Controller, 20, causes matrix switch, 258, to transfer audio from decryptor, 107, to monitor, 202M, causing monitor, 202M, to commence receiving audio and emitting sound. Controller, 20, causes matrix switch, 258, to commence transferring video from decryptor, 231, to divider, 4, causing divider, 4, to transfer decrypted video to microcomputer, 205, and decoder, 203. Controller, 20, causes decoder, 203, to commence detecting SPAM information in the inputted video and waiting to receive header information and to cause microcomputer, 205, to transfer the video to monitor, 202M, causing monitor, 202M, to display the transmitted image.

At 8:30 PM, said program originating studio commences transmitting "Wall Street Week", thereby causing the station to function in the fashions described in "One Combined Medium" and examples #1, #2, #3, and #4.

The foregoing is presented by way of example, and modifications may be made in the structure of the various parts without functionally departing from the spirit of the invention. For example, decryptors, 107, 224, and 231, may be conventional descramblers that descramble analog television transmissions. The transmitted programming may be recorded at apparatus such as a properly configured video recorder rather than displayed at a monitor, 202M. Rather than a transmitter at a remote station, the source of the transmission may be a local video tape recorder or a laser disc player.

MONITORING RECEPTION AND OPERATION

Fig. 5 exemplifies one embodiment of a subscriber station configured and preprogrammed to monitor. Fig. 5 shows a representative group of equipment; many other apparatus could be included. Associated with each intermediate and output apparatus is one or more appropriate decoders. At radio tuner & amplifier, 138, are radio decoder, 138, and other decoder, 281. At TV tuner, 215, is TV decoder, 282. At audio recorder/player, 255, is other decoder, 284. At video recorder/player, 217, is TV decoder, 218. At microcomputer, 205, is TV decoder, 203. At other tuner and/or recorder/player, 257, is other decoder, 283. At TV monitor, 202M, is TV decoder, 145. At multi-picture TV monitor, 148, are TV decoders, 149 and 150. At speaker system, 263, is other decoder, 285. At printer, 221, is other decoder, 227. At other output system, 261, is other decoder, 286. Each decoder is located physically inside the unit of its associated apparatus.

Any given SPAM decoder may merely monitor the operation of its associated apparatus or function also to control said apparatus in execution of SPAM controlled functions (in which case said decoder is preprogrammed to execute controlled functions). Fig. 5 shows each decoder as having capacity for transferring monitor information to signal processor, 200, by bus communications means. Said information is received and processed at processor, 200, by onboard controller, 14A, which controls communications of said bus means. Decoders, 138, 281, 282, 284, 218, 283, 145, 149, 150, 285, 227, and 286, merely monitor. Each one is located at a point in the circuitry of its associated apparatus where said one receives the information of the frequency, channel or transmission to which its associated apparatus is tuned. Each one is preprogrammed to detect and transfer via said bus means, the meter-monitor information of every unencrypted SPAM message in the transmission to which its associated apparatus is tuned. Decoder, 203, not only monitors its associated apparatus, microcomputer, 205, but also controls said apparatus. Onboard controller, 14A, controls the decoders that merely monitor. Decoders that execute SPAM controlled functions are controlled, by controller, 20, of signal processor, 200. In Fig. 5, decoder, 203, is the only such decoder.

By embedding SPAM information in audio and/or video programming conventionally recorded by recorders, these methods provide techniques for gathering statistics on what is recorded, for example, on video and audio cassette recorders and on how people replay such recordings. Video and audio tapes, videodiscs, compact discs, and "CD ROM" discs of data can contain unique codes, embedded in prerecorded programming, that identify usage of said programming when said tapes or discs are played.

AUTOMATING INTERMEDIATE TRANSMISSION STATIONS

Signal processing apparatus in Figs. 2, 2A, 2B, 2C, and 2D, and their variants automate intermediate transmission stations. The stations so automated range from wireless stations that transmit a single transmission to cable systems that cablecast many channels.

Fig. 6 illustrates a cable television head end that cablecasts several channels. The station receives programming transmissions by satellite antenna, 50, low noise amplifiers, 51 and 52, and TV receivers, 53, 54, 55, and 56. Microwave transmissions are received by antenna, 57, and television receivers, 58 and 59. TV broadcast transmissions are received by antenna, 60, and TV demodulator, 61. Other transmissions are received by other input means, 62. Each receiver/modulator/input apparatus, 53 through 62, transfers its received transmissions to a conventional matrix switch, 75, that outputs to one or more recorder/players, 76 and 78, and to apparatus that outputs transmissions over various channels to the cable system's field distribution system, 93, which apparatus includes modulators, 83, 87, and 91, and multiplexing system, 92. When played on video recorders, 76 and 78, prerecorded programming can be transmitted via switch 75 to field distribution system, 93.

In the prior art, identification of incoming programming, however received; operation of video player and recorder equipment, 76 and 78; and maintenance of records are largely manual operations.

Fig. 6 shows signal processing apparatus to automate these and other operations.

In line between each receiver/demodulator/input apparatus, 53, 54, 55, 56, 57, 58, 59, 60, 61, or 62, and matrix switch,. 75, is a dedicated distribution amplifier, 63, 64, 65, 66, 67, 68, 69, or 70, that splits each incoming feed into two paths. One path is the conventional path whereby programming flows from each receiver/demodulator/input apparatus, 53, 54, 55, 56, 57, 58, 59, 60, 61, or 62, to matrix switch, 75. The other path inputs the transmission of said apparatus, 53, 54, 55, 56, 57, 58, 59, 60, 61, or 62, individually to signal processor system, 71.

At signal processor system, 71, which is a system as shown in Fig. 2D, the transmission of each amplifier, 63, 64, 65, 66, 67, 68, 69, or 70, is inputted to a dedicated decoder (such as decoders, 27, 28, and 29 in Fig. 2D) that processes continuously the transmission of said amplifier, 63, 64, 65, 66, 67, 68, 69, or 70; selects SPAM messages in said transmission that are addresses to apparatus of said station; adds source mark information that identifies said associated amplifier, 63, 64, 65, 66, 67, 68, 69, or 70; and transfers said selected messages with said source mark information to code reader, 72. Signal processor system, 71, also has signal processor means to control system, 71, record meter-monitor information, and transfer recorded information to communications network, 97.

Code reader, 72, buffers and passes the information to cable program controller and computer, 73.

Cable program controller and computer, 73, is the central automatic control unit for the transmission station. Computer, 73, has an installed clock and is preprogrammed with information on the operating speeds and capacities of all station apparatus and the connections of said apparatus with matrix switch, 75. Computer, 73, has means for receiving input from local input, 74, and from remote stations via telephone or other data transfer network, 98. Such input include the complete programming schedule of the station with each unit of programming identified by its program unit identification code. Such input indicate when and how the station should receive each program unit, when and on which channel or channels and how the station should transmit the unit, what kind of programming the unit is--eg., conventional television, television/computer combined medium programming, etc.--and how the station should process the programming. Computer, 73, is preprogrammed to receive and record schedule information and to maintain records which indicate the operating status of each controlled apparatus.

Computer, 73, monitors the operation of the station by means of TV decoders, 77, 79, 80, 84, and 88, each shown in detail in Fig. 2A. Computer, 73, has means to communicate control information with each decoder, 77, 79, 80, 84, and 88, to instruct each how to operate and how and where to search for SPAM information. Decoders, 80, 84, and 88, select and transfer SPAM meter-monitor information and by comparing said information to information of its contained schedule records, computer, 73, can determine whether scheduled programming is being transmitted properly to field distribution system, 93, on each cable channel of the station. Whenever computer, 73, detects errors, computer, 73, can execute predetermined error correction procedures.

By means of the SPAM message information with source mark information received from code reader, 72, computer, 73, determines what specific program unit has been received by each receiver, 53 through 62, and is passing in line, via each distribution amplifier, 63 through 70, to matrix switch, 75. By comparing selected meter-monitor information of said message information with information of the programming schedule received from input, 74, and/or network, 98, computer, 73, can determine when and on what channel or channels the station should transmit the programming of each received program unit.

Computer, 73, has means for communicating control information with matrix switch, 75, and video recorders, 76 and 78, and can cause selected programming to be transmitted to field distribution system, 93, or recorded. Determining that incoming programming is scheduled for immediate retransmission can cause computer, 73, to cause matrix switch, 75, to configure its switches to transfer said programming to a scheduled output channel. Determining that incoming programming is scheduled for time deferred transmission can cause computer, 73, to cause recording of said programming. Determining that incoming programming is not scheduled for transmission can cause computer, 73, either to cause matrix switch, 75, to transfer the programming to no output of switch, 75; or to cause a selected recorder, 76 or 78, to cease recording; or both.

Computer, 73, has capacity for determining what programming is loaded on recorders, 76 and 78, and for positioning the start points (or other selected points) of program units at the play heads. Whenever programming is played on recorder, 76 or 78, decoder, 77 or 79 respectively, detects SPAM information embedded in the prerecorded programming played at the play heads of recorder, 76 or 78, and transmits said SPAM information to computer, 73. Said SPAM information can include not only program unit identification code information but also information regarding of the distance from the point on the tape at which a given SPAM message is embedded to the point where the program unit begins (or to any other selected point).

Computer, 73, has capacity for organizing units of programming loaded on recorder/players to play according to a schedule and for playing program units according to its station schedule. For example, computer, 73, causes recorder, 78, to move forward or rewind to the start of program unit Y; causes recorder, 76, to rewind to the start of available space; and causes switch, 75, to configure its switches so as to transfer the output of recorder, 78, to the input of recorder, 76. Computer, 73, causes recorder, 78, to play and recorder, 76, to record for the duration of program unit Y. Computer, 73, causes recorder, 78, to move forward or rewind to the start of program unit D and causes recorder, 78, to play and recorder, 76, to record for the duration of program unit D. Finally, computer, 73, alters its contained records to document the locations of Y and D on the tape on recorder, 76, and the availability of the spaces that Y and D occupied on the tape on recorder, 78, for recording other programming.

In the preferred embodiment, at least two signal processors (such as the signal processor of said system, 71, and signal processor, 96) monitor the transmissions of any given transmission station.

EXAMPLE #8

Using the capacity described above for identifying, selecting, and recording received programming; for organizing recorded programming to play according to schedule; for playing selected organized programming on schedule; and for retaining, recording, and retransmitting monitor records that document the transmission of program units, a remote distribution station can transmit to a plurality of intermediate transmission stations programming that is scheduled for delayed transmission, cause each station to select and retransmit programming according to its schedule, and cause signal processing apparatus to transmit to remote auditing stations signal records that document the transmission of specific program units at the specific stations of said plurality. For example, a so-called "spot rep." agency that sells the "spot time" of local broadcast stations and cable systems can transmit spot commercials and cause each station or system automatically to retransmit its specific commercials according to its schedule.

In example #8, a remote distribution station transmits television programming to a plurality of intermediate stations by a satellite. Among the intermediate stations are broadcast stations in Texas and Washington, and the station of Fig. 6 in Vermont. Each intermediate station is preprogrammed to process messages transmitted from said remote distribution station.

At 5 P.M., said remote distribution station commences contacting, individually and in turn, the computers, 73, of each intermediate station, via network, 98, and inputs schedule information to each computer, 73. The information identifies the time and satellite transponder said stations should receive programming. The information also identifies to each computer, 73, which program units it should select and record, and when and on which channel said computer, 73, should cause the station to transmit the units. For the station of Fig. 6, said remote distribution station informs computer, 73, to select and record program units Q, D, Y, and W; to transmit Q at 2:30:30 PM on the channel transmitting Cable News Network; to transmit Y at 2:45:00 PM on Cable News Network; to transmit W at 2:45:00 PM on the channel transmitting USA Cable Network; to transmit D at 9:15:30 PM on Cable News Network. In inputting schedule information, said remote distribution station instructs different computers, 73, to operate differently.

At 3:50 A.M., the schedule information causes said intermediate stations each, to receive the transmission of transponder 23 of the Galaxy 1 satellite. Computer, 73, instructs earth station, 50, to move its antenna to receive Galaxy 1 and instructs amplifier, 51, and receiver, 53, to receive the transmission of transponder 23. (Means whereby computer, 73, can control earth station, 50, amplifier, 51, and receiver, 53, exist at the station of Fig. 6.) Computer, 73, causes matrix switch, 75, to transfer transmissions from receiver, 53, to recorder, 76; causes recorder, 76, to turn on; and causes said recorder, 76, to move forward or rewind to a particular place on the tape loaded at its record head. (The station could include apparatus for loading tape on recorders, 76 and 78, and control means whereby computer, 73, could instruct said apparatus to load a particular tapes selectively on recorder, 76 and 78.)

At 4 A.M., said remote distribution station commences transmitting 26 spot commercials. Said station transmits units A, B, C, D, E, F, G, H, I, J, K, L, M, N, O, P, Q, R, S, T, U, V, W, X, Y, and Z. Embedded in each are SPAM messages containing program unit identification codes and distance information. Separating each program unit is a brief interval. Before the first program unit and in each interval, said station transmits a message addressed to ITS computers, 73, that contains the program unit identification code of the program unit that follows. Said messages are collectively "cue-to-select messages (#8)." At the station of Fig. 6, said cue-to-select messages (#8) are detected and transferred to computer, 73, by that dedicated decoder of signal processing system, 71, that receives a transmission from distribution amplifier, 63. Receiving any one of said messages causes each computer, 73, to determine whether the program unit identification code matches schedule information. A match causes a computer, 73, to cause its station to record the program unit immediately after said one. No match causes a station not to record said program unit.

Receiving the select-Q-message (#8) causes computer, 73, to determine that the "program unit identification code" information of unit Q matches schedule information which causes said computer, 73, to cause recorder, 76, to record program unit Q.

Each computer, 73, is preprogrammed to account for and keep track of the quantity of time available for additional recording on the individual tapes loaded on the recorders (eg., 76 and 78) of its station, and receiving a cue-to-select message can cause a computer, 73, to cause its station to switch from a primary to a secondary recorder.

When a computer, 73, causes a recorder (e.g., 76 or 78) station to cease recording, said computer, 73, checks its contained records in a predetermined fashion to determine whether all scheduled units have been received. Whenever a computer, 73, determines that no further units will be received, said computer, 73, causes its station to cease receiving the transmission of said remote distribution station, and commences automatically organizing, in the fashions described above, the order of the program units and playing said units according to its contained schedule.

(In so transmitting said programming and cue-to-select messages (#8), said remote distribution station causes different intermediate transmission stations to select and record different programming and to organize recorded program units differently.)

At 2:30:29 PM, the program originating studio that originates the Cable News Network embeds the cue-to-transmit-locally message (#8). Said message is inputted to computer, 73, with source mark information of distribution amplifier, 63. Said message causes the station of Fig. 6, to cease transmitting the Cable News Network to field system, 93, and commence transmitting unit Q. Said message causes the signal processor of system, 71, and signal processor, 96, to retain meter-monitor information of said message.

Causing the station to transmit unit Q causes the signal processor of system 71, and signal processor, 96, to retain meter-monitor information of unit Q, to record signal record information of prior programming--i.e., Cable News Network--and may cause one or both of said processors to transmit signal record information or one or more remote auditing stations.

AUTOMATING INTERMEDIATE STATION COMBINED MEDIUM OPERATIONS ... (INCLUDING EXAMPLE #9)

The station has capacity to process and transmit combined medium programming. Fig. 6 shows signal strippers, 81, 85, and 89, well known in the art, that computer, 73, can cause to remove SPAM information from programming, and signal generators, 82, 86, and 90, well known in the art, that computer, 73, can cause to embed SPAM information. Said generators, 82, 86, and 90, have capacity for receiving control information and programming in a transmission from computer, 73, and distinguishing said information from said programming.

For example, computer, 73, must insert locally generated instruction sets into a local transmission. Program unit Q is a commercial that describes discounts and coupon specials at local supermarkets. The formulas that apply to discounts and the items on special vary, and the information embedded must reflect the formulas and items that apply at local supermarkets at the time of transmission.

Computer, 73, is preprogrammed to process combined medium programming. When the remote station inputs information via network, 98, regarding unit Q, said station instructs computer, 73, to commence generation at a time interval prior to the scheduled playing of Q. Such a time period is called "interval," as in "interval Q" of unit Q. Prior to generation time, local-formula-and-item information is inputted to computer, 73, regarding the formulas and items that apply. Said information may be inputted from local input, 74, or network, 98.

An instance of instructions that cause a computer to generate a program instruction set is an "intermediate generation set." In the preferred embodiment, an intermediate generation set is prerecorded in a program unit with conventional programming whose program set generation said intermediate set causes. Said intermediate set is prerecorded before the start of said conventional programming. An intermediate set contains generally applicable information of the program instruction set whose generation it causes. For example, the intermediate set of Q includes information of a announcer saying, "forty-three", "forty-five" and "Hot version Quick". Said generally applicable information lacks specific information that is required to complete the generation of a given instance of a generated program instruction set. (For example, in the case of unit Q, the intermediate generation set lacks information of the particular discount formulas and items offered as coupon specials at the scheduled time of the transmission of unit Q at the particular supermarket or markets that are local to the station of Fig. 6.) When executed at a computer, 73, that is preprogrammed with local-formula-and-item information, the instructions of a intermediate generation set cause said computer, 73, to generate formula-and-item-of-this-transmission information, thereby generating the program instruction set applicable to a particular transmission at a particular intermediate station. The set so generated may consist of computer program instructions and/or data.

Example #9 focuses on generating, embedding, and transmitting program instruction set programming of unit Q.

At interval Q time prior to the scheduled playing of Q, instructions cause computer, 73, to commence generation. Computer, 73, causes matrix switch, 75, to switch the input from recorder, 76, to no output; recorder, 76, to position the start of unit Q at its play head; decoder, 77, to commence detecting signals on all lines of the full video frame; then recorder, 76, to commence playing which causes decoder, 77, to detect a message. Said message is addressed to ITS computers, 73, and contains an information segment whose information is the "intermediate generation set of Q".

Detecting said message causes decoder, 77, to transmit said message to computer, 73. Receiving said message at computer, 73, causes particular SPAM decoder apparatus of computer, 73, (analogous to SPAM-controller, 205C, at microcomputer, 205, and not distinguished from computer, 73, hereinafter) to execute controlled functions. Computer, 73, is caused to load said intermediate set at RAM then position the start of the unit Q conventional television programming at the play head of recorder, 76, and execute said set as a machine language job.

Said set causes computer, 73, to compute formula-and-item-of-this-transmission information. Said information can consist of both computer program instructions and data. Data in said local-formula-and-item information includes, for example, the street address of every supermarket in the locality said station. Other formula-and-item information can be computer program instructions. For example, one discount special is untrimmed pork bellies advertised in conventional television programming unit Q. The offer is, "Discount Supermarkets will deliver to you, at cost, all the pork you need ... ." The cost of delivery involves transportation from the central warehouse to each subscriber who orders a pork belly. The cost of delivery for any given subscriber is calculated under control of formulae that are computer program instructions.

The particulars of the pork belly special illustrate generating formula-and-item-of-this-transmission information. The cost of a pork belly for any given subscriber is computed according to a formula:

$$Y = a + b + c(X) \quad (1)$$

where:

Y is the delivered cost to said subscriber,
a is the supermarket's cost per pork belly at a warehouse,
b is the cost of transportation to the market,
c is the cost per mile of deliveries from said market, and
X is the distance between said market and said subscriber.

Pork belly prices vary from day to day. Transportation costs vary from time to time and place to place. Each time the programming of unit Q is transmitted to subscribers, the values of b and c are computed according to the following equations (2) and (3) respectively:

$$b = (p + q + d)Z \quad (2)$$

where:

p is the cost of gasoline per pork belly unit mile between warehouse and market,
q is the wage of the driver per unit mile,
d is the depreciation of the vehicle per unit mile and
Z is the distance in miles between warehouse and market.

$$c = r + s + dd \quad (3)$$

where:

r is the cost of gasoline per unit mile between market and subscriber,
s is the wage of the local driver per unit mile, and
dd is the depreciation of the local vehicle per unit mile.

For any transmission of Q, the following variables are data pre-entered into computer, 73, and recorded in said local-formula-and-item information: a, p, q, d, Z, r, s, and dd.

When computer, 73, commences generating, the local-formula-and-item information includes information that:

a is 1000.00
p is .00625
q is .12
d is .1
Z is 275
r is .007
s is 2.00
dd is .11

The intermediate generation set includes instructions to compute values of variables b and c according to formulas (2) and (3). Computer, 73, selects information of a, p, q, d, Z, r, s, and dd; computes the value of b, to be 62.21875; computes c to be 2.117; and replaces variable values, a, b, and c, in a higher language line of program code that is among the generally applicable information of said program instruction set and is:

$$Y = a + b + (c * X)$$

to become formula-and-item-of-this-transmission information of:

$$Y = 1000.00 + 62.21875 + (2.117 * X)$$

Computer, 73, selects and computes other variables and replaces other variable values until a complete instance of higher language code has been generated and exists at memory. Computer, 73, compiles, links, generates a PROGRAM.EXE file that is said program instruction set; and places said file at particular program-set-to-transmit memory of computer, 73. The program instruction set generated in example #9 is called the "program instruction set of Q".

Said intermediate set causes computer, 73, also to generate a data module called a "data module set". Computer, 73, selects, from said local-formula-and-item information, information of the street address of every supermarket in the vicinity and the order-taking telephone number 1-(800) 247-8700. Computer, 73, places selected information in a file called DATA OF.ITS until said file constitutes the "data module set of Q".

Subsequently, at the scheduled time of playing Q, the station is transmitting a network transmission. At the program originating studio, a SPAM message to ITS computers, 73, is transmitted. The decoder of signal processing system, 71, that receives the transmission of distribution amplifier, 63, detects said message and inputs said message with source mark information to computer, 73. Said message and mark cause computer, 73, to cause recorder, 76, to commence playing and matrix switch, 75, to transfer the output of recorder, 76, to modulator, 83, which causes transmission of unit Q to field distribution system, 93. In addition, the playing schedule causes generator, 82, to cease embedding other signal information in the normal transmission location (for example, teletext) and transmit a SPAM end of file signal.

Immediately recorder, 76, transmits three SPAM messages embedded in the programming of Q. The first is the "align-URS-microcomputers-205 message (#9)". The second message is embedded at a distance after said first that is sufficient to allow time for subscriber stations to combine. Said second is the "synch-SPAM-reception message (#9) ". The third is the "control-invoking message (#9)".

Causing recorder, 76, to play causes decoder, 77, to detect a series of SPAM messages that are embedded in Q and addressed to ITS computers, 73.

The first message contains execution and meter-monitor segments. Said message causes computer, 73, to generate and transmit the "data-module-set message (#9)." Computer, 73, causes stripper, 81, to strip all signals from the normal transmission location; causes generator, 82, to commence embedding information received from computer, 73; selects information of said meter-monitor segment, adds information that identifies the station of Fig. 6 and the time of transmission, and retains the modified meter-monitor information; and transmits to generator, 82, complete information of said message. Computer, 73, transmits a "01" header; a SPAM execution segment addressed to URS microcomputers, 205; said retained meter-monitor information; any required padding bits; complete information of said data file, DATA_OF.ITS; and a SPAM end of file signal. Receiving said message causes generator, 82, to transmit said message to said system, 93.

The second message in the series causes computer, 73, to generate a second message that includes said program instruction set of Q and to cause said message to be embedded in the transmission of the programming of Q and transmitted to field distribution system, 93. Said message is the "program-instruction-set message (#9)." Automatically, computer, 73, selects the information of a meter-monitor segment, adds information that identifies the station of Fig. 6 and the time of transmission, modifies the meter-monitor format field information to reflect said added information, and retains the received, added, and modified meter-monitor information. Automatically, computer, 73, selects and transmits to generator, 82, a "01" header; a SPAM execution segment addressed to URS microcomputers, 205; said retained meter-monitor information; complete information of the file at the program-set-to-transmit memory of computer, 73, that is said program instruction set of Q; and a SPAM end of file signal. Said selected and transmitted information is program-instruction-set message (#9).

Receiving said information causes generator, 82, to embed said information in the normal transmission location of the programming of Q transmission being transmitted via generator, 82, to field distribution system, 93, thereby transmitting said program-instruction-set message (#9) to said system,93.

The third message causes computer, 73, to cause stripper, 81, to cease stripping and generator, 82, to cease embedding.

Subsequently, as recorder, 76, plays, recorder, 76, transmits eight SPAM messages embedded in the prerecorded programming of Q. Said messages include the "lst commence-outputting message (#9)" and the "1st cease- outputting message (#9)".

At the scheduled end time of playing Q, a message is embedded at said program originating studio and transmitted in said network. Said message and mark information causes computer, 73, to cue said network transmission and continue in its automatic playing fashion. Computer, 73, causes matrix switch, 75, to cease transferring the output of recorder, 76, to modulator, 83, and commence transferring input from distribution amplifier, 63, to modulator, 83, which causes said network transmission to field distribution system, 93. Automatically, computer, 73, may cause generator, 82, to embed the "disband-URS-microcomputers-205 message (#9)" that causes subscriber stations whose microcomputers, 205, are combined to the computer system of recorder, 76, to separate said microcomputers, 205. According to the schedule, computer, 73, may cause generator, 82, to commence embedding other signal information (for example, teletext). Computer, 73, causes recorder, 76, to cease playing and to prepare to play its next scheduled program unit.

NETWORK CONTROL ... EXAMPLE #10

In example #10, a program originating studio transmits the commercial of program unit Q in a network transmission and controls a plurality of intermediate transmission stations each of which controls, in turn, a plurality of ultimate receiver stations. The station of Fig. 6 is one intermediate station. The station of Fig. 6 receives said network transmission at receiver, 53, and retransmits said transmission immediately via modulator, 83. The program unit Q of example #10 is identical to unit Q of example #9, and each intermediate station must transmit its own program instruction set.

Prior to an early time, complete local-formula-and-item information is inputted to the computer, 73, of each intermediate transmission station. At of the station of Fig. 6, the local-formula-and-item information in example #10 is identical to example #9. (At a second intermediate station, the local-formula-and-item information include: a is 1000.00, p is .00625, q is .13, d is .11, Z is 537, r is .0082, s is 1.98, and dd is .10.)

At said early time, the computers, 73, of said controlled intermediate stations are caused to receive a transmission. Schedule information causes said computers, 73, to cause their earth station receivers, 50, amplifiers, 51, and TV receivers, 53, to tune to a particular satellite transmission. Those dedicated decoders of the signal processor systems, 71, of said stations that process the transmission of distrubuted amplifiers, 63, detect and input SPAM information to the computers, 73.

Then the program originating studio transmits a SPAM message that is addressed to ITS computers, 73 and consists of a "01" header, a particular execution segment, appropriate meter-monitor information, padding bits as required, information segment information of the aforementioned intermediate generation set of Q, and an end of file signal. Said message is called the "generate-set-information message (#10)". Said dedicated decoders detect and input said message to the computers, 73.

Said message causes each computer, 73, to load said intermediate generation set at RAM; execute the information so loaded as a machine language job; compute formula-and-item-of-this-transmission information, compile, link complete program instruction set information of this instance of Q, and record said information at memory. The set generated at the station of Fig. 6 in example #10 is the "program instruction set of Q.1".

At the station of Fig. 6, said intermediate generation set causes the computer, 73, to record the computed, compiled, and linked program instruction set of Q in a file named "PROGRAM.EXE" on a computer memory disk of computer, 73. Executing said intermediate generation set also causes said computer, 73, to select data among the local-formula-and-item information of said station, including "Nabisco Zweiback Teething Toast" and the street address of markets in the vicinity of the station of Fig. 6, and to record said selected data on said memory disk in a data file named DATA OF.ITS. In so doing, said computer, 73, generates said data module set of Q.1. (At said second station, said intermediate set causes the computer, 73, to compute formula-and-item-of-this-transmission information of:

$$Y = 1000.00 + 132.2362 + (2.0882 * X)$$

The set generated at said second station is the "program instruction set of Q.2".)

One difference between example #9 and example #10, which is based on the preprogrammed schedule information, is that the generate-set-information message (#10) causes the generated program instruction set and data module set information to be recorded at non-volatile, disk memory.)

Shortly before commencing to transmit the television programming of Unit Q, said programming originating studio transmits a second SPAM message called the "load-set-information message (#10). Said message causes computer, 73, to load PROGRAM.EXE and DATA_OF.ITS at program-set-to-transmit and data-set-to-transmit RAM memories of computer, 73.

Then said program originating studio starts to transmit the conventional television programming of unit Q.

After an interval said studio embeds and transmits a SPAM message addressed to ITS computers, 73, called the "transmit-data-module-set message (#10)". Receiving said transmit-data-module-set message (#10) causes computer, 73, to generate a first outbound SPAM message that includes the data file, DATA_OF.ITS, at its data-set-to-transmit RAM memory; and to cause said message to be transmitted to its field distribution system, 93. The first outbound SPAM message is called "data-module-set message (#10)". At the station of Fig 6, computer, 73, selects the meter-monitor segment of said transmit-data-module-set message (#10); adds information that identifies the station of Fig. 6 and the time of transmission; modifies the meter-monitor format field information to reflect said added information; and retains the received, added, and modified meter-monitor information. Then said computer, 73, selects and transmits to generator, 82, a "01" header; a particular SPAM execution segment that is addressed to URS microcomputers, 205; said retained meter-monitor information; any required padding bits; complete information of the data file at the data-set-to-transmit RAM memory which is said file, DATA_OF.ITS and is said data module set of Q.1; and information of a SPAM end of file signal.

Receiving the data-module-set message (#10) causes generator, 82, to embed said information in the normal transmission location of the programming of Q being transmitted via said generator, 82, to field distribution system, 93, thereby transmitting the data-module-set-message (#10) to said system, 93.

Then said program originating studio transmits a SPAM message that is addressed to ITS computers, 73, and that contains execution and meter-monitor segments. (Said message is called the "transmit-and-execute-program-instruction-set message (#10)".)

Receiving said message causes each of said computers, 73, to generate a second outbound SPAM message that includes information of the program instruction set at its program-set-to-transmit RAM memory and to cause said message to be transmitted to its field distribution system, 93. (Hereinafter, the outbound SPAM message is the "program-instruction-set-message (#10)." The station of Fig. 6 transmits the program instruction set of Q.1 and a second intermediate station transmits the program instruction set of Q.2.)

Example #10 is discussed more fully below.

So far this disclosure has described an intermediate transmission station transmitting television. The station could process and transmit radio programming in the same fashions. Likewise, the station could transmit broadcast print and data communications. Intermediate transmission station apparatus can include signal processing regulating system apparatus as in Fig. 4 by means of which transmissions are decrypted and metered, apparatus that encrypt programming transmissions selectively and monitoring system apparatus in the spirit of Fig. 5.

AUTOMATING ULTIMATE RECEIVER STATIONS

Signal processing apparatus automate ultimate receiver stations. Fig. 7 exemplifies one embodiment of an ultimate receiver station; is in field distribution system, 93, of of Fig. 6; and may be a home, office, theater, hotel, or any other station where programming is displayed.

Fig. 7 shows apparatus for inputting programming (including SPAM information) selectively; intermediate apparatus for processing and/or recording selectively; output apparatus for displaying programming selectively; other controlled apparatus; and other meter apparatus. Input apparatus include satellite earth station, 250, satellite receiver circuitry, 251, converter boxes, 201 and 222, antennas, 298 and 299, and other input apparatus, 252 (for example, a laser disc player). Said apparatus input their information to matrix switch, 258, which is a conventional matrix switch. Intermediate apparatus include microcomputer, 205, television recorder/player, 217, audio recorder/player, 255, computer memory unit, 256 (for example, a fixed disk), decryptor, 224, decryptor, 231, signal stripper, 229, signal generator, 230, and other intermediate apparatus, 257, for example, amplifier apparatus. In addition, the tuner of TV set, 202--that is, TV tuner, 215--(which is not distinguished from monitor, 202M, in Fig. 7), and the tuner/amplifier of radio, 209--that is, radio tuner & amplifier, 213--(which is not distinguished from radio, 209, in Fig. 7), are also intermediate apparatus. All intermediate apparatus receive their programming inputs from and transmit their programming outputs to matrix switch, 258. Output apparatus include, TV monitor apparatus of TV set, 202, printer, 221, speaker system, 263, and one or more other output systems, 261. All output apparatus receive their programming input from matrix switch, 258. Other controlled apparatus include electronically actuated window opening and closing means, 208, furnace, 206, air conditioning system, 207, and other controlled apparatus, 260. Other meter apparatus include an electronically actuated utilities meter, 262.

One or more SPAM decoders exist at each apparatus controlled by SPAM message information. Appropriate decoders exist at microcomputer, 205, at recorder/players, 217 and 255, (which can operate in fashions of the station of Fig. 6) at radio, 209, and TV set, 202, (which radio and TV set can be actuated, tuned, and controlled in other functions) and at computer memory unit, 256, other intermediate apparatus, 257, printer, 221, speaker system, 263, and other output means, 261. (For simplicity, Fig. 7 does not distinguish said decoders.)

Two matrix switches, 258 and 259, communicate programming and SPAM message/control information transmissions among station apparatus. Switch, 258, is a conventional matrix switch with capacity for switching television, radio, and other electronically transmitted programming. Matrix switch, 259, is a digital matrix switch with capacity for switching binary information transmissions. By means of matrix switch, 259, all apparatus communicate control information and SPAM messages that have been detected in programming transmissions.

For communicating switch request information to the controller, 20, of signal processor, 200, said decoders have separate control information bus means (not shown in Fig. 7). A processor, 20A, that is located at controller, 20 separate from the CPU and controlled by said CPU controls communications of said bus means.

Signal processor, 200, is the basic SPAM control apparatus of the station. Signal processor, 200, communicates control information directly with decryptors, 224 and 231, signal stripper, 229, signal generator, 230, microcomputer, 205, and matrix switch, 259. Via matrix switch, 259, signal processor, 200, has means for communicating control information individually to all controlled apparatus. The aforementioned SPAM decoders have capacity for communicating with each other by means of matrix switch, 259. Signal processor, 200, controls matrix switches, 258 and 259.

Microcomputer, 205, controls apparatus of the station in accordance with preprogrammed instructions of the subscriber. Microcomputer, 205, has capacity to communicate control information (under control of signal processor, 200) with selected apparatus by means of matrix switch, 259.

(This is a representative group of equipment; many other apparatus could be included in Fig. 7.)

## MORE REGARDING THE PREFERRED CONTROLLER OF A SPAM DECODER

The controller, 39, 44, or 47, of a SPAM decoder has capacity for communicating information from the matrix switch, 39I, to matrix switch, 259, and for receiving information from matrix switch, 259, at the decryptor, 39K, buffer, 39G, and control processor, 39J. Said control processor, 39J, has capacity to communicate switch request information to signal processor, 200, via the aforementioned control information bus means and has SPAM-switch-connection register memory.

## COORDINATING A SIMULCAST

Fig. 7B illustrates control of a stereo simulcast.

Turning on or changing a channel at a receiver causes apparatus at said receiver to transmit an interrupt signal of new-channel information and input said signal to the control processor of the decoder associated with said receiver [which said apparatus has means to input].

A subscriber decides to watch a television program which is stereo simulcast on a radio station. Switching power on and tuning causes tuner, 215, to input an interrupt signal of new-channel information to control processor, 39J, of decoder, 203. Said signal causes said processor, 39J, to cause all apparatus of decoder, 203, to delete received SPAM information (thereby discarding any end of file signal information); to cause EOFS valve, 39F, to commence processing for an end of file signal; and to cause decoder, 203, to commence receiving television. In due course, the program originating studio embeds an end of file signal.

Periodically said studio embeds and transmits a Tune-Radio-to-FM-104.1 message that consists of a "01" header, an execution segment of particular activate-simulcast information that is addressed to URS radio decoders, 210, a meter-monitor segment that contains the "program unit identification code" information of said particular television program, an information segment that contains particular 104.1-MHz information, and an end of file signal.

Receiving said message causes controller, 39, to transfer said message to the radio decoder, 210, of radio, 209. Controller, 39, compares preprogrammed to-210 information to the information at its SPAM switch-connection register memory. Not resulting in a match causes controller, 39, to input a switch-203-to-210 instruction to control processor, 20A, via the control information bus means. Said instruction causes control processor, 20A, to establish a transmission link between the controller, 39, of decoder, 203, and the controller, 44, of decoder, 210. Control processor, 20A, causes matrix switch, 259, to switch and to transfer a to-210 instruction to controller, 39. Receiving said instruction causes controller, 39, to place to-210 information at said SPAM-switch-connection memory then to transfer said message to the controller, 44, of said decoder, 210.

Said message causes said controller, 44, switch power on to and tune radio, 209, to the frequency, 104.1 MHz.

Because the station of Fig. 7 (and Fig. 7B) is preprogrammed to collect monitor information, said message also causes transmission of monitor information to signal processor, 200. Decoder, 203, transfers via bus means a first information transmission of the execution and meter-monitor information of said message with first source mark information that identifies TV set, 202. Decoder, 210, transfers a second information transmission of the execution and meter-monitor information of said message with source mark information identifying radio, 209. Said first transmission causes onboard controller, 14A, to initiate a first signal record, associated with source mark information of TV set, 202, that is based on the program unit identification code. Said second transmission causes onboard controller, 14A, to initiate a second signal record, associated with source mark information of radio, 209, based on said program unit identification code. In a predetermined fashion onboard controller, 14A, determines that TV set, 202/decoder, 203, is the principal source of information associated with said "code"; retains information in said second record that identifies said second record as a secondary record of said first record; and retains information at said first signal record that identifies radio, 209/decoder, 210, as a secondary source. In so doing, onboard controller, 14A, consolidates signal record information of transmissions that contain different source mark information but common program unit identification information.

Switching power on to said radio, 209, and tuning radio, 209, causes decoder, 210, to commence processing SPAM message information in of said frequency. Radio, 209, inputs an interrupt signal of new-frequency-input information to the control processor, 44J, of the controller, 44, of radio decoder, 210 (which does not include radio receiver circuitry, 41, because the input is the transmission received by the circuitry of radio, 209.)

The program originating studio that originates the transmission of said frequency periodically embeds and transmits an Activate-Stereo-Output SPAM message that consists of a "01" header, an execution segment of activate-speakers information that is addressed to URS signal processors, 200, a meter-monitor segment that contains secondary program unit identification code information of the audio program unit of said radio transmission and primary program unit identification code information of said television program, an information segment that contains information of television channel 13 and radio frequency 104.1 MHz, and an end of file signal. Control processor, 20A, establishes a control information transmission link between said controller, 44, and said controller, 20. Said message causes controller, 20, to determine that certain preconditions are met--more precisely, that TV set, 202, and radio, 209, are tuned, respectively, to the television channel and radio frequency of the stereo simulcast. Automatically, controller, 20, executes station-specific-simulcast instructions.

Station-specific-simulcast instructions reflect the particular fashion in which the subscriber of any given station wishes to have audio of stereo simulcasts outputted at his station, and preprogrammed station-specific-simulcast instructions vary from subscriber station to subscriber station. The station-specific-simulcast instructions of the station of Figs. 7 and 7C cause said station to emit the audio of said transmission in a particular fashion. TV set, 202, and of radio, 209, cease emitting sound. Matrix switch, 258, switches to input from radio, 209, to speaker system, 263. Controller, 20, causes speaker system, 263, to switch power on and commence operating. (At other stations, certain preconditions may not be satisfied--for example, the TV set, 202, may be tuned to a channel other than channel 13. Said stations would not execute station-specific-simulcast instructions. At stations where station-specific-simulcast instructions are executed, the instructions vary and cause different functioning at different stations. For example, balance and volume can vary from station to station.)

Automatically, monitor information is collected at signal processor, 200, that reflects the operation of speaker system, 263. Onboard controller, 14A, initiates a third signal record, associated with source mark information of speaker system, 263, and consolidates signal record information of three different monitor information transmissions that contain different source mark information but common program unit identification information.

RECEIVING SELECTED PROGRAMMING

Fig. 7C illustrates monitoring multiple channels and receiving selected programming. The station is preprogrammed to hold records of stocks and receive news about said stocks. At control processor, 39J, of decoder, 30, with news-of-interest information that includes "T".

Remote stations broadcast print transmissions. Remote service-A station transmits an AT&T news item in a message that contains subject matter information of "T". Receiving said message causes the station of Fig. 6 to transmit a number of times on digital data channel A a Select-AT&T message then to transmit an AT&T-News message. Said Select-AT&T message contains "T". Said AT&T-News message contains said AT&T news item.

Signal processor, 200, scans all channels in the fashion of example #5. In due course, one Select-AT&T message is detected at decoder, 30, and inputted to the controller, 39. Receiving said message causes controller, 39, to transmit said message to the controller, 20, of signal processor, 200, with channel mark information. Receiving said message causes controller, 20, to cause converter box, 222, to receive the transmission identified by said channel mark; to cause All signal decoder, 290, (which is identical to the TV signal decoder of Fig. 2A with added capacity of the radio signal decoder of Fig. 2B plus the other signal decoder of Fig. 2C) to commence processing detected SPAM information; and to establish a transmission link between box, 222, and decoder, 290.

In due course, said AT&T-News message is transmitted on channel A and input to controller, 39, of decoder, 290. Receiving said message causes controller, 39, to cause microcomputer, 205, to process said message. Automatically, controller, 39, executes the instructions of a particular preprogrammed controlled function and inputs to an input buffer of microcomputer, 205, said AT&T news item. Microcomputer, 205, causes controller, 20, to switch the input from microcomputer, 205, to printer, 221, and causes printer, 221, to print said AT&T news item.

MORE ON EXAMPLE #7 ... COMBINING TO THE COMPUTER SYSTEM SELECTED

In the present invention, the computer information of any given combined medium combining is processed by a computer system that consists of a plurality of computers, each at a subscriber station, all processing in parallel under control of one input at a program originating studio. The present invention includes capacity whereby a program originating studio can cause selected computers to combine to the computer system of said studio.

Microcomputers, 205, of a plurality of subscriber stations are preprogrammed with program-of-interest information and station-specific-selection-and-display instructions. Said program-of-interest information includes information of television programs that subscribers wish to view. Some are combined medium programs. Said station-specific-selection-and-display instructions reflect the specific fashion in which any selected program is to be selected and displayed.

The program-of-interest information at microcomputer, 205, of the station of Figs. 7 and 7C includes specific-WSW information that reflects the wish of the subscriber to view "Wall Street Week". The station-specific-selection-and-display instructions include information that said subscriber will pay up to twenty-five cents to receive said program and that, if the TV set, 202, is switched off when said program is detected, power should be switched on to said TV set, 202, and said program should be displayed at monitor, 202M, and, in addition, said program should be recorded at said recorder/player, 217.

The computer, 73, of each intermediate station is preprogrammed with schedule information that reflects the time and channel on which said station will retransmit "Wall Street Week". The information of computer, 73, of the station Fig. 6 is CC13 and particular-8:30. (Another computer, 73, is preprogrammed with CC11 and particular-9:30.)

The program originating studio transmits a Prepare-To-Retransmit message of information segment instructions that include generally applicable enable-WSW-on-XXXX-at-YYYYYYYYYYYYYYY information and specific-WSW information, timing instructions and encrypt-audio instructions.

Receiving said message causes the station of Fig. 6 to input the information segment to computer, 73, and execute the input. (Other stations function similarly.) Said instructions cause said computer, 73, to generate enable-WSW-on-CC13-at-particular-8:30 information and a Select-WSW-Program SPAM message and retain said message at memory. Computer, 73, generates said information by replacing variables, XXXX and YYYYYYYYYYYYYYY, in said enable-WSW-on-XXXX-at-YYYYYYYYYYYYYYY information with said CC13 and said particular-8:30 information. (Said instructions cause said another, 73, to generate enable-WSW-on-CC11-at-particular-9:30 information.) Said instructions cause computer, 73, to generate a Specific-WSW-Enabling-message, which is the aforementioned local-enabling-message (#7), and to retain said message at memory.

Said timing instructions cause each intermediate station to commence transmitting its Select-WSW-Program message at a specific time; execute said encrypt-audio instructions at a particular time; and transmit its Specific-WSW-Enabling-message after a particular enabling time. In due course, said timing instructions cause computer, 73, to commence transmitting its Select-WSW-Program message in the normal transmission location of cable channel 13. Subsequently said instructions cause computer, 73, to receive the transmission of the program originating studio of "Wall Street Week"; input said transmission, via matrix switch, 75, to apparatus that encrypt the audio portion of said transmission; cause said apparatus to encrypt; and transfer the output of said apparatus, via matrix switch, 75, to field distribution system, 93, via the modulator, 82, 86, or 90, of cable channel 13.

Signal processor, 200, of the station of Fig. 7 and 7C detects one Select-WSW-Program message. Receiving said message causes signal processor, 200, to input said message to microcomputer, 205. Said message causes microcomputer, 205, to input said enable-WSW-on-CC13-at-particular-8:30 information to the controller, 20, of signal processor, 200.

Then said timing instructions cause said computer, 73, to transmit said local-enabling-message (#7).

Receiving said local-enabling-message (#7) at the station of Fig. 7 causes said station to function in the fashion of example #7.

(Simultaneously, other subscriber stations [i.e., ultimate receiver stations] of field distribution systems, 93, of other intermediate transmission stations, each receive the station specific SPAM messages of their specific intermediate stations, tune to an intermediate station specific channel [eg. cable channel 11 rather than 13] in an intermediate station specific fashion [eg. by decrypting with cipher key Ta rather than Ca] and even at an intermediate station specific time [eg. at 9:30 PM rather than 8:30 PM] to receive "Wall Street Week", sample selected subscriber station specific SPAM information in their subscriber station specific fashions, determine whether unauthorized tampering has occurred, and respond station specifically in fashions described above.)

Up to a point, the station of Fig. 7 functions just as the station of Fig. 4 in example #7 to function. Said point occurs after controller, 20, executes the additional 2nd-stage-enable-WSW-program instructions which, at the station of Fig. 4, cause apparatus to commence transferring decrypted television "Wall Street Week" to microcomputer, 205, and monitor, 202M.

At the station of Fig. 4, the television output of the PC MicroKey System of microcomputer, 205, is inputted directly to TV monitor, 202M. By contrast, at the station of Fig. 7, the television output of microcomputer, 205, is inputted to matrix switch, 258. Furthermore, the station of Fig. 7 is preprogrammed with the aforementioned stationspecific-selection-and-display instructions.

At the station of Fig. 7, said additional 2nd-stage-enable-WSW-program instructions causes controller, 20, to cause said station to determine that monitor, 202M, is not on and operating. Decoder, 145, responds by transmitting 202M-is-not-on information to controller, 20. Said 202M-is-not-on information causes controller, 20, under control of said additional 2nd-stage-enable-WSW-program instructions, to cause microcomputer, 205, to process the station-specific-selection-and-display instructions. Microcomputer, 205, inputs to controller, 20, preprogrammed display-at-202M-and-record-at-217 instructions. Said instructions cause controller, 20, to instruct decoder, 145, to switch power on to monitor, 202M, and tune monitor, 202M, cause matrix switch, 258, to transfer decrypted audio from decryptor, 107, to monitor, 202M, and also to recorder/player, 217, cause matrix switch, 258, to transfer video from microcomputer, 205, to monitor, 202M, and also to recorder/player, 217, cause control processor, 20A, to establish a control information communications link, via matrix switch, 259, with TV signal decoder, 218, at recorder/player, 217, that controls recorder/player, 217, and cause said decoder, 218, to switch power on to recorder/player, 217, and cause recorder/player, 217, to record the inputted audio and video.

CONTROLLING COMPUTER-BASED COMBINED MEDIA

The process of controlling computer-based combined media is continuous and involves systematic inputting and maintaining of up-to-date user data at each subscriber station. For example, only at subscriber stations where stock data is up-to-date can the first message of "Wall Street Week" generate Fig. 1A images that actually show the performance of portfolios of subscribers.

The present invention provides means and methods for inputting and maintaining data at subscriber stations. Microcomputer, 205, has an installed modem; receives information transmitted by means of telephone or data network, 262; and is preprogrammed to process data received via said network, 262. Each time the stockbroker who represents the subscriber buys or sells stocks for said subscriber, a computer at said broker's station telephones microcomputer, 205; inputs data of the transaction; and causes microcomputer, 205, to update its portfolio records. Each weekday a remote stock-data station transmits all closing stock price data applicable that day and causes each subscriber station to select and record at the microcomputer, 205, of said station the closing price datum or data that apply to the stock or stocks of the portfolio of said computer. (Said remote station transmits said closing stock price data and causes specific subscriber stations to select and process their specific information of interest in the fashion in which remote news-service-A station transmitted the AT&T news item and caused selected stations to select and process said item.) Alternatively, microcomputer, 205, is caused in a predetermined fashion automatically to telephone a remote data service computer, by means of network, 262, and cause said remote computer to select and transmit the particular closing price datum or data of the stock or stocks of the portfolio of said microcomputer, 205, thereby causing said microcomputer, 205, to record said datum or data. By 8:00 PM, microcomputer, 205, (and microcomputers, 205, at other stations) has been updated.

Subsequently, the combining process described in "One Combined Medium" and example #4 commences.

The combining of Fig. 1C is part of a larger process. Computer operations take time and some computers are slower than others. For example, it takes longer to calculate the value of a portfolio containing one thousand stocks than a portfolio of one. Furthermore, it is undesireable to separate computer operations merely because they result in the generation of separate overlays because such separation may result in unnecessaty duplication of calculations. In the preferred embodiment, unlike conventional television where information is presented strictly in the sequence of its transmission, the transmission and execution of program instruction set information for second (or subsequent) overlays can precede the transmission of the combining synch command of first overlays and the time of first overlay ceasings. To minimize waiting time, the controllers, 39, of decoders, 203, (or controllers, 44 or 47) combining synch commands that cause combining or the ceasing of combining (as, for example, the commands of the second and third messages of the "Wall Street Week" examples) are processed as interrupts to the CPUs of microcomputers, 205; program instruction sets, once executed, instruct microcomputers, 205, to wait only when further processing, under the control of the instructions of said sets, would entail overwriting RAM information whose overlay time or processing time has not yet ended. To prevent microcomputers, 205, that fall behind from displaying incomplete overlays, any SPAM message that causes a combining specifies the identity of the overlay whose combining it causes and causes combining only at subscriber station where information exists of completion of the overlay. For example, the second message of "Wall Street Week" causes combining only at stations where information at SPAM-first-precondition and SPAM-second-precondition memories matches selected information of the meter-monitor segment of said message.

Finally, in the preferred embodiment, to restore efficient operations, microcomputers, 205, that fall behind are caused to jump over and avoid executing instructions that control the generating of overlay information (such as Fig. 1A) whose combining time has passed. In the "Wall Street Week" example, the second message causes the decoder, 203, at each subscriber station to compare SPAM-second-precondition register memory to the "00000001" of the overlay number field of said message. At stations that have not completed generating at RAM the first overlay (e.g., Fig. 1A), matches do not result, causing the controllers, 39, of the decoders, 203, of said stations to execute second-condition-test-failed instructions of the conditional-overlay-at-205 instructions. Said second-condition-test-failed instructions cause each controller, 39, to compute an overlay-target number; interrupt the CPU of the microcomputer, 205, of its station; cause said CPU to execute a machine language jump to the offset address of said program instruction set that is associated with said overlay-target number; and to cause said microcomputer, 205, to continue executing the instructions of said set from the instruction at said address. In so doing, said microcomputer, 205, skips over instructions whose overlay time has passed.

The particular overlay-target number that any given controller, 39, calculates is a function of the overlay number information of the SPAM message that invokes said conditional-overlay-at-205 instructions and also of the history of the efficiency of operation of the microcomputer, 205, of the subscriber station of said controller, 39. Particular history-of-efficiency memory exists at each controller, 39, of a decoder, 203. When said second message causes execution of said second-condition-test-failed instructions, said instructions cause said controllers, 39, to increment by one the information at said history-of-efficiency memory, thereby generating history-of-efficiency information which indicates that its associated microcomputer, 205, has failed to generate one overlay, under control of said set. Thereafter, whenever a SPAM message of "Wall Street Week" causes one of said controllers, 39, to execute said second-condition-test-failed instructions, said instructions cause said controller, 39, to compute its overlay-target number by incrementing the overlay number information of said message by more than one and to cause the microcomputer, 205, of its station to restore efficiency by skipping over instructions that cause the generation of more than one overlay (including one or more overlays whose overlay time has not yet come).

Thus a SPAM message that invokes said conditional-overlay-at-205 instructions causes selected stations to combine locally generated overlay information (e.g., Fig. 1A) with transmitted information (e.g., Fig. 1B) and to display combined medium information (e.g., Fig. 1C) and causes selected other stations to generate information of overlays whose combining is not caused by said message (because the overlay times of said overlays is subsequent to the time of said message). Furthermore, said message causes said other stations to generate overlays in such a way that each station generates an overlay that has a specific overlay time and the overlay times vary from station to station.

AUDIO AND OTHER OVERLAYS

Fig. 7D illustrates a radio/computer combined medium. Tuner, 209T, receives a conventional radio transmission. Divider, 209D, splits the received transmission into two paths and transmits one to microcomputer, 205, and the other to radio decoder, 211. Decoder, 211, detects and inputs selected information to microcomputer, 205. Microcomputer, 205, has capacity to receive an audio transmission, generate and enter into audio RAM, combine audio overlay programming, and transmit the combined audio to speaker system, 263. An example illustrates operation. A radio station transmits radio programming and embeds a SPAM message that causes microcomputer, 205, to record digital audio of statements prerecorded--"And your portfolio went up" and "But the value of your portfolio went down". The radio transmission conveys the announcer saying, "Stock prices rose today in heavy trading." Then said radio station transmits silent audio and embeds a SPAM command that causes microcomputer, 205, to generate and transmit audio to speaker system, 263. System, 263, emits sound of "But your portfolio went down."

A broadcast print and computer combined medium subscriber station operates and is configured similarly to Fig. 7D. Said station has receiver apparatus analogous to radio, 209T; appropriate decoder apparatus that may consist of the decoder of Fig. 2C; a microcomputer, 205; and a printer, 221. Said decoder detects digital information and inputs to the CPU of microcomputer, 205, and to a buffer at microcomputer, 205, that is an input buffer to said printer, 221. A SPAM message causes microcomputer, 205, to compute a value, determine said value is greater, and transfer to said printer, 221, selected print. For example:

Stock prices rose today in heavy trading, and your portfolio went up.

Fig. 7E shows the full combined medium of television and computers. To the apparatus of Fig. 1, a divider, 202D, is added in the audio transmission path which splits the transmission into two paths and transmits one to the appropriate audio processing apparatus of TV decoder, 203, and the other to microcomputer, 205, at apparatus that has capacity for combining computer audio into the transmitted audio and that inputs its audio information to monitor, 202M. Microcomputer, 205, has audio RAM and audio synthesizing and combining capacities.

EXAMPLE #10 CONTINUED

Microcomputer, 205, of the station of Fig. 7 and 7F holds records of the family of the subscriber. For example, information in a file named DATA_OF.URS on a disk at the A: drive specifies that said family prefers hot and spicy foods, prefers to minimize salt and consists of four adults. (Microcomputer, 205, at the station of a second subscriber holds information in DATA_OF.URS at its A: drive which specifies mild foods, indifferent regarding salt and two adults. Microcomputer, 205, of a third subscriber holds moderate foods, indifferent regarding salt, and two adults and three children.)

The program originating studio transmits a conventional television program called "Exotic Meals of India." Said transmission is received at the intermediate station of Fig. 6 and at the aforementioned second intermediate station and retransmitted. The program is devoted to cooking fish curry. The host says, "If you want a copy of the recipe tailored to your tastes for 10 cents, enter TV567#".

Each subscriber enters TV567# at the local input, 225, of his station which causes said input, 225, to transmit said TV567# information to the signal processor, 200, of said station.

Later said studio transmits a message of check-entered-information instructions. Receiving said message causes controller, 20, to determine that TV567# information exists at memory, cause particular information to be placed at control-function-invoking information memory and initiate a signal record of meter information which contains TV567# information. Said studio embeds and transmits a second message of generate-recipe-and-list instructions. Said message is detected at decoder, 145, and transferred to controller, 39, of decoder, 203. Said instructions cause microcomputer, 205, to generate the fish curry recipe and shopping list of the subscriber, cause said recipe and list to be printed at printer, 221, and retain information of said list at memory. Microcomputer, 205, determines that one ingredient is "Patak's low-salt Vindaloo Curry Paste". (Stations where TV567# information was not entered discard said message.)

Causing said instructions to be embedded enables any subscriber who records said programming at a recorder/player, 217, to access said instructions whenever the recorded programming is played back--and in so doing, to cause the signal processor, 200, of his station to process meter-monitor information anew whenever TV567# is entered at a local input, 225, in the course of play back.

(An alternate method is to embed said message in a second transmission and cause a selected All signal decoder, 290, at each of said stations to receive said second transmission, thereby causing said decoder, 290, to detect and transfer said second message to the microcomputer, 205. This method has the advantage of making the instructions relatively invulnerable to programming pirates.)

(Whichever method is employed said second message can be encrypted and decrypted in any of the methods described above.)

Said studio ceases transmitting "Exotic Meals of India" for a commercial and commences transmitting program unit Q. Immediately said studio transmits said align-URS-microcomputers-205 message (#10), embedded in Q. Said message causes controller, 20, to combine microcomputer, 205, to the computer system of said studio. Controller, 20, causes matrix switch, 258, to connect apparatus in the fashion of Fig. 7E. After an interval sufficient to allow each subscriber station so to combine, said studio transmits said synch-SPAM-reception message (#10). Said message causes decoder, 203, to detect an end of file signal and commence processing messages embedded in Q. Said studio transmits said control-invoking message (#10). Said message causes microcomputer, 205, to come under control of said studio. (The stations of said second subscriber and third subscriber come under control of said studio.)

Said studio causes each intermediate station to transmit its data-module-set message. Receiving the data-module-set message of its intermediate station causes each ultimate receiver station to record information in said message in a file named "DATA_OF.ITS".

Said studio causes each intermediate station to transmit its specific program-instruction-set message (#10). Receiving the program-instruction-set message of its intermediate transmission station causes each ultimate receiver station to record PROGRAM.EXE information at RAM and execute the information. At the station of Figs. 7 and 7F, receiving the program-instruction-set message (#10) transmitted by the intermediate transmission station of Fig. 6 causes decoder, 203, to load and execute at microcomputer, 205, the information segment of said message (which is the program instruction set of Q.1). (The station of said second subscriber executes said set of Q.1. The station of said third subscriber executes the program instruction set of Q.2.)

Under control of said set of Q.1, microcomputer, 205, generates of a first video overlay and subsequent overlays. Microcomputer, 205, accesses A:DATA_OF.URS and locates the address of the subscriber and accesses D:DATA_OF.ITS and locates the address of each market in the locality. Microcomputer, 205, computes and determines which market is closest, that the distance between said station and said market is 4.3 miles, and that said station is southwest of said market. Microcomputer, 205, stores southwest information at memory then substitutes 4.3 for X in the equation:

$$Y = 1000.00 + 62.21875 + (2.117 * X)$$

computes Y to be 1071.32; clears video RAM; causes the background of video RAM to be a color that is transparent when combined; causes "$1,071.32" to be placed at bit locations of video RAM. (Microcomputer, 205, of said second subscriber determines distance is 8.7, computes the Y to be 1080.64, and causes "$1,080.64" to be placed at video RAM. Microcomputer, 205, of said third subscriber substitutes 3.2 for X in its received equation:

$$Y = 1000.00 + 132.2362 + (2.0882 * X)$$

computes Y to be 1138.92 and causes "$1,138.92" to be placed at video RAM.) Microcomputer, 205, computes the amount that the subscriber will save to be 915.93, clears audio RAM, selects audio information of "forty-six" from D: DATA_OF.ITS and places said information at audio RAM.

The programming of Q conveys a picture of a person and audio of an announcer saying,

"Discount Supermarkets will deliver to you, at cost, all the pork you need for this low price ... "

Said studio transmits the 1st commence-outputting message (#10). Said message causes each subscriber station that has completed generation of first overlay information at video RAM to display combined information. "$1,071.32" is displayed at monitor, 202M. (At the station of said second subscriber "$1,080.64" is displayed. At the station of said third subscriber, "$1,138.92" is displayed.)

Said studio transmits audio of:

"This offer represents a saving to you of over."

Said studio transmits the 2nd commence-outputting message (#10) that causes each subscriber station that has completed generation of first audio to emit its audio. The subscriber can hear:

"forty-six".

(Simultaneously, said second subscriber can hear:

"forty-five".

And:

"forty-three"

is what said third subscriber can hear.)

After an interval long enough for each station to emit its audio, said studio transmits audio of;

"percent."

Receiving said 2nd commence-outputting message (#10) causes each subscriber station immediately after so transmitting one instance of its specific information at audio RAM, to continue executing instructions of its specific program instruction set at the next instruction. Automatically, each subscriber station clears audio RAM, selects information of second audio and places said information at audio RAM.

Meanwhile, said studio transmits audio of:

"To confirm this offer, we are printing at your printer ... "

Said studio transmits a message that causes each subscriber station to commence printing. At printer, 221, hard copy emerges as:

```
Discount Supermarkets offers to deliver at cost
one unit of pork to:

                111 First St.
                Anytown, Masachusetts
```

in exchange for this coupon and:

$1,071.32

15 cents off 15 cents off

Nabisco Zweiback Teething Toast

(At the station of said second subscriber, hard copy emerges as:

Discount Supermarkets offers to deliver at cost one unit of pork to:

222 Second St.
Anytown, Massachusetts

in exchange for this coupon and:

$1,080.64

And at the station of said third subscriber:

```
Discount Supermarkets offers to deliver at cost
one unit of pork to:



                333 Third St.
            Anothertown, Florida

       in exchange for this coupon and:

                 $1,138.92
```

emerges.)

Said studio transmits the 1st cease-outputting message (#10). Said message is identical to the third message of "Wall Street Week" and causes each subscriber station to cease combining and display only transmitted video at its monitor, 202M, then to prepare to combine a second video overlay. Said message causes decoder, 203, after executing "GRAPHICS OFF", to input the aforementioned clear-and-continue instruction to the CPU of microcomputer, 205, as an interrupt signal. Said instruction causes microcomputer, 205, to execute a when-interrupted portion of said program instruction set of Q. Microcomputer, 205, ceases generating and transmitting print, having just outputted "and the sum of:". (Microcomputer, 205, of said second subscriber ceases, having just outputted "222 Second St." Microcomputer, 205, of said third subscriber ceases, having just outputted "$1,139.92".) Microcomputer, 205, jumps to a first address of said set of Q.1 and executes first-clear-and-continue instructions. Microcomputer, 205, clears video RAM; sets the background color to transparent overlay black; determines that it holds southwest information; selects from D: DATA_OF.ITS the southwest delivery telephone number, "456-1414", and causes information of said number to be placed at bit locations that produce video image information in the lower middle of a video screen. Then said instructions cause microcomputer, 205, to resume generating and transmitting said print output. (The fact that the output is print is incidental. Said message could cause each subscriber station to stop then resume generating and outputting data, computer program instructions, audio and/or video.

Said studio commences transmitting video of said person and audio of said announcer saying:

"Tonight your recipe and shopping list call for Patak's"

Then said studio embeds and transmits a message that causes each subscriber station that has completed generation of second audio at audio RAM to emit its audio. The subscriber can hear:

"low-salt Vindaloo".

(Said second subscriber can hear

"Mild version Quick".

And at the station of said third subscriber, emission of

"Hot version Quick"

is caused.)

(The program instruction sets do not clear audio RAM.)

After an interval, said studio transmits audio of:

"Curry Paste. Your local Discount Supermarket has a complete line of Patak's products. Call the telephone number,"

Said studio transmits a message that causes each subscriber station that has completed generation of second overlay information at video RAM to cause its monitor, 202M, to display combined video. Decoder, 203, executes "GRAPHICS ON." "456-1414" is displayed in the lower middle screen of monitor, 202M. Apparatus of said second subscriber causes "224-3121" to be displayed. At the station of said third subscriber "623-3000" is displayed.)

Said studio transmits audio of,

"on your screen to have your order delivered. Or enter on your Local Input the information that you see,"

Said studio transmits video of "TV568*",

"your Discount manager will see that all ingredients for your recipe are delivered. Enter "TV568*" now, and your manager promises to include one jar of Patak's"

Said studio transmits a message that causes each subscriber station that has completed generation of second audio to emit its audio. Monitor, 202M, emits:

"low-salt Vindaloo".

After an interval, said studio transmits audio of:

"Curry Paste for free."

At the station of Figs. 7 and 7F, the subscriber enters TV568*. Subsequently, instructions of its specific program instruction set of Q.1 or Q.2 causes each subscriber station where where TV568* has been inputted to telephone a shopping list order. At the station of Figs. 7 and 7F, under control of said program instruction set of Q.1, microcomputer, 205, acceses said D:DATA_OF.ITS file; to select the telephone number of the supermarket in the vicinity of the intermediate transmission station of Fig. 6 which is 1-(800) 247-8700; and causes controller, 20, to establish telephone communications with a computer of said supermarket chain at a remote station. Then microcomputer, 205, transmits via controller, 20, to said computer the street address of the station of Figs. 7 and 7F and the shopping list of the subscriber of said station.

After time has elapsed said studio embeds and transmits the disband-URS-microcomputers-205 message (#10). Said message causes controller, 20, to separate microcomputer, 205, from the computer system of said studio. Said message may also cause controller, 20, to cause the microcomputer, 205, to revert from broadcast control to local control and to commence processing at the instruction at which invoking broadcast control interrupted processing.

(Except for meter-monitor information, the messages transmitted in example #9 to stations of field system, 93, are identical to the messages transmitted in example #10 and cause the same functioning.)

In examples #9 and #10 apparatus at subscriber stations of particularly slow microcomputers, 205, restores efficiency. For example, receiving said 1st commence-outputting message (#10) (or (#9)) causes at least one decoder, 203, to cause a microcomputer, 205, to jump and execute first-clear-and-continue instructions of program instruction set of Q.1 [or of Q].

PROGRAMMING RECEIVER STATION OPERATING SYSTEMS

One objective of present invention is standardization of operating systems. Another is flexibility to expand system functions.

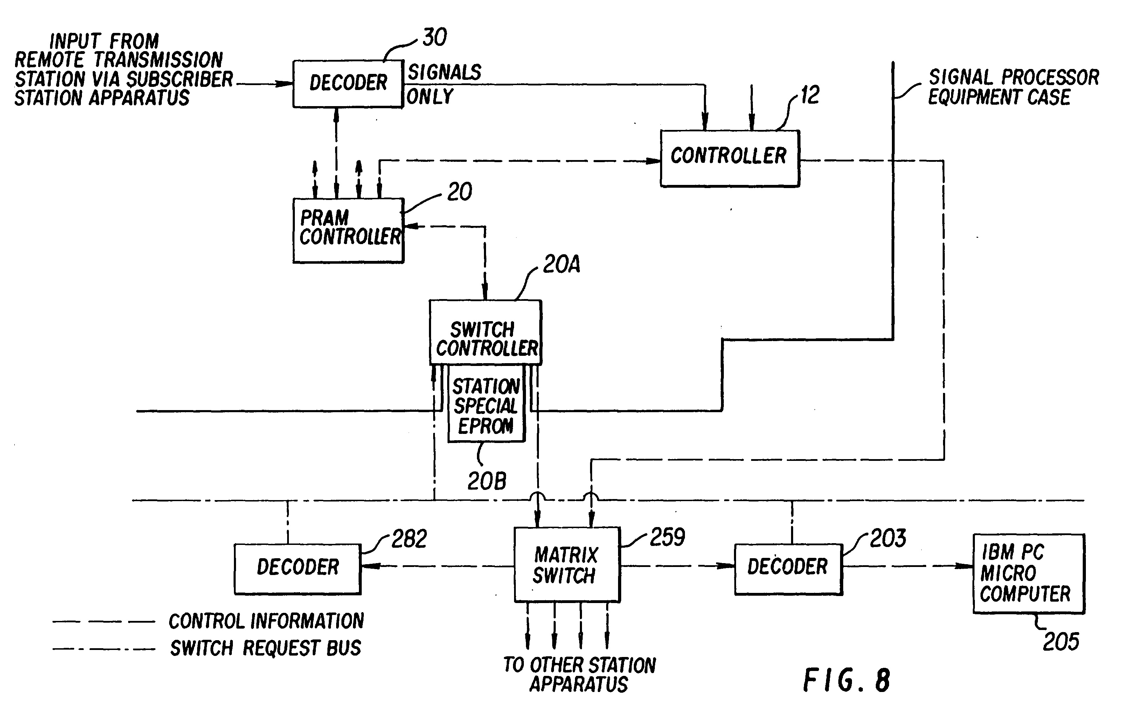

Fig. 8 illustrates the installation of non-volatile memory that identifies preprogrammable apparatus of the station of Fig. 7. Said memory is EPROM, 20B. EPROM, 20B, is reprogrammed whenever apparatus is installed or removed from the station of Figs. 7 and 8 and contains switch control instructions that identify which apparatus input to the inputs of matrix switch, 259; identify which outputs output to which station apparatus; and control switch controller, 20A. EPROM, 20B, is mounted in a cartridge and inserted manually into switch controller, 20A, at a port in the equipment case of signal processor, 200. EPROM, 20B, is also programmed with information of a master control frequency. (Similar memory is installed at each computer, 73, of an intermediate station such as Fig. 6.)

An example illustrates programming receiver station operating systems. A message causes the station of Figs. 7 and 8 to determine that the microcomputer, 205, is not an APPLE II. A second message causes the station to determine microcomputer, 205, is an IBM PC and causes decoder, 203, to cause operating system instructions of said message to be recorded on a disk at a drive of microcomputer, 205, and to cause microcomputer, 205, to boot the operating system so recorded. A third message causes the station to determine that a decoder, 203, of the #3 version exists at said station and causes decoder, 203, to record operating system instructions of said message at locations at RAM of decoder, 203, and to commence operating under control of said instructions. Following each message, for a time no SPAM information is transmitted to any apparatus of the version of the message.

THE PREFERRED SPAM HEADER

An important feature of the present invention is flexibility for expansion. In the preferred embodiment, SPAM headers identify not only alternate message compositions but also alternate versions of message composition. A SPAM header--and SPAM-header register memory of SPAM apparatus--is the length of one signal word which is one byte.

SUMMARY EXAMPLE #11

In February, 2027, farmers all over Europe decide what mix of crops to grow. Each farmer has a subscriber station identical to Fig. 7 except that each has two television recorder/players, 217 and 217A; two television tuners, 215 and 215A; and a laser disk player, 232. Information of the farm is recorded in a file named MY_FARM.DAT at the A: drive of the microcomputer, 205, of each station. At each laser disc player, 232, is a file named "PROPRIET.MOD" that contains an encrypted proprietary software module. Said module generates information of a recommended planting plan.

National planners seek to formulate policy and influence farmers' decisions. Each nation has a national intermediate transmission station identical to Fig. 6 except that it transmits via a satellite. At the computer, 73, of each national intermediate station is local-formula-and-item information. In a file named NATIONAL.AGI are proposed subsidy formulas and items regarding alternate crops. In a file named NATIONAL.TAX are proposed tax formulas regarding farm incomes and proposed depreciation schedules of farm equipment. And in a file named NATIONAL.MON are proposed money supply growth rates and interest rates.

Local planners seek to formulate local policies. Each local government has a local intermediate station identical to Fig. 6. In a file named LOCAL.TAX are proposed property taxes on land and equipment. In a file named LOCAL.EMP are proposed employment subsidy formulas.

At 3:00 AM GMT on February 15, 2027, the signal processor of each station commences receiving the master transmission of the European master station. At 3:10 AM, said station inputs operating system instructions to all SPAM apparatus and receiver station computers, 73, and microcomputers, 205. (The master control frequency at the EPROM, 20B, of each receiver station is either said master transmission or a master channel transmission of an intermediate station on which said master transmission is retransmitted.)

Automatically receiver stations commence tuning to transmissions that differ from station to station.

At 3:59 PM, said European master station commences transmitting program unit identification information of a combined medium television program, "Farm Plans of Europe." Farmers and planners all over Europe have preprogrammed their stations to receive and combine to the program. Each receiver station that is not equipped with a satellite earth station tunes to the master channel of its local intermediate station (which retransmits the master transmission).

At 3:59:45 PM, said European master station causes each local intermediate station to tune to the second television channel of its national intermediate station, causing its computer, 73, to come under control of its national station.

At 3:59:55 PM, said European master station invokes broadcast control.

At 4:00 PM, said master station commences transmitting "Farm Plans of Europe". Immediately said station causes ultimate receiver stations to obscure all video and display locally generated information and causes all computers, 73, and microcomputers, 205, to commence receiving SPAM information embedded in the full frame video. Said master station causes microcomputers, 205, to display titles. Then said station causes ultimate receiver stations each to receive and emit at its speaker system, 263, sound of a transmission of audio in the primary language of its subscriber. Next said master station transmits a message to national intermediate stations that contains a national level intermediate generation set. Said master station causes the signal processor, 200, of each ultimate receiver station to input the raster frequency of its EPROM, 20B, to its decoder, 30, continuously. (In so doing, said master station causes said master transmission to be inputted to said processor, 200, continuously irrespective of transmissions inputted to decoders, 145, 203, or 282, and prevents signal processor, 200, from identifying any other programming of interest.) Said master station transmits a first program instruction set. Then said master station causes all SPAM decoder apparatus to commence receiving SPAM information embedded in only the normal transmission location.

Said national level intermediate generation set causes national intermediate stations each to generate a local level intermediate generation set. Said national level set includes generally applicable information of national agriculture and economic policy, of local tax formulas and items and employment subsidy formulas, and of recommended crop planting plans. Said set also contains a price at which farmers are projected to be able to sell each crop. Said set causes each national intermediate station to access its NATIONAL.AGI, NATIONAL.TAX, and NATIONAL.MON files and compute specific subsidy formulas and items, tax formulas and depreciation schedules, and monetary growth and interest rates given projected farm borrowing.

After an interval, said European master station transmits a message that causes each national intermediate station to embed in its second television channel transmission and transmit a message that contains its local level intermediate generation set.

The message of its national station causes each local intermediate station to generate a program instruction set. Each local intermediate station accesses its LOCAL.TAX and LOCAL.EMP files and computes specific local property tax and employment subsidy formulas.

At 4:29:50 PM, said master station transmits a cueing message. Said message causes each national intermediate station to embed in its second television channel a message that causes each local intermediate station to play its recorder, 76, and transmit the programming on its master channel. Each local intermediate station commences transmitting a national and local segment of "Farm Plans of Europe".

At 4:29:55 PM, GMT, said European master network station embeds in its master transmission and transmits a message that causes each ultimate receiver station that receives said transmission by satellite to receive and process the combined medium programming of the master channel of its local intermediate station (of which information is preprogrammed at its EPROM, 20B).

In due course, each recorder, 76, transmits a message addressed to ITS computers, 73. Each local intermediate station detects the message of its recorder, 76, and transmits its program instruction set. Subsequently, additional messages addressed to URS microcomputers, 205, are transmitted by the recorder, 76.

Each farmer's station displays information of national and local policies combined periodically with locally generated information.

Its program instruction set causes each microcomputer, 205, to generate an optimal solution for its farmer's mix of crops problem. Each microcomputer, 205, accesses the file, MY_FARM.DAT, at its A: drive and also accesses the encrypted "PROPRIET.MOD" file that is prerecorded at laser disc player, 232. To access the "PROPRIET.MOD" file, the instructions of its particular program instruction set cause each microcomputer, 205, to decrypt and enter the decrypted information of said file at particular RAM. Each microcomputer, 205, instructs its signal processor, 200, to cause its laser disk player, 232, to play. In the fashion of example #7, each station decrypts and retains meter information of its "PROPRIET.MOD" file. Using linear programming techniques, each microcomputer, 205, computes its farmer's optimal crop planting plan by making reference to data that includes, for example, size of the farm, soil conditions, aspects of sunlight and shade, history of crop rotation, farm equipment, and financial resources and by applying information of said program instruction set. The plans include projected revenues, expenses, and profits and sensitivity analyses that are close to but not quite optimal. The microcomputer, 205, records its plan at its A: disk in a file named PLANTING.DAT.

Then automatically, under control of its program instruction set, each farmer's microcomputer, 205, computes a schedule of commercials. Information of twenty-six commercials are included in its set. Under control of its set, by analyzing the budget information of its farmer's crop planting plan, each microcomputer, 205, identifies four that are of highest potential value to its farmer. Each station inputs to signal processor, 200, schedule information of its four commercials. Then the recorder, 76, of each local intermediate station transmits a local cueing message addressed to ITS computers, 73.

In the fashion of example #10, each station displays and outputs generally applicable information of a crop planting plan combined periodically with specific information of its farmer. Automatically, the optimal plan of each farmer is explained.

Receiving its local cueing message causes each local intermediate station to embed a message addressed to URS signal processors, 200, in its master channel transmission then cause its video recorder/player, 78, to output on a second television channel. Said message causes each farmer's station to receive the second television channel of its local intermediate station and transfer the transmission to a selected video recorder/player, 217 or 217A. After an interval, each computer, 73, causes said recorder, 78, to play twenty-six commercials. The signal processor, 200, of each station causes its recorder/players, 217 and 217A, to record then organize to play the selected commercial spots of its station. Automatically, said signal processor, 200, causes a selected recorder/player, 217, or 217A, to record selected programming then, after a particular last unit is received, to organize the recorded programing to play according to its schedule previously inputted by its microcomputer, 205.

The program instruction set at each farmer's station cause a module, TELEPHON.EXE, to be recorded at the microcomputer, 205, which will permit the farmer to modify his specific plan and transmit the plan to a remote station.

A message embedded at the end of the national and local segment causes each farmer's station to separate from the master channel of its local intermediate station and interconnect to commence generating and outputting combined medium programming of a selected recorder/player, 217 or 217A. Playing each commercial spot causes combined medium information to display a product such as a truck or a software package; access "A:PLANTING.DAT"; generate an analysis of the incremental benefit of using the product or service; and display information of said analysis (if said analysis results in a positive benefit).

Studying his plan, each farmer runs TELEPHONE.EXE and modifies his file to suit his wishes. TELEPHONE.EXE causes his signal processor, 200, to transmit his file to a computer at a remote data collection station. The data is aggregated at the computer of said European master station which allows planners to refine the variables of the national intermediate generation set, especially projected prices.

At 3:59 PM, on February 18, 2027, the cycle of generating and communicating information of farmers is repeated using refined variables. In an iterative fashion, this cycle is repeated until a European master agricultural plan is achieved. In this fashion, the unified system of the present invention facilitates planning and decision making.

The foregoing Is presented by way of example only and modifications may be made without departing from the spirit of the invention. Any message and programming transmission can, through encryption/decryption and other regulating techniques, affect only selected stations and apparatus. Invoking any controlled function can also cause monitor information to be processed. Intermediate transmission stations can be equipped with control information switching and bus communications capacity such as that illustrated in Figs. 7 and 8. Any transmission station can cause its receiver stations to function in any appropriate fashion.

## Claims

**1.** A method of processing signals at a receiver station having a microcomputer (205) and an output device (202M) to deliver at the output device a combined output of a broadcast or cablecast program and a receiver specific datum, said method comprising the steps of:

(a) receiving (215) an information transmission comprising a program and one or more control signals;
(b) selecting said received broadcast or cablecast program from the information transmission and transferring it to the output device (202M) for delivery to the user;
(c) detecting (203) a specific control signal in the information transmission and passing said detected specific control signal to the microcomputer (205); and
(d) controlling (205) said microcomputer based on the specific control signal, said step of controlling comprising:

(1) generating (205) a receiver specific datum by processing information that is stored in said microcomputer;
(2) placing (205) said datum at a specific memory location of the microcomputer (PC-MicroKey of microcomputer 205);
(3) communicating (205) said receiver specific datum at said memory location to said output device (202M); and subsequently
(4) clearing (205) said datum from said specific memory location, whereby the combined output of said received broadcast or cablecast program and said receiver specific datum is delivered at said output device (202M) in the period of time between said step of placing said datum at said memory location and said step of clearing said datum from said memory location.

**2.** The method of claim 1, wherein prior to placing said receiver specific datum at the specific memory location the memory device at which said receiver specific datum is placed is cleared.

**3.** The method of claim 1 wherein one or more further receiver specific data are automatically communicated (205) to said output device (202M) following said receiver specific datum.

**4.** The method of any preceding claim wherein the step of generating a receiver specific datum by processing information that is stored in the microcomputer is achieved by executing (205) a computer program stored in the memory of the microcomputer to process said stored information, and the method further comprises the steps of:
detecting (203) in said information transmission a first further control signal which is effective to load the computer program into the memory of the microcomputer (205).

**5.** The method of claim 4 wherein the information transmission incorporates the computer program.

**6.** The method of claim 4 wherein the first further control signal is effective to instruct the microcomputer to fetch a software module from a memory peripheral (232).

**7.** The method of any preceding claim wherein the combined output of said received broadcast or cablecast program and said receiver specific datum is delivered at the output device as part of a series of combined outputs and the steps of communicating said receiver specific datum and clearing the specific memory location are in response to one or more control signals.

**8.** The method of any preceding claim wherein the processing, generating, and/or outputting of said microcomputer is controlled by a programmable controller in response to control signals detected in the broadcast or cablecast information transmission.

**9.** The method of claim 8, further comprising the step of interrupting (39F and 39H of Fig. 3A) the controller to cause said microcomputer to communicate a receiver specific datum at a specific time.

**10.** The method of claim 8, further comprising the step of instructing (205, 39J) the controller to cause said microcomputer to communicate a specific receiver specific datum to said output device.

**11.** The method of claim 8, wherein said controller is capable of communicating an interrupt signal to a plurality of processor and/or controller devices, said method further comprising the step of programming said controller to interrupt a specific one of said plurality of processor and/or controller devices.

**12.** The method of any one of claims 8-11, further comprising the steps of detecting a interrupt signal in the information transmission and controlling said controller to communicate said detected interrupt signal to a processor or controller.

**13.** The method of any one of claims 8-12, wherein in response to the detection of said specific control signal in the information transmission the microcomputer is organized to generate said receiver specific datum as part of a series of receiver specific data, and a processor interrupt signal is inputted to the microcomputer to enable the communication of one or more specific receiver specific data to said output device at a specific time.

**14.** The method of claim 13, wherein said interrupt signal is inputted to said microcomputer in response to a second further control signal detected in said broadcast or cablecast information transmission, and said interrupt signal causes said microcomputer to clear the specific memory location and place a generated receiver specific datum at the specific memory location to form a subsequent combined output.

**15.** The method of claim 14, wherein a control signal detected in said broadcast or cablecast information transmission causes said microcomputer to cease communicating one or more receiver specific data to said output device and to commence or resume generating said series.

**16.** The method of any one of claims 8-12, further comprising the steps of detecting a control program in the information transmission and causing said controller to control one or more receiver station devices in accordance with said control program.

**17.** The method of any preceding claim wherein said receiver specific datum is not automatically communicated to said output device (202M) when said receiver specific datum is placed at said memory location, and the method further comprises the steps of:

detecting (203) in said information transmission a third further control signal which is effective to instruct the microcomputer (205) to communicate the receiver specific datum at said memory location to said output device, whereby to cause the microcomputer (205) to communicate said receiver specific datum to the output device (202M).

**18.** The method as claimed in claim 13, further comprising the steps of determining (39J) that said microcomputer is not prepared to communicate a first receiver specific datum to said output device at a specific time and consequently causing (39J) said microcomputer to execute a specific computer program instruction thereby to commence generating a subsequent receiver specific datum of said series.

**19.** The method as claimed in any preceding claim, wherein the information that is stored in the microcomputer comprises user specific data and the method further comprises the step of:

passing (203) update data to the microcomputer (205) whereby to cause the stored user data to be updated, whereby in generating a subsequent receiver specific datum the updated user data are processed by said microcomputer.

**20.** The method of claim 19, wherein the update data are detected in the broadcast or cablecast information transmission and passed by a decoder (290).

**21.** The method of claim 19, wherein said update data are received in an information transmission that comprises a telephone transmission.

**22.** The method of claim 21, wherein said receiver station automatically initiates said telephone transmission for one or more update data.

**23.** The method as claimed in any preceding claim further comprising the steps of storing (200) information at the receiver station that specifies that said receiver station should automatically selectively receive a specific information transmission, and selectively receiving (200) said information transmission in accordance with said stored information.

**24.** The method of claim 23, wherein in response to an enabling control signal the receiver station is enabled to receive said broadcast or cablecast program by inputting (200) to a processor one or more computer program instructions capable of controlling (200) said receiver station to receive said broadcast or cablecast information transmission, select said program, and detect said control signals.

**25.** The method of claim 23 or claim 24, further comprising the steps of receiving (200, Fig. 2) and storing (200, Fig. 2) advance information of transmission of said specific program.

**26.** The method as claimed in any preceding claim further comprising the steps of assembling records (200, Fig. 2) at the receiver station that chronicle the availability, selection, and/or usage of broadcast or cablecast programs, control signals, and/or user data, and communicating (200, Fig. 2) said records to a remote data collection station.

**27.** The method as claimed in any preceding claim, further comprising the step of inputting (225) to a processor at the receiver station information of the reaction of a user to an output at the output device (202M).

**28.** The method of claim 27, further comprising the step of processing (200, Fig. 2, or 205) said user reaction information in response to a fourth further control signal detected in the broadcast or cablecast information transmission thereby to generate additional response information besides said input information.

**29.** The method of claim 27 or 28, further comprising the step of communicating (200, Fig. 2) at least some of said input information or said additional response information to a remote data collection station.

**30.** The method as claimed in any preceding claim wherein the broadcast or cablecast program and at least some of the control signals comprised in the information transmission are encrypted and are designated by a signal indicating an encrypted transmission, and the method further comprises the step of controlling (200, Fig. 2) a decryptor in the receiver station to decrypt said program and encrypted control signals in response to detection of said designated signal.

**31.** The method as claimed in any preceding claim, further comprising the step of storing the received information transmission on a storage means (217, 255, or 256) to allow the delivery of the combined output at a time when said broadcast or cablecast program is not being received by the receiver station.

**32.** The method as claimed in any preceding claim, wherein the output device is one or more from the group consisting of a printer (221) for outputting printed information, a sound generator (263) for outputting sounds, a video display device (202M) for displaying video information, a video storage device (217) for storing video information, an audio storage device (255) for storing audio information, and an intermediate transmitter (92).

**33.** The method of claim 32 wherein the output device is a TV monitor (202M), said specific memory location is a video RAM, and said receiver specific datum is cleared from said memory location by placing information of a change color at said memory location and said change color appears transparent when displayed at said monitor in combination with a television image.

**34.** The method of claim 33 wherein the specific memory location of the microcomputer at which the receiver specific datum is placed is selected on the basis of determining a reference point and scalar dimension for the receiver specific datum in the step of generating (205) said receiver specific datum.

**35.** The method as claimed in any preceding claim wherein said receiver station is one of a plurality of similar receiver stations receiving the same information transmission, the generated receiver specific datum at each station being specific to its receiver station, and the series of receiver specific data generated at the receiver stations differing from station to station.

**36.** The method of claim 35, wherein a time period separating the receiver stations' receipt of the specific control signal and the receiver stations' receipt of the third further control signal is sufficient to allow each receiver station microcomputer to complete said step of generating before each receiver station microcomputer receives said first further control signal.

**37.** A receiver station apparatus for processing signals to deliver a combined output of a broadcast or cablecast program and a receiver specific computer generated datum, said station having an output device (202M) for delivering the broadcast or cablecast program and other information, said apparatus comprising:

a decoder (203) comprising means for:

(1) receiving an information transmission comprising a broadcast or cablecast program and one or more control signals;
(2) detecting the presence of the control signals in the information transmission; and
(3) passing the detected control signals to a microcomputer (205);

said microcomputer (205) being operatively connected to said output device (202M) and said decoder (203), said microcomputer (205) having a specific memory location (PC-MicroKey of microcomputer 205) connected to said output device (202M) for communicating data stored in said specific memory location (PC-MicroKey of microcomputer 205) to said output device (202M), and said microcomputer (205) being programmed to perform the following steps based upon one or more specific control signals:

(1) generating a receiver specific datum by processing information that is stored in said microcomputer (205) in response to receiving a specific signal;
(2) placing said receiver specific datum in said specific memory location (PC-MicroKey of microcomputer 205);
(3) communicating said receiver specific datum at said memory location to said output device (202M); and subsequently
(4) clearing said datum from said specific memory location (PC-MicroKey of microcomputer 205), thereby delivering a combined output of said received broadcast or cablecast program and said receiver specific datum at said output device (202M) in the period of time between said step of placing said datum at said memory location (PC-MicroKey of microcomputer 205) and said step of clearing said datum from said memory location (PC-MicroKey of microcomputer 205).

**38.** The apparatus of claim 37, wherein said output device is a video output device (202M) and said detected control signal is a signal which controls said microcomputer (205) to place a receiver specific video datum at said specific memory location, said apparatus further comprising a video output memory (PC-MicroKey of 205) connected to said microcomputer (205) and said video output device (202M) for communicating video information to said video output device (202M).

**39.** The apparatus of claim 37 or claim 38, wherein said output device is an audio output device (263) and said detected control signal is a signal which controls said microcomputer (205) to place a receiver specific audio datum at said specific memory location, said apparatus further comprising an audio output memory location (audio RAM of 205) connected to said microcomputer (205) and said audio output device (263) for communicating audio information to said audio output device (263).

**40.** The apparatus of any one of claims 37-39, further comprising a programmable controller (39 of decoder 203) connected to said microcomputer (205) for controlling the processing, generating and/or outputting of said microcomputer (205) in response to control signals detected in a broadcast or cablecast information transmission.

**41.** The apparatus of claim 40 wherein said controller (39 in Fig 2A, 44 in Fig. 2B, 47 in Fig. 2C) is operatively connected to said decoder (203), said apparatus further comprising a programmable control processor (39J in Fig. 3A) for controlling the communication of information detected in said information transmission.

**42.** The apparatus of claim 41 wherein said control processor (39J) inputs a computer program to a selected processor (39J, CPU of 205) or controller (39, 20 of 200) or causes a selected processor (39J, CPU of 205) or controller (39, 20 of 200) to modify a manner of identifying or responding to a control signal in said information transmission, said apparatus further comprising a selective transmission device (13 in Fig. 2D, 39I in Fig. 3A, 259 in Fig. 7) for communicating information detected in said information transmission to said selected processor (39J, CPU of 205) or controller (39, 20 of 200).

**43.** The apparatus of claim 42, wherein said selective transmission device (13 in Fig. 2D, 39I in Fig. 3A, 259 in Fig. 7) is a bus (13 in Fig. 2D), a matrix switch (39I), or a digital switch (39I).

**44.** The apparatus of any one of claims 41-43, wherein any one of said controller (39), said control processor (39J), and said microcomputer (205) comprises a plurality of processors (39B, 39D, 39J) on a single microchip (39, Fig. 3A).

**45.** The apparatus of any one of claims 37-44, wherein the microcomputer (205) receives an input comprising a computer program and one or more interrupt signals and generates said receiver specific datum in accordance with said computer program or clears said specific memory location in response to said one or more interrupt signals, said apparatus further comprising one or more buffers (8, 39A, 39C, 39E, 39G, in 205) or memories (in 39B, in 39D, in 39J, 217, 217A) for storing and communicating said computer program to said microcomputer (205).

**46.** The apparatus of any one of claims 37-45, wherein a processor (39J, 200) communicates a control instruction based on a record of the presence or absence of a program or a receiver specific datum, said apparatus further comprising a memory (SPAM-first-precondition and SPAM-second-precondition register memories in 39J; in 20, 14 or 16 in 200) for storing one or more records of the presence or absence of a program or a receiver specific datum.

**47.** The apparatus of claim 45 when appendant to claim 40 or of claim 46, wherein the controller (39 of decoder 203) inputs an interrupt signal to said microcomputer (205) to cause said microcomputer (205) to communicate a receiver specific datum at a specific time.

**48.** The apparatus of any one of claims 37-47, wherein a receiver specific datum is outputted in response to a reaction of user to an output at said output device (202M), said apparatus further comprising an input device (225) for inputting information of a reaction of a user to an output, and a processor (200, CPU of 205) operatively connected to said input device (225) for processing the inputted information of a reaction of a user.

**49.** The apparatus of any one of claims 37-48, wherein said station outputs to a remote station a record that chronicles the availability, use and/or usage of a program, a control signal, or a combined output at said receiver station or some input of the reaction of a user to a combined output of a received broadcast or cablecast program and a receiver specific datum at said output device (202M), said apparatus further comprising a transmitting device (telephone connection 22) for communicating input to a remote station.

**50.** The apparatus of any one of claims 37-49, wherein said specific control signal causes said microcomputer (205) to access and retrieve data stored at a computer peripheral (A: disk drive of computer 205), said apparatus further comprising a computer peripheral memory unit (232, 256) connected to said microcomputer (205) for storing said data to be retrieved.

**51.** The apparatus of any one of claims 37-50, further comprising a memory (in 20 of 200) connected to a receiver (mixer 3 of Fig. 2) for storing information of a selected program and receiving from a remote station information of a time or frequency of the transmission of said program and a controller (20) connected to said memory (in 20) and to a tuner (214) for causing said station to receive said selected program at said time or in said frequency.

**52.** The apparatus of any one of claims 37-51, further comprising a storage device (217, 255, 256) connected to a receiver (201, 215) or an output device (202M) for receiving and storing, whereby at least some information of a received program and a received control signal or a receiver specific datum is stored for time shifted output to a user.

**53.** The apparatus of any one of claims 37-52, further comprising a decryptor or descrambler (224) connected to a receiver (201) to enable decrypting or descrambling of information of a received program or of a received control signal which is encrypted or scrambled.

**54.** The apparatus of any one of claims 37-53, further comprising a selective transmission device (258) for communicating the program from a receiver (201, 215) or storage device (217, 217A) to a storage device (217, 217A) or an output device (202M).

**55.** The apparatus of any one of claims 37-54, wherein said information transmission is a multichannel transmission, said apparatus further comprising a converter (201) for receiving and converting some portion of said multichannel transmission and converting some portion of said multichannel transmission to a specific output frequency.

**56.** The apparatus of any one of claims 37-55, further comprising a printer (221) and a print output memory location (print buffer of 205) connected to said microcomputer (205) and said printer (221) for communicating print information to said printer (221).

**57.** The apparatus of any one of claims 37-56, wherein said program is a television program, said apparatus further comprising a television tuner (215) for receiving a television signal containing said program and a television monitor for outputting said television program and said receiver specific datum.

**58.** The apparatus of claim 37 and any one of claims 39-56, wherein said program is a radio program, said apparatus further comprising a radio tuner (209T) for receiving a radio program and a speaker system (263) for outputting said program and said receiver specific datum.

**59.** A method of communicating mass medium program material to a plurality of receiver stations each of which includes a broadcast or cablecast program receiver (tuner 215), an output device (202M), a control signal detector (decoder 203), a microcomputer (205) with a specific memory location (PC-MicroKey of microcomputer 205) capable of communicating to said output device (202M), and with each said receiver station adapted to detect the presence of one or more control signals, to generate a receiver specific datum in response to a detected specific control signal, and to deliver at said output device a combined output of the broadcast or cablecast program and the receiver specific datum, said method of communicating comprising the steps of:

(1) receiving a program to be transmitted and delivering the program to a transmitter;
(2) receiving and storing a control signal which at the receiver station operates to generate the receiver specific datum; and
(3) causing the stored control signal to be communicated to the transmitter at a specific time,
thereby to transmit an information transmission comprising the program and one or more control signals.

**60.** The method of claim 59, wherein said information transmission is transmitted to two of said plurality of receiver stations at the same time and each of said two receiver stations delivers its combined output of said received broadcast or cablecast program and its generated receiver specific datum at its output device (202M) in the same period of time.

**61.** The method of claim 59, wherein said information transmission is transmitted to two of said plurality of receiver stations at different times and each of said two receiver stations delivers its combined output of said received broadcast or cablecast program and its generated receiver specific datum at its output device (202M) in a different period of time.

**62.** The method of any one of claims 59-61, wherein a memory location is operatively connected to a computer for receiving and storing some information of said control signal, said method further comprising the steps of detecting a signal which is effective at the transmitter station to generate, and inputting said transmitter generate signal to said computer thereby to cause said computer to generate some information of said control signal and place said generated information at said memory location.

**63.** The method of claim 62, further comprising the step of programming said computer to respond to said transmitter generate signal by processing information stored in said computer.

**64.** The method of claim 62 or claim 63, wherein said computer processes specific formula-and-item-of-this-transmission information in response to said transmitter generate signal, further comprising the steps of inputting formula-and-item data to said computer.

**65.** The method of any one of claims 62-64, further comprising generating some portion of one of a computer program and a data module in response to said transmitter generate signal.

**66.** The method of any one of claims 59-65, further comprising the steps of causing a memory location that is capable of storing and communicating a computer program, to communicate a computer program to a transmitter to transmit said computer program, thereby to cause at least one receiver station to load said computer program at a processor and cause said processor to generate and output information under the control of said computer program.

**67.** The method of claim 66, further comprising the step of assembling said stored and communicated computer program into a message with a plurality of segments, and said computer program is located in a specific portion of said message and said message includes information that causes at least one receiver station to input said computer program to a selected one of a plurality of processors.

**68.** The method of claim 66 or claim 67, further comprising the steps of causing a memory location that is capable of storing and communicating an instruct signal, to communicate said instruct signal to a computer in order to generate a portion of said computer program at said computer in response thereto.

**69.** The method of any one of claims 59-68, wherein said transmitter station transmits one or more of a video, an audio and a data signal received from a remote station, said method further comprising the step of storing said received one or more of a video, an audio and a data signal for a period of time, whereby transmission of said received one or more of a video, an audio, and a data signal is delayed.

**70.** The method of any one of claims 59-69, wherein a controller controls the passing of a specific received signal, said method further comprising the steps of detecting embedded information in said specific received signal and controlling the passing of said specific received signal on the basis of said detected embedded information.

**71.** The method of claim 70, wherein said controller controls a switch, said method further comprising controlling said switch to communicate signals selectively from one or more program input receivers and one or more memory locations to one or more memory locations and one or more transmitters.

**72.** The method of claim 71, wherein said transmitter station transmits a plurality of messages to one of said plurality of receiver stations to control said one receiver station to deliver its combined output of said program and its receiver specific datum at its output device, said method further comprising the steps of communicating a signal containing one of said plurality of messages from a program input receiver to a memory location and subsequently communicating said signal containing said one of said plurality of messages from said memory location to a transmitter.

**73.** The method of any one of claims 70-72, wherein said transmitter station stores at least one program, said method further comprising the steps of receiving said program at a program input receiver, communicating said program to a storage device, and storing said program at said storage device with an instruct signal which is effective at the transmitter station to control one of said computer and said controller.

**74.** The method of claim 73, further comprising the steps of detecting said instruct signal and communicating said instruct signal to one of said computer and said controller.

**75.** The method of claim 71 and any one of claims 72-74 when appendant to claim 71, further comprising the step of controlling said switch on the basis of the presence or absence of an instruct signal stored with a program.

**76.** The method of any one of claims 59-75, wherein said transmitter station includes a plurality of program input receivers, said method further comprising the steps of processing signals received at said plurality of program input receivers, communicating control information in response to an embedded datum, and controlling the passing of a signal received at a specific one of said plurality of program input receivers on the basis of said communicated control information.

**77.** The method of any one of claims 59-76, wherein said program and said receiver generate signal are received from one or more remote stations, said method further comprising the steps of processing a signal received from said one or more remote stations and controlling said transmitter station to communicate said program to a transmitter, or said receiver generate signal to said computer, on the basis of information in said processed, received signal.

**78.** The method of any one of claims 59-77, further comprising the steps of receiving said program at a receiver in the transmitter station, communicating said program from said receiver to a memory location, and storing said program at said memory location for a period of time prior to communicating said program to a transmitter.

**79.** The method of claim 78, further comprising the steps of receiving said program at a selected one of a plurality of receivers in the transmitter station and communicating said program from said selected receiver to a transmitter.

**80.** The method of any one of claims 78-79, further comprising the steps of transmitting said program at a selected one of a plurality of transmitters and communicating said program to said selected transmitter.

**81.** The method of any one of claims 59-80, wherein a switch communicates received signals selectively from at least one receiver and at least one memory location to a transmitter, said method further comprising the steps of inputting a signal which is effective at the transmitter station to instruct communication, and controlling said switch to communicate a received signal from a receiver to a memory location in response to said instruct signal.

**82.** The method of claim 81 when appendant to claim 62, wherein said received signal contains said transmitter generate signal, said method further comprising the step of subsequently communicating at least some of said transmitter generate signal from said memory location to a second memory location.

**83.** The method of claim 81, wherein said received signal contains said program, said method further comprising the step of controlling said switch to communicate said program to a transmitter.

**84.** The method of any one of claims 59-83, wherein a plurality of signals is received from one or more remote stations at said transmitter station, said method further comprising the steps of selecting one or more of said plurality of signals, and communicating each selected signal to a storage device.

**85.** The method of claim 84 when appendant to claim 70, wherein one or more of said selected signals is a signal which is effective at the transmitter station to instruct one of said computer and said controller, said method further comprising the step of causing a memory location to communicate said instruct signal prior to said specific time and controlling said one of said computer and said controller in response to said instruct signal.

**86.** The method of any one of claims 59-85, wherein a plurality of signals is received from one or more remote stations and at least one is stored at said transmitter station and one of said plurality of received signals is operative to schedule, said method further comprising the steps of programming said transmitter station to store the schedule and causing said transmitter to transmit in accordance with the schedule.

**87.** The method of claim 86, further comprising the step of causing said transmitter station to generate in accordance with the schedule.

**88.** The method of claim 86 or claim 87, further comprising the step of tuning a receiver or controlling a satellite earth station to receive a signal in accordance with the schedule.

**89.** The method of any one of claims 59-88, further comprising the steps of receiving an information transmission from a remote station, detecting in the information transmission an instruct signal which is effective at the transmitter station to execute an instruction set, loading an instruction set at a computer in response to said instruct signal, and on the basis of said instruction set, selecting information to be processed at a receiver station or communicating information to be associated with said program.

**90.** The method of any one of claims 59-89, wherein a controller controls a memory location to communicate to a transmitter a selected control signal, said method further comprising the steps of detecting a signal which is effective at the transmitter station to instruct transmission, and inputting said signal to said controller thereby to cause said memory location to communicate a selected control signal.

**91.** The method of claim 90, further comprising the step of programming said controller to respond to a said signal by controlling a selected memory location to communicate a control signal or by causing a memory location to communicate a selected control signal.

**92.** The method of claim 90 or claim 91, wherein the instruct transmission signal is received in a broadcast or cablecast information transmission transmitted by a remote station.

**93.** The method of any one of claims 90-92, further comprising the steps of storing a signal which is effective at the transmitter station to instruct, and controlling said memory location to communicate a selected control signal at a scheduled time according to said instruct signal.

**94.** The method of any one of claims 90-93, further comprising the step of storing said signal at said memory location with said program.

**95.** The method of any one of claims 90-94, further comprising the steps of controlling a memory location to communicate said program to a transmitter in response to a first instruct signal and controlling a memory location to communicate a selected control signal in response to a second instruct signal.

**96.** The method of claim 95, further comprising the steps of detecting a control signal communicated from said memory location and programming a controller to respond to a control signal communicated from said memory location.

**97.** The method of any one of claims 90-96, further comprising the step of embedding an instruct signal in said program thereby to enable a controller to respond to said embedded instruct signal at a time when said program is being communicated.

**98.** The method of claim 64 and of any one of claims 65-97 when appendant to claim 64, wherein said transmitter generate signal or said formula-and-item data is received in a broadcast or cablecast information transmission transmitted by a remote station, said method further comprising the steps of receiving an instruct signal from a remote station and transmitting said formula-and-item information in response thereto.

**99.** The method of any one of claims 59-98, further comprising the steps of storing a signal which is effective at the transmission station to instruct generation, and controlling a computer to process stored information before said specific time according to said stored instruct signal.

**100.** The method of any one of claims 59-99, further comprising the steps of storing and transmitting to a receiver station data that specifies a time of transmission of or a channel of transmission of or some subject matter of a specific program, and subsequently transmitting said program in accordance with said specified data thereby to enable said receiver station to select and store or select and output said program.

**101.** The method of any one of claims 59-100, further comprising the steps of transmitting to a receiver station a control signal to cause said receiver station to align to a parallel processing system and select and input to a microcomputer some information associated with a program or control signal transmitted in a broadcast or cablecast information transmission and cause said microcomputer to process stored information and generate output in response to said inputted information.

**102.** The method of claim 100 or 101, further comprising the steps of communicating to a signal generator data that specifies a time of transmission of or a channel of transmission of or some subject matter of a specific program or a control signal and adding said communicated data or control signal to a specific part of a broadcast or cablecast information transmission or adding said communicated data or control signal to a broadcast or cablecast information transmission in a message of a specific format.

**103.** The method of any one of claims 59-102, further comprising the steps of causing a memory location that is capable of storing and communicating a signal which is effective at the receiver station to synchronize, to communicate said signal to a transmitter to transmit said signal, thereby to cause at least one receiver station to commence executing selected controlled functions programmed at said one station in response to selected information in the broadcast or cablecast information transmitted by said transmitter.

**104.** The method of any one of claims 59-103, further comprising the steps of causing a memory location that is capable of storing and communicating a signal which is effective at the receiver station to interrupt, to communicate said signal to a transmitter to transmit said signal, thereby to cause at least one receiver station to interrupt the processing of a selected microcomputer, controller, or processor in response thereto.

**105.** The method of any one of claims 59-104, further comprising the steps of causing a memory location that is capable of storing and communicating a signal which is effective at the receiver station to serve as a source from which to select a receiver specific datum to be generated, to communicate the signal to a transmitter to transmit said signal, thereby to cause at least one receiver station to select a receiver specific datum to be generated.

**106.** The method of claim 105, wherein said signal which is effective at the receiver staton to serve as a source is transmitted before said receiver generate signal, whereby at least one receiver station stores data received in said source signal and generates a receiver specific datum by processing said stored data.

**107.** The method of any one of claims 59-106, further comprising the steps of causing a memory location that is capable of storing and communicating a signal which is effective at the receiver station to cease combining, to communicate the signal to a transmitter to transmit said signal, thereby to cause at least one receiver station to cease combining its generated receiver specific datum at a specific time.

**108.** The method of any one of claims 59-107, further comprising the steps of causing a memory location that is capable of storing and communicating a signal which at the receiver station operates to combine, to communicate the signal to a transmitter to transmit said signal, thereby to cause to at least one receiver station to deliver a combined output of said received broadcast or cablecast program and said receiver specific datum at its output device at a specific time.

**109.** The method of any one of claims 59-108, further comprising the steps of causing a memory location that is capable of storing and communicating a signal which at the receiver station operates to clear a generated receiver specific datum, to communicate said signal to a transmitter to transmit said signal, thereby to cause at least one receiver station to clear its generated receiver specific datum in response thereto.

**110.** The method of any one of claims 59-109, further comprising the step of detecting a signal which is effective at the transmitter station to instruct generation, in one of a television signal and a radio signal or at a memory location that stores one of a television program or a radio program.

**111.** The method of any one of claims 59-110, wherein the receiver station is a remote intermediate transmitter station, the output device (202M) is a transmitter (83, 87, 91, 92), the microcomputer (205) is an automatic control unit (73) for the intermediate transmitter station, and the specific memory location is a program-set-to-transmit memory, said method further comprising the steps of:

(1) receiving one or more instruct signals which are effective at a subscriber station to instruct a computer (73, 205) or processor (in 71, 200, 39J) in a manner of receiving or presenting television program material or computer output or functioning on the basis of a viewer reaction to a television programming or computer output presentation and delivering the one or more instruct signals to a transmitter;
(2) receiving one or more control signals which at the remote intermediate transmitter station operate to execute or communicate said one or more instruct signals; and
(3) causing said one or more control signals to be communicated to said transmitter before said specific time,

thereby to transmit an information transmission comprising the one or more instruct signals and one or more control signals.

**112.** The method of any one of claims 59-111, wherein the receiver station is a remote intermediate transmitter station, the output device (202M) is a transmitter (83, 87, 91, 92), the microcomputer (205) is an automatic control unit (73) for the intermediate transmitter station, and the specific memory location is a memory (73) or recorder (76 or 78), said method further comprising one of the steps of:

(1) receiving said program and delivering said program to a transmitter before said specific time;
(2) receiving one or more instruct signals which are effective at a subscriber station to instruct a computer (73, 205) or processor (in 71, 200, 39J) in a manner of receiving or presenting material associated with said program or functioning on the basis of a user reaction to output associated with said program and delivering the one or more instruct signals to a transmitter before said specific time;
(3) receiving one or more control signals which at the remote intermediate transmitter station operate to select or communicate said program or said one or more instruct signals and delivering said one or more control signals to a transmitter before said specific time; and
(4) receiving a schedule which at the remote intermediate transmitter station operates to transmit said program and said one or more instruct signals and delivering the schedule to a transmitter before said specific time.

**113.** The method of any one of claims 59-112, wherein a transmitter station receives from a subscriber station some information of a reaction of a subscriber to a television programming or computer output presentation, said method further comprising at least one of the steps of:

transmitting to a subscriber station a computer program that processes some information of a reaction of a subscriber to a television programming or computer output presentation;
refining some variable of an instruct signal on the basis of a reaction of a subscriber to a television programming or computer output presentation; and

transmitting some portion of a television program or an instruct signal on the basis of a reaction of a subscriber to a television programming or computer output presentation.

**114.** The method of any one of claims 59-113, further comprising the steps of causing one transmitter station to transmit said program and causing a second transmitter station to transmit said control signal which at the receiver station operates to generate the receiver specific datum or to transmit a data module which at the receiver station serves as a source of a receiver specific datum to select and generate.

**115.** The method of any one of claims 59-114, wherein said program is transmitted to a subscriber station by satellite and a second transmitter station is caused to broadcast or cablecast to said subscriber station said control signal or a data module assocated with said program.

**116.** The method of any one of claims 59-115, further comprising transmitting a plurality of programs and one or more signals which are effective at a subscriber station to analyze a value or generate a schedule, thereby to cause at least one subscriber station to select one of said plurality of programs on the basis of its potential value to a subscriber or to output two or more of said programs in a receiver specific order.

**117.** A transmitter station apparatus for processing signals and communicating mass medium program materials to present at each of a plurality of receiver stations a combined output of a broadcast or cablecast program and a receiver specific computer generated datum, with each of said receiver stations having an output device (202M) for receiving and delivering the broadcast or cablecast program and other information, said station also having a microcomputer (205) with a specific memory location (PC-MicroKey of microcomputer 205) operatively connected to said output device (202M) for storing and outputting information to said output device (202M), said transmitter station apparatus comprising:

a broadcast or cablecast transmitter (83, 87, 91 or 92) for communicating to a plurality of receiver stations an information transmission comprising a program and one or more control signals;
a program input receiver (76, 78, 53-62) operatively connected to said transmitter (83, 87, 91 or 92) for communicating the program to said transmitter (83, 87, 91 or 92);
a memory (73) or recorder (76 or 78) operatively connected to said transmitter (83, 87, 91 or 92) for storing and communicating a control signal which at the receiver station operates to generate the receiver specific datum; and
an input device (98, 74, 50-62) operatively connected to said memory (73) or recorder (76 or 78) for causing said memory (73) or recorder (76 or 78) to communicate said control signal at a specific time to said transmitter (83, 87, 91 or 92), thereby to communicate said program and said control signal to said receiver stations and cause each of said plurality of receiver stations to deliver said program at its output device (202M), generate (205) a receiver station specific datum, place its receiver station specific datum at its memory location (PC-MicroKey of microcomputer 205) for a period of time, and deliver a combined output of said broadcast or cablecast program and its receiver station specific datum at its output device (202M).

**118.** The transmitter station apparatus of claim 117, wherein said transmitter station transmits to said plurality of receiver stations a first transmitter specific datum and at least one of said plurality of receiver stations presents some information of a receiver specific datum on the basis of said first transmitter specific datum, said apparatus further comprising:

a second memory (73) or recorder (76 or 78) operatively connected to said transmitter (83, 87, 91 or 92) for storing and communicating a transmitter specific datum which at the receiver station serves as a basis for computing some information of a receiver specific datum.

**119.** The transmitter station apparatus of claim 117, wherein said transmitter station transmits to said plurality of receiver stations a second transmitter specific datum and at least one of said plurality of receiver stations outputs said second transmitter specific datum at its output device (202M), said apparatus further comprising:

a third memory (73) or recorder (76 or 78) operatively connected to said transmitter (83, 87, 91 or 92) for storing and communicating some data which at the receiver station serve as a source from which to select a receiver specific datum to be generated.

**120.** The transmitter station apparatus of any one of claims 117-119, wherein said input device inputs a first advance signal which is subsequently effective at the transmitter station at said specific time to output said first named memory (73) or recorder (76 or 78) to said transmitter (83, 87, 91, or 92), said apparatus further comprising:

a first processor (73) operatively connected to said input device (50-62, 74, 98) for distinguishing an advance signal;
a first memory controller (73, 205C in 73) operatively connected to said first processor (73) for controlling a memory (73) or recorder (76 or 78) to store one or more advance signals; and
a fourth memory (73) or recorder (76 or 78) operatively connected to said first controller (73, 205C in 73) for storing said first advance signal.

**121.** The transmitter station apparatus of any one of claims 117-120, wherein said input device (98, 74, 50-62) inputs an instruct signal which is effective at the transmitter station to output said first named memory (73) or recorder (76 or 78) to said transmitter (83, 87, 91 or 92) at said specific time, said apparatus further comprising:

a first control processor (39J, 73) operatively connected to said input device (98, 74, 50-62) for distinguishing a signal which is effective at said transmitter station to instruct; and
a first output controller (73, 205C in 73, 39 in any decoder, 12 in 71) operatively connected to said first control processor (73) for outputting a control signal which is effective to output a memory (73) or recorder (76 or 78).

**122.** The transmitter station apparatus of any one of claims 117-121, further comprising at least one of:

a first selective transmission device controller (73) operatively connected to said program input receiver (76, 78, 53-62) for controlling a first selective transmission device (75, 76, 78, 53-62) to communicate one or more signals to a memory (73) or recorder (76 and 78) before a specific time;
a second selective transmission device controller (73) operatively connected to said broadcast or cablecast transmitter (83, 87, 91, 92) for controlling a second selective transmission device (73, 75, 76, 78) to communicate one or more signals from one or more memories (73) and/or recorders (76 or 78) at a specific time.

**123.** The transmitter station apparatus of any one of claims 117-122, further comprising:
a central controller (73) operatively connected to one of said program input receiver (76, 78, 53-62) and said broadcast or cablecast transmitter (83, 87, 91, 92) for controlling the communication to said one of some portion of said program, some of a message to be associated with said program, one or more data that identify said program, some advance information of said program, one or more data that designate the starting point of some portion of said program, or a signal that designates said program and is effective at the receiver station to instruct.

**124.** The transmitter station apparatus of claim 123, further comprising one of:

a clock operatively connected to said central controller (73); and
a second input device (98, 74, 50-62) operatively connected to said central controller (73) for inputting one or more timing control instructions.

**125.** The transmitter station of apparatus of claim 123 or claim 124, further comprising one of:

a second processor (73, in 71, in any decoder) operatively connected to said central controller (73) for distinguishing a timing control signal or a time at which to pass a signal which is effective to instruct;
a second memory controller (73) operatively connected to said central controller (73) for controlling a selected memory (73) or recorder (76 or 78) to store an advance signal which is effective to instruct; and
a fifth memory (73) or recorder (76 or 78) operatively connected to said central controller (73) for storing two or more signals in order.

**126.** The transmitter station apparatus of any one of claim 119 and claims 120-125 when appendant on claim 119, further comprising:

a first computer (73) operatively connected one of said second memory (73) or recorder (76 or 78) and said third memory (73) or recorder (76 or 78) for receiving formula-and-item data, and for outputting some portion of a data module to that one memory (73) or recorder (76 or 78).

**127.** The transmitter station apparatus of any one of claims 117-126, wherein some of said control signal is formula-and-item-of-this-transmission information, said apparatus further comprising:
a second computer (73) operatively connected to said first named memory (73) or recorder (76 or 78) for outputting formula-and-item-of-this-transmission information in response to an instruct signal which is effective at the transmitter station to generate.

**128.** The transmitter station apparatus of any one of claim 120 and claims 121-127 when appendant to claim 120, wherein a signal containing said program inputs a coded advance signal which is effective at the transmitter station to output said first named memory (73) or recorder (76 or 78) to said transmitter (83, 87, 91, or 92), said apparatus further comprising:

a first decoder (in 71, 77, 79) operatively connected to said input device (98, 74, 50-62) for decoding information coded in a signal containing a program.
a third selective transmission device (in 39, in 71) operatively connected to said first decoder (in 71) for communicating to said first processor (in 39, in 71) one or more data.

**129.** The transmitter station apparatus of claim 128 when appendant to claim 122, wherein said transmitter station includes said first selective transmission device controller (73) and said decoder (in 71, 77, 79) decodes one or more data which are effective at the transmitter station to delay communication to the receiver station of some portion of said signal containing said program, said apparatus further comprising:

a fourth selective transmission device (in 39, in 71) operatively connected to said first decoder (in 71) for communicating to said first control processor (in 39, in 71) one or more data; and
a fifth selective transmission device (in 39, in 71) operatively connected to said first control processor (in 39, in 71) for communicating to said first selective transmission device controller (73) a signal which is effective to instruct.

**130.** The transmitter station apparatus of any one of claims 117-129 wherein said input device (98, 74, 50-62) includes a first receiver (50-62, 71, 73) for receiving from a remote station a signal which is effective at the transmitter station to instruct.

**131.** The transmitter station apparatus of any one of claims 117-130, wherein said first computer (73) or said second computer (73) generates some output in response to an instruct signal which is effective at the transmitter station to generate, said apparatus further comprising:

a sixth memory (73) or recorder (76 or 78) for storing an instruct signal that is effective at the transmitter station to generate; and
a third input device (73, 74, 98, in 71) operatively connected to said sixth memory (73) or recorder (76 or 78) for causing said sixth memory (73) or recorder (76 or 78) to output at a second specific time an instruct signal that is effective at the transmitter station to generate; and
a sixth selective transmission device (73) operatively connected to said sixth memory (73) or recorder (76 or 78) for receiving and transferring one or more instruct signals.

**132.** The transmitter station apparatus of claim 131, further comprising:
a third processor (73) operatively connected to said second input device (73, 98, in 71) and said second memory controller (73) for distinguishing an instruct signal which is effective at the transmitter station to generate and causing said second memory controller (73) to control said sixth memory (73) or recorder (76 or 78) to store said distinguished instruct signal.

**133.** The transmitter station apparatus of claim 131 or 132 wherein said second input device (73, 74, 98, in 71) receives from a second remote station said instruct signal which is effective at the transmitter station to generate.

**134.** The transmitter station apparatus of any one of claims 131-133, further comprising:
a SPAM-controller (205C in 73, 39 in any decoder, 12 in 71) operatively connected to a specific computer (73) for controlling said specific computer (73) to generate or output a computer program or a data module in accordance with an instruct signal that is effective at the transmitter station to generate.

**135.** The transmitter station apparatus of any one of claims 128-134, wherein said program input receiver (76, 78, 53-62) inputs a coded instruct signal which is received with said program and is effective at the transmitter station to generate, said apparatus further comprising:

a seventh selective transmission device (in 71, in 77, in 79) operatively connected to said first decoder (in 71, 77, 79) for receiving and transferring a decoded signal; and

a fourth processor (73, in 71, in 77, in 79) operatively connected to said seventh selective transmission device (in 71, in 77, in 79) for distinguishing a device to which to pass a signal which is effective at the transmitter station to instruct.

**136.** The transmitter station apparatus of any one of claims 117-135, wherein said transmitter station transmits one or more signals that are effective at the receiver station to instruct the specific memory location to combine or cease combining or clear a receiver specific computer generated datum, said apparatus further comprising:

a fourth input device (50-62, 74, 98) operatively connected to a broadcast or cablecast transmitter (83, 87, 91, or 92) for communicating to said broadcast or cablecast transmitter (83, 87, 91, or 92) at a third specific time one or more signals which are effective at the receiver station to instruct.

**137.** The transmitter station apparatus of claim 136, wherein a third remote station communicates said one or more signals which are effective at the receiver station to instruct, said apparatus further comprising:

a second receiver (50-62, 71, 73) operatively connected to a selective transmission device (73, 75, in 71, 39 in any decoder) for receiving from a remote station one or more signals which are effective at the receiver station to instruct.

**138.** The transmitter station apparatus of claim 136 or claim 137, further comprising:

a seventh memory (73) or recorder (76 or 78) operatively connected to a selective transmission device (73, 75, in 71, 39 in any decoder) for storing one or more signals which are effective at the receiver station to instruct; and

a fifth input device (50-62, 74, 98) operatively connected to said seventh memory (73) or recorder (76 or 78) for causing said seventh memory (73) or recorder (76 or 78) to output to a broadcast or cablecast transmitter (83, 87, 91, or 92) at a specific time one or more signals which are effective at the receiver station to instruct.

**139.** The transmitter station apparatus of any one of claims 117-138, wherein said program input receiver (76, 78, 53-62) is a memory (73) or recorder (76 or 78) at which at least some of said program is stored, said apparatus further comprising:

a sixth input device (50-62, 74, 98) operatively connected to said program input receiver (76, 78, 53-62) for causing said program input receiver (76, 78, 53-62) to commence outputting said program to a broadcast or cablecast transmitter (83, 87, 91, or 92) at a fourth specific time.

**140.** The transmitter station apparatus of claim 139, further comprising:

an eighth memory (73) or recorder (76 or 78) for storing one or more data that designate the starting point of a portion of a program; and

a second output controller (73, 205C in 73, 39 in any decoder, 12 in 71) operatively connected said eighth memory (73) and to said program input receiver (76, 78, 53-62) for controlling said program input receiver (76, 78, 53-62) to commence outputting a portion of a program at the beginning of said portion.

**141.** The transmitter station apparatus of claim 139, wherein said sixth input device (50-62, 74, 98) inputs an instruct signal which is effective at the transmitter station to output said program at said fourth specific time, said apparatus further comprising one of:

a fifth processor (73) operatively connected to said fifth input device (50-62, 74, 98) for distinguishing an signal which is effective at said transmitter station to output a program; and

an sixth processor (73) operatively connected to said sixth processor (73) for locating or identifying some portion of a program.

**142.** The transmitter station apparatus of claim 139, wherein said sixth input device (50-62, 74, 98) receives from a fourth remote station an instruct signal which is effective at the transmitter station to output said program at said fourth specific time.

**143.** The transmitter station apparatus of any one of claims 117-142, wherein said program input receiver (76, 78, 53-62) receives a signal that contains at least some of said program and contains embedded data that identifies said program or designates the starting point of some portion of said program or comprises a message associated with said program, said apparatus further comprising:

a digital detector (34, 37, 38, 43 or 44 in any decoder) operatively connected to said program input receiver (76, 78, 53-62) for detecting data embedded in a signal.

**144.** The transmitter station apparatus of any one of claims 117-143, wherein a message associated with said program, that contains video, audio, or computer programming or a video, audio, or data file, is communicated to or stored at said program input receiver (76, 78, 53-62) prior to said first named specific time, said apparatus further comprising:

a seventh processor (73, 39J in any decoder) for processing one or more such messages.

**145.** The transmitter station apparatus of any one of claims 117-144, wherein a message that contains a command associated with said program is communicated to or stored at said program input receiver (76, 78, 53-62) prior to said first named specific time, said apparatus further comprising one of:

an eighth processor (39J in any decoder) for distinguishing a command in a message associated with a program; and
a first response controller (73, 39 in any decoder, 12 in 71) operatively connected to said tenth processor (39J in any decoder) for controlling some apparatus in response to such a command in a message.

**146.** The transmitter station apparatus of any one of claims 117-145, wherein a message that contains a meter-monitor segment associated with said program is communicated to or stored at said program input receiver (76, 78, 53-62), said apparatus further comprising one of:

an ninth processor (39J in any decoder) for distinguishing a meter-monitor segment in a message associated with a program; and
a tenth processor (in 71, 96) operatively connected to said eleventh processor (39J in any decoder) for assembling or storing meter files or monitor files that evidence the handling or transmitting of a program or a message associated with a program.

**147.** The transmitter station apparatus of any one of claims 117-146, wherein a message associated with said program that contains a header or format field is communicated to or stored at said program input receiver (76, 78, 53-62), said apparatus further comprising:

an eleventh processor (39J in any decoder) for distinguishing the format, content, or end of some portion of a message associated with a program on the basis of a header or format field.

**148.** The transmitter station apparatus of any one of claims 117-147, wherein a message associated with said program that contains an end of file signal or a processor interrupt is communicated to or stored at said program input receiver (76, 78, 53-62), said apparatus further comprising:

a signal detector (39F or 39H in any decoder) for detecting an end of file signal or communicating a processor interrupt associated with a broadcast or cablecast program; and
a twelfth processor (73, 39J in any decoder) operatively connected to said signal detector (39F or 39H in any decoder) for responding to a processor interrupt associated with a broadcast or cablecast program.

**149.** The transmitter station apparatus of any one of claims 117-148, further comprising:

a third computer (73) operatively connected to a transmitter (83, 87, 91 or 92) for generating and communicating a message that is to be associated with a program and contains some video, audio, or computer programming or a video, audio, or data file.

**150.** The transmitter station apparatus of any one of claims 117-149, further comprising:

a fourth computer (73) operatively connected to to a transmitter (83, 87, 91 or 92) for generating some portion of a command and communicating said command in a message to be associated with a program.

**151.** The transmitter station apparatus of any one of claims 117-150, further comprising:

a fifth computer (73) operatively connected to a transmitter (83, 87, 91 or 92) for generating and communicating some portion of a meter-monitor segment to be associated with a program.

**152.** The transmitter station apparatus of any one of claims 117-151, further comprising:

a sixth computer (73) operatively connected to a transmitter (83, 87, 91 or 92) for generating some part of part of a message having a specific format and to be associated with a program and for communicating said portion of a message with a header or format field that designates said specific format.

**153.** The transmitter station apparatus of any one of claims 117-152, further comprising:

a seventh computer (73) operatively connected to said program input receiver (76, 78, 53-62) to a transmitter (83, 87, 91 or 92) for generating a message associated with a program and containing a processor interrupt.

**154.** The transmitter station apparatus of any one of claim 139 and claims 140-153 when appendant to claim 139, further comprising:

an eighth selective transmission device (73 or 75) operatively connected to one or more of said input devices (50-62, 71, 73, 74, 98) and to said program input receiver (76, 78, 53-62) for communicating to said program input receiver a message to be associated with said program, one or more data that identify said program, one or more data that designate the starting point of some portion of said program, or a signal that is effective at the receiver station to instruct.

**155.** The transmitter station apparatus of any one of claims 117-154, wherein said program is communicated to and stored at said program input receiver (76, 78, 53-62) prior to said first named specific time, said apparatus further comprising:

a second program input receiver (78, 53-62) operatively connected to a transmission device (73 or 75) for communicating a program to said first named program input receiver (76, 78, 53-62.

**156.** The transmitter station apparatus of claim 120 and any one of claims 121-155 when appendant to claim 120, wherein said first named program input receiver (76, 78, 53-62) is said fourth memory (73) or recorder (76 or 78), said apparatus further comprising:

a second decoder (77, 79) operatively connected to a memory (73) or recorder (76 or 78) for decoding information coded in a stored signal;
a second control processor (39J in 77, 39J in 79, 73) for distinguishing a decoded stored signal which is effective at the transmitter station to instruct;
a ninth selective transmission device (39I in 77, 39I in 79) operatively connected to said second control processor (39I in 77, 39I in second decoder (77, 79) for communicating a transmitter instruct signal to a controller (73, 205C, 39 in any decoder) or computer (73); and
a third output controller (39 in 77, 39 in 79, 73) operatively connected to said ninth selective transmission device (39I in 77, 39I in 79) for controlling said ninth selective transmission device (39I in 77, 39I in 79) to communicating a transmitter instruct signal to a specific controller (73, 205C, 39 in any decoder) or computer (73).

**157.** The transmitter station apparatus of claim 156, further comprising:

a thirteenth processor (in 71, 73, in 39 of any decoder) operatively connected to a controller (73, 205C, 39 in any decoder) or computer (73) for distinguishing a specific decoder (in 71, 77, 79, 80, 84, 88) or communicating a datum designating a specific program input receiver (76, 78, 53-62).

**158.** The transmitter station apparatus of claim 155 and any one of claim 156 or claim 157 when appendant to claim 155, further comprising one of:

a first switch (75) operatively connected to said broadcast or cablecast transmitter (83, 87, 91, 92) for communicating signals selectively from said first named program input receiver (76, 78, 53-62) and said second program input receiver (78, 53-62); and
a second switch (75) operatively connected to said second program input receiver (78, 53-62) for communicating signals selectively to said first named program input receiver (76 or 78) and said broadcast or cablecast transmitter (83, 87, 91, 92).

**159.** The transmitter station apparatus of claim 158, wherein said first switch (75) or said second switch (75) is controlled by said central controller (73).

**160.** The transmitter station apparatus of any one of claims 117-159, wherein said transmitter station includes a plurality of program input receivers (53-62) for receiving signals from one or more remote programming sources or a plurality of memories (73) or recorders (76 and 78) for storing signals or a plurality of broadcast or cablecast transmitters (83, 87, 91, 92), said apparatus further comprising:

a matrix switch (75) or digital switch (39I in any decoder) capable of communicating a plurality of signals simultaneously.

**161.** The transmitter station apparatus of claim 160 when appendant to claim 123, wherein said matrix switch (75) or digital switch (39I in any decoder) is controlled by said central controller (73).

**162.** The transmitter station apparatus of any one of claims 117-161, further comprising:

a signal generator (82, 86, 90) operatively connected to said broadcast or cablecast transmitter (83, 87, 91, 90) for receiving said control signal and embedding said control signal in said information transmission.

**163.** The transmitter station apparatus of claim 162 when appendant to claim 153, wherein said control signal is communicated to said signal generator (82, 86, 90) by any one of said third computer (73), said fourth computer (73), said fifth computer (73), said sixth computer (73), and said seventh computer (73).

**164.** The transmitter station apparatus of any one of claims 117-163, wherein said information transmission comprises a plurality of channels of television programming and/or radio programming, said apparatus further comprising:

a plurality of modulators (83, 87, 91), each modulator (83, 87, 91) operatively connected to a program input receiver (76, 78, 53-62) for modulating a channel; and
a multiplexing system (92) operatively connected to said broadcast or cablecast transmitter (83, 87, 91) for communicating an information transmission comprising a plurality of channels.

**165.** The transmitter station apparatus of any one of claims 117-164, wherein said transmitter station comprises one or more processor systems (71, 39 in any decoder) for processing signals that contain commands and program output information content, said apparatus further comprising:

one or more transmitter sections (12 and 39 in each decoder of 71; 39I in each 39) for transmitting commands and/or program output information content selectively to one or more external receiver devices (72, 73, 97 in 71; 73 and 205C in 73);
one or more receiver sections (1, 2, 3, 6, 27, 28, 29 in 71; 39B, 39D, 39J in 39) for receiving input of said commands and program output information content;
one or more memory (8, 14, in 39 in 71; 39E, 39F, 39G, 39H, RAMs in 39) or recorder (20 in 71) sections for storing and communicating a control signal which at a receiver device (73) or receiver station (97) can operate to generate a receiver specific datum; and
one or more control input sections (20 and each 39 in 71; 39F, 39H, 39J in 39) operatively connected to said memory (8, 14, in 39 in 71; 39E, 39F, 39G, 39H, RAMs in 39) or recorder (20 in 71) section, for causing said memory (8, 14, in 39 in 71; 39E, 39F, 39G, 39H, RAMs in 39) or recorder (20 in 71) section to communicate said control signal at a specific time.

**166.** The apparatus of claim 165, wherein any one of said one or more transmitter sections (12 and 39 in each decoder of 71; 391 in each 39), said one or more receiver sections (1, 2, 3, 6, 27, 28, 29 in 71; 39B, 39D, 39J in 39), said one or more memory (8, 14, in 39 in 71; 39E, 39F, 39G, 39H, RAMs in 39) or recorder (20 in 71) sections, and said one or more control input sections (20 and each 39 in 71; 39F, 39H, 39J in 39) comprises a plurality of processors (39B, 39D, 39J) on a single microchip (39, Fig. 3A).

**Patentansprüche**

**1.** Verfahren zur Verarbeitung von Signalen in einer Empfängerstation mit einem Mikrocomputer (205) und einer Ausgabevorrichtung (202M), um in der Ausgabevorrichtung eine kombinierte Ausgabe eines rundgesendeten oder kabelgesendeten Programms und eines empfängerspezifischen Datenelements abzugeben, wobei das Verfahren die folgenden Schritte aufweist:

(a) Empfangen (215) einer Informationsübertragung, die ein Programm und ein oder mehrere Steuersignale umfaßt;
(b) Wählen des empfangenen rundgesendeten oder kabelgesendeten Programms aus der Informationsübertragung und Weiterleiten desselben an die Ausgabevorrichtung (202M) zur Übergabe an den Nutzer;
(c) Ermitteln (203) eines spezifischen Steuersignals in der Informationsübertragung und Weitergeben des ermittelten spezifischen Steuersignals an den Mikrocomputer (205); und
(d) Steuern (205) des Mikrocomputers auf der Grundlage des spezifischen Steuersignals, wobei der Schritt des Steuerns folgendes umfaßt:

(1) Erzeugen (205) eines empfängerspezifischen Datenelements durch Verarbeiten von Information, die in dem Mikrocomputer gespeichert ist;
(2) Ablegen (205) des Datenelements an einer spezifischen Speicherstelle des Mikrocomputers (PC-MicroKey des Mikrocomputers 205);
(3) Übermitteln (205) des empfängerspezifischen Datenelements an der Speicherstelle an die Ausgabevorrichtung (202M); und anschließendes
(4) Löschen (205) des Datenelements aus der spezifischen Speicherstelle, wodurch die kombinierte Ausgabe des empfangenen rundgesendeten oder kabelgesendeten Programms und des empfängerspezifischen Datenelements in der Ausgabevorrichtung (202M) in der Zeitperiode zwischen dem Schritt des Ablegens des Datenelements an der Speicherstelle und dem Schritt des Löschens des Datenelements aus der Speicherstelle abgegeben wird.

**2.** Verfahren nach Anspruch 1, bei dem vor dem Ablegen des empfängerspezifischen Datenelements an der spezifischen Speicherstelle die Speichervorrichtung, an der das empfängerspezifische Datenelement abgelegt wird, gelöscht wird.

**3.** Verfahren nach Anspruch 1, bei dem ein oder mehrere weitere empfängerspezifische Daten automatisch an die Ausgabevorrichtung (202M), dem empfängerspezifischen Datenelement folgend, übermittelt (205) werden.

**4.** Verfahren nach einem der vorhergehenden Ansprüche, bei dem der Schritt des Erzeugens eines empfängerspezifischen Datenelements durch Verarbeiten von Information, die im Mikrocomputer gespeichert ist, dadurch erreicht wird, daß ein Computerprogramm, das im Speicher des Mikrocomputers gespeichert ist, ausgeführt (205) wird, um die gespeicherte Information zu verarbeiten, und das Verfahren ferner die folgenden Schritte aufweist:
Ermitteln (203), in der Informationsübertragung, eines ersten weiteren Steuersignals, das so wirkt, daß das Computerprogramm in den Speicher des Mikrocomputers (205) geladen wird.

**5.** Verfahren nach Anspruch 4, bei dem die Informationsübertragung das Computerprogramm einschließt.

**6.** Verfahren nach Anspruch 4, bei dem das erste weitere Steuersignal so wirkt, daß der Mikrocomputer angewiesen wird, ein Softwaremodul aus einem peripheren Speicher (232) zu holen.

**7.** Verfahren nach einem der vorhergehenden Ansprüche, bei dem das kombinierte Ausgangssignal des empfangenen rundgesendeten oder kabelgesendeten Programms und des empfängerspezifischen Datenelements in der Ausgabevorrichtung als Teil einer Serie von kombinierten Ausgaben abgegeben wird und die Schritte des Übermittelns des empfängerspezifischen Datenelements und des Löschens der spezifischen Speicherstelle als Antwort auf ein oder mehrere Steuersignale erfolgen.

**8.** Verfahren nach einem der vorhergehenden Ansprüche, bei dem das Verarbeiten, Erzeugen und/oder Ausgeben des Mikrocomputers von einem programmierbaren Controller als Antwort auf Steuersignale gesteuert wird, die in der rundgesendeten oder kabelgesendeten Informationsübertragung ermittelt werden.

**9.** Verfahren nach Anspruch 8, ferner mit dem folgenden Schritt: Unterbrechen (39F und 39H gemäß Fig. 3A) des Controllers, um zu bewirken, daß der Mikrocomputer zu einer spezifischen Zeit ein empfängerspezifisches Datenelement übermittelt.

**10.** Verfahren nach Anspruch 8, ferner mit dem folgenden Schritt: Anweisen (205, 39J) des Controllers, um zu bewirken, daß der Mikrocomputer ein spezifisches empfängerspezifisches Datenelement an die Ausgabevorrichtung übermittelt.

**11.** Verfahren nach Anspruch 8, bei dem der Controller in der Lage ist, ein Interruptsignal an eine Vielzahl von Prozessor- und/oder Controller-Vorrichtungen zu übermitteln, wobei das Verfahren den folgenden Schritt aufweist: Programmieren des Controllers, um eine spezifische Vorrichtung aus der Vielzahl von Prozessor- und/oder Controller-Vorrichtungen zu unterbrechen.

**12.** Verfahren nach einem der Ansprüche 8 bis 11, ferner mit den folgenden Schritten: Ermitteln eines Interruptsignals in der Informationsübertragung und Steuern des Controllers, um das ermittelte Interruptsignal an einen Prozessor oder Controller zu übermitteln.

**13.** Verfahren nach einem der Ansprüche 8 bis 12, bei dem als Antwort auf die Ermittlung des spezifischen Steuersignals in der Informationsübertragung der Mikrocomputer so organisiert wird, daß das empfängerspezifische Datenelement als Teil einer Serie von empfängerspezifischen Daten erzeugt wird und ein Prozessor-Interruptsignal in den Mikrocomputer eingegeben wird, um zu einer spezifischen Zeit die Übermittlung eines oder mehrerer spezifischer empfängerspezifischer Daten an die Ausgabevorrichtung zu ermöglichen.

**14.** Verfahren nach Anspruch 13, bei dem das Interruptsignal an den Mikrocomputer als Antwort auf ein zweites weiteres Steuersignal, das in der rundgesendeten oder kabelgesendeten Informationsübertragung ermittelt wird, eingegeben wird und das Interruptsignal bewirkt, daß der Mikrocomputer die spezifische Speicherstelle löscht und ein erzeugtes empfängerspezifisches Datenelement an der spezifischen Speicherstelle ablegt, um eine nachfolgende kombinierte Ausgabe zu bilden.

**15.** Verfahren nach Anspruch 14, bei dem ein Steuersignal, das in der rundgesendeten oder kabelgesendeten Informationsübertragung ermittelt wird, bewirkt, daß der Mikrocomputer aufhört, einen oder mehrere empfängerspezifische Daten an die Ausgabevorrichtung zu übermitteln, und beginnt oder wiederbeginnt, diese Serie zu erzeugen.

**16.** Verfahren nach einem der Ansprüche 8 bis 12, ferner mit den folgenden Schritten: Ermitteln eines Steuerprogramms in der Informationsübertragung und Bewirken, daß der Controller, einen oder mehrere Empfängerstationsvorrichtungen entsprechend dem Steuerprogramm steuert.

**17.** Verfahren nach einem der vorhergehenden Ansprüche, bei dem das empfängerspezifische Datenelement nicht automatisch an die Ausgabevorrichtung (202M) übermittelt wird, wenn das empfängerspezifische Datenelement an der Speicherstelle abgelegt wird, und das Verfahren ferner die folgenden Schritte aufweist:

Ermitteln (203), in der Informationsübertragung, eines dritten weiteren Steuersignals. das so wirkt, daß der Mikrocomputer (205) anweisen wird, das empfängerspezifische Datenelement an der Speicherstelle an die Ausgabevorrichtung zu übermitteln, wodurch bewirkt wird, daß der Mikrocomputer (205) das empfängerspezifische Datenelement an die Ausgabevorrichtung (202M) übermittelt.

**18.** Verfahren nach Anspruch 13, ferner mit dem folgenden Schritt: Bestimmen (39J), daß der Mikrocomputer nicht vorbereitet ist, ein erstes empfängerspezifisches Datenelement zu einer spezifischen Zeit an die Ausgabevorrichtung zu übermitteln, und anschließendes Bewirken (39J), daß der Mikrocomputer eine spezifische Computerprogrammanweisung ausführt, um dadurch zu beginnen, ein nachfolgendes empfängerspezifisches Datenelement dieser Serie zu erzeugen.

**19.** Verfahren nach einem der vorhergehenden Ansprüche, bei dem die Information, die im Mikrocomputer gespeichert ist, nutzerspezifische Daten aufweist und das Verfahren ferner den folgenden Schritt aufweist:

Weitergeben (203) von Aktualisierungsdaten an den Mikrocomputer (205), um dadurch zu bewirken, daß die gespeicherten Nutzerdaten aktualisiert werden, wodurch beim Erzeugen eines nachfolgenden empfängerspezifischen Datenelements die aktualisierten Nutzerdaten von dem Mikrocomputer verarbeitet werden.

**20.** Verfahren nach Anspruch 19, bei dem die Aktualisierungsdaten in der rundgesendeten oder kabelgesendeten Informationsübertragung ermittelt und von einem Decodierer (290) weitergegeben werden.

**21.** Verfahren nach Anspruch 19, bei dem die Aktualisierungsdaten in einer Informationsübertragung empfangen werden, die eine Telefonübertragung umfaßt.

**22.** Verfahren nach Anspruch 21, bei dem die Empfängerstation automatisch die Telefonübertragung für eine oder mehrere Aktualisierungsdaten auslöst.

**23.** Verfahren nach einem der vorhergehenden Ansprüche, ferner mit den folgenden Schritten: Speichern (200) von Information in der Empfängerstation, die festlegt, daß die Empfängerstation eine spezifische Informationsübertragung automatisch selektiv empfangen sollte, und selektives Empfangen (200) der Informationsübertragung entsprechend der gespeicherten Information.

**24.** Verfahren nach Anspruch 23, bei dem als Antwort auf ein Freigabe-Steuersignal die Empfängerstation befähigt wird, das rundgesendete oder kabelgesendete Programm zu empfangen, indem in einen Prozessor ein oder mehrere Computerprogrammanweisungen eingegeben (200) werden, die in der Lage sind, die Empfängerstation zu steuern (200), um die rundgesendete oder kabelgesendete Informationsübertragung zu empfangen, das Programm zu wählen und die Steuersignale zu ermitteln.

**25.** Verfahren nach Anspruch 23 oder 24, ferner mit den folgenden Schritten: Empfangen (200, Fig. 2) und Speichern (200, Fig. 2) von Vorausinformation der Übertragung des spezifischen Programms.

**26.** Verfahren nach einem der vorhergehenden Ansprüche, ferner mit den folgenden Schritten: Zusammenstellen von Aufzeichnungen (200, Fig. 2) in der Empfängerstation, die die Verfügbarkeit, Auswahl und/oder Verwendung von rundgesendeten oder kabelgesendeten Programmen, Steuersignalen und/oder Nutzerdaten aufzeichnen, und Übermitteln (200, Fig. 2) der Aufzeichnungen an eine entfernt stehende Datensammelstation.

**27.** Verfahren nach einem der vorhergehenden Ansprüche, ferner mit dem folgenden Schritt: Eingeben (225), in einen Prozessor in der Empfängerstation, von Information der Reaktion eines Nutzers auf eine Ausgabe in der Ausgabevorrichtung (202M).

**28.** Verfahren nach Anspruch 27, ferner mit dem folgenden Schritt: Verarbeiten (200, Fig. 2, oder 205) der Nutzerreaktionsinformation als Antwort auf ein viertes weiteres Steuersignal, das in der rundgesendeten oder kabelgesendeten Informationsübertragung ermittelt wird, um dadurch neben der Eingabeinformation zusätzliche Antwortinformation zu erzeugen.

**29.** Verfahren nach Anspruch 27 oder 28, ferner mit dem folgenden Schritt: Übermitteln (200, Fig. 2) mindestens eines Teils der Eingabeinformation oder der zusätzlichen Antwortinformation an eine entfernt stehende Datensammelstation.

**30.** Verfahren nach einem der vorhergehenden Ansprüche, bei dem das rundgesendete oder kabelgesendete Programm oder mindestens einige der Steuersignale, die in der Informationsübertragung enthalten sind, verschlüsselt und mit einem Signal bezeichnet sind, das eine verschlüsselte Übertragung anzeigt, und das Verfahren ferner den folgenden Schritt aufweist: Steuern (200, Fig. 2) eines Entschlüsselers in der Empfängerstation, um das Programm und die verschlüsselten Steuersignale als Antwort auf eine Ermittlung des bestimmten Signals zu entschlüsseln.

**31.** Verfahren nach einem der vorhergehenden Ansprüche, ferner mit dem folgenden Schritt: Speichern der empfangenen Informationsübertragung in einer Speichereinrichtung (217, 255 oder 256), um die Abgabe der kombinierten Ausgabe zu einer Zeit zu ermöglichen, zu der das rundgesendete oder kabelgesendete Programm nicht von der Empfängerstation empfangen wird.

**32.** Verfahren nach einem der vorhergehenden Ansprüche, bei dem die Ausgabevorrichtung eine oder mehrere aus der Gruppe ist, die aus einem Drucker (221) zum Ausgeben von gedruckter Information, einem Tongenerator (263) zum Ausgeben von Tönen, einer Videoausgabevorrichtung (202M) zum Ausgeben von Videoinformation, einer Videospeichervorrichtung (217) zum Speichern von Videoinformation, einer Tonspeichervorrichtung (255) zum Speichern von Toninformation und einem Zwischensender (92) besteht.

**33.** Verfahren nach Anspruch 32, bei dem die Ausgabevorrichtung ein Fernsehmonitor (202M) ist, die spezifische Speicherstelle ein Video-RAM ist und das empfängerzpezifische Datenelement aus der Speicherstelle gelöscht wird, indem Information einer Wechsel farbe an der Speicherstelle abgelegt wird, und die Wechsel farbe lichtdurchlässig erscheint, wenn sie in dem Monitor in Kombination mit einem Fernsehbild ausgegeben wird.

**34.** Verfahren nach Anspruch 33, bei dem die spezifische Speicherstelle des Mikrocomputers, an der das empfängerspezifische Datenelement abgelegt wird, auf der Grundlage des Bestimmens eines Referenzpunktes und einer skalaren Dimension für das empfängerspezifische Datenelement im Schritt des Erzeugens (205) des empfängerspezifischen Datenelements gewählt wird.

**35.** Verfahren nach einem der vorhergehenden Ansprüche, bei dem die Empfängerstation eine Station aus einer Vielzahl von ähnlichen Empfängerstationen ist, die die gleiche informationsübertragung empfangen, wobei das erzeugte empfängerspezifische Datenelement in jeder Station für seine Empfängerstation spezifisch ist und die Serie von empfängerspezifischen Daten, die in den Empfängerstationen erzeugt wird, sich von Station zu Station unterscheidet.

**36.** Verfahren nach Anspruch 35, bei dem eine Zeitperiode. die den Empfang des spezifischen Steuersignals durch die Empfängerstationen und den Empfang der des dritten weiteren Steuersignals durch die Empfängerstationen trennt, ausreicht, daß jeder Empfängerstationsmikrocomputer den Schritt des Erzeugens beenden kann, bevor jeder Empfängerstationsmikrocomputer das erste weitere Steuersignal empfängt.

**37.** Empfängerstationsgerät zur Verarbeitung von Signalen, um eine kombinierte Ausgabe eines rundgesendeten oder kabelgesendeten Programms und eines von einem empfängerspezifischen Computer erzeugten Datenelements abzugeben, wobei die Station eine Ausgabevorrichtung (202M) zum Abgeben des rundgesendeten oder kabelgesendeten Programms und anderer Information aufweist, wobei das Gerät umfaßt:

einen Decodierer (203) mit Einrichtungen zum:

(1) Empfangen einer Informationsübertragung, die ein rundgesendetes oder kabelgesendetes Programm und ein oder mehrere Steuersignale umfaßt;
(2) Ermitteln des Vorhandenseins von Steuersignalen in der Informationsübertragung; und
(3) Weitergeben der ermittelten Steuersignale an einen Mikrocomputer (205);

wobei der Mikrocomputer (205) betriebsfähig mit der Ausgabevorrichtung (202M) und dem Decodierer (203) verbunden ist, wobei der Mikrocomputer (205) eine spezifische Speicherstelle (PC-MicroKey des Mikrocomputers 205) aufweist, die mit der Ausgabevorrichtung (202M) verbunden ist, zum Übermitteln von Daten, die an der spezifischen Speicherstelle (PC-MicroKey des Mikrocomputers 205) gespeichert sind, an die Ausgabevorrichtung (202M) und der Mikrocomputer (205) so programmiert wird, daß die folgenden Schritte auf der Grundlage eines oder mehrerer spezifischer Steuersignale durchgeführt werden:

(1) Erzeugen eines empfängerspezifischen Datenelements durch Verarbeiten von Information, die in dem Mikrocomputer (205) gespeichert ist, als Antwort auf das Empfangen eines spezifischen Signals;
(2) Ablegen des empfängerspezifischen Datenelements an der spezifischen Speicherstelle (PC-MicroKey des Mikrocomputers 205);
(3) Übermitteln des empfängerspezifischen Datenelements an der Speicherstelle an die Ausgabevorrichtung (202M); und nachfolgendes
(4) Löschen des Datenelements aus der spezifischen Speicherstelle (PC-MicroKey des Mikrocomputers 205), wodurch eine kombinierte Ausgabe des empfangenen rundgesendeten oder kabelgesendeten Programms und des empfängerspezifischen Datenelements in der Ausgabevorrichtung (202M) in der Zeitperiode zwischen dem Schritt des Ablegens des Datenelements an der Speicherstelle (PC-MicroKey des Mikrocomputers 205) und dem Schritt des Löschens des Datenelements aus der Speicherstelle (PC-MicroKey des Mikrocomputers 205) abgegeben wird.

**38.** Gerät nach Anspruch 37, bei dem die Ausgabevorrichtung eine Videoausgabevorrichtung (202M) und das ermittelte Steuersignal ein Signal ist, das den Mikrocomputer (205) so steuert, daß ein empfängerspezifisches Videodatenelement an der spezifischen Speicherstelle abgelegt wird, wobei das Gerät ferner einen Videoausgabespeicher (PC-MicroKey von 205) aufweist, der mit dem Mikrocomputer (205) und der Videoausgabevorrichtung (202M) verbunden ist, zum Übermitteln von Videoinformation an die Videoausgabevorrichtung (202M).

**39.** Gerät nach Anspruch 37 oder 38, bei dem die Ausgabevorrichtung eine Tonausgabevorrichtung (263) und das ermittelte Steuersignal ein Signal ist, das den Mikrocomputer (205) so steuert, daß ein spezifisches Tondatenelement an der spezifischen Speicherstelle abgelegt wird, wobei das Gerät ferner eine Tonausgabespeicherstelle (Ton-RAM von 205), die mit dem Mikrocomputer (205) und der Tonausgabevorrichtung (263) verbunden ist, zum Übermitteln von Toninformation an die Tonausgabevorrichtung (263) aufweist.

**40.** Gerät nach einem der Ansprüche 37 bis 39, ferner mit einem programmierbaren Controller (39 des Decodierers 203), der mit dem Mikrocomputer (205) verbunden ist, zum Steuern des Verarbeitens, Erzeugens und/oder Ausgebens des Mikrocomputers (205) als Antwort auf Steuersignale, die in einer rundgesendeten oder kabelgesendeten Informationsübertragung ermittelt werden.

**41.** Gerät nach Anspruch 40, bei dem der Controller (39 in Fig. 2A, 44 in Fig. 2B, 47 in Fig. 2C) betriebsfähig mit dem Decodierer (203) verbunden ist, wobei das Gerät ferner einen programmierbaren Steuerprozessor (39J in Fig. 3A) zum Steuern der Übermittlung von Information, die in der Informationsübertragung ermittelt wird, aufweist.

**42.** Gerät nach Anspruch 41, bei dem der Steuerprozessor (39J) ein Computerprogramm in einen gewählten Prozessor (39J, CPU von 205) oder Controller (39, 20 von 200) eingibt oder bewirkt, daß ein gewählter Prozessor (39J, CPU von 205) oder Controller (39, 20 von 200) eine Art und Weise der Identifizierung oder Beantwortung eines Steuersignals in der Informationsübertragung modifiziert, wobei das Gerät ferner ein selektives Übertragungsgerät (13 in Fig. 2D, 39I in Fig. 3A, 259 in Fig. 7) zum Übermitteln von Information, die in der Informationsübertragung ermittelt wird, an den gewählten Prozessor (39J, CPU von 205) oder Controller (39, 20 von 200) aufweist.

**43.** Gerät nach Anspruch 42, bei dem die selektive Übertragungsvorrichtung (13 in Fig. 2D, 39I in Fig. 3A, 259 in Fig. 7) ein Bus (13 in Fig. 2D), ein Matrixschalter (39I) oder ein Digitalschalter (39I) ist.

**44.** Gerät nach einem der Ansprüche 41 bis 43, wobei irgendeiner, nämlich der Controller (39), der Steuerprozessor (39J) oder der Mikrocomputer (205) eine Vielzahl von Prozessoren (39B, 39D, 39J) auf einem einzigen Mikrochip (39, Fig. 3A) aufweist.

**45.** Gerät nach einem der Ansprüche 37 bis 44, bei dem der Mikrocomputer (205) eine Eingabe empfängt, die ein Computerprogramm und ein oder mehrere Interruptsignale aufweist, und das empfängerspezifische Datenelement entsprechend dem Computerprogramm erzeugt oder die spezifische Speicherstelle als Antwort auf das eine oder mehrere Interruptsignale löscht, wobei das Gerät ferner einen oder mehrere Puffer (8, 39A, 39C, 39E, 39G, in 205) oder Speicher (in 39B, in 39D, in 39J, 217, 217A) zum Speichern und Übermitteln des Computerprogramms an den Mikrocomputer (205) aufweist.

**46.** Gerät nach einem der Ansprüche 37 bis 45, bei dem der Prozessor (39J, 200) eine Steueranweisung auf der Grundlage einer Aufzeichnung des Vorhandenseins oder Nichtvorhandenseins eines Programms oder eines empfängerspezifischen Datenelements übermittelt, wobei das Gerät ferner einen Speicher (Registerspeicher für die erste SPAM-Vorbedingung und für die zweite SPAM-Vorbedingung (in 39J; in 20, 14 oder 16 in 200)) zum Speichern einer oder mehrerer Aufzeichnungen des Vorhandenseins oder Nichtvorhandenseins eines Programms oder eines empfängerspezifischen Datenelements aufweist.

**47.** Gerät nach Anspruch 45, wenn dieser von Anspruch 40 abhängig ist, oder nach Anspruch 46, wobei der Controller (39 des Decodierers 203) ein Interruptsignal in den Mikrocomputer (205) eingibt, um zu bewirken, daß der Mikrocomputer (205) zu einer spezifischen Zeit ein empfängerspezifisches Datenelement übermittelt.

**48.** Gerät nach einem der Ansprüche 37 bis 47, bei dem ein empfängerspezifisches Datenelement als Antwort auf eine Reaktion des Nutzers auf eine Ausgabe in dem Ausgabegerät (202M) ausgegeben wird, wobei das Gerät ferner aufweist: eine Eingabevorrichtung (225) zum Eingeben von Information einer Reaktion eines Nutzers auf eine Ausgabe und einen Prozessor (200, CPU von 205), der betriebsfähig mit der Eingabevorrichtung (225) verbunden ist, zum Verarbeiten der eingegebenen Information einer Reaktion eines Nutzers.

**49.** Gerät nach einem der Ansprüche 37 bis 48, bei dem die Station an eine entfernt stehende Station eine Aufzeichnung ausgibt, die die Verfügbarkeit, den Zweck und/oder die Verwendung eines Programms, eines Steuersignals oder einer kombinierten Ausgabe in der Empfängerstation oder eine gewisse Eingabe der Reaktion eines Nutzers auf eine kombinierte Ausgabe eines empfangenen rundgesendeten oder kabelgesendeten Programms und eines empfängerspezifischen Datenelements in der Ausgabevorrichtung (202M) aufzeichnet, wobei das Gerät ferner eine Übertragungsvorrichtung (Telefonanschluß 22) zur Übermittlung einer Eingabe an eine entfernt stehende Station aufweist.

**50.** Gerät nach einem der Ansprüche 37 bis 49, bei dem das spezifische Steuersignal bewirkt, daß der Mikrocomputer (205) Daten, die in einer Computerperipherieeinrichtung (A: Plattenlaufwerk des Computers 205) gespeichert sind. anspricht und auffindet, wobei das Gerät ferner eine Computerperipheriespeichereinheit (232, 256), die mit dem Mikrocomputer (205) verbunden ist, zum Speichern der aufzufindenden Daten aufweist.

**51.** Gerät nach einem der Ansprüche 37 bis 50, ferner mit einem Speicher (in 20 von 200), der mit einem Empfänger (Mischer 3 gemäß Fig. 2) verbunden ist, zum Speichern von Information eines gewählten Programms und zum Empfangen von Information einer Zeit oder Frequenz der Übertragung des Programms von einer entfernt stehenden Station und mit einem Controller (20). der mit dem Speicher (in 20) und mit einem Tuner (214) verbunden ist, um zu bewirken, daß die Station das gewählte Programm zu der Zeit oder in der Frequenz empfängt.

**52.** Gerät nach einem der Ansprüche 37 bis 51, ferner mit einer Speichervorrichtung (217, 255, 256), die mit einem Empfänger (201, 215) oder einer Ausgabevorrichtung (202M) verbunden ist, zum Empfangen und Speichern, wodurch mindestens gewisse Information eines empfangenen Programms und eines empfangenen Steuersignals oder eines empfängerspezifischen Datenelements für eine zeitverschobene Ausgabe an den Nutzer gespeichert wird.

**53.** Gerät nach einem der Ansprüche 37 bis 52, ferner mit einem Entschlüsseler oder Entwürfler (224), der mit einem Empfänger (201) verbunden ist, um ein Entschlüsseln oder Entwürfeln der Information eines empfangenen Programms oder eines empfangenen Steuersignals, das verschlüsselt oder verwürfelt ist, zu ermöglichen.

**54.** Gerät nach einem der Ansprüche 37 bis 53, ferner mit einer selektiven Übertragungsvorrichtung (258) zum Übermitteln des Programms von einem Empfänger (201, 215) oder einer Speichervorrichtung (217, 217A) an eine Speichervorrichtung (217, 217A) oder eine Ausgabevorrichtung (202M).

**55.** Gerät nach einem der Ansprüche 37 bis 54, bei dem die Informationsübertragung eine Mehrkanalübertragung ist, wobei das Gerät ferner einen Umsetzer (201) zum Empfangen und Umsetzen eines gewissen Abschnitts der Mehrkanalübertragung und zum Umsetzen eines gewissen Abschnitts der Mehrkanalübertragung in eine spezifische Ausgangsfrequenz aufweist.

**56.** Gerät nach einem der Ansprüche 37 bis 55, ferner mit einem Drucker (221) und einer Druckausgabespeicherstelle (Druckpuffer von 205). die mit dem Mikrocomputer (205) und dem Drucker (221) verbunden ist, zur Übermittlung von Druckinformation an den Drucker (221).

**57.** Gerät nach einem der Ansprüche 37 bis 56, bei dem das Programm ein Fernsehprogramm ist, wobei das Gerät ferner einen Fernsehtuner (215) zum Empfangen eines Fernsehsignals, das das Programm enthält, und einen Fernsehmonitor zum Ausgeben des Fernsehprogramms und des empfängerspezifischen Datenelements aufweist.

**58.** Gerät nach Anspruch 37 und einem der Ansprüche 39 bis 56, wobei das Programm ein Hörfunkprogramm ist, wobei das Gerät ferner einen Hörfunktuner (209T) zum Empfangen eines Hörfunkprogramms und ein Lautsprechersystem (263) zum Ausgeben des Programms und des empfängerspezifischen Datenelements aufweist.

**59.** Verfahren zum Übermitteln eines Massenmediumprogrammaterials an eine Vielzahl von Empfängerstationen, von denen jede aufweist: einen Empfänger für rundgesendete oder kabelgesendete Programme (Tuner 215), eine Ausgabevorrichtung (202M), einen Steuersignaldetektor (Decodierer 203), einen Mikrocomputer (205) mit einer spezifischen Speicherstelle (PC-MicroKey des Mikrocomputers 205), der in der Lage ist, an die Ausgabevorrichtung (202M) zu übermitteln, und wobei jede Empfängerstation geeignet ist, das Vorhandensein eines oder mehrerer Steuersignale zu ermitteln, ein empfängerspezifisches Datenelement als Antwort auf das ermittelte spezifische Steuersignal zu erzeugen und in der Ausgabevorrichtung eine kombinierte Ausgabe des rundgesendeten oder kabelgesendeten Programms und des empfängerspezifischen Datenelements abzugeben, wobei das Verfahren des Übermittelns die folgenden Schritte aufweist:

(1) Empfangen eines zu übertragenden Programms und Abgeben des Programms an einen Sender;
(2) Empfangen und Speichern eines Steuersignals, das in der Empfängerstation wirkt, um das empfängerspezifische Datenelement zu erzeugen; und
(3) Bewirken, daß das gespeicherte Steuersignal zu einer spezifischen Zeit an den Sender übermittelt wird,

um dadurch eine Informationsübertragung, die das Programm und ein oder mehrere Steuersignale umfaßt, zu übertragen.

**60.** Verfahren nach Anspruch 59, bei dem die Informationsübertragung zur gleichen Zeit an zwei Stationen aus der Vielzahl der Empfängerstationen übertragen wird und jede der beiden Empfängerstationen ihre kombinierte Ausgabe des empfangenen rundgesendeten oder kabelgesendeten Programms abgibt und ihr erzeugtes empfängerspezifisches Datenelement in der gleichen Zeitperiode in ihrer Ausgabevorrichtung (202M) abgibt.

**61.** Verfahren nach Anspruch 59, bei dem die Informationsübertragung zu verschiedenen Zeiten an zwei aus der Vielzahl von Empfängerstationen übertragen wird und jede der beiden Empfängerstationen ihre kombinierte Ausgabe des empfangenen rundgesendeten oder kabelgesendeten Programms und ihr erzeugtes empfängerspezifisches Datenelement in einer anderen Zeitperiode in ihrer Ausgabevorrichtung (202M) abgibt.

**62.** Verfahren nach einem der Ansprüche 59 bis 61, bei dem eine Speicherstelle mit einem Computer zum Empfangen und Speichern gewisser Information des Steuersignals betriebsfähig verbunden ist, wobei das Verfahren ferner die folgenden Schritte aufweist: Ermitteln eines Signals, das in der Senderstation wirksam ist, um zu erzeugen, und Eingeben des Sender-Erzeugungssignals in den Computer, um dadurch zu bewirken, daß der Computer gewisse Information des Steuersignals erzeugt und die erzeugte Information an der Speicherstelle ablegt.

**63.** Verfahren nach Anspruch 62, ferner mit dem folgenden Schritt: Programmieren des Computers, um auf das Sender-Erzeugungssignal zu antworten, indem Information, die in dem Computer gespeichert ist, verarbeitet wird.

**64.** Verfahren nach Anspruch 62 oder 63, bei dem der Computer spezifische Formel-und-Artikel-dieser-Übertragung-Information als Antwort auf das Sender-Erzeugungssignal verarbeitet, ferner mit den folgenden Schritten: Eingeben der Formel-und-Artikel-Daten in den Computer.

**65.** Verfahren nach einem der Ansprüche 62 bis 64, das ferner umfaßt: Erzeugen eines gewissen Abschnitts eines eines Computerprogramms und eines Datenmoduls als Antwort auf das Sender-Erzeugungssignal.

**66.** Verfahren nach einem der Ansprüche 59 bis 65, ferner mit den folgenden Schritten: Bewirken, daß eine Speicherstelle, die in der Lage ist, ein Computerprogramm zu speichern und zu übermitteln, ein Computerprogramm an einen Sender übermittelt, um das Computerprogramm zu übertragen, um dadurch zu bewirken, daß mindestens eine Empfängerstation das Computerprogramm in einen Prozessor lädt und bewirkt, daß der Prozessor unter Steuerung des Computerprogramms Information erzeugt und ausgibt.

**67.** Verfahren nach Anspruch 66, ferner mit dem folgenden Schritt: Zusammenstellen des gespeicherten und übermittelten Computerprogramms zu einer Nachricht mit einer Vielzahl von Segmenten, wobei das Computerprogramm sich in einem spezifischen Teil der Nachricht befindet und die Nachricht Information aufweist, die bewirkt, daß mindestens eine Empfängerstation das Computerprogramm in einen gewählten Prozessor aus einer Vielzahl von Prozessoren eingibt.

**68.** Verfahren nach Anspruch 66 oder 67, ferner mit den folgenden Schritten: Bewirken, daß eine Speicherstelle, die in der Lage ist, ein Anweisungssignal zu speichern und zu übermitteln, um das Anweisungssignal an einen Computer zu übermitteln, um als Antwort darauf einen Abschnitt des Computerprogramms in dem Computer zu erzeugen.

**69.** Verfahren nach einem der Ansprüche 59 bis 68, bei dem die Senderstation eines oder mehrerer Signale, nämlich ein Video-, ein Ton- und/oder ein Datensignal, das von der entfernt stehenden Station kommend empfangen wird, überträgt, wobei das Verfahren ferner den folgenden Schritt aufweist: Speichern des empfangenen einen oder mehrerer Signale, nämlich des Video-, Ton- und/oder Datensignals, für eine Zeitperiode, wodurch eine Übertragung des empfangenen einen oder mehrerer Signale, nämlich des Video-, Ton- und/oder Datensignals, verzögert wird.

**70.** Verfahren nach einem der Ansprüche 59 bis 69, bei dem ein Controller das Weitergeben eines spezifischen empfangenen Signals steuert, wobei das Verfahren ferner die folgenden Schritte aufweist: Ermitteln von eingebetteter Information in dem spezifischen empfangenen Signal und Steuern des Weitergebens des spezifischen empfangenen Signals auf der Grundlage der ermittelten eingebetteten Information.

**71.** Verfahren nach Anspruch 70, bei dem der Controller einen Schalter steuert, wobei das Verfahren ferner umfaßt: Steuern des Schalters, um Signale selektiv von einem oder mehreren Programmeingabeempfängern und einem oder mehreren Speicherstellen an eine oder mehrere Speicherstellen oder einen oder mehrere Sender zu übermitteln.

**72.** Verfahren nach Anspruch 71, bei dem die Senderstation eine Vielzahl von Nachrichten an eine Station aus der Vielzahl von Empfängerstationen überträgt, um die eine Empfängerstation zu steuern, um ihre kombinierte Ausgabe des Programms und ihres empfängerspezifischen Datenelements in ihrer Ausgabevorrichtung auszugeben, wobei das Verfahren ferner die folgenden Schritte aufweist: Übermitteln eines Signals, das eine Nachricht aus der Vielzahl von Nachrichten enthält, von einem Programmeingabeempfänger an eine Speicherstelle und nachfolgendes Übermitteln des Signals, das die eine Nachricht aus der Vielzahl von Nachrichten enthält, von dieser Speicherstelle an einen Sender.

**73.** Verfahren nach einem der Ansprüche 70 bis 72, bei dem die Senderstation mindestens ein Programm speichert, wobei das Verfahren ferner die Schritte aufweist: Empfangen des Programms in einem Programmeingabeempfänger, Übermitteln des Programms an eine Speichervorrichtung und Speichern des Programms in der Speichervorrichtung mit einem Anweisungssignal, das in der Senderstation so wirksam ist, daß einer. nämlich der Computer oder der Controller gesteuert wird.

**74.** Verfahren nach Anspruch 73, ferner mit den folgenden Schritten: Ermitteln des Anweisungssignals und Übermitteln des Anweisungssignals an einen, nämlich den Computer oder den Controller.

**75.** Verfahren nach Anspruch 71 oder nach einem der Ansprüche 72 bis 74, wenn diese vom Anspruch 71 abhängig sind, ferner mit dem folgenden Schritt: Steuern des Schalters auf der Grundlage des Vorhandenseins oder Nichtvorhandenseins eines Anweisungssignals, das mit einem Programm gespeichert ist.

**76.** Verfahren nach einem der Ansprüche 59 bis 75. bei dem die Senderstation eine Vielzahl von Programmeingabeempfängern aufweist, wobei das Verfahren ferner die folgenden Schritte aufweist: Verarbeiten von Signalen, die in der Vielzahl von Programmeingabeempfängern empfangen werden, Übermitteln von Steuerinformation als Antwort auf ein eingebettetes Datenelement und Steuern des Weitergebens eines Signals, das in einem spezifischen Empfänger aus der Vielzahl von Programmeingabeempfängern empfangen wird, auf der Grundlage der übermittelten Steuerinformation.

**77.** Verfahren nach einem der Ansprüche 59 bis 76, bei dem das Programm und das Empfänger-Erzeugungssignal von einem oder mehreren entfernt stehenden Stationen kommend empfangen werden, wobei das Verfahren ferner die folgenden Schritte aufweist: Verarbeiten eines Signals, das von der einen oder mehreren entfernt stehenden Stationen kommend empfangen wird und Steuern der Senderstation, um das Programm an einen Sender oder das Empfänger-Erzeugungssignal an einen Computer zu übermitteln, und zwar auf der Grundlage von Information in dem verarbeiteten. empfangenen Signal.

**78.** Verfahren nach einem der Ansprüche 59 bis 77, ferner mit den folgenden Schritten: Empfangen des Programms in einem Empfänger in der Empfängerstation, Übermitteln des Programms von dem Empfänger an die Speicherstelle und Speichern des Programms an der Speicherstelle für eine Zeitperiode vor dem Übermitteln des Programms an einen Sender.

**79.** Verfahren nach Anspruch 78, ferner mit den folgenden Schritten: Empfangen des Programms in einem gewählten Empfänger aus einer Vielzahl von Empfängern in der Senderstation und Übermitteln des Programms von dem gewählten Empfänger an einen Sender.

**80.** Verfahren nach einem der Ansprüche 78 bis 79, ferner mit den folgenden Schritten: Übertragen des Programms in einem gewählten Sender aus einer Vielzahl von Sendern und Übermitteln des Programms an den gewählten Sender.

**81.** Verfahren nach einem der Ansprüche 59 bis 80, bei dem ein Schalter empfangene Signale selektiv von mindestens einem Empfänger und mindestens einer Speicherstelle an einen Sender übermittelt, wobei das Verfahren ferner die folgenden Schritte aufweist: Eingeben eines Signals, das in der Senderstation so wirkt, daß eine Übermittlung angewiesen wird, und Steuern des Schalters, um ein empfangenes Signal von einem Empfänger an eine Speicherstelle zu übermitteln, und zwar als Antwort auf das Anweisungssignal.

**82.** Verfahren nach Anspruch 81, wenn dieser von Anspruch 62 abhängig ist. wobei das empfangene Signal das Sender-Erzeugungssignal enthält, wobei das Verfahren ferner den folgenden Schritt aufweist: nachfolgendes Übermitteln mindestens eines Teils des Sender-Erzeugungssignals von der Speicherstelle an die zweite Speicherstelle.

**83.** Verfahren nach Anspruch 81, bei dem das empfangene Signal das Programm enthält, wobei das Verfahren ferner den folgenden Schritt aufweist: Steuern des Schalters, um das Programm an einen Sender zu übermitteln.

**84.** Verfahren nach einem der Ansprüche 59 bis 83, bei dem eine Vielzahl von Signalen von einer oder mehreren entfernt stehenden Stationen in der Senderstation empfangen wird, wobei das Verfahren ferner die folgenden Schritte aufweist: Wählen eines oder mehrerer Signale aus der Vielzahl von Signalen und Übermitteln jedes gewählten Signals an eine Speichervorrichtung.

**85.** Verfahren nach Anspruch 84, wenn dieser von Anspruch 70 abhängig ist, wobei eines oder mehrere des gewählten Signals ein Signal ist, das in der Senderstation so wirkt, daß einer, nämlich der Computer oder der Controller angewiesen wird, wobei das Verfahren ferner den folgenden Schritt aufweist: Bewirken, daß eine Speicherstelle das Anweisungssignal vor der spezifischen Zeit übermittelt, und Steuern des einen, nämlich des Computers oder des Controllers als Antwort auf das Anweisungssignal.

**86.** Verfahren nach einem der Ansprüche 59 bis 85, bei dem eine Vielzahl von Signalen von einer oder mehreren entfernt stehenden Stationen empfangen wird und mindestens eines in der Senderstation gespeichert wird und ein Signal aus der Vielzahl von empfangenen Signalen nach einem Plan betriebsfähig ist, wobei das Verfahren ferner die folgenden Schritte aufweist: Programmieren der Senderstation, um den Plan zu speichern und bewirken, daß der Sender entsprechend dem Plan überträgt.

**87.** Verfahren nach Anspruch 86, ferner mit dem folgenden Schritt: Bewirken, daß die Senderstation entsprechend dem Plan erzeugt.

**88.** Verfahren nach Anspruch 86 oder 87. ferner mit dem folgenden Schritt: Abstimmen eines Empfängers oder Steuern einer Satelliten-Erdstation, um ein Signal entsprechend dem Plan zu empfangen.

**89.** Verfahren nach einem der Ansprüche 59 bis 88, ferner mit den folgenden Schritten: Empfangen einer Informationsübertragung von einer entfernt stehenden Station, Ermitteln, in der Informationsübertragung, eines Anweisungssignals, das in der Senderstation so wirkt, daß ein Anweisungssatz ausgeführt wird, Laden eines Anweisungssatzes in einen Computer als Antwort auf das Anweisungssignal und, auf der Grundlage des Anweisungssatzes, Wählen von Information, die in der Empfängerstation zu verarbeiten ist, oder Übermitteln von Information, die mit dem Programm im Zusammenhang steht.

**90.** Verfahren nach einem der Ansprüche 59 bis 89, bei dem ein Controller eine Speicherstelle steuert, um an einen Sender ein gewähltes Steuersignal zu übermitteln, wobei das Verfahren ferner die folgenden Schritte aufweist: Ermitteln eines Signals, das in der Senderstation so wirkt, daß eine Übertragung angewiesen wird, und Eingeben des Signals in den Controller, um dadurch zu bewirken, daß die Speicherstelle ein gewähltes Steuersignal übermittelt.

**91.** Verfahren nach Anspruch 90, ferner mit dem folgenden Schritt: Programmieren des Controllers, um auf das Signal zu antworten, indem eine gewählte Speicherstelle gesteuert wird, um ein Steuersignal zu übermitteln, oder indem bewirkt wird, daß eine Speicherstelle ein gewähltes Steuersignal übermittelt.

**92.** Verfahren nach Anspruch 90 oder 91, bei dem das Übertragungsanweisungssignal in einer von einer entfernt stehenden Station übertragenen rundgesendeten oder kabelgesendeten Informationsübertragung empfangen wird.

**93.** Verfahren nach einem der Ansprüche 90 bis 92, ferner mit den folgenden Schritten: Speichern eines Signals, das in der Empfängerstation so wirkt, daß angewiesen wird, und Steuern der Speicherstelle, um ein gewähltes Steuersignal in einer geplanten Zeit entsprechend dem Anweisungssignal zu übermitteln.

**94.** Verfahren nach einem der Ansprüche 90 bis 93, ferner mit dem folgenden Schritt: Speichern des Signals an der Speicherstelle mit dem Programm.

**95.** Verfahren nach einem der Ansprüche 90 bis 94, ferner mit den folgenden Schritten: Steuern einer Speicherstelle, um das Programm als Antwort auf ein erstes Anweisungssignal an einen Sender zu übermitteln, und Steuern einer Speicherstelle, um ein gewähltes Steuersignal als Antwort auf ein zweites Anweisungssignal zu übermitteln.

**96.** Verfahren nach Anspruch 95, ferner mit den folgenden Schritten: Ermitteln eines Steuersignals, das von der Speicherstelle übermittelt wird, und Programmieren eines Controllers, um auf ein von der Speicherstelle übermitteltes Steuersignal zu antworten.

**97.** Verfahren nach einem der Ansprüche 90 bis 96, ferner mit dem folgenden Schritt: Einbetten eines Anweisungssignals in das Programm, um dadurch einen Controller in die Lage zu versetzen, in einer Zeit, in der das Programm übermittelt wird, auf das eingebettete Anweisungssignal zu antworten.

**98.** Verfahren nach Anspruch 64 und nach einem der Ansprüche 65 bis 97, wenn diese von Anspruch 64 abhängig sind, wobei das Sender-Erzeugungssignal oder die Formel-und-Artikel-Daten in einer von einer entfernt stehenden Station übertragenen rundgesendeten oder kabelgesendeten Informationsübertragung empfangen werden, wobei das Verfahren ferner die folgenden Schritte aufweist: Empfangen eines Anweisungssignals von einer entfernt stehenden Station und Übertragen der Formel-und-Artikel-Information als Antwort darauf.

**99.** Verfahren nach einem der Ansprüche 59 bis 98, ferner mit den folgenden Schritten: Speichern eines Signals, das in der Übertragungsstation so wirkt, daß eine Erzeugung angewiesen wird, und Steuern eines Computers, um vor der spezifischen Zeit entsprechend dem gespeicherten Anweisungssignal gespeicherte Information zu verarbeiten.

**100.** Verfahren nach einem der Ansprüche 59 bis 99, ferner mit den folgenden Schritten: Speichern und Übertragen, an eine Empfängerstation, von Daten, die eine Übertragungzeit oder einen Übertragungskanal oder eine gewisse Sparte eines spezifischen Programms festlegen, und nachfolgendes Übertragen des Programms entsprechend den festgelegten Daten, um dadurch zu ermöglichen, daß die Empfängerstation das Programm wählt und speichert oder wählt und ausgibt.

**101.** Verfahren nach einem der Ansprüche 59 bis 100, ferner mit den folgenden Schritten: Übertragen, an eine Empfängerstation, eines Steuersignals, um zu bewirken, daß die Empfängerstation sich nach einem Parallelverarbeitungssystem ausrichtet und gewisse Information, die mit einem in einer rundgesendeten oder kabelgesendeten Informationsübertragung übertragenen Programm oder Steuersignal im Zusammenhang steht, auswählt und in einen Mikrocomputer eingibt und bewirkt, daß der Mikrocomputer gespeicherte Information verarbeitet und als Antwort auf die eingegebene Information eine Ausgabe erzeugt.

**102.** Verfahren nach Anspruch 100 oder 101, ferner mit den folgenden Schritten: Übermitteln, an einen Signalgenerator, von Daten, die eine Übertragungszeit oder einen Übertragungskanal oder eine gewisse Sparte eines spezifischen Programms festlegen, oder eines Steuersignals und Anfügen der übermittelten Daten oder des Steuersignals an einen spezifischen Teil einer rundgesendeten oder kabelgesendeten Informationsübertragung oder Anfügen der übermittelten Daten oder des übermittelten Steuersignals an eine rundgesendete oder kabelgesendete Informationsübertragung in einer Nachricht eines spezifischen Formats.

**103.** Verfahren nach einem der Ansprüche 59 bis 102, ferner mit den folgenden Schritten: Bewirken, daß eine Speicherstelle, die in der Lage ist, ein Signal zu speichern und zu übermitteln, das im Empfängerstation so wirkt, daß synchronisiert wird, das Signal an einen Sender übermittelt, um das Signal zu übertragen, um dadurch zu bewirken, daß mindestens eine Empfängerstation beginnt, gewählte gesteuerte Funktionen, die in der einen Station programmiert werden, als Antwort auf gewählte Information in der von dem Sender übertragenen rundgesendeten oder kabelgesendeten Information auszuführen.

**104.** Verfahren nach einem der Ansprüche 59 bis 103, ferner mit den folgenden Schritten: Bewirken, daß eine Speicherstelle, die in der Lage ist, ein Signal zu speichern und zu übermitteln, das in der Empfängerstation so wirkt, daß unterbrochen wird, das Signal an einen Sender übermittelt, um das Signal zu übertragen, um dadurch zu bewirken, daß als Antwort darauf mindestens eine Empfängerstation die Verarbeitung eines gewählten Mikrocomputers, Controllers oder Prozessors unterbricht.

**105.** Verfahren nach einem der Ansprüche 59 bis 104, ferner mit den folgenden Schritten: Bewirken, daß eine Speicherstelle, die in der Lage ist, ein Signal zu speichern und zu übermitteln. das in der Empfängerstation so wirkt, daß es als Quelle dient, aus der ein zu erzeugendes empfängerspezifisches Datenelement zu wählen ist, das Signal an einen Sender übermittelt, um das Signal zu übertragen, um dadurch zu bewirken, daß mindestens eine Empfängerstation ein zu erzeugendes empfängerspezifisches Datenelement wählt.

**106.** Verfahren nach Anspruch 105. bei dem das Signal, das in der Empfängerstation so wirkt, daß es als Quelle dient, vor dem Empfänger-Erzeugungssignal übertragen wird, wodurch mindestens eine Empfängerstation in dem Quellsignal empfangene Daten speichert und ein empfängerspezifisches Datenelement erzeugt, indem die gespeicherten Daten verarbeitet werden.

**107.** Verfahren nach einem der Ansprüche 59 bis 106, ferner mit den folgenden Schritten: Bewirken, daß eine Speicherstelle, die in der Lage ist, ein Signal zu speichern und zu übermitteln, das in der Empfängerstation so wirkt, daß ein Kombinieren beendet wird, das Signal an einen Sender übermittelt, um das Signal zu übertragen, um dadurch zu bewirken, daß mindestens eine Empfängerstation das Kombinieren ihres erzeugten empfängerspezifischen Datenelements zu einer spezifischen Zeit beendet.

**108.** Verfahren nach einem der Ansprüche 59 bis 107, ferner mit den folgenden Schritten: Bewirken, daß eine Speicherstelle, die in der Lage ist, ein Signal zu speichern und zu übermitteln, das in der Empfängerstation so wirkt, daß kombiniert wird, das Signal an einen Sender übermittelt, um das Signal zu übertragen, um dadurch zu bewirken, daß mindestens eine Empfängerstation eine kombinierte Ausgabe des empfangenen rundgesendeten oder kabelgesendeten Programms und des empfängerspezifischen Datenelements in ihrer Ausgabevorrichtung zu einer spezifischen Zeit abgibt.

**109.** Verfahren nach einem der Ansprüche 59 bis 108, ferner mit den folgenden Schritten: Bewirken, daß eine Speicherstelle, die in der Lage ist, ein Signal zu speichern und zu übermitteln, das in der Empfängerstation so wirkt, daß ein erzeugtes empfängerspezifisches Datenelement gelöscht wird, das Signal an einen Sender übermittelt, um das Signal zu übertragen, um dadurch zu bewirken, daß mindestens eine Empfängerstation als Antwort darauf ihr erzeugtes empfängerspezifisches Datenelement löscht.

**110.** Verfahren nach einem der Ansprüche 59 bis 109, ferner mit dem folgenden Schritt: Ermitteln eines Signals, das in der Senderstation so wirkt, daß es eine Erzeugung anweist, in einem Signal, nämlich einem Fernsehsignal oder einem Rundfunksignal oder an einer Speicherstelle, die ein Programm, nämlich ein Fernsehprogramm oder ein Funkprogramm speichert.

**111.** Verfahren nach einem der Ansprüche 59 bis 110, bei dem die Empfängerstation eine entfernt stehende Zwischensenderstation ist, die Ausgabevorrichtung (202M) ein Sender (83, 87, 91, 92) ist, der Mikrocomputer (205) eine automatische Steuereinheit (73) für die Zwischensenderstation ist und die spezifische Speicherstelle ein Programm-gesetzt-zum-Übertragen-Speicher ist, wobei das Verfahren ferner die Schritte umfaßt:

(1) Empfangen eines oder mehrerer Anweisungssignale, die in der Teilnehmerstation so wirken, daß ein Computer (73, 205) oder Prozessor (in 71, 200, 39J) angewiesen wird in bezug auf eine Art und Weise des Empfangens oder Darbietens von Fernsehprogrammaterial oder Computerausgabe oder des Funktionierens auf der Grundlage einer Zuschauerreaktion auf ein Fernsehprogramm- oder Computerausgabedarbietung und des Abgebens des einen oder mehrerer Anweisungssignale an einen Sender;
(2) Empfangen eines oder mehrerer Steuersignale, die in der entfernt stehenden Zwischensenderstation so wirken, daß sie den einen oder mehrere Anweisungssignale ausführen oder übermitteln; und
(3) Bewirken, daß einer oder mehrere Steuersignale vor der spezifischen Zeit an den Sender übermittelt werden,

um dadurch eine Informationsübertragung zu übertragen, die einen oder mehrere Anweisungssignale und ein oder mehrere Steuersignale aufweist.

**112.** Verfahren nach einem der Ansprüche 59 bis 111, bei dem die Empfängerstation eine entfernt stehende Zwischensenderstation ist, die Ausgabevorrichtung (202M) ein Sender (83, 87, 91, 92) ist, der Mikrocomputer (205) eine automatische Steuereinheit (73) für die Zwischensenderstation ist und die spezifische Speicherstelle ein Speicher (73) oder eine Aufzeichnungseinrichtung (76 oder 78) ist, wobei das Verfahren ferner einen der folgenden Schritte aufweist:

(1) Empfangen des Programms und Abgeben des Programms an einen Sender vor der spezifischen Zeit;
(2) Empfangen eines oder mehrerer Anweisungssignale, die in der Teilnehmerstation so wirken, daß ein Computer (73, 205) oder Prozessor (in 71, 200. 39J) angewiesen wird in bezug auf eine Art und Weise des Empfangens oder Darbietens von Material, das mit dem Programm im Zusammenhang steht, oder des Funktionierens auf der Grundlage einer Nutzerreaktion auf eine Ausgabe, die mit dem Programm im Zusammenhang steht, und des Abgebens des einen oder mehrerer Anweisungssignale an den Sender vor der spezifischen Zeit;
(3) Empfangen eines oder mehrerer Steuersignale, die in der entfernt stehenden Zwischensenderstation so wirken, daß das Programm oder das eine oder mehrere Anweisungssignale gewählt oder übermittelt werden, und Abgeben des einen oder mehrerer Steuersignale an einen Sender vor der spezifischen Zeit; und

(4) Empfangen eines Plans, der in der entfernt stehenden Zwischensenderstation so wirkt, daß das Programm und das eine oder mehrere Anweisungssignale übertragen werden, und Abgeben des Plans an einen Sender vor der spezifischen Zeit.

**113.** Verfahren nach einem der Ansprüche 59 bis 112, bei dem eine Senderstation von einer Teilnehmerstation gewisse Information einer Reaktion eines Teilnehmers auf ein Fernsehprogramm oder eine Computerausgabedarbietung empfängt, wobei das Verfahren ferner mindestens einen der folgenden Schritte aufweist:

Übertragen, an die Teilnehmerstation, eines Computerprogramms, das gewisse Information einer Reaktion eines Teilnehmers auf ein Fernsehprogramm oder eine Computerausgabedarbietung verarbeitet;
Definieren einer gewissen Variablen eines Anweisungssignals auf der Grundlage einer Reaktion eines Teilnehmers auf ein Fernsehprogramm oder eine Computerausgabedarbietung; und
Übertragen eines gewissen Teils eines Fernsehprogramms oder eines Anweisungssignals auf der Grundlage einer Reaktion eines Teilnehmers auf ein Fernsehprogramm oder eine Computerausgabedarbietung.

**114.** Verfahren nach einem der Ansprüche 59 bis 113, ferner mit den folgenden Schritten: Bewirken, daß eine Senderstation das Programm überträgt, und Bewirken, daß eine zweite Senderstation das Steuersignal überträgt, das in der Empfängerstation so wirkt, daß das empfängerspezifische Datenelement erzeugt oder ein Datenmodul übertragen wird, das in der Empfängerstation als eine Quelle eines empfängerspezifischen Datenelements dazu dient, auszuwählen und zu erzeugen.

**115.** Verfahren nach einem der Ansprüche 59 bis 114, bei dem das Programm über Satellit an eine Teilnehmerstation übertragen wird und bewirkt wird, daß eine zweite Senderstation veranlaßt wird, das Steuersignal oder ein Datenmodul, das mit dem Programm in Zusammenhang steht, an die Teilnehmerstation rundzusenden oder kabelzusenden.

**116.** Verfahren nach einem der Ansprüche 59 bis 115, ferner mit dem folgenden Schritt: Übertragen einer Vielzahl von Programmen und eines oder mehrerer Signale, die in der Empfängerstation so wirken, daß ein Wert analysiert oder ein Plan erzeugt wird. um dadurch zu bewirken, daß mindestens eine Teilnehmerstation auf der Grundlage seines potentiellen Wertes für einen Teilnehmer ein Programm aus der Vielzahl von Programmen wählt oder zwei oder mehrere der Programme in einer empfängerspezifischen Reihenfolge ausgibt.

**117.** Empfängerstationsgerät zum Verarbeiten von Signalen und zum Übermitteln von Massenmedium-Programmaterialien, um in jeder aus einer Vielzahl von Empfängerstationen eine kombinierte Ausgabe eines rundgesendeten oder kabelgesendeten Programms und eines empfängerspezifischen computererzeugten Datenelements darzubieten, wobei jede der Empfängerstationen eine Ausgabevorrichtung (202M) aufweist zum Empfangen und zum Abgeben des rundgesendeten oder kabelgesendeten Programms und anderer Information, wobei die Station auch einen Mikrocomputer (205) mit einer spezifischen Speicherstelle (PC-MicroKey des Mikrocomputers 205) aufweist, die betriebsfähig mit der Ausgabevorrichtung (202M) verbunden ist zum Speichern und Abgeben von Information an die Ausgabevorrichtung (202M), wobei das Senderstationsgerät aufweist:

einen Rundfunk- oder Kabelsender (83, 87, 91 oder 92) zum Übermitteln, an eine Vielzahl von Empfängerstationen, einer Informationsübertragung, die ein Programm und ein oder mehrere Steuersignale aufweist;
einen Programmeingabeempfänger (76, 78, 53 bis 62), der betriebsfähig mit dem Sender (83, 87, 91 oder 92) verbunden ist, zum Übermitteln des Programms an den Sender (83, 87, 91 oder 92);
einen Speicher (73) oder eine Aufzeichnungseinrichtung (76 oder 78), die betriebsfähig mit dem Sender (83, 87, 91 oder 92) verbunden ist, zum Speichern und Übermitteln eines Steuersignals, das in der Empfängerstation so wirkt, daß das empfängerspezifische Datenelement erzeugt wird; und
eine Eingabevorrichtung (98, 74, 50 bis 62), die betriebsfähig mit dem Speicher (73) oder der Aufzeichnungseinrichtung (76 oder 78) verbunden ist. um zu bewirken, daß der Speicher (73) oder die Aufzeichnungseinrichtung (76 oder 78) das Steuersignal in einer spezifischen Zeit an den Sender (83, 87, 91 oder 92) übermittelt, um dadurch das Programm und das Steuersignal an die Empfängerstationen zu übermitteln und zu bewirken, daß jede Station aus der Vielzahl der Empfängerstationen das Programm in ihrer Ausgabevorrichtung (202M) abgibt, ein empfängerstationsspezifisches Datenelement erzeugt (205), ihr empfängerstationsspezifisches Datenelement an ihrer Speicherstelle (PC-MicroKey des Mikrocomputers 205) für eine Zeitperiode ablegt und eine kombinierte Ausgabe des rundgesendeten oder kabelgesendeten Programms und ihres empfängerstationsspezifischen Datenelements in ihrer Ausgabevorrichtung (202M) abgibt.

**118.** Senderstationsgerät nach Anspruch 117, bei dem die Senderstation an die Vielzahl von Empfängerstationen ein erstes senderspezifisches Datenelement überträgt und mindestens eine Station aus der Vielzahl von Empfängerstationen gewisse Information eines empfängerspezifischen Datenelements auf der Grundlage des ersten senderspezifischen Datenelements darbietet, wobei das Gerät ferner aufweist:
einen zweiten Speicher (73) oder eine zweite Aufzeichnungseinrichtung (73 oder 78), die betriebsfähig mit dem Sender (83, 87, 91 oder 92) verbunden ist, zum Speichern und Übermitteln eines senderspezifischen Datenelements, das in der Empfängerstation als Basis zum Berechnen gewisser Information eines empfängerspezifischen Datenelements dient.

**119.** Senderstationsgerät nach Anspruch 117, bei dem die Senderstation an die Vielzahl von Empfängerstationen ein zweites senderspezifisches Datenelement überträgt und mindestens eine Station aus der Vielzahl der Empfängerstationen das zweite senderspezifische Datenelement in ihrer Ausgabevorrichtung (202M) abgibt, wobei das Gerät ferner aufweist:
einen dritten Speicher (73) oder eine dritte Aufzeichnungseinrichtung (76 oder 78), die betriebsfähig mit dem Sender (83, 87, 91 oder 92) verbunden ist, zum Speichern und Übermitteln gewisser Daten, die in der Empfängerstation als Quelle dienen, aus der ein zu erzeugendes empfängerspezifisches Datenelement zu wählen ist.

**120.** Senderstationsgerät nach einem der Ansprüche 117 bis 119, bei dem die Eingabevorrichtung ein erstes Voraussignal eingibt, das danach in der Senderstation zu der spezifischen Zeit so wirkt, daß der zuerst genannte Speicher (73) oder die zuerst genannte Aufzeichnungseinrichtung (76 oder 78) an den Sender (83, 87, 91 oder 92) ausgegeben wird, wobei das Gerät ferner aufweist:

einen ersten Prozessor (73), der betriebsfähig mit der Eingabevorrichtung (50 bis 62, 74, 98) verbunden ist, zum Unterscheiden eines Voraussignals;
einen ersten Speichercontroller (73, 205C in 73), der betriebsfähig mit dem ersten Prozessor (73) verbunden ist, zum Steuern eines Speichers (73) oder einer Aufzeichnungseinrichtung (76 oder 78), um ein oder mehrere Voraussignale zu speichern; und
einen vierten Speicher (73) oder eine vierte Aufzeichnungseinrichtung (76 oder 78), der bzw. die betriebsfähig mit dem ersten Controller (73, 205C in 73) verbunden ist, zum Speichern des ersten Voraussignals.

**121.** Senderstationsgerät nach einem der Ansprüche 117 bis 120, bei dem die Eingabevorrichtung (98, 74, 50 bis 62) ein Anweisungssignal eingibt, das in der Senderstation so wirkt, daß der zuerst genannte Speicher (73) oder die zuerst genannte Aufzeichnungseinrichtung (76 oder 78) zu der spezifischen Zeit an den Sender (83, 87, 91 oder 92) abgegeben wird, wobei das Gerät ferner aufweist:

einen ersten Steuerprozessor (39J, 73), der betriebsfähig mit der Eingabevorrichtung (98, 74, 50 bis 62) verbunden ist, zum Unterscheiden eines Signals, das in der Senderstation so wirkt, daß angewiesen wird; und
einen ersten Ausgabecontroller (73, 205C in 73, 39 in jedem Decodierer, 12 in 71), der betriebsfähig mit dem ersten Steuerprozessor (73) verbunden ist, zum Ausgeben eines Steuersignals. das so wirkt, daß ein Speicher (73) oder eine Aufzeichnungseinrichtung (76 oder 78) ausgegeben wird.

**122.** Senderstationsgerät nach einem der Ansprüche 117 bis 121, ferner mit mindestens einem, nämlich:

einem ersten selektiven Übertragungsvorrichtungscontroller (73), der betriebsfähig mit dem Programmeingabeempfänger (76, 78, 53 bis 62) verbunden ist, zum Steuern einer ersten selektiven Übertragungsvorrichtung (75, 76, 78, 53 bis 62), um ein oder mehrere Signale an einen Speicher (73) oder eine Aufzeichnungseinrichtung (76 und 78) vor einer spezifischen Zeit zu übermitteln; und
einem zweiten selektiven Übertragungsvorrichtungscontroller (73), der betriebsfähig mit dem Rundfunk- oder Kabelsender (83, 87, 91, 92) verbunden ist, zum Steuern einer zweiten selektiven Übertragungsvorrichtung (73, 75, 76, 78), um eines oder mehrere Signale aus einem oder mehreren Speichern (73) und/oder Aufzeichnungseinrichtungen (76 oder 78) zu einer spezifischen Zeit zu übermitteln.

**123.** Senderstationsgerät nach einem der Ansprüche 117 bis 122, ferner mit:
einem zentralen Controller (73), der betriebsfähig mit einem verbunden ist, nämlich mit dem Programmeingabeempfänger (76, 78, 53 bis 62) oder dem Rundfunk- oder Kabelsender (83, 87, 91, 92), zum Steuern der Übermittlung, an diesen einen, eines gewissen Abschnitts des Programms, eines Teils einer Nachricht, die mit dem Programm im Zusammenhang steht, eines Datenelements oder mehrerer Daten, die das Programm identifizieren, gewisser Vorausinformation des Programms, eines Datenelements oder mehrere Daten, die den Anfangspunkt eines gewissen Abschnitts des Programms bezeichnen, oder eines Signals, das das Programm bezeichnet und in der Empfängerstation so wirkt, daß angewiesen wird.

**124.** Empfängerstationsgerät nach Anspruch 123, ferner mit einem, nämlich:

einem Taktgeber, der betriebsfähig mit dem zentralen Controller (73) verbunden ist; oder
einer zweiten Eingabevorrichtung (98, 74, 50 bis 62), die betriebsfähig mit dem zentralen Controller (73) verbunden ist, zum Eingeben einer oder mehrerer Taktsteueranweisungen.

**125.** Senderstationsgerät nach Anspruch 123 oder 124, ferner mit einem, nämlich:

einem zweiten Prozessor (73, in 71, in jedem Decodierer), der betriebsfähig mit dem zentralen Controller (73) verbunden ist, zum Unterscheiden eines Taktsteuersignals oder einer Zeit, zu der ein Signal weiterzugeben ist, das so wirkt, daß angewiesen wird;
einem zweiten Speichercontroller (73), der betriebsfähig mit dem zentralen Controller (73) verbunden ist, zum Steuern eines gewählten Speichers (73) oder einer gewählten Aufzeichnungseinrichtung (76 oder 78), um ein Voraussignal zu speichern, das so wirkt, daß angewiesen wird; oder
einem fünften Speicher (73) oder einer fünften Aufzeichnungseinrichtung (76 oder 78), der bzw. die betriebsfähig mit dem zentralen Controller (73) verbunden ist, zum Speichern von zwei oder mehreren Signalen in einer Reihenfolge.

**126.** Senderstationsgerät nach einem der Ansprüche 119 oder 120 bis 125, wenn diese von Anspruch 119 abhängig sind, ferner mit:
einem ersten Computer (73), der betriebsfähig mit einem, nämlich dem zweiten Speicher (73) oder der zweiten Aufzeichnungseinrichtung (76 oder 78) bzw. dem dritten Speicher (73) oder der dritten Aufzeichnungseinrichtung (76 oder 78) verbunden ist, zum Empfangen von Formel-und-Artikel-Daten und zum Ausgeben eines gewissen Abschnitts eines Datenmoduls an den einen Speicher (73) oder die eine Aufzeichnungseinrichtung (76 oder 78).

**127.** Senderstationsgerät nach einem der Ansprüche 117 bis 126, bei dem ein Teil des Steuersignals Formel-und-Artikel-dieser-Übertragung-Information ist, wobei das Gerät ferner aufweist:
einen zweiten Computer (73), der betriebsfähig mit dem zuerst genannten Speicher (73) oder der zuerst genannten Aufzeichnungseinrichtung (76 oder 78) verbunden ist, zum Ausgeben von Formel-und-Artikel-dieser-Übertragung-Information als Antwort auf das Anweisungssignal, das in der Senderstation so wirkt, daß erzeugt wird.

**128.** Senderstationsgerät nach einem der Ansprüche 120 und 121 bis 127. wenn diese von Anspruch 120 abhängig sind, wobei ein Signal, das das Programm enthält, ein codiertes Voraussignal eingibt, das in der Senderstation so wirkt, daß der zuerst genannte Speicher (73) oder die zuerst genannte Aufzeichnungseinrichtung (76 oder 78) an den Sender (83, 87, 91 oder 92) ausgegeben wird, wobei das Gerät ferner aufweist:

einen ersten Decodierer (in 71, 77, 79), der betriebsfähig mit der Eingabevorrichtung (98, 74, 50 bis 62) verbunden ist, zum Decodieren von Information, die in einem Signal codiert ist, das ein Programm enthält;
eine dritte selektive Übertragungsvorrichtung (in 39, in 71), die betriebsfähig mit dem ersten Decodierer (in 71) verbunden ist, zum Übermitteln eines Datenelements oder mehrerer Daten an den ersten Prozessor (in 39, in 71).

**129.** Senderstationsgerät nach Anspruch 128, wenn dieser von Anspruch 122 abhängig ist, wobei die Senderstation den ersten selektiven Übertragungsvorrichtungscontroller (73) aufweist und der Decodierer (in 71, 77, 79) ein Datenelement oder mehrere Daten decodiert, die in der Empfängerstation so wirken, daß eine Übermittlung eines gewissen Abschnitts des Signals, der das Programm enthält, an die Empfängerstation verzögert wird, wobei das Gerät ferner aufweist:

eine vierte selektive Übertragungsvorrichtung (in 39, in 71), die betriebsfähig mit dem ersten Decodierer (in 71) verbunden ist, zum Übermitteln eines Datenelements oder mehrerer Daten an den ersten Steuerprozessor (in 39, in 71); und
eine fünfte selektive Übertragungsvorrichtung (in 39, in 71), die betriebsfähig mit dem ersten Steuerprozessor (in 39, in 71) verbunden ist, zum Übermitteln, an den ersten selektiven Übertragungsvorrichtungscontroller (73), eines Signals, das so wirkt, daß angewiesen wird.

**130.** Senderstationsgerät nach einem der Ansprüche 117 bis 129, bei dem die Eingabevorrichtung (98, 74, 50 bis 62) einen ersten Empfänger (50 bis 62, 71, 73) aufweist zum Empfangen, von einer entfernt stehenden Station, eines Signals, daß in der Empfängerstation so wirkt, daß angewiesen wird.

**131.** Senderstationsvorrichtung nach einem der Ansprüche 117 bis 130, bei dem der erste Computer (73) oder der zweite Computer (73) eine gewisse Ausgabe als Antwort auf ein Anweisungssignal erzeugt, das in der Senderstation so wirkt, daß erzeugt wird, wobei das Gerät ferner aufweist:

einen sechsten Speicher (73) oder eine sechste Aufzeichnungseinrichtung (76 oder 78) zum Speichern eines Anweisungssignals, das in der Empfängerstation so wirkt, daß erzeugt wird; und
eine dritte Eingabevorrichtung (73, 74, 98, in 71), die betriebsfähig mit dem sechsten Speicher (73) oder der sechsten Aufzeichnungseinrichtung (76 oder 78) verbunden ist, um zu bewirken, daß der sechste Speicher (73) oder die sechste Aufzeichnungseinrichtung (76 oder 78) in einer zweiten spezifischen Zeit ein Anweisungssignal ausgibt. das in der Senderstation so wirkt, daß erzeugt wird; und
eine sechste selektive Übertragungsvorrichtung (73), die betriebsfähig mit dem sechsten Speicher (73) oder der sechsten Aufzeichnungseinrichtung (76 oder 78) verbunden ist, zum Empfangen und Weiterleiten eines oder mehrerer Anweisungssignale.

**132.** Senderstationsgerät nach Anspruch 131, ferner mit:
einem dritten Prozessor (73), der betriebsfähig mit der zweiten Eingabevorrichtung (73, 98, in 71) und dem zweiten Speichercontroller (73) verbunden ist, zum Unterscheiden eines Anweisungssignals, das in der Empfängerstation so wirkt, daß erzeugt wird, und zum Bewirken, daß der zweite Speichercontroller (73) den sechsten Speicher (73) oder die sechste Aufzeichnungseinrichtung (76 oder 78) steuert, um das durch Unterscheidung bestimmte Anweisungssignal zu speichern.

**133.** Senderstationsgerät nach Anspruch 131 oder 132, bei dem die zweite Eingabevorrichtung (73, 74, 98, in 71) von der zweiten entfernt stehenden Station das Anweisungssignal empfängt, das in der Senderstation so wirkt, daß erzeugt wird.

**134.** Senderstationsgerät nach einem der Ansprüche 131 bis 133, ferner mit:
einem SPAM-Controller (205C in 73, 39 in jedem Decodierer, 12 in 71), der betriebsfähig mit einem spezifischen Computer (73) verbunden ist. zum Steuern des spezifischen Computers (73), um ein Computerprogramm oder ein Datenmodul entsprechend einem Anweisungssignal, das in der Senderstation so wirksam ist, daß erzeugt wird. zu erzeugen oder auszugeben.

**135.** Senderstationsgerät nach einem der Ansprüche 128 bis 134, bei dem der Programmeingabeempfänger (76, 78, 53 bis 62) ein codiertes Anweisungssignal eingibt, das mit dem Programm empfangen wird und in der Empfängerstation so wirkt, daß erzeugt wird, wobei das Gerät ferner aufweist:

eine siebente selektive Übertragungsvorrichtung (in 71, in 77, in 79), die betriebsfähig mit dem ersten Decodierer (in 71, 77, 79) verbunden ist, zum Empfangen und Weiterleiten eines decodierten Signals; und
einen vierten Prozessor (73, in 71, in 77, in 79), der betriebsfähig mit der siebenten selektiven Übertragungsvorrichtung (in 71, in 77, in 79) verbunden ist, zum Unterscheiden einer Vorrichtung, an die ein Signal weiterzugeben ist, das in der Senderstation so wirkt, daß angewiesen wird.

**136.** Senderstationsgerät nach einem der Ansprüche 117 bis 135, bei dem die Senderstation ein oder mehrere Signale überträgt, die in der Empfängerstation so wirken, daß angewiesen wird, daß die spezifische Speicherstelle ein empfängerspezifisches computererzeugtes Datenelement kombiniert oder zu kombinieren aufhört oder löscht, wobei das Gerät ferner aufweist:
eine vierte Eingabevorrichtung (50 bis 62, 74, 98), die betriebsfähig mit dem Rundfunk- oder Kabelsender (83, 87, 91 oder 92) verbunden ist, zum Übermitteln, zu einer dritten spezifischen Zeit. an den Rundfunk- oder Kabelsender (83, 87, 91 oder 92), eines oder mehrerer Signale, die in der Senderstation so wirken, daß angewiesen wird.

**137.** Senderstationsgerät nach Anspruch 136. bei dem die dritte entfernt stehende Station das eine oder mehrere Signale übermittelt, die in der Senderstation so wirken, daß angewiesen wird, wobei das Gerät ferner aufweist:

einen zweiten Empfänger (50 bis 62, 71, 73), der betriebsfähig mit einer selektiven Übertragungsvorrichtung (73, 75, in 71, 39 in jedem Decodierer) verbunden ist, zum Empfangen, von einer entfernt stehenden Station, eines oder mehrerer Signale, die in der Empfängerstation so wirken, daß angewiesen wird.

**138.** Senderstationsgerät nach Anspruch 136 oder 137, ferner mit:

einem siebenten Speicher (73) oder einer siebenten Aufzeichnungseinrichtung (76 oder 78), der bzw. die betriebsfähig mit einer selektiven Übertragungsvorrichtung (73, 75, in 71, 39 in jedem Decodierer) verbunden ist, zum Speichern eines oder mehrerer Signale, die in der Empfängerstation so wirken, daß angewiesen wird; und

einer fünften Eingabevorrichtung (50 bis 62, 74, 98), die betriebsfähig mit dem siebenten Speicher (73) oder der siebenten Aufzeichnungseinrichtung (76 oder 78) verbunden ist, zum Bewirken, daß der siebente Speicher (73) oder die siebente Aufzeichnungseinrichtung (76 oder 78) in einer spezifischen Zeit an einen Rundfunk- oder Kabelsender (83, 87, 91 oder 92) ein oder mehrere Signale ausgibt, die in der Empfängerstation so wirken, daß angewiesen wird.

**139.** Empfängerstationsgerät nach einem der Ansprüche 117 bis 138, bei dem der Programmeingabeempfänger (76, 78, 53 bis 62) ein Speicher (73) oder eine Aufzeichnungseinrichtung (76 oder 78) ist, in dem bzw. der mindestens ein Teil des Programms gespeichert wird, wobei das Gerät ferner aufweist:

eine sechste Eingabevorrichtung (50 bis 62, 74, 98), die betriebsfähig mit dem Programmeingabeempfänger (76, 78, 53 bis 62) verbunden ist, zum Bewirken, daß der Programmeingabeempfänger (76. 78. 53 bis 62) beginnt, das Programm an den Rundfunk- oder Kabelsender (83, 87, 91 oder 92) zu einer vierten spezifischen Zeit auszugeben.

**140.** Senderstationsgerät nach Anspruch 139, ferner mit:

einem achten Speicher (73) oder einer achten Aufzeichnungseinrichtung (76 oder 78) zum Speichern eines Datenelements oder mehrerer Daten, die den Anfangspunkt eines Abschnitts eines Programms bezeichnen; und

einem zweiten Ausgabecontroller (73, 205C in 73, 39 in jedem Decodierer, 12 in 71), der betriebsfähig mit dem achten Speicher (73) oder dem Programmeingabeempfänger (76, 78, 53 bis 62) verbunden ist, zum Steuern des Programmeingabeempfängers (76, 78, 53 bis 62), um die Ausgabe eines Abschnitts eines Programms am Anfang dieses Abschnitts zu beginnen.

**141.** Empfängerstationsgerät nach Anspruch 139, bei dem die sechste Eingabevorrichtung (50 bis 62, 74, 98) ein Anweisungssignal eingibt, das in der Empfängerstation so wirkt, daß das Programm zu der vierten spezifischen Zeit ausgegeben wird, wobei das Gerät ferner eines aufweist, nämlich:

einen fünften Prozessor (73), der betriebsfähig mit der fünften Eingabevorrichtung (50 bis 62, 74, 98) verbunden ist, zum Unterscheiden eines Signals, das in der Senderstation so wirkt, daß ein Programm ausgegeben wird; oder

einen sechsten Prozessor (73), der betriebsfähig mit dem sechsten Prozessor (73) verbunden ist, zum Lokalisieren oder Identifizieren eines gewissen Teils eines Programms.

**142.** Senderstationsgerät nach Anspruch 139, bei dem die sechste Eingabevorrichtung (50 bis 62, 74, 98) von einer vierten entfernt stehenden Station ein Anweisungssignal empfängt, das in der Senderstation so wirkt, daß das Programm zu der vierten spezifischen Zeit ausgegeben wird.

**143.** Senderstationsgerät nach einem der Ansprüche 117 bis 142, bei dem der Programmeingabeempfänger (76, 78, 53 bis 62) ein Signal empfängt, das mindestens einen Teil des Programms und eingebettete Daten enthält, die das Programm identifizieren oder den Anfangspunkt eines gewissen Abschnitts des Programms festlegen oder eine Nachricht, die mit dem Programm im Zusammenhang steht, umfassen, wobei das Gerät ferner aufweist:

einen Digitaldetektor (34, 37, 38, 43 oder 44 in jedem Decodierer), der betriebsfähig mit dem Programmeingabeempfänger (76, 78, 53 bis 62) verbunden ist, zum Ermitteln von Daten, die in einem Signal eingebettet sind.

**144.** Senderstationsgerät nach einem der Ansprüche 117 bis 143, bei dem eine Nachricht, die mit dem Programm im Zusammenhang steht, und Video-, Ton- oder Computerprogramm oder eine Video-, Ton- oder Datendatei enthält, an den ersten Programmeingabeempfänger (76. 78. 53-62) übermittelt wird oder vor der zuerst genannten spezifischen Zeit in diesem gespeichert wird, wobei das Gerät ferner aufweist:

einen siebenten Prozessor (73, 39J in jedem Decodierer) zum Verarbeiten einer oder mehrerer solcher Nachrichten.

**145.** Senderstationsgerät nach einem der Ansprüche 117 bis 144, bei dem eine Nachricht, die einen Befehl enthält, der mit dem Programm im Zusammenhang steht, an den Programmeingabeempfänger (76, 78, 53 bis 62) übermittelt wird oder vor der zuerst genannten spezifischen Zeit in diesem gespeichert wird, wobei das Gerät ferner eines aufweist, nämlich:

einen achten Prozessor (39J in jedem Decodierer) zum Unterscheiden eines Befehls in einer Nachricht, die mit einem Programm im Zusammenhang steht; oder

einen ersten Antwortcontroller (73, 39 in jedem Decodierer, 12 in 71), der betriebsfähig mit dem zehnten Prozessor (39J in jedem Decodierer) verbunden ist, zum Steuern eines gewissen Geräts als Antwort auf einen Befehl in einer Nachricht.

**146.** Senderstationsgerät nach einem der Ansprüche 117 bis 145, bei dem eine Nachricht, die ein Nutzungsmessungskontrollsegment enthält, das mit dem Programm im Zusammenhang steht, an den Programmeingabeempfänger (76, 78, 53 bis 62) übermittelt wird oder in diesem gespeichert ist, wobei das Gerät ferner eines aufweist, nämlich:

einen neunten Prozessor (39J in jedem Decodierer) zum Unterscheiden eines Nutzungsmessungskontrollsegments in einer Nachricht, die mit einem Programm im Zusammenhang steht; oder

einen zehnten Prozessor (in 71, 96), der betriebsfähig mit dem elften Prozessor (39J in jedem Decodierer) verbunden ist, zum Zusammenstellen oder Speichern von Nutzungsmessungsdateien oder Überwachungsdateien, die Benutzung oder Übertragung eines Programms oder einer Nachricht, die mit einem Programm im Zusammenhang steht, nachweisen.

**147.** Senderstationsgerät nach einem der Ansprüche 117 bis 146, bei dem eine Nachricht, die mit dem Programm im Zusammenhang steht und die einen Kopf oder ein Formatfeld enthält, an den Programmeingabeempfänger (76, 78, 53 bis 62) übermittelt wird oder in diesem gespeichert ist, wobei das Gerät ferner aufweist:

einen elften Prozessor (39J in jedem Decodierer) zum Unterscheiden des Formats, Inhalts oder Endes eines gewissen Abschnitts einer Nachricht, die mit dem Programm im Zusammenhang steht, auf der Grundlage eines Kopfes oder Formatfeldes.

**148.** Senderstationsgerät nach einem der Ansprüche 117 bis 147, bei dem eine Nachricht, die mit dem Programm im Zusammenhang steht und die ein Dateiendesignal oder ein Prozessor-Interrupt enthält. an den Programmeingabeempfänger (76, 78, 53 bis 62) übermittelt wird oder in diesem gespeichert ist, wobei das Gerät ferner aufweist:

einen Signaldetektor (39F oder 39H in jedem Decodierer) zum Ermitteln eines Dateiendesignals oder zum Übermitteln eines Prozessor-Interrupts, das mit einem Rundfunk- oder Kabel programm im Zusammenhang steht; und

einen zwölften Prozessor (73, 39J in jedem Decodierer), der betriebsfähig mit dem Signaldetektor (39F oder 39H in jedem Decodierer) verbunden ist, zum Antworten auf ein Prozessor-Interrupt, das mit einem Rundfunk- oder Kabel programm im Zusammenhang steht.

**149.** Senderstationsgerät nach einem der Ansprüche 117 bis 148, ferner mit:

einem dritten Computer (73), der betriebsfähig mit einem Sender (83, 87, 91 oder 92) verbunden ist, zum Erzeugen und Übermitteln einer Nachricht, die mit einem Programm in Zusammenhang zu bringen ist und gewisse Video-, Ton- oder Computerprogramme oder Video-, Ton- oder Datendateien enthält.

**150.** Senderstationsgerät nach einem der Ansprüche 117 bis 149, ferner mit:

einem vierten Computer (73), der betriebsfähig mit einem Sender (83, 87, 91 oder 92) verbunden ist, zum Erzeugen eines gewissen Abschnitts eines Befehls und zum Übermitteln des Befehls in einer Nachricht, die mit einem Programm in Zusammenhang zu bringen ist.

**151.** Senderstationsgerät nach einem der Ansprüche 117 bis 150, ferner mit:

einem fünften Computer (73), der betriebsfähig mit dem Sender (83, 87, 91 oder 92) verbunden ist, zum Erzeugen und Übermitteln eines gewissen Abschnitts eines Nutzungsmessungskontrollsegments, das mit einem Programm in Zusammenhang zu bringen ist.

**152.** Senderstationsgerät nach einem der Ansprüche 117 bis 151, ferner mit:
einem sechsten Computer (73), der betriebsfähig mit einem Sender (83, 87, 91 oder 92) verbunden ist, zum Erzeugen eines gewissen Teils eines Teils einer Nachricht, die ein spezifisches Format aufweist und mit einem Programm in Zusammenhang zu bringen ist, und zum Übermitteln des Abschnitts einer Nachricht mit einem Kopf oder Formatfeld, das das spezifische Format bezeichnet.

**153.** Senderstationsgerät nach einem der Ansprüche 117 bis 152, ferner mit:
einem siebenten Computer (73), der betriebsfähig mit dem Programmeingabeempfänger (76, 78, 53 bis 62) und mit einem Sender (83, 87, 91 oder 92) verbunden ist, zum Erzeugen einer Nachricht, die mit einem Programm im Zusammenhang steht und ein Prozessor-Interrupt enthält.

**154.** Senderstationsgerät nach einem der Ansprüche 139 und 140 bis 153, wenn diese von Anspruch 139 abhängig sind, ferner mit:
einer achten selektiven Übertragungsvorrichtung (73 oder 75), die betriebsfähig mit einem oder mehreren Eingabevorrichtungen (50 bis 62, 71, 73, 74, 98) und mit dem Programmeingabeempfänger (76, 78, 53 bis 62) verbunden ist, zum Übermitteln, an den Programmeingabeempfänger, einer Nachricht, die mit dem Programm in Zusammenhang zu bringen ist, eines Datenelements oder mehrerer Daten, die das Programm identifizieren, eines Datenelements oder mehrerer Daten, die den Anfangspunkt eines gewissen Abschnitts des Programms bezeichnen oder eines Signals, das in der Empfängerstation so wirkt, daß angewiesen wird.

**155.** Senderstationsgerät nach einem der Ansprüche 117 bis 154, bei dem das Programm an den Programmeingabeempfänger (76, 78, 53 bis 62) übermittelt wird oder vor der zuerst genannten spezifischen Zeit in diesem gespeichert wird, wobei das Gerät ferner aufweist:
einen zweiten Programmeingabeempfänger (78, 53 bis 62), der betriebsfähig mit der Übertragungsvorrichtung (73 oder 75) verbunden ist, zum Übermitteln eines Programms an den zuerst genannten Programmeingabeempfänger (76, 78, 53 bis 62).

**156.** Senderstationsgerät nach Anspruch 120 oder einen der Ansprüche 121 bis 155. wenn diese von Anspruch 120 abhängig sind, wobei der zuerst genannte Programmeingabeempfänger (76, 78, 53 bis 62) der vierte Speicher (73) oder die vierte Aufzeichnungseinrichtung (76 oder 78) ist, wobei das Gerät ferner aufweist:

einen zweiten Decodierer (77, 79), der betriebsfähig mit einem Speicher (73) oder einer Aufzeichnungseinrichtung (76 oder 78) verbunden ist, zum Decodieren von Information, die in einem gespeicherten Signal codiert ist;
einen zweiten Steuerprozessor (39J in 77, 39J in 79, 73) zum Unterscheiden eines decodierten gespeicherten Signals, das in der Empfängerstation so wirkt, daß angewiesen wird;
eine neunte selektive Übertragungsvorrichtung (39I in 77, 39I in 79), die betriebsfähig mit dem zweiten Steuerprozessor (39I in 77, 39I im zweiten Decodierer (77, 79)) verbunden ist, zum Übermitteln eines Sender-Anweisungssignals an einen Controller (73, 205C, 39 in jedem Decodierer) oder Computer (73); und
einen dritten Ausgabecontroller (39 in 77, 39 in 79, 73), der betriebsfähig mit der neunten selektiven Übertragungsvorrichtung (39I in 77, 39I in 79) verbunden ist, zum Steuern der neunten selektiven Übertragungsvorrichtung (39I in 77, 39I in 79), um ein Sender-Anweisungssignal an einen spezifischen Controller (73, 205C, 39 in jedem Decodierer) oder Computer (73) zu übermitteln.

**157.** Senderstationsgerät nach Anspruch 156, ferner mit:
einem dreizehnten Prozessor (in 71, 73, in 39 jedes Decodierers), der betriebsfähig mit einem Controller (73, 205C, 39 in jedem Decodierer) oder Computer (73) verbunden ist, zum Unterscheiden eines spezifischen Decodierers (in 71, 77, 79, 80, 84, 88) oder zum Übermitteln eines Datenelements, das einen spezifischen Programmeingabeempfänger (76, 78, 53 bis 62) bezeichnet.

**158.** Senderstationsgerät nach Anspruch 155 und nach einem der Ansprüche 156 oder 157, wenn diese von Anspruch 155 abhängig sind, ferner mit einem, nämlich:

einem ersten Schalter (75), der betriebsfähig mit dem Rundfunk- oder Kabelsender (83, 87, 91, 92) verbunden ist, zum selektiven Übermitteln von Signalen von dem zuerst genannten Programmeingabeempfänger (76, 78, 53 bis 62) und dem zweiten Programmeingabeempfänger (78, 53 bis 62); und
einem zweiten Schalter (75), der betriebsfähig mit dem zweiten Programmeingabeempfänger (78, 53 bis 62) verbunden ist, zum selektiven Übermitteln von Signalen an den zuerst genannten Programmeingabeempfänger (76 oder 78) und den Rundfunk- oder Kabelsender (83, 87, 91, 92).

**159.** Senderstationsgerät nach Anspruch 158. bei dem der erste Schalter (75) oder der zweite Schalter (75) von dem zentralen Controller (73) gesteuert wird.

**160.** Senderstationsgerät nach einem der Ansprüche 117 bis 159, bei dem die Senderstation eine Vielzahl von Programmeingabeempfängern (53 bis 62) aufweist zum Empfangen von Signalen von einer oder mehreren entfernt stehenden Programmquellen oder einer Vielzahl von Speichern (73) oder Aufzeichnungseinrichtungen (76 oder 78) zum Speichern von Signalen oder einer Vielzahl von Rundfunk- oder Kabelsendern (83, 87, 91, 92), wobei das Gerät ferner aufweist:

einen Matrixschalter (75) oder einen Digitalschalter (39I in jedem Decodierer), der in der Lage ist, eine Vielzahl von Signalen gleichzeitig zu übermitteln.

**161.** Senderstationsgerät nach Anspruch 160, wenn dieser von Anspruch 123 abhängig ist, wobei der Matrixschalter (75) oder der Digital schalter (39I in jedem Decodierer) von dem zentralen Controller (73) gesteuert wird.

**162.** Senderstationsgerät nach einem der Ansprüche 117 bis 161, ferner mit:

einem Signalgenerator (82, 86, 90), der betriebsfähig mit dem Rundfunk- oder Kabelsender (83, 82, 91, 90) verbunden ist, zum Empfangen des Steuersignals und zum Einbetten des Steuersignals in die Informationsübertragung.

**163.** Senderstationsgerät nach Anspruch 162, wenn dieser von Anspruch 153 abhängig ist, wobei das Steuersignal an den Signalgenerator (82, 86, 90) durch irgendeinen Computer übermittelt wird, nämlich durch den dritten Computer (73), den vierten Computer (73), den fünften Computer (73), den sechsten Computer (73) oder den siebenten Computer (73).

**164.** Senderstationsgerät nach einem der Ansprüche 117 bis 163, bei dem die Informationsübertragung eine Vielzahl von Kanälen von Fernsehprogrammen und/oder Hörfunkprogrammen aufweist, wobei das Gerät ferner aufweist:

eine Vielzahl von Modulatoren (83, 87, 91), wobei jeder Modulator (83, 87, 91) betriebsfähig mit einem Programmeingabeempfänger (76, 78, 53 bis 62) verbunden ist zum Modulieren eines Kanals; und
ein Multiplexiersystem (92), das betriebsfähig mit dem Rundfunk- oder Kabel sender (83, 87, 91) verbunden ist, zum Übermitteln einer Informationsübertragung, die eine Vielzahl von Kanälen umfaßt.

**165.** Senderstationsgerät nach einem der Ansprüche 117 bis 164, bei dem die Senderstation einen oder mehrere Prozessorsysteme (71, 39 in jedem Decodierer) aufweist, zum Verarbeiten von Signalen, die Befehle und Programmausgabeinformationsinhalt enthalten, wobei das Gerät ferner umfaßt:

einen oder mehrere Senderbereiche (12 und 39 in jedem Decodierer von 71; 39I jeweils in 39) zum selektiven Übertragen von Befehlen und/oder Programmausgabeinformationsinhalt an einen oder mehrere externe Empfängervorrichtungen (72, 73, 97 in 71; 73 und 205C in 73);
einen oder mehrere Empfängerbereiche (1, 2, 3, 6, 27, 28, 29 in 71; 39B, 39D, 39J in 39) zum Empfangen einer Eingabe dieser Befehle und von Programmausgabeinformationsinhalt;
einen oder mehrere Speicher-(8, 14, in 39 in 71; 39E, 39F, 39G, 39H, RAMs in 39) oder Aufzeichnungseinrichtungs-(20 in 71)Bereiche zum Speichern und Übermitteln eines Steuersignals, das in einer Empfängervorrichtung (73) oder Empfängerstation (97) so arbeiten kann, daß ein empfängerspezifisches Datenelement erzeugt wird; und
einen oder mehrere Steuereingabebereiche (20 und jeweils 39 in 71; 39F, 39H, 39J in 39), die betriebsfähig mit dem Speicher-(8, 14, in 39 in 71; 39E, 39F, 39G, 39H, RAMs in 39) oder Aufzeichnungseinrichtungs-(20 in 71)Bereich verbunden sind, zum Bewirken, daß der Speicher-(8, 14, in 39 in 71; 39E, 39F, 39G, 39H, RAMs in 39) oder der Aufzeichnungseinrichtung-(20 in 71)Bereich das Steuersignal zu einer spezifischen Zeit übermittelt.

**166.** Gerät nach Anspruch 165, bei dem irgendeines, nämlich der eine oder mehrere Senderbereiche (12 und 39 in jedem Decodierer von 71; 39I jeweils in 39), der eine oder mehrere Empfängerbereiche (1, 2, 3, 6, 27, 28, 29 in 71; 39B, 39D, 39J in 39), der eine oder mehrere Speicher-(8, 14, in 39 in 71; 39E, 39F, 39G, 39H, RAMs in 39) oder Aufzeichnungseinrichtungs-(20 in 71)Bereiche oder der eine oder mehrere Steuereingabebereiche (20 und jeder 39 in 71; 39F, 39H, 39J in 39) eine Vielzahl von Prozessoren (39B, 39D, 39J) auf einem einzelnen Mikrochip (39, Fig. 3A) aufweist.

**Revendications**

1. Procédé de traitement de signaux au niveau d'une station de récepteur comportant un micro-ordinateur (205) et un dispositif de sortie (202M) afin de délivrer au niveau du dispositif de sortie une sortie combinée constituée par un programme de radiodiffusion ou de diffusion par câble et par une donnée spécifique au récepteur, ledit procédé comprenant les étapes de:

   (a) réception (215) d'une émission d'information comprenant un programme et un ou plusieurs signaux de commande;
   (b) sélection dudit programme de radiodiffusion ou de diffusion par câble à partir de l'émission d'information et transfert de celui-ci sur le dispositif de sortie (202M) en vue d'une délivrance à l'utilisateur;
   (c) détection (203) d'un signal de commande spécifique dans l'émission d'information et passage dudit signal de commande spécifique détecté au micro-ordinateur (205); et
   (d) commande (205) dudit micro-ordinateur sur la base du signal de commande spécifique. ladite étape de commande comprenant:

      (1) la génération (205) d'une donnée spécifique au récepteur en traitant une information qui est stockée dans ledit micro-ordinateur;
      (2) le placement (205) de ladite donnée en un emplacement de mémoire spécifique du micro-ordinateur (PC-MicroKey du micro-ordinateur 205);
      (3) la communication (205) de ladite donnée spécifique au récepteur au niveau dudit emplacement de mémoire audit dispositif de sortie (202M); et ensuite
      (4) la remise à zéro (205) de ladite donnée dudit emplacement de mémoire spécifique de telle sorte que la sortie combinée constituée par ledit programme de radiodiffusion ou de diffusion par câble reçu et par ladite donnée spécifique au récepteur soit délivrée au niveau dudit dispositif de sortie (202M) pendant la période temporelle entre ladite étape de placement de ladite donnée au niveau dudit emplacement de mémoire et ladite étape de remise à zéro de ladite donnée audit emplacement de mémoire.

2. Procédé selon la revendication 1, dans lequel, avant le placement de ladite donnée spécifique au récepteur au niveau de l'emplacement de mémoire spécifique, le dispositif de mémoire au niveau duquel ladite donnée spécifique au récepteur est placée est remis à zéro.

3. Procédé selon la revendication 1, dans lequel une ou plusieurs données spécifiques au récepteur supplémentaires sont communiquées automatiquement (205) audit dispositif de sortie (202M) à la suite de ladite donnée spécifique au récepteur.

4. Procédé selon l'une quelconque des revendications précédentes, dans lequel l'étape de génération d'une donnée spécifique au récepteur en traitant une information qui est stockée dans le micro-ordinateur est réalisée en exécutant (205) un programme d'ordinateur stocké dans la mémoire du micro-ordinateur afin de traiter ladite information stockée, et le procédé comprend en outre l'étape de:
   détection (203) dans ladite émission d'information d'un premier signal de commande supplémentaire qui sert à charger le programme d'ordinateur dans la mémoire du micro-ordinateur (205).

5. Procédé selon la revendication 4, dans lequel l'émission d'information incorpore le programme d'ordinateur.

6. Procédé selon la revendication 4, dans lequel le premier signal de commande supplémentaire sert à donner instruction au micro-ordinateur de rechercher un module de logiciel dans un périphérique de mémoire (232).

7. Procédé selon l'une quelconque des revendications précédentes, dans lequel la sortie combinée dudit programme de radiodiffusion ou de diffusion par câble reçu et de ladite donnée spécifique au récepteur est délivrée au niveau du dispositif de sortie en tant que partie d'une série de sorties combinées et les étapes de communication de ladite donnée spécifique au récepteur et de remise à zéro de l'emplacement de mémoire spécifique sont réalisées en réponse à un ou plusieurs signaux de commande.

8. Procédé selon l'une quelconque des revendications précédentes, dans lequel le traitement, la génération et/ou l'émission en sortie dudit micro-ordinateur sont commandés par un contrôleur programmable en réponse à des signaux de commande détectés dans l'émission d'information de radiodiffusion ou de diffusion par câble.

**9.** Procédé selon la revendication 8, comprenant en outre l'étape d'interruption (39F et 39H de la figure 3A) du contrôleur pour forcer ledit micro-ordinateur à communiquer une donnée spécifique au récepteur à un instant spécifique.

**10.** Procédé selon la revendication 8, comprenant en outre l'étape consistant à donner instruction (205, 39J) au contrôleur de forcer ledit micro-ordinateur à communiquer une donnée spécifique au récepteur spécifique audit dispositif de sortie.

**11.** Procédé selon la revendication 8, dans lequel ledit contrôleur peut communiquer un signal d'interruption à une pluralité de dispositifs de processeur et/ou de contrôleur, ledit procédé comprenant en outre l'étape de programmation dudit contrôleur afin d'interrompre l'un spécifique de ladite pluralité de dispositifs de processeur et/ou de contrôleur.

**12.** Procédé selon l'une quelconque des revendications 8 à 11, comprenant en outre les étapes de détection d'un signal d'interruption dans l'émission d'information et de commande dudit contrôleur pour communiquer ledit signal d'interruption détecté à un processeur ou contrôleur.

**13.** Procédé selon l'une quelconque des revendications 8 à 12, dans lequel, en réponse à la détection dudit signal de commande spécifique dans l'émission d'information, le micro-ordinateur est organisé pour générer ladite donnée spécifique au récepteur en tant que partie d'une série de données spécifiques au récepteur, et un signal d'interruption de processeur est entré sur le micro-ordinateur pour permettre la communication d'une ou de plusieurs données spécifiques au récepteur spécifique audit dispositif de sortie à un instant spécifique.

**14.** Procédé selon la revendication 13, dans lequel ledit signal d'interruption est entré sur ledit micro-ordinateur en réponse à un second signal de commande supplémentaire détecté dans ladite émission d'information de radiodiffusion ou de diffusion par câble, et ledit signal d'interruption force ledit micro-ordinateur à remettre à zéro l'emplacement mémoire spécifique et à placer une donnée spécifique au récepteur générée au niveau de l'emplacement de mémoire spécifique afin de former une sortie combinée suivante.

**15.** Procédé selon la revendication 14, dans lequel un signal de commande détecté dans ladite émission d'information de radiodiffusion ou de diffusion par câble force ledit micro-ordinateur à cesser de communiquer une ou plusieurs données spécifiques au récepteur audit dispositif de sortie et à commencer ou à reprendre la génération de ladite série.

**16.** Procédé selon l'une quelconque des revendications 8 à 12, comprenant en outre les étapes de détection d'un programme de commande dans l'émission d'information et de contrainte dudit contrôleur à commander un ou plusieurs dispositifs de station de récepteur conformément audit programme de commande.

**17.** Procédé selon l'une quelconque des revendications précédentes, dans lequel ladite donnée spécifique au récepteur n'est pas communiquée automatiquement audit dispositif de sortie (202M), lorsque ladite donnée spécifique au récepteur est placée au niveau dudit emplacement de mémoire, et le procédé comprend en outre les étapes de:

détection (203), dans ladite émission d'information, d'un troisième signal de commande supplémentaire qui sert à donner instruction au micro-ordinateur (205) de communiquer la donnée spécifique au récepteur au niveau dudit emplacement de mémoire audit dispositif de sortie pour ainsi forcer le micro-ordinateur (205) à communiquer ladite donnée spécifique au récepteur au dispositif de sortie (202M).

**18.** Procédé selon la revendication 13, comprenant en outre les étapes de détermination (39J) du fait que ledit micro-ordinateur n'est pas préparé à communiquer une première donnée spécifique au récepteur audit dispositif de sortie à un instant spécifique et par conséquent de contrainte (39J) dudit micro-ordinateur à exécuter une instruction de programme d'ordinateur spécifique pour ainsi commencer la génération d'une donnée spécifique au récepteur suivante de ladite série.

**19.** Procédé selon l'une quelconque des revendications précédentes, dans lequel l'information qui est stockée dans ledit micro-ordinateur comprend des données spécifiques utilisateur et le procédé comprend en outre l'étape de:

passage (203) de données de mise à jour au micro-ordinateur (205) de manière à provoquer la mise à jour des données utilisateur stockées de manière à ce que, lors de la génération d'une donnée spécifique au récepteur suivante, les données utilisateur mises à jour soient traitées par ledit micro-ordinateur.

**20.** Procédé selon la revendication 19, dans lequel les données mises à jour sont détectées dans l'émission d'information de radiodiffusion ou de diffusion par câble et sont passées par un décodeur (290).

**21.** Procédé selon la revendication 19, dans lequel lesdites données de mise à jour sont reçues dans une émission d'information qui comprend une émission téléphonique.

**22.** Procédé selon la revendication 21, dans lequel ladite station de récepteur initie automatiquement ladite émission téléphonique pour une ou plusieurs données de mise à jour.

**23.** Procédé selon l'une quelconque des revendications précédentes, comprenant en outre les étapes de stockage (200) d'une information au niveau de la station de récepteur qui spécifie que ladite station de récepteur doit recevoir sélectivement automatiquement une émission d'information spécifique, et de réception sélective (200) de ladite émission d'information conformément à ladite information stockée.

**24.** Procédé selon la revendication 23, dans lequel, en réponse à un signal de commande de validation, la station de récepteur est validée pour recevoir ledit programme de radiodiffusion ou de diffusion par câble en entrant (200) sur un processeur une ou plusieurs instructions de programme d'ordinateur permettant de commander (200) ladite station de récepteur afin de recevoir ladite émission d'information de radiodiffusion ou de diffusion par câble, de sélectionner ledit programme et de détecter lesdits signaux de commande.

**25.** Procédé selon la revendication 23 ou 24, comprenant en outre les étapes de réception (200, figure 2) et de stockage (200, figure 2) d'une information d'émission préalable dudit programme spécifique.

**26.** Procédé selon l'une quelconque des revendications précédentes, comprenant en outre les étapes d'assemblage d'enregistrements (200, figure 2) au niveau de la station de récepteur qui répertorient la disponibilité, la sélection et/ou l'utilisation de programmes de radiodiffusion ou de diffusion par câble, de signaux de commande et/ou de données utilisateur, et de communication (200, figure 2) desdits enregistrements à une station de collecte de données à distance.

**27.** Procédé selon l'une quelconque des revendications précédentes, comprenant en outre l'étape d'entrée (225) sur un processeur au niveau de la station de récepteur d'une information concernant la réaction d'un utilisateur à une sortie au niveau du dispositif de sortie (202M).

**28.** Procédé selon la revendication 27, comprenant en outre l'étape de traitement (200, figure 2, ou 205) de ladite information de réaction d'utilisateur en réponse à un quatrième signal de commande supplémentaire détecté dans l'émission d'information de radiodiffusion ou de diffusion par câble pour ainsi générer une information de réponse supplémentaire en plus de ladite information d'entrée.

**29.** Procédé selon la revendication 27 ou 28, comprenant en outre l'étape de communication (200, figure 2) d'au moins une certaine part de ladite information d'entrée ou de ladite information de réponse supplémentaire à une station de collecte de données à distance.

**30.** Procédé selon l'une quelconque des revendications précédentes. dans lequel le programme de radiodiffusion ou de diffusion par câble et au moins certains des signaux de commande contenus dans l'émission d'information sont cryptés et sont désignés par un signal indiquant une émission cryptée, et le procédé comprend en outre l'étape de commande (200, figure 2) d'un décrypteur dans la station de récepteur afin de décrypter ledit programme et des signaux de commande cryptés en réponse à la détection dudit signal désigné.

**31.** Procédé selon l'une quelconque des revendications précédentes, comprenant en outre l'étape de stockage de ladite émission d'information reçue sur un moyen de stockage (217, 255 ou 256) afin de permettre la délivrance de la sortie combinée à un instant où ledit programme de radiodiffusion ou de diffusion par câble n'est pas en train d'être reçu par la station de récepteur.

**32.** Procédé selon l'une quelconque des revendications précédentes, dans lequel le dispositif de sortie est un ou plusieurs dispositifs pris parmi le groupe constitué par une imprimante (221) pour émettre en sortie une information imprimée, un générateur de son (263) pour émettre en sortie des sons, un dispositif d'affichage vidéo (202M) pour afficher une information vidéo, un dispositif de stockage vidéo (217) pour stocker une information vidéo, un dispositif de stockage audio (255) pour stocker une information audio et un émetteur intermédiaire (92).

**33.** Procédé selon la revendication 32. dans lequel le dispositif de sortie est un moniteur TV (202M), ledit emplacement de mémoire spécifique est une RAM vidéo et ladite donnée spécifique au récepteur est mise à zéro audit emplacement de mémoire en plaçant une information d'une couleur qui change au niveau dudit emplacement de mémoire et ladite couleur qui change apparaît comme étant transparente lorsqu'elle est affichée au niveau dudit moniteur en combinaison avec une image de télévision.

**34.** Procédé selon la revendication 33, dans lequel l'emplacement de mémoire spécifique du micro-ordinateur au niveau duquel la donnée spécifique au récepteur est placée est choisi sur la base de la détermination d'un point de référence et d'une dimension scalaire pour la donnée spécifique au récepteur lors de l'étape de génération (205) de ladite donnée spécifique au récepteur.

**35.** Procédé selon l'une quelconque des revendications précédentes, dans lequel ladite station de récepteur est l'une d'une pluralité de stations de récepteur similaires recevant la même émission d'information, la donnée spécifique au récepteur générée au niveau de chaque station étant spécifique à sa station de récepteur, et la série de données spécifique au récepteur générée au niveau des stations de récepteur différant d'une station à une autre station.

**36.** Procédé selon la revendication 35, dans lequel une période temporelle séparant la réception des stations de récepteur du signal de commande spécifique et la réception des stations de récepteur du troisième signal de commande supplémentaire suffit pour permettre à chaque micro-ordinateur de station de récepteur de terminer ladite étape de génération avant que chaque micro-ordinateur de station de récepteur reçoive ledit premier signal de commande supplémentaire.

**37.** Appareil de station de récepteur pour traiter des signaux afin de délivrer une sortie combinée constituée par un programme de radiodiffusion ou de diffusion par câble et par une donnée générée par ordinateur spécifique au récepteur, ladite station comportant un dispositif de sortie (202M) pour délivrer le programme de radiodiffusion ou de diffusion par câble et une autre information, ledit appareil comprenant:

un décodeur (203) comprenant un moyen pour:

(1) recevoir une émission d'information comprenant un programme de radiodiffusion ou de diffusion par câble et un ou plusieurs signaux de commande;
(2) détecter la présence des signaux de commande dans l'émission d'information; et
(3) passer les signaux de commande détectés à un micro-ordinateur (205);

ledit micro-ordinateur (205) étant connecté en fonctionnement audit dispositif de sortie (202M) et audit décodeur (203), ledit micro-ordinateur (205) comportant un emplacement de mémoire spécifique (PC-MicroKey du micro-ordinateur 205) connecté audit dispositif de sortie (202M) pour communiquer des données stockées dans ledit emplacement de mémoire spécifique (PC-MicroKey du micro-ordinateur 205) audit dispositif de sortie (202M), et ledit micro-ordinateur (205) étant programmé pour réaliser les étapes qui suivent sur la base d'un ou de plusieurs signaux de commande spécifiques:

(1) génération d'une donnée spécifique au récepteur en traitant une information qui est stockée dans ledit micro-ordinateur (205) en réponse à la réception d'un signal spécifique;
(2) placement de ladite donnée spécifique au récepteur dans ledit emplacement de mémoire spécifique (PC-MicroKey du micro-ordinateur 205);
(3) communication de ladite donnée spécifique au récepteur au niveau dudit emplacement de mémoire audit dispositif de sortie (202M); et ensuite
(4) remise à zéro de ladite donnée audit emplacement de mémoire spécifique (PC-MicroKey du micro-ordinateur 205) pour ainsi délivrer une sortie combinée constituée par ledit programme de radiodiffusion ou de diffusion par câble reçu et par ladite donnée spécifique au récepteur au niveau dudit dispositif de sortie (202M) pendant la période temporelle entre ladite étape de placement de ladite donnée audit emplacement de mémoire (PC-MicroKey du micro-ordinateur 205) et ladite étape de remise à zéro de ladite donnée audit emplacement de mémoire (PC-MicroKey du micro-ordinateur 205).

**38.** Appareil selon la revendication 37, dans lequel ledit dispositif de sortie est un dispositif de sortie vidéo (202M) et ledit signal de commande détecté est un signal qui commande ledit micro-ordinateur (205) afin de placer une donnée vidéo spécifique au récepteur au niveau dudit emplacement spécifique, ledit appareil comprenant en outre une mémoire de sortie vidéo (PC-MicroKey de 205) connectée audit micro-ordinateur (205) et audit dispositif de sortie vidéo (202M) pour communiquer une information vidéo audit dispositif de sortie vidéo (202M).

**39.** Appareil selon la revendication 37 ou 38, dans lequel ledit dispositif de sortie est un dispositif de sortie audio (263) et ledit signal de commande détecté est un signal qui commande ledit micro-ordinateur (205) pour placer une donnée audio spécifique au récepteur au niveau dudit emplacement de mémoire spécifique, ledit appareil comprenant en outre un emplacement de mémoire de sortie audio (RAM audio de 205) connecté audit micro-ordinateur (205) et audit dispositif de sortie audio (263) pour communiquer une information audio audit dispositif de sortie audio (263).

**40.** Appareil selon l'une quelconque des revendications 37 à 39, comprenant en outre un contrôleur programmable (39 du décodeur 203) connecté audit micro-ordinateur (205) pour commander le traitement, la génération et/ou l'émission en sortie dudit micro-ordinateur (205) en réponse à des signaux de commande détectés dans une émission d'information de radiodiffusion ou de diffusion par câble.

**41.** Appareil selon la revendication 40, dans lequel ledit contrôleur (39 sur la figure 2A, 44 sur la figure 2B, 47 sur la figure 2C) est connecté en fonctionnement audit décodeur (203), ledit appareil comprenant en outre un processeur de commande programmable (39J sur la figure 3A) pour commander la communication d'une information détectée dans ladite émission d'information.

**42.** Appareil selon la revendication 41, dans lequel ledit processeur de commande (39J) entre un programme d'ordinateur sur un processeur sélectionné (39J, CPU de 205) ou sur un contrôleur (39, 20 de 200) ou force un processeur sélectionné (39J, CPU de 205) ou un contrôleur sélectionné (39, 20 de 200) à modifier une manière d'identifier ou de répondre à un signal de commande dans ladite émission d'information, ledit appareil comprenant en outre un dispositif d'émission sélective (13 sur la figure 2D, 39I sur la figure 3A, 259 sur la figure 7) pour communiquer une information détectée dans ladite émission d'information audit processeur sélectionné (39J, CPU de 205) ou audit contrôleur sélectionné (39, 20 de 200).

**43.** Appareil selon la revendication 42, dans lequel ledit dispositif d'émission sélective (13 sur la figure 2D, 39I sur la figure 3A, 259 sur la figure 7) est un bus (13 sur la figure 2D), un commutateur matriciel (39I) ou un commutateur numérique (39I).

**44.** Appareil selon l'une quelconque des revendications 41 à 43, dans lequel un dispositif quelconque pris parmi ledit contrôleur (39), ledit processeur de commande (39J) et ledit micro-ordinateur (205) comprend une pluralité de processeurs (39B, 39D, 39J) sur une unique micropuce (39, figure 3A).

**45.** Appareil selon l'une quelconque des revendications 37 à 44, dans lequel le micro-ordinateur (205) reçoit une entrée comprenant un programme d'ordinateur et un ou plusieurs signaux d'interruption et génère ladite donnée spécifique au récepteur conformément audit programme d'ordinateur ou met à zéro ledit emplacement de mémoire spécifique en réponse audit un ou auxdits plusieurs signaux d'interruption, ledit appareil comprenant en outre un ou plusieurs tampons (8, 39A, 39C, 39E, 39G dans 205) ou mémoires (en 39B, en 39D, en 39J, 217, 217A) pour stocker et communiquer ledit programme d'ordinateur audit micro-ordinateur (205).

**46.** Appareil selon l'une quelconque des revendications 37 à 45, dans lequel un processeur (39J, 200) communique une instruction de commande basée sur un enregistrement de la présence ou de l'absence d'un programme ou d'une donnée spécifique au récepteur, ledit appareil comprenant en outre une mémoire (mémoires de registre de première précondition SPAM ou de seconde précondition SPAM en 39J; en 20, 14 ou 16 dans 200) pour stocker un ou plusieurs enregistrements de la présence ou de l'absence d'un programme ou d'une donnée spécifique au récepteur.

**47.** Appareil selon la revendication 45, lorsqu'elle dépend de la revendication 40, ou selon la revendication 46, dans lequel le contrôleur (39 du décodeur 203) entre un signal d'interruption sur ledit micro-ordinateur (205) afin de forcer ledit micro-ordinateur (205) à communiquer une donnée spécifique au récepteur à un instant spécifique.

**48.** Appareil selon l'une quelconque des revendications 37 à 47, dans lequel une donnée spécifique au récepteur est émise en sortie en réponse à une réaction d'utilisateur à une sortie au niveau dudit dispositif de sortie (202M), ledit appareil comprenant en outre un dispositif d'entrée (225) pour entrer une information d'une réaction d'un utilisateur à une sortie, et un processeur (200, CPU de 205) connecté en fonctionnement audit dispositif d'entrée (225) pour traiter l'information entrée d'une réaction d'un utilisateur.

**49.** Appareil selon l'une quelconque des revendications 37 à 48, dans lequel ladite station émet en sortie sur une station à distance un enregistrement qui répertorie la disponibilité, l'utilisation et/ou l'usage d'un programme, d'un signal de commande ou d'une sortie combinée au niveau de ladite station de récepteur ou d'une certaine entrée de la réaction d'un utilisateur à une sortie combinée constituée par un programme de radiodiffusion ou de diffusion par câble reçu et par une donnée spécifique au récepteur au niveau dudit dispositif de sortie (202M), ledit appareil comprenant en outre un dispositif d'émission (connexion téléphonique 22) pour communiquer une entrée à une station à distance.

**50.** Appareil selon l'une quelconque des revendications 37 à 49, dans lequel ledit signal de commande spécifique force ledit micro-ordinateur (205) à accéder à et à retrouver des données stockées au niveau d'un périphérique d'ordinateur (A: unité de disque de l'ordinateur 205), ledit appareil comprenant en outre une unité de mémoire périphérique d'ordinateur (232, 256) connectée audit micro-ordinateur (205) pour stocker lesdites données à retrouver.

**51.** Appareil selon l'une quelconque des revendications 37 à 50, comprenant en outre une mémoire (en 20 de 200) connectée à un récepteur (mélangeur 3 de la figure 2) pour stocker une information d'un programme sélectionné et pour recevoir depuis une station à distance une information d'un horaire ou d'une fréquence de l'émission dudit programme et un contrôleur (20) connecté à ladite mémoire (en 20) et à un tuner (214) pour forcer ladite station à recevoir ledit programme sélectionné audit horaire ou selon ladite fréquence.

**52.** Appareil selon l'une quelconque des revendications 37 à 51, comprenant en outre un dispositif de stockage (217, 255, 256) connecté à un récepteur (201, 215) ou à un dispositif de sortie (202M) pour recevoir et stocker, de manière à ce qu'au moins une quelconque information constituée par un programme reçu et par un signal de commande reçu ou par une donnée spécifique au récepteur soit stockée pour une émission en sortie décalée temporellement sur un utilisateur.

**53.** Appareil selon l'une quelconque des revendications 37 à 52, comprenant en outre un décrypteur ou un débrouilleur (224) connecté à un récepteur (201) pour permettre le décryptage ou le débrouillage de l'information d'un programme reçu ou d'un signal de commande reçu qui est crypté ou brouillé.

**54.** Appareil selon l'une quelconque des revendications 37 à 53, comprenant en outre un dispositif d'émission sélective (258) pour communiquer le programme provenant d'un récepteur (201, 215) ou d'un dispositif de stockage (217, 217A) à un dispositif de stockage (217, 217A) ou à un dispositif de sortie (202M).

**55.** Appareil selon l'une quelconque des revendications 37 à 54, dans lequel ladite émission d'information est une émission multicanal, ledit appareil comprenant en outre un convertisseur (201) pour recevoir et convertir une certaine partie de ladite émission multicanal et pour convertir une certaine partie de ladite émission multicanal selon une fréquence de sortie spécifique.

**56.** Appareil selon l'une quelconque des revendications 37 à 55, comprenant en outre une imprimante (221) et un emplacement de mémoire de sortie d'impression (tampon d'impression de 205) en connexion avec ledit micro-ordinateur (205) et ladite imprimante (221) pour communiquer une information d'impression à ladite imprimante (221).

**57.** Appareil selon l'une quelconque des revendications 37 à 56, dans lequel ledit programme est un programme de télévision, ledit appareil comprenant en outre un tuner de télévision (215) pour recevoir un signal de télévision contenant ledit programme et un moniteur de télévision pour émettre en sortie ledit programme de télévision et ladite donnée spécifique au récepteur.

**58.** Appareil selon la revendication 37 et selon l'une quelconque des revendications 39 à 56, dans lequel ledit programme est un programme radio, ledit appareil comprenant en outre un tuner radio (209T) pour recevoir un programme radio et un système de haut-parleur (263) pour émettre en sortie ledit programme et ladite donnée spécifique au récepteur.

**59.** Procédé de communication d'un produit de programme de mass media à une pluralité de stations de récepteur dont chacune inclut un récepteur de programme de radiodiffusion ou de diffusion par câble (tuner 215), un dispositif de sortie (202M), un détecteur de signal de commande (décodeur 203), un micro-ordinateur (205) muni d'un emplacement de mémoire spécifique (PC-MicroKey du micro-ordinateur 205) permettant de communiquer avec ledit dispositif de sortie (202M), chaque dite station de récepteur étant adaptée pour détecter la présence d'un ou de plusieurs signaux de commande, pour générer une donnée spécifique au récepteur en réponse à un signal de commande spécifique détecté et pour délivrer au niveau dudit dispositif de sortie une sortie combinée constituée par le programme de radiodiffusion ou de diffusion par câble et par la donnée spécifique au récepteur, ledit procédé de communication comprenant les étapes de:

(1) réception d'un programme à émettre et délivrance du programme à un émetteur;
(2) réception et stockage d'un signal de commande qui, au niveau de la station de récepteur, opère pour générer la donnée spécifique au récepteur; et
(3) action consistant à provoquer la communication du signal de commande stocké sur un émetteur à un instant spécifique pour ainsi émettre une émission d'information comprenant le programme et un ou plusieurs signaux de commande.

**60.** Procédé selon la revendication 59, dans lequel ladite émission d'information est émise sur deux de ladite pluralité de stations de récepteur en même temps et chacune desdites deux stations de récepteur délivre sa sortie combinée constituée par ledit programme de radiodiffusion ou de diffusion par câble reçu et par sa donnée spécifique au récepteur générée au niveau de son dispositif de sortie (202M) dans la même période temporelle.

**61.** Procédé selon la revendication 59, dans lequel ladite émission d'information est émise sur deux de ladite pluralité de stations de récepteur à différents instants et chacune desdites deux stations de récepteur délivre sa sortie combinée constituée par ledit programme de radiodiffusion ou de diffusion par câble reçu et par sa donnée spécifique au récepteur générée au niveau de son dispositif de sortie (202M) dans une période temporelle différente.

**62.** Procédé selon l'une quelconque des revendications 59 à 61, dans lequel un emplacement de mémoire est connecté en fonctionnement à un ordinateur pour recevoir et stocker une certaine information dudit signal de commande, ledit procédé comprenant en outre les étapes de détection d'un signal qui permet, au niveau de la station d'émetteur, de générer et d'entrer ledit signal de génération d'émetteur sur ledit ordinateur pour ainsi forcer ledit ordinateur à générer une certaine information dudit signal de commande et à placer ladite information générée au niveau dudit emplacement de mémoire.

**63.** Procédé selon la revendication 62, comprenant en outre l'étape de programmation dudit ordinateur afin de répondre audit signal de génération d'émetteur en traitant une information stockée dans ledit ordinateur.

**64.** Procédé selon la revendication 62 ou 63, dans lequel ledit ordinateur traite une information spécifique de "formule et élément de cette émission" en réponse audit signal de génération d'émetteur, comprenant en outre les étapes d'entrée de données de "formule et élément" sur ledit ordinateur.

**65.** Procédé selon l'une quelconque des revendications 62 à 64, comprenant en outre la génération d'une certaine partie de soit un programme d'ordinateur, soit un module de données en réponse audit signal de génération d'émetteur.

**66.** Procédé selon l'une quelconque des revendications 59 à 65, comprenant en outre les étapes consistant à forcer un emplacement de mémoire qui peut stocker et communiquer un programme d'ordinateur à communiquer un programme d'ordinateur à un émetteur afin d'émettre ledit programme d'ordinateur pour ainsi forcer au moins une station de récepteur à charger ledit programme d'ordinateur au niveau d'un processeur et pour ainsi forcer ledit processeur à générer une information de sortie sous la commande dudit programme d'ordinateur.

**67.** Procédé selon la revendication 66, comprenant en outre l'étape d'assemblage dudit programme d'ordinateur stocké et communiqué selon un message muni d'une pluralité de segments, et ledit programme d'ordinateur est placé dans une partie spécifique dudit message et ledit message inclut une information qui force au moins une station de récepteur à entrer ledit programme d'ordinateur sur l'un sélectionné d'une pluralité de processeurs.

**68.** Procédé selon la revendication 66 ou 67, comprenant en outre les étapes consistant à forcer un emplacement de mémoire qui peut stocker et communiquer un signal d'instruction à communiquer ledit signal d'instruction à un ordinateur afin de générer une partie dudit programme d'ordinateur au niveau dudit ordinateur en réponse à cela.

**69.** Procédé selon l'une quelconque des revendications 59 à 68, dans lequel ladite station d'émetteur émet un ou plusieurs éléments pris parmi un signal vidéo, un signal audio et un signal de données reçus depuis une station à distance. ledit procédé comprenant en outre l'étape de stockage dudit un ou desdits plusieurs éléments reçus pris parmi un signal vidéo, un signal audio et un signal de données pendant une certaine période temporelle et ainsi, une émission dudit un ou desdits plusieurs éléments reçus pris parmi un signal vidéo, un signal audio et un signal de données est retardée.

**70.** Procédé selon l'une quelconque des revendications 59 à 69, dans lequel un contrôleur commande le passage d'un signal reçu spécifique, ledit procédé comprenant en outre les étapes de détection d'une information noyée dans ledit signal reçu spécifique et de commande du passage dudit signal reçu spécifique sur la base de ladite information noyée détectée.

**71.** Procédé selon la revendication 70, dans lequel ledit contrôleur commande un commutateur, ledit procédé comprenant en outre la commande dudit commutateur pour communiquer des signaux sélectivement depuis un ou plusieurs récepteurs d'entrée de programme et un ou plusieurs emplacements de mémoire à un ou plusieurs emplacements de mémoire et un ou plusieurs émetteurs.

**72.** Procédé selon la revendication 71, dans lequel ladite station d'émetteur émet une pluralité de messages sur l'une de ladite pluralité de stations de récepteur afin de commander ladite une station de récepteur pour délivrer sa sortie combinée constituée par ledit programme et par sa donnée spécifique au récepteur au niveau de son dispositif de sortie, ledit procédé comprenant en outre les étapes de communication d'un signal contenant un de ladite pluralité de messages provenant d'un récepteur d'entrée de programme à un emplacement de mémoire et de communication ensuite dudit signal contenant ledit un de ladite pluralité de messages depuis ledit emplacement de mémoire à un émetteur.

**73.** Procédé selon l'une quelconque des revendications 70 à 72, dans lequel ladite station d'émetteur stocke au moins un programme, ledit procédé comprenant en outre les étapes de réception dudit programme au niveau d'un récepteur d'entrée de programme, de communication dudit programme à un dispositif de stockage et de stockage dudit programme au niveau dudit dispositif de stockage à l'aide d'un signal d'instruction qui permet, au niveau de la station d'émetteur, de commander un dispositif pris parmi ledit ordinateur et ledit contrôleur.

**74.** Procédé selon la revendication 73, comprenant en outre les étapes de détection dudit signal d'instruction et de communication dudit signal d'instruction à un dispositif pris parmi ledit ordinateur et ledit contrôleur.

**75.** Procédé selon la revendication 71 et selon l'une quelconque des revendications 72 à 74 lorsqu'elle dépend de la revendication 71, comprenant en outre l'étape de commande dudit commutateur sur la base de la présence ou de l'absence d'un signal d'instruction stocké avec un programme.

**76.** Procédé selon l'une quelconque des revendications 59 à 75, dans lequel ladite station d'émetteur inclut une pluralité de récepteurs d'entrée de programme, ledit procédé comprenant en outre les étapes de traitement de signaux reçus au niveau de ladite pluralité de récepteurs d'entrée de programme, de communication d'une information de commande en réponse à une donnée noyée et de commande du passage d'un signal reçu au niveau de l'un spécifique de ladite pluralité de récepteurs d'entrée de programme sur la base de ladite information de commande communiquée.

**77.** Procédé selon l'une quelconque des revendications 59 à 76, dans lequel ledit programme et ledit signal de génération de récepteur sont reçus depuis une ou plusieurs stations à distance, ledit procédé comprenant en outre les étapes de traitement d'un signal reçu depuis ladite une ou lesdites plusieurs stations à distance et de ladite commande de ladite station d'émetteur afin de communiquer ledit programme à un émetteur, ou ledit signal de génération de récepteur audit ordinateur, sur la base d'une information dans ledit signal reçu traité.

**78.** Procédé selon l'une quelconque des revendications 59 à 77, comprenant en outre les étapes de réception dudit programme au niveau d'un récepteur dans la station d'émission, de communication dudit programme provenant dudit récepteur à un emplacement de mémoire et de stockage dudit programme au niveau dudit emplacement de mémoire pendant une certaine période temporelle avant la communication dudit programme à un émetteur.

**79.** Procédé selon la revendication 78, comprenant en outre les étapes de réception dudit programme au niveau de l'un sélectionné d'une pluralité de récepteurs dans la station d'émetteur et de communication dudit programme depuis ledit récepteur sélectionné à un émetteur.

**80.** Procédé selon l'une quelconque des revendications 78 et 79, comprenant en outre les étapes d'émission dudit programme au niveau de l'un sélectionné d'une pluralité d'émetteurs et de communication dudit programme audit émetteur sélectionné.

**81.** Procédé selon l'une quelconque des revendications 59 à 80, dans lequel un commutateur communique des signaux reçus sélectivement depuis au moins un récepteur et au moins un emplacement de mémoire à un émetteur, ledit procédé comprenant en outre les étapes d'entrée d'un signal qui permet, au niveau de la station d'émetteur, de donner en instruction une communication, et de commande dudit commutateur pour communiquer un signal reçu depuis un récepteur à un emplacement de mémoire en réponse audit signal d'instruction.

**82.** Procédé selon la revendication 81 lorsqu'elle dépend de la revendication 62, dans lequel ledit signal reçu contient ledit signal de génération d'émetteur, ledit procédé comprenant en outre l'étape de communication ensuite d'au moins une certaine part dudit signal de génération d'émetteur depuis ledit emplacement de mémoire jusqu'à un second emplacement de mémoire.

**83.** Procédé selon la revendication 81, dans lequel ledit signal reçu contient ledit programme, ledit procédé comprenant en outre l'étape de commande dudit commutateur pour communiquer ledit programme à un émetteur.

**84.** Procédé selon l'une quelconque des revendications 59 à 83, dans lequel une pluralité de signaux sont reçus depuis une ou plusieurs stations à distance au niveau de ladite station d'émetteur, ledit procédé comprenant en outre les étapes de sélection d'un ou de plusieurs de ladite pluralité de signaux et de communication de chaque signal sélectionné à un dispositif de stockage.

**85.** Procédé selon la revendication 84 lorsqu'elle dépend de la revendication 70, dans lequel un ou plusieurs desdits signaux sélectionnés est un signal qui permet, au niveau de la station d'émetteur, d'appliquer une instruction à un dispositif pris parmi ledit ordinateur et ledit contrôleur, ledit procédé comprenant en outre l'étape consistant à forcer un emplacement de mémoire à communiquer ledit signal d'instruction avant ledit instant spécifique et à commander ledit dispositif pris parmi ledit ordinateur et ledit contrôleur en réponse audit signal d'instruction.

**86.** Procédé selon l'une quelconque des revendications 59 à 85, dans lequel une pluralité de signaux sont reçus depuis une ou plusieurs stations à distance et au moins l'un est stocké au niveau de ladite station d'émetteur et l'un de ladite pluralité de signaux reçus opère pour réaliser une planification, ledit procédé comprenant en outre les étapes de programmation de ladite station d'émetteur afin de stocker la planification et de contrainte dudit émetteur à émettre conformément à la planification.

**87.** Procédé selon la revendication 86, comprenant en outre l'étape consistant à forcer ladite station d'émetteur à générer conformément à la planification.

**88.** Procédé selon la revendication 86 ou 87, comprenant en outre l'étape consistant à accorder un récepteur ou à commander une station terrienne de satellite afin de recevoir un signal conformément à la planification.

**89.** Procédé selon l'une quelconque des revendications 59 à 88, comprenant en outre les étapes de réception d'une émission d'information depuis une station à distance, de détection dans l'émission d'information d'un signal d'instruction qui permet, au niveau de la station d'émetteur, d'exécuter un jeu d'instructions, de chargement d'un jeu d'instructions au niveau d'un ordinateur en réponse audit signal d'instruction et sur la base dudit jeu d'instructions, de sélection d'une information à traiter au niveau d'une station de récepteur ou de communication d'une information à associer audit programme.

**90.** Procédé selon l'une quelconque des revendications 59 à 89, dans lequel un contrôleur commande un emplacement de mémoire afin de communiquer à un émetteur un signal de commande sélectionné, ledit procédé comprenant en outre les étapes de détection d'un signal qui permet, au niveau de la station d'émetteur, de donner en instruction une émission, et d'entrée dudit signal sur ledit contrôleur pour ainsi forcer ledit emplacement de mémoire à communiquer un signal de commande sélectionné.

91. Procédé selon la revendication 90, comprenant en outre l'étape de programmation dudit contrôleur afin de répondre à un dit signal en commandant un emplacement de mémoire sélectionné afin de communiquer un signal de commande ou en forçant un emplacement de mémoire à communiquer un signal de commande sélectionné.

92. Procédé selon la revendication 90 ou 91, dans lequel le signal d'émission d'instruction est reçu dans une émission d'information de radiodiffusion ou de diffusion par câble émise par une station à distance.

93. Procédé selon l'une quelconque des revendications 90 à 92, comprenant en outre les étapes de stockage d'un signal qui permet, au niveau de la station d'émetteur, d'appliquer une instruction, et de commande dudit emplacement de mémoire afin de communiquer un signal de commande sélectionné à un instant planifié conformément audit signal d'instruction.

94. Procédé selon l'une quelconque des revendications 90 à 93, comprenant en outre l'étape de stockage dudit signal audit emplacement de mémoire avec ledit programme.

95. Procédé selon l'une quelconque des revendications 90 à 94, comprenant en outre les étapes de commande d'un emplacement de mémoire afin de communiquer ledit programme à un émetteur en réponse à un premier signal d'instruction et de commande d'un emplacement de mémoire afin de communiquer un signal de commande sélectionné en réponse à un second signal d'instruction.

96. Procédé selon la revendication 95, comprenant en outre les étapes de détection d'un signal de commande communiqué depuis ledit emplacement de mémoire et de programmation d'un contrôleur pour répondre à un signal de commande communiqué depuis ledit emplacement de mémoire.

97. Procédé selon l'une quelconque des revendications 90 à 96, comprenant en outre l'étape consistant à noyer un signal d'instruction dans ledit programme pour ainsi permettre à un contrôleur de répondre audit signal d'instruction noyé à un instant où ledit programme est en train d'être communiqué.

98. Procédé selon la revendication 64 et selon l'une quelconque des revendications 65 à 97 lorsqu'elle dépend de la revendication 64, dans lequel ledit signal de génération d'émetteur ou lesdites données de "formule et élément" sont reçues dans une émission d'information de radiodiffusion ou de diffusion par câble émise par la station à distance, ledit procédé comprenant en outre les étapes de réception d'un signal d'instruction provenant d'une station à distance et d'émission de ladite information "formule et élément" en réponse à cela.

99. Procédé selon l'une quelconque des revendications 59 à 98, comprenant en outre les étapes de stockage d'un signal qui permet, au niveau de la station d'émission, de donner en instruction une génération, et de commande d'un ordinateur afin de traiter une information stockée avant ledit instant spécifique conformément audit signal d'instruction stocké.

100. Procédé selon l'une quelconque des revendications 59 à 99, comprenant en outre les étapes de stockage et d'émission sur une station de récepteur de données qui spécifient un instant d'émission ou un canal d'émission d'un quelconque produit considéré d'un programme spécifique, et d'émission ensuite dudit programme conformément aux données spécifiées pour ainsi permettre à ladite station de récepteur de sélectionner et de stocker ou de sélectionner et d'émettre en sortie ledit programme.

101. Procédé selon l'une quelconque des revendications 59 à 100, comprenant en outre les étapes d'émission sur une station de récepteur d'un signal de commande pour forcer ladite station de récepteur à s'aligner sur un système de traitement parallèle et à sélectionner et entrer sur un micro-ordinateur une quelconque information associée à un programme ou un signal de commande émis dans une émission d'information de radiodiffusion ou de diffusion par câble et pour forcer ledit micro-ordinateur à traiter une information stockée et à générer une sortie en réponse à ladite information entrée.

102. Procédé selon la revendication 100 ou 101, comprenant en outre les étapes de communication à un générateur de signal de données qui spécifient un instant d'émission ou un canal d'émission d'un quelconque produit considéré d'un programme spécifique ou d'un signal de commande et d'addition desdites données communiquées ou dudit signal de commande à une partie spécifique d'une émission d'information de radiodiffusion ou de diffusion par câble ou d'addition desdites données communiquées ou dudit signal de commande communiqué à une émission d'information de radiodiffusion ou de diffusion par câble dans un message d'un format spécifique.

**103.** Procédé selon l'une quelconque des revendications 59 à 102, comprenant en outre les étapes consistant à forcer un emplacement de mémoire qui permet de stocker et de communiquer un signal qui permet, au niveau de la station de récepteur, de réaliser une synchronisation, à communiquer ledit signal à un émetteur afin d'émettre ledit signal pour ainsi forcer l'au moins une station de récepteur à commencer l'exécution de fonctions commandées sélectionnées programmées au niveau de ladite une station en réponse à une information sélectionnée dans l'information de radiodiffusion ou de diffusion par câble émise par ledit émetteur.

**104.** Procédé selon l'une quelconque des revendications 59 à 103, comprenant en outre les étapes consistant à forcer un emplacement de mémoire qui permet de stocker et de communiquer un signal qui permet, au niveau de la station de récepteur, de réaliser une interruption, à communiquer ledit signal à un émetteur afin d'émettre ledit signal pour ainsi forcer l'au moins une station de récepteur à interrompre le traitement d'un micro-ordinateur, contrôleur ou processeur sélectionné en réponse à cela.

**105.** Procédé selon l'une quelconque des revendications 59 à 104, comprenant en outre les étapes consistant à forcer un emplacement de mémoire qui permet de stocker et de communiquer un signal qui peut, au niveau de la station de récepteur, jouer le rôle de source à partir de laquelle est sélectionnée une donnée spécifique au récepteur à générer, à communiquer le signal à un émetteur afin d'émettre ledit signal pour ainsi forcer l'au moins une station de récepteur à sélectionner une donnée spécifique au récepteur à générer.

**106.** Procédé selon la revendication 105, dans lequel ledit signal qui peut, au niveau de la station de récepteur, jouer le rôle de source est émis avant ledit signal de génération de récepteur et ainsi, l'au moins une station de récepteur stocke des données reçues dans ledit signal de source et génère une donnée spécifique au récepteur en traitant lesdites données stockées.

**107.** Procédé selon l'une quelconque des revendications 59 à 106, comprenant en outre les étapes consistant à forcer un emplacement de mémoire qui permet de stocker et de communiquer un signal qui permet, au niveau de la station de récepteur, de cesser une combinaison, à communiquer le signal à un émetteur afin d'émettre ledit signal pour ainsi forcer l'au moins une station de récepteur à cesser de combiner sa donnée spécifique au récepteur générée à un instant spécifique.

**108.** Procédé selon l'une quelconque des revendications 59 à 107, comprenant en outre les étapes consistant à forcer un emplacement de mémoire qui permet de stocker et de communiquer un signal qui, au niveau de la station de récepteur, opère pour réaliser une combinaison, à communiquer le signal à un émetteur afin d'émettre ledit signal pour ainsi forcer l'au moins une station de récepteur à délivrer une sortie combinée constituée par ledit programme de radiodiffusion ou de diffusion par câble reçu et par ladite donnée spécifique au récepteur au niveau de son dispositif de sortie à un instant spécifique.

**109.** Procédé selon l'une quelconque des revendications 59 à 108, comprenant en outre les étapes consistant à forcer un emplacement de mémoire qui permet de stocker et de communiquer un signal qui, au niveau de la station de récepteur, opère pour remettre à zéro une donnée spécifique au récepteur générée, à communiquer ledit signal à un émetteur afin d'émettre ledit signal pour ainsi forcer l'au moins une station de récepteur à remettre à zéro sa donnée spécifique au récepteur générée en réponse à cela.

**110.** Procédé selon l'une quelconque des revendications 59 à 109, comprenant en outre l'étape de détection d'un signal qui permet. au niveau de la station d'émetteur, de donner en instruction une génération, dans un signal pris parmi un signal de télévision et un signal radio ou au niveau d'un emplacement de mémoire qui stocke soit un programme de télévision, soit un programme de radio.

**111.** Procédé selon l'une quelconque des revendications 59 à 110, dans lequel la station de récepteur est une station d'émetteur intermédiaire à distance, le dispositif de sortie (202M) est un émetteur (83, 87, 91, 92), le micro-ordinateur (205) est une unité de commande automatique (73) pour la station d'émetteur intermédiaire et l'emplacement de mémoire spécifique est une mémoire de "programme établi pour l'émission", ledit procédé comprenant en outre les étapes de:

(1) réception d'un ou de plusieurs signaux d'instruction qui permettent, au niveau d'une station d'abonné, de donner instruction à un ordinateur (73, 205) ou à un processeur (en 71, 200, 39J) la manière de recevoir ou de présenter un produit de programme de télévision ou une sortie d'ordinateur ou de fonctionner sur la base d'une réaction de téléspectateurs à une programmation de télévision ou à une présentation de sortie d'ordinateur et de délivrer l'un ou les plusieurs signaux d'instruction à un émetteur;
(2) réception d'un ou de plusieurs signaux de commande qui, au niveau de la station d'émetteur intermédiaire à distance, opèrent pour exécuter ou communiquer ledit un ou lesdits plusieurs signaux d'instruction; et
(3) contrainte dudit un ou desdits plusieurs signaux de commande à être communiqués audit émetteur avant ledit instant spécifique pour ainsi émettre une émission d'information comprenant l'un ou les plusieurs signaux d'instruction et l'un ou les plusieurs signaux de commande.

**112.** Procédé selon l'une quelconque des revendications 59 à 111, dans lequel la station de récepteur est une station d'émetteur intermédiaire à distance, le dispositif de sortie (202M) est un émetteur (83, 87, 91, 92), le micro-ordinateur (205) est une unité de commande automatique (73) pour la station d'émetteur intermédiaire et l'emplacement de mémoire spécifique est une mémoire (73) ou un enregistreur (76 ou 78), ledit procédé comprenant en outre l'une des étapes suivantes:

(1) réception dudit programme et délivrance dudit programme à un émetteur avant ledit instant spécifique;
(2) réception d'un ou de plusieurs signaux d'instruction qui permettent, au niveau d'une station d'abonné, de donner instruction à un ordinateur (73, 205) ou à un processeur (en 71, 200, 39J) la manière de recevoir ou de présenter un produit associé audit programme ou de fonctionner sur la base d'une réaction d'utilisateur à une sortie associée audit programme et de délivrer l'un ou les plusieurs signaux d'instruction à un émetteur avant ledit instant spécifique;
(3) réception d'un ou de plusieurs signaux de commande qui, au niveau de la station d'émetteur intermédiaire à distance, opèrent pour sélectionner ou communiquer ledit programme ou l'un ou plusieurs signaux d'instruction et délivrance desdits un ou plusieurs signaux de commande à un émetteur avant ledit instant spécifique; et
(4) réception d'une planification qui, au niveau de la station d'émetteur intermédiaire à distance, opère pour émettre ledit programme et lesdits un ou plusieurs signaux d'instruction et délivrance de la planification à un émetteur avant ledit instant spécifique.

**113.** Procédé selon l'une quelconque des revendications 59 à 112, dans lequel une station d'émetteur reçoit depuis une station d'abonné une quelconque information d'une réaction d'un abonné à une programmation de télévision ou à une présentation de sortie d'ordinateur, ledit procédé comprenant en outre au moins l'une des étapes suivantes:

émission sur une station d'abonné d'un programme d'ordinateur qui traite une certaine information d'une réaction d'un abonné à une programmation de télévision ou à une présentation de sortie d'ordinateur;
affinage d'une certaine variable d'un signal d'instruction sur la base d'une réaction d'un abonné à une programmation de télévision ou à une présentation de sortie d'ordinateur; et
émission d'une certaine partie d'un programme de télévision ou d'un signal d'instruction sur la base d'une réaction d'un abonné à une programmation de télévision ou à une présentation de sortie d'ordinateur.

**114.** Procédé selon l'une quelconque des revendications 59 à 113, comprenant en outre les étapes consistant à forcer une station d'émetteur à émettre ledit programme et à forcer une seconde station d'émetteur à émettre ledit signal de commande qui, au niveau de la station de récepteur, opère pour générer la donnée spécifique au récepteur ou à émettre un module de données qui, au niveau de la station de récepteur, joue le rôle de source d'une donné spécifique au récepteur afin de réaliser une sélection et une génération.

**115.** Procédé selon l'une quelconque des revendications 59 à 114, dans lequel ledit programme est émis sur une station d'abonné par satellite et une seconde station d'émetteur est amenée à radiodiffuser ou à diffuser par câble sur ladite station d'abonné ledit signal de commande ou ledit module de données associé audit programme.

**116.** Procédé selon l'une quelconque des revendications 59 à 115, comprenant en outre l'émission d'une pluralité de programmes et d'un ou de plusieurs signaux qui permettent, au niveau d'une station d'abonné, d'analyser une valeur ou de générer une planification pour ainsi forcer au moins une station d'abonné à sélectionner l'un de ladite pluralité de programmes sur la base de sa valeur potentielle pour un abonné ou à émettre en sortie deux ou plusieurs desdits programmes selon un ordre spécifique au récepteur.

**117.** Appareil de station d'émetteur pour traiter des signaux et communiquer des produits de programme de mass media afin de présenter au niveau de chacune d'une pluralité de stations de récepteur une sortie combinée constituée par un programme de radiodiffusion ou de diffusion par câble et par une donnée générée par un ordinateur spécifique au récepteur, chacune desdites stations de récepteur comportant un dispositif de sortie (202M) pour recevoir et délivrer le programme de radiodiffusion ou de diffusion par câble et toute autre information, ladite station comportant également un micro-ordinateur (205) muni d'un emplacement de mémoire spécifique (PC-MicroKey du micro-ordinateur 205) connecté en fonctionnement audit dispositif de sortie (202M) pour stocker et émettre en sortie une information sur ledit dispositif de sortie (202M), ledit appareil de station d'émetteur comprenant:

un émetteur de radiodiffusion ou de diffusion par câble (83, 87, 91 ou 92) pour communiquer à une pluralité de stations de récepteur une émission d'information comprenant un programme et un ou plusieurs signaux de commande;
un récepteur d'entrée de programme (76, 78, 53-62) connecté en fonctionnement audit émetteur (83, 87, 91 ou 92) pour communiquer le programme audit émetteur (83, 87, 91 ou 92);
une mémoire (73) ou un enregistreur (76 ou 78) connecté en fonctionnement audit émetteur (83, 87, 91 ou 92) pour stocker et communiquer un signal de commande qui, au niveau de la station de récepteur, opère pour générer la donnée spécifique au récepteur; et
un dispositif d'entrée (98, 74, 50-62) connecté en fonctionnement à ladite mémoire (73) ou audit enregistreur (76 ou 78) pour forcer ladite mémoire (73) ou ledit enregistreur (76 ou 78) à communiquer ledit signal de commande à un instant spécifique audit émetteur (83, 87, 91 ou 92) afin d'ainsi communiquer ledit programme et ledit signal de commande auxdites stations de récepteur et d'ainsi forcer chacune de ladite pluralité de stations de récepteur à délivrer ledit programme au niveau de son dispositif de sortie (202M), à générer (205) une donnée spécifique à la station de récepteur, à placer sa donnée spécifique à la station de récepteur au niveau de son emplacement de mémoire (PC-MicroKey du micro-ordinateur 205) pendant une période temporelle et à délivrer une sortie combinée constituée par ledit programme de radiodiffusion ou de diffusion par câble et par sa donnée spécifique de station de récepteur au niveau de son dispositif de sortie (202M).

**118.** Appareil de station d'émetteur selon la revendication 117, dans lequel ladite station d'émetteur émet sur ladite pluralité de stations de récepteur une première donnée spécifique à l'émetteur et au moins l'une de ladite pluralité de stations de récepteur présente une certaine information d'une donnée spécifique au récepteur sur la base de ladite première donnée spécifique à l'émetteur. ledit appareil comprenant en outre:
une seconde mémoire (73) ou un second enregistreur (76 ou 78) connecté en fonctionnement audit émetteur (83, 87, 91 ou 92) pour stocker et communiquer une donnée spécifique à l'émetteur, qui, au niveau de la station de récepteur, joue le rôle de base pour calculer une certaine information d'une donnée spécifique au récepteur.

**119.** Appareil de station d'émetteur selon la revendication 117, dans lequel ladite station d'émetteur émet sur ladite pluralité de stations de récepteur une seconde donnée spécifique d'émetteur et au moins l'une de ladite pluralité de stations de récepteur émet en sortie ladite seconde donnée spécifique à l'émetteur au niveau de son dispositif de sortie (202M), ledit appareil comprenant en outre:
une troisième mémoire (73) ou un troisième enregistreur (76 ou 78) connecté en fonctionnement audit émetteur (83, 87, 91 ou 92) pour stocker et communiquer certaines données qui, au niveau de la station de récepteur, jouent le rôle de source depuis laquelle est sélectionnée une donnée spécifique au récepteur à générer.

**120.** Appareil de station d'émetteur selon l'une quelconque des revendications 117 à 119, dans lequel ledit dispositif d'entrée entre un premier signal d'avancement qui permet ensuite, au niveau de la station d'émetteur, audit instant spécifique, d'émettre en sortie ladite mémoire (73) ou ledit enregistreur (76 ou 78) nommé en premier sur ledit émetteur (83, 87, 91 ou 92), ledit appareil comprenant en outre:

un premier processeur (73) connecté en fonctionnement audit dispositif d'entrée (50-62, 74, 98) pour distinguer un signal d'avancement;
un premier contrôleur de mémoire (73, 205C en 73) connecté en fonctionnement audit premier processeur (73) pour commander une mémoire (73) ou un enregistreur (76 ou 78) afin de stocker un ou plusieurs signaux d'avancement; et
une quatrième mémoire (73) ou un quatrième enregistreur (76 ou 78) connecté en fonctionnement audit premier contrôleur (73, 205C en 73) pour stocker ledit premier signal d'avancement.

**121.** Appareil de station d'émetteur selon l'une quelconque des revendications 117 à 120, dans lequel ledit dispositif d'entrée (98, 74, 50-62) entre un signal d'instruction qui permet, au niveau de la station d'émetteur, d'émettre en sortie ladite mémoire (73) ou ledit enregistreur (76 ou 78) nommé en premier sur ledit émetteur (83, 87, 91 ou 92) audit instant spécifique, ledit appareil comprenant en outre:

un premier processeur de commande (39J, 73) connecté en fonctionnement audit dispositif d'entrée (98, 74, 50-62) pour distinguer un signal qui permet, au niveau de ladite station d'émetteur. d'appliquer une instruction; et

un premier contrôleur de sortie (73, 205C en 73, 39 dans un quelconque décodeur, 12 dans 71) connecté en fonctionnement audit premier processeur de commande (73) pour émettre en sortie un signal de commande qui permet d'émettre en sortie une mémoire (73) ou un enregistreur (76 ou 78).

**122.** Appareil de station d'émetteur selon l'une quelconque des revendications 117 à 121, comprenant en outre au moins un dispositif pris parmi:

un premier contrôleur de dispositif d'émission sélective (73) connecté en fonctionnement audit récepteur d'entrée de programme (76, 78, 53-62) pour commander un premier dispositif d'émission sélective (75, 76, 78, 53-62) pour communiquer un ou plusieurs signaux à une mémoire (73) ou à un enregistreur (76 et 78) avant un instant spécifique;

un second contrôleur de dispositif d'émission sélective (73) connecté en fonctionnement audit émetteur de radiodiffusion ou de diffusion par câble (83, 87, 91, 92) pour commander un second dispositif d'émission sélective (73, 75, 76, 78) afin de communiquer un ou plusieurs signaux depuis une ou plusieurs mémoires (73) et/ou enregistreurs (76 ou 78) à un instant spécifique.

**123.** Appareil de station d'émetteur selon l'une quelconque des revendications 117 à 122, comprenant en outre:

un contrôleur central (73) connecté en fonctionnement à un dispositif pris parmi ledit récepteur d'entrée de programme (76, 78, 53-62) et ledit émetteur de radiodiffusion ou de diffusion par câble (83, 87, 91, 92) pour commander la communication sur ladite une partie prise parmi une certaine partie dudit programme, une certaine part d'un message à associer audit programme, une ou plusieurs données qui identifient ledit programme, une certaine information d'avancement dudit programme, une ou plusieurs données qui désignent le point de début d'une certaine partie dudit programme ou un signal qui désigne ledit programme et qui permet, au niveau de la station de récepteur, d'appliquer une instruction.

**124.** Appareil de station d'émetteur selon la revendication 123, comprenant en outre un dispositif pris parmi:

une horloge connectée en fonctionnement audit contrôleur central (73); et

un second dispositif d'entrée (98, 74, 50-62) connecté en fonctionnement audit contrôleur central (73) pour entrer une ou plusieurs instructions de commande de cadencement.

**125.** Appareil de station d'émetteur selon la revendication 123 ou 124, comprenant en outre un dispositif pris parmi:

un second processeur (73, dans 71, dans un quelconque décodeur) connecté en fonctionnement audit contrôleur central (73) pour distinguer un signal de commande de cadencement ou un instant auquel il convient de laisser passer un signal qui est permet d'appliquer une instruction;

un second contrôleur de mémoire (73) connecté en fonctionnement audit contrôleur central (73) pour commander une mémoire sélectionnée (73) ou un enregistreur sélectionné (76 ou 78) afin de stocker un signal d'avancement qui permet d'appliquer une instruction; et

une cinquième mémoire (73) ou un cinquième enregistreur (76 ou 78) connecté en fonctionnement audit contrôleur central (73) pour stocker deux signaux ou plus en ordre.

**126.** Appareil de station d'émetteur selon l'une quelconque de la revendication 119 et des revendications 120 à 125 lorsqu'elle dépend de la revendication 119, comprenant en outre:

un premier ordinateur (73) connecté en fonctionnement à un élément pris parmi ladite seconde mémoire (73) ou ledit second enregistreur (76 ou 78) et ladite troisième mémoire (73) ou ledit troisième enregistreur (76 ou 78) pour recevoir des données "formule et élément" et pour émettre en sortie une certaine partie d'un module de données sur cette mémoire (73) ou cet enregistreur (76 ou 78).

**127.** Appareil de station d'émetteur selon l'une quelconque des revendications 117 à 126, dans lequel un certain dit signal de commande est une information "formule et élément de cette émission", ledit appareil comprenant en outre:

un second ordinateur (73) connecté en fonctionnement à ladite mémoire (73) ou audit enregistreur (76 ou 78) nommé en premier pour émettre en sortie une information "formule et élément de cette émission" en réponse à un signal d'instruction qui permet, au niveau de la station d'émetteur, de réaliser une génération.

**128.** Appareil de station d'émetteur selon l'une quelconque de la revendication 120 et des revendications 121 à 127 lorsqu'elle dépend de la revendication 120, dans lequel un signal contenant ledit programme entre un signal d'avancement codé qui permet, au niveau de la station d'émetteur, d'émettre en sortie ladite mémoire (73) ou ledit enregistreur (76 ou 78) nommé en premier sur ledit émetteur (83, 87, 91 ou 92), ledit appareil comprenant en outre:

un premier décodeur (71, 77, 79) connecté en fonctionnement audit dispositif d'entrée (98, 74, 50-62) pour décoder une information codée dans un signal contenant un programme;
un troisième dispositif d'émission sélective (en 39, en 71) connecté en fonctionnement audit premier décodeur (en 71) pour communiquer audit premier processeur (en 39, en 71) une ou plusieurs données.

**129.** Appareil de station d'émetteur selon la revendication 128 lorsqu'elle dépend de la revendication 122, dans lequel ladite station d'émetteur inclut ledit premier contrôleur de dispositif d'émission sélective (73) et ledit décodeur (en 71, 77, 79) décode une ou plusieurs données qui permettent, au niveau de la station d'émetteur. de retarder une communication sur la station de récepteur d'une certaine partie dudit signal contenant ledit programme, ledit appareil comprenant en outre:

un quatrième dispositif d'émission sélective (en 39, en 71) connecté en fonctionnement audit premier décodeur (en 71) pour communiquer audit premier processeur de commande (en 39, en 71) une ou plusieurs données; et
un cinquième dispositif d'émission sélective (en 39, 71) connecté en fonctionnement audit premier processeur de commande (en 39, en 71) pour communiquer audit premier contrôleur de dispositif d'émission sélective (73) un signal qui permet d'appliquer une instruction.

**130.** Appareil de station d'émetteur selon l'une quelconque des revendications 117 à 129, dans lequel ledit dispositif d'entrée (98, 74, 50-62) inclut un premier récepteur (50-62, 71, 73) pour recevoir depuis une station à distance un signal qui permet, au niveau de la station d'émetteur, d'appliquer une instruction.

**131.** Appareil de station d'émetteur selon l'une quelconque des revendications 117 à 130, dans lequel ledit premier ordinateur (73) ou ledit second ordinateur (73) génère une certaine sortie en réponse à un signal d'instruction qui permet, au niveau de la station d'émetteur, de réaliser une génération, ledit appareil comprenant en outre:

une sixième mémoire (73) ou un sixième enregistreur (76 ou 78) pour stocker un signal d'instruction qui permet, au niveau de la station d'émetteur, de réaliser une génération; et
un troisième dispositif d'entrée (73, 74, 98, en 71) connecté en fonctionnement à ladite sixième mémoire (73) ou audit sixième enregistreur (76 ou 78) pour forcer ladite sixième mémoire (73) ou ledit sixième enregistreur (76 ou 78) à émettre en sortie à un second instant spécifique un signal d'instruction qui permet, au niveau de la station d'émetteur, de réaliser une génération; et
un sixième dispositif d'émission sélective (73) connecté en fonctionnement à ladite sixième mémoire (73) ou audit sixième enregistreur (76 ou 78) pour recevoir et transférer un ou plusieurs signaux d'instruction.

**132.** Appareil de station d'émetteur selon la revendication 131 comprenant en outre:
un troisième processeur (73) connecté en fonctionnement audit second dispositif d'entrée (73, 98, en 71) et audit second contrôleur de mémoire (73) pour distinguer un signal d'instruction qui permet, au niveau de la station d'émetteur, de réaliser une génération et pour forcer ledit second contrôleur de mémoire (73) à commander ladite sixième mémoire (73) ou ledit sixième enregistreur (76 ou 78) afin de stocker ledit signal d'instruction distingué.

**133.** Appareil de station d'émetteur selon la revendication 131 ou 132, dans lequel ledit second dispositif d'entrée (73, 74, 98, en 71) reçoit, depuis une seconde station à distance, ledit signal d'instruction qui permet, au niveau de la station d'émetteur, de réaliser une génération.

**134.** Appareil de station d'émetteur selon l'une quelconque des revendications 131 à 133, comprenant en outre:
un contrôleur SPAM (205C en 73, 39 dans un quelconque décodeur, 12 en 71) connecté en fonctionnement à un ordinateur spécifique (73) pour commander ledit ordinateur spécifique (73) afin de générer ou d'émettre en sortie un programme d'ordinateur ou un module de données conformément à un signal d'instruction qui permet, au niveau de la station d'émetteur, de réaliser une génération.

**135.** Appareil de station d'émetteur selon l'une quelconque des revendications 128 à 134, dans lequel ledit récepteur d'entrée de programme (76, 78, 53-62) entre un signal d'instruction codé qui est reçu avec ledit programme et qui permet, au niveau de la station d'émetteur, de réaliser une génération, ledit appareil comprenant en outre:

un septième dispositif d'émission sélective (en 71, en 77, en 79) connecté en fonctionnement audit premier décodeur (en 71, 77, 79) pour recevoir et transférer un signal décodé; et

un quatrième processeur (73, en 71, en 77, en 79) connecté en fonctionnement audit septième dispositif d'émission sélective (en 71, en 77, en 79) pour distinguer un dispositif sur lequel il convient de laisser passer un signal qui permet, au niveau de la station d'émetteur, d'appliquer une instruction.

**136.** Appareil de station d'émetteur selon l'une quelconque des revendications 117 à 135, dans lequel ladite station d'émetteur émet un ou plusieurs signaux qui permettent, au niveau de la station de récepteur, de donner instruction à l'emplacement de mémoire spécifique de combiner ou de cesser de combiner ou de remettre à zéro une donnée générée par un ordinateur spécifique au récepteur, ledit appareil comprenant en outre:

un quatrième dispositif d'entrée (50-62, 74, 98) connecté en fonctionnement à un émetteur de radiodiffusion ou de diffusion par câble (83, 87, 91 ou 92) pour communiquer audit émetteur de radiodiffusion ou de diffusion par câble (83, 87, 91 ou 92) à un troisième instant spécifique un ou plusieurs signaux qui permettent, au niveau de la station de récepteur, d'appliquer une instruction.

**137.** Appareil de station d'émetteur selon la revendication 136, dans lequel une troisième station à distance communique ledit un ou lesdits plusieurs signaux qui permettent, au niveau de la station de récepteur, d'appliquer une instruction, ledit appareil comprenant en outre:

un second récepteur (50-62, 71, 73) connecté en fonctionnement à un dispositif d'émission sélective (73, 75, en 71, 39 dans un quelconque décodeur) pour recevoir depuis une station à distance un ou plusieurs signaux qui permettent, au niveau de la station de récepteur, d'appliquer une instruction.

**138.** Appareil de station d'émetteur selon la revendication 136 ou 137. comprenant en outre:

une septième mémoire (73) ou un septième enregistreur (76 ou 78) connecté en fonctionnement à un dispositif d'émission sélective (73, 75, en 71, 39 dans un quelconque décodeur) pour stocker un ou plusieurs signaux qui permettent, au niveau de la station de récepteur, d'appliquer une instruction; et

un cinquième dispositif d'entrée (50-62, 74, 98) connecté en fonctionnement à ladite septième mémoire (73) ou audit septième enregistreur (76 ou 78) pour forcer ladite septième mémoire (73) ou ledit septième enregistreur (76 ou 78) à émettre en sortie sur un émetteur de radiodiffusion ou de diffusion par câble (83, 87, 91 ou 92) à un instant spécifique un ou plusieurs signaux qui permettent. au niveau de la station de récepteur, d'appliquer une instruction.

**139.** Appareil de station d'émetteur selon l'une quelconque des revendications 117 à 138, dans lequel ledit récepteur d'entrée de programme (76, 78, 53-62) est une mémoire (73) ou un enregistreur (76 ou 78) au niveau duquel au moins une certaine part dudit programme est stockée, ledit appareil comprenant en outre:

un sixième dispositif d'entrée (50-62, 74, 98) connecté en fonctionnement audit récepteur d'entrée de programme (76, 78, 53-62) pour forcer ledit récepteur d'entrée de programme (76, 78, 53-62) à commencer à émettre en sortie ledit programme sur un émetteur de radiodiffusion ou de diffusion par câble (83, 87, 91 ou 92) à un quatrième instant spécifique.

**140.** Appareil de station d'émetteur selon la revendication 139, comprenant en outre:

une huitième mémoire (73) ou un huitième enregistreur (76 ou 78) pour stocker une ou plusieurs données qui désignent le point de début d'une partie d'un programme; et

un second contrôleur de sortie (73, 205C dans 73, 39 dans un quelconque décodeur, 12 dans 71) connecté en fonctionnement à ladite huitième mémoire (73) et audit récepteur d'entrée de programme (76, 78, 53-62) pour commander ledit récepteur d'entrée de programme (76, 78, 53-62) afin de commencer l'émission en sortie d'une partie d'un programme au début de ladite partie.

**141.** Appareil de station d'émetteur selon la revendication 139, dans lequel ledit sixième dispositif d'entrée (50-62, 74, 98) entre un signal d'instruction qui permet, au niveau de la station d'émetteur, d'émettre en sortie ledit programme audit quatrième instant spécifique, ledit appareil comprenant en outre un dispositif pris parmi:

un cinquième processeur (73) connecté en fonctionnement audit cinquième dispositif d'entrée (50-62, 74, 98) pour distinguer un signal qui permet, au niveau de ladite station d'émetteur, d'émettre en sortie un programme; et

un sixième processeur (73) connecté en fonctionnement audit sixième processeur (73) pour localiser ou identifier une certaine partie d'un programme.

**142.** Appareil de station d'émetteur selon la revendication 139, dans lequel ledit sixième dispositif d'entrée (50-62, 74, 98) reçoit depuis une quatrième station à distance un signal d'instruction qui permet, au niveau de la station d'émetteur, d'émettre en sortie ledit programme audit quatrième instant spécifique.

**143.** Appareil de station d'émetteur selon l'une quelconque des revendications 117 à 142, dans lequel ledit récepteur d'entrée de programme (76, 78, 53-62) reçoit un signal qui contient au moins une partie dudit programme et qui contient des données noyées qui identifient ledit programme ou qui désignent le point de début d'une certaine partie dudit programme ou qui comprend un message associé audit programme, ledit appareil comprenant en outre:

un détecteur numérique (34, 37, 38, 43 ou 44 dans un quelconque décodeur) connecté en fonctionnement audit récepteur d'entrée de programme (76, 78, 53-62) pour détecter des données noyées dans un signal.

**144.** Appareil de station d'émetteur selon l'une quelconque des revendications 117 à 143, dans lequel un message associé audit programme, qui contient une programmation vidéo, audio ou d'ordinateur ou un fichier vidéo, audio ou de données, est communiqué à ou est stocké au niveau dudit récepteur d'entrée de programme (76, 78, 53-62) avant ledit instant spécifique nommé en premier, ledit appareil comprenant en outre:

un septième processeur (73, 39J dans un quelconque décodeur) pour traiter un ou plusieurs de ces messages.

**145.** Appareil de station d'émetteur selon l'une quelconque des revendications 117 à 144, dans lequel un message qui contient une commande associée audit programme est communiqué à ou est stockée au niveau dudit récepteur d'entrée de programme (76, 78, 53-62) avant ledit instant spécifique nommé en premier, ledit appareil comprenant en outre un dispositif pris parmi:

un huitième processeur (39J dans un quelconque décodeur) pour distinguer une commande dans un message associé à un programme; et

un premier contrôleur de réponse (73, 39 dans un quelconque décodeur, 12 dans 71) connecté en fonctionnement audit dixième processeur (39J dans un quelconque décodeur) pour commander un certain appareil en réponse à une telle commande dans un message.

**146.** Appareil de station d'émetteur selon l'une quelconque des revendications 117 à 145, dans lequel un message qui contient un segment de mesure-surveillance associé audit programme est communiqué à ou est stocké au niveau dudit récepteur d'entrée de programme (76, 78, 53-62), ledit appareil comprenant en outre un dispositif pris parmi:

un neuvième processeur (39J dans un quelconque décodeur) pour distinguer un segment de mesure-surveillance dans un message associé à un programme; et

un dixième processeur (en 71, 96) connecté en fonctionnement audit onzième processeur (39J dans un quelconque décodeur) pour assembler ou stocker des fichiers de mesure ou des fichiers de surveillance qui mettent en évidence la manipulation ou l'émission d'un programme ou d'un message associé à un programme.

**147.** Appareil de station d'émetteur selon l'une quelconque des revendications 117 à 146, dans lequel un message associé audit programme qui contient un champ d'en-tête ou de format est communiqué à et ou est stocké au niveau dudit récepteur d'entrée de programme (76, 78, 53-62), ledit appareil comprenant en outre:

un onzième processeur (39J dans un quelconque décodeur) pour distinguer le format, le contenu ou la fin d'une certaine partie d'un message associé à un programme sur la base d'un champ d'en-tête ou de format.

**148.** Appareil de station d'émetteur selon l'une quelconque des revendications 117 à 147, dans lequel un message associé audit programme qui contient un signal de fin de fichier ou une interruption de processeur est communiqué à ou est stocké au niveau dudit récepteur d'entrée de programme (76, 78, 53-62), ledit appareil comprenant en outre:

un détecteur de signal (39F ou 39H dans un quelconque décodeur) pour détecter un signal de fin de fichier ou pour communiquer une interruption de processeur associée à un programme de radiodiffusion ou de diffusion par câble; et

un douzième processeur (73, 39J dans un quelconque décodeur) connecté en fonctionnement audit détecteur de signal (39F ou 39H dans un quelconque décodeur) pour répondre à une interruption de processeur associée à un programme de radiodiffusion ou de diffusion par câble.

**149.** Appareil de station d'émetteur selon l'une quelconque des revendications 117 à 148, comprenant en outre:

un troisième ordinateur (73) connecté en fonctionnement à un émetteur (83, 87, 91 ou 92) pour générer et communiquer un message qui doit être associé à un programme et qui contient une certaine programmation vidéo, audio ou d'ordinateur ou un fichier vidéo, audio ou de données.

**150.** Appareil de station d'émetteur selon l'une quelconque des revendications 117 à 149, comprenant en outre:

un quatrième ordinateur (73) connecté en fonctionnement à un émetteur (83, 87, 91 ou 92) pour générer une certaine partie d'une commande et pour communiquer ladite commande dans un message à associer à un programme.

**151.** Appareil de station d'émetteur selon l'une quelconque des revendications 117 à 150, comprenant en outre:

un cinquième ordinateur (73) connecté en fonctionnement à un émetteur (83, 87, 91 ou 92) pour générer et communiquer une certaine partie d'un segment de mesure-surveillance à associer avec un programme.

**152.** Appareil de station d'émetteur selon l'une quelconque des revendications 117 à 151, comprenant en outre:

un sixième ordinateur (73) connecté en fonctionnement à un émetteur (83, 87, 91 ou 92) pour générer une certaine partie d'un message présentant un format spécifique et à associer à un programme et pour communiquer ladite partie d'un message avec un champ d'en-tête ou de format qui désigne ledit format spécifique.

**153.** Appareil de station d'émetteur selon l'une quelconque des revendications 117 à 152, comprenant en outre:

un septième ordinateur (73) connecté en fonctionnement audit récepteur d'entrée de programme (76, 78, 53-62) à un émetteur (83, 87, 91 ou 92) pour générer un message associé à un programme et contenant une interruption de processeur.

**154.** Appareil de station d'émetteur selon l'une quelconque des revendications 139 et 140 à 153 lorsqu'elle dépend de la revendication 139, comprenant en outre:

un huitième dispositif d'émission sélective (73 ou 75) connecté en fonctionnement à un ou plusieurs desdits dispositifs d'entrée (50-62, 71, 73, 74, 98) et audit récepteur d'entrée de programme (76, 78, 53-62) pour communiquer audit récepteur d'entrée de programme un message à associer audit programme, une ou plusieurs données qui identifient ledit programme, une ou plusieurs données qui désignent le point de début d'une certaine partie dudit programme ou un signal qui permet, au niveau de la station de récepteur, d'appliquer une instruction.

**155.** Appareil de station d'émetteur selon l'une quelconque des revendications 117 à 154, dans lequel ledit programme est communiqué à et est stocké au niveau dudit récepteur d'entrée de programme (76, 78, 53-62) avant ledit instant spécifique nommé en premier, ledit appareil comprenant en outre:

un second récepteur d'entrée de programme (78, 53-62) connecté en fonctionnement à un dispositif d'émission (73 ou 75) pour communiquer un programme audit récepteur d'entrée de programme nommé en premier (76, 78, 53-62).

**156.** Appareil de station d'émetteur selon la revendication 120 et l'une quelconque des revendications 121 à 155 lorsqu'elle dépend de la revendication 120, dans lequel ledit récepteur d'entrée de programme nommé en premier (76, 78, 53-62) est ladite quatrième mémoire (73) ou ledit quatrième enregistreur (76 ou 78), ledit appareil comprenant en outre:

un second décodeur (77, 79) connecté en fonctionnement à une mémoire (73) ou un enregistreur (76 ou 78) pour décoder une information codée dans un signal stocké;
un second processeur de commande (39J dans 77, 39J dans 79, 73) pour distinguer un signal stocké décodé qui permet, au niveau de la station d'émetteur, d'appliquer une instruction;
un neuvième dispositif d'émission sélective (39I dans 77, 39I dans 79) connecté en fonctionnement audit second processeur de commande (39I dans 77, 39I dans le second décodeur (77, 79)) pour communiquer un signal d'instruction d'émetteur à un contrôleur (73, 205C, 39 dans un quelconque décodeur) ou à un ordinateur (73); et
un troisième contrôleur de sortie (39 dans 77, 39 dans 79, 73) connecté en fonctionnement audit neuvième dispositif d'émission sélective (39I dans 77, 39I dans 79) pour commander ledit neuvième dispositif d'émission sélective (39I dans 77, 39I dans 79) afin de communiquer un signal d'instruction d'émetteur à un contrôleur spécifique (73, 205C, 39 dans un quelconque décodeur) ou à un ordinateur spécifique (73).

**157.** Appareil de station d'émetteur selon la revendication 156, comprenant en outre:
un treizième processeur (en 71, 73, dans 39 d'un quelconque décodeur) connecté en fonctionnement à un contrôleur (73, 205C, 39 dans un quelconque décodeur) ou à un ordinateur (73) pour distinguer un décodeur spécifique (en 71, 77, 79, 80, 84, 88) ou pour communiquer une donnée désignant un récepteur d'entrée de programme spécifique (76, 78, 53-62).

**158.** Appareil de station d'émetteur selon la revendication 155 et selon l'une quelconque des revendications 156 et 157 lorsqu'elle dépend de la revendication 155, comprenant en outre un dispositif pris parmi :

un premier commutateur (75) connecté en fonctionnement audit émetteur de radiodiffusion ou de diffusion par câble (83, 87, 91, 92) pour communiquer des signaux sélectivement depuis ledit récepteur d'entrée de programme nommé en premier (76, 78, 53-62) et ledit second récepteur d'entrée de programme (78, 53-62); et
un second commutateur (75) connecté en fonctionnement audit second récepteur d'entrée de programme (78, 53-62) pour communiquer des signaux sélectivement audit récepteur d'entrée de programme nommé en premier (76 ou 78) et audit émetteur de radiodiffusion ou de diffusion par câble (83, 87, 91, 92).

**159.** Appareil de station d'émetteur selon la revendication 158, dans lequel ledit premier commutateur (75) ou ledit second commutateur (75) est commandé par ledit contrôleur central (73).

**160.** Appareil de station d'émetteur selon l'une quelconque des revendications 117 à 159, dans lequel ladite station d'émetteur inclut une pluralité de récepteurs d'entrée de programme (53-62) pour recevoir des signaux depuis une ou plusieurs sources de programmation à distance ou une pluralité de mémoires (73) ou d'enregistreurs (76 et 78) pour stocker des signaux ou une pluralité d'émetteurs de radiodiffusion ou de diffusion par câble (83, 87, 91, 92), ledit appareil comprenant en outre:
un commutateur matriciel (75) ou un commutateur numérique (39I dans un quelconque décodeur) permettant de communiquer une pluralité de signaux simultanément.

**161.** Appareil de station d'émetteur selon la revendication 160 lorsqu'elle dépend de la revendication 123, dans lequel ledit commutateur matriciel (75) ou ledit commutateur numérique (39I dans un quelconque décodeur) est commandé par ledit contrôleur central (73).

**162.** Appareil de station d'émetteur selon l'une quelconque des revendications 117 à 161, comprenant en outre:
un générateur de signal (82, 86, 90) connecté en fonctionnement audit émetteur de radiodiffusion ou de diffusion par câble (83, 87, 91, 90) pour recevoir ledit signal de commande et pour noyer ledit signal de commande dans ladite émission d'information.

**163.** Appareil de station d'émetteur selon la revendication 162 lorsqu'elle dépend de la revendication 153, dans lequel ledit signal de commande est communiqué audit générateur de signal (82, 86, 90) au moyen d'un dispositif quelconque pris parmi ledit troisième ordinateur (73), ledit quatrième ordinateur (73), ledit cinquième ordinateur (73), ledit sixième ordinateur (73) et ledit septième ordinateur (73).

**164.** Appareil de station d'émetteur selon l'une quelconque des revendications 117 à 163, dans lequel ladite émission d'information comprend une pluralité de canaux de programmation de télévision et/ou de programmation de radio, ledit appareil comprenant en outre:

une pluralité de modulateurs (83, 87, 91), chaque modulateur (83, 87, 91) étant connecté en fonctionnement à un récepteur d'entrée de programme (76, 78, 53-62) pour moduler un canal; et
un système de multiplexage (92) connecté en fonctionnement audit émetteur de radiodiffusion ou de diffusion par câble (83, 87, 91) pour communiquer une émission d'information comprenant une pluralité de canaux.

**165.** Appareil de station d'émetteur selon l'une quelconque des revendications 117 à 164, dans lequel ladite station d'émetteur comprend un ou plusieurs systèmes de processeur (71, 39 dans un quelconque décodeur) pour traiter des signaux qui contiennent des commandes et un contenu d'information de sortie de programme, ledit appareil comprenant en outre:

une ou plusieurs sections d'émetteur (12 et 39 dans chaque décodeur de 71; 39I dans chaque 39) pour émettre des commandes et/ou un contenu d'information de sortie de programme sélectivement sur un ou plusieurs dispositifs de récepteur externe (72, 73, 97 dans 71; 73 et 205C dans 73);

une ou plusieurs sections de récepteur (1, 2, 3, 6, 27, 28, 29 dans 71; 39B, 39D, 39J dans 39) pour recevoir une entrée desdites commandes et dudit contenu d'information de sortie de programme;
une ou plusieurs sections de mémoire (8, 14, en 39 dans 71; 39E, 39F, 39G, 39H, des RAM dans 39) ou d'enregistreur (20 dans 71) pour stocker et communiquer un signal de commande qui, au niveau d'un dispositif de récepteur (73) ou d'une station de récepteur (97), peut opérer pour générer une donnée spécifique au récepteur; et
une ou plusieurs sections d'entrée de commande (20 et chaque 39 dans 71; 39F, 39H, 39J dans 39) connectées en fonctionnement à ladite section de mémoire (8, 14, en 39 dans 71; 39E, 39F, 39G, 39H, des RAM dans 39) ou d'enregistreur (20 dans 71) pour forcer ladite section de mémoire (8, 14, en 39 dans 71; 39E, 39F, 39G, 39H, des RAM dans 39) ou d'enregistreur (20 dans 71) à communiquer ledit signal de commande à un instant spécifique.

**166.** Appareil selon la revendication 165, dans lequel l'une quelconque desdites une ou plusieurs sections d'émetteur (12 et 39 dans chaque décodeur de 71; 39I dans chaque 39), desdites une ou plusieurs sections de récepteur (1, 2, 3, 6, 27, 28, 29 dans 71; 39B, 39D, 39J dans 39), desdites une ou plusieurs sections de mémoire (8, 14, en 39 dans 71; 39E, 39F, 39G, 39H, des RAM dans 39) ou d'enregistreur (20 dans 71), et desdites une ou plusieurs sections d'entrée de commande (20 et chaque 39 dans 71; 39F, 39H, 39J dans 39) comprend une pluralité de processeurs (39B, 39D, 39J) sur une unique micropuce (39, figure 3A).

202M
TV MONITOR
VIDEO
205
MICROCOMPUTER
SIGNALS ONLY
203
TV SIGNAL DECODER (FIG. 2A)
VIDEO
4
DIVIDER
VIDEO
AUDIO
VIDEO
215
TELEVISION TUNER


FIG. 1

FIG. 1A

+1.0
+0.5
0
-0.5
M
T
W
T
F

FIG. 1B

+1.0
+0.5
0
-0.5
M
T
W
T
F

FIG. 1C

JACK PORTS TO
EXTERNAL EQUIPMENT
OTHER
INPUTS
MULTI-
CHANNEL
CABLE
TRANSMISSION
RADIO SIGNAL
DECODER(FIG.2B)
TV SIGNAL
DECODER(FIG.2A)
BUFFER/
COMPARA-
TOR
DECRYPTOR
CONTROLLER
JACK PORTS
TO EXTERNAL
EQUIPMENT
OTHER
INPUTS
LOCAL
OSCILLATOR
FREQUENCY
SYNCHRONIZER &
SWITCH CONTROL
CLOCK
BUFFER/
COMPARATOR
AUTO
DIALER
PRAM
CONTROLLER
ROM
TELEPHONE
CONNECTION
DIGITAL
RECORDER
OTHER
INPUTS
SIGNALS & PROGRAMMING
CONTROL INFORMATION
TELEPHONE
OR OTHER DATA
TRANSFER
NETWORK
1
2
3
6
8
10
12
14
16
18
20
21
22
24
30
40

FIG. 2

FREQUENCY OF INTEREST AT FIXED FREQUENCY
FILTER
31
ONE TV CHANNEL
AMPLITUDE DEMODULATOR
32
PATH C
DIGITAL DETECTOR
38
CONTROLLER
39
PATH A
LINE RECEIVER
33
DIGITAL DETECTOR
34
PATH B
AUDIO DEMODULATOR
35
0-15 KHz
HIGH PASS FILTER
36
DIGITAL DETECTOR
37
PATH A · · · VIDEO SIGNALLING TECHNIQUES
PATH B · · · AUDIO SIGNALLING TECHNIQUES
PATH C · · · SEPARATE SIGNALLING TECHNIQUES
SIGNALS & PROGRAMMING
CONTROL INFORMATION
MONITOR INFORMATION

FIG. 2A

41
RADIO RECEIVER CIRCUITRY
42
RADIO DECODER
43
DIGITAL DETECTOR
44
CONTROLLER
PROGRAMMING AND SIGNALS
CONTROL INFORMATION
MONITOR INFORMATION
45
OTHER RECEIVER CIRCUIT
46
DIGITAL DETECTOR
47
CONTROLLER

FIG. 2B

FIG. 2C

SELECTED FREQUENCY
29
DECODER (FIG.2A,2B OR 2C)
OTHER STATION APARATUS
SELECTED FREQUENCY
28
DECODER (FIG.2A,2B, OR 2C)
OTHER STATION APARATUS
SELECTED FREQUENCY
27
DECODER (FIG.2A,2B, OR 2C)
OTHER STATION APARATUS
13
JACK PORT TO EXTERNAL EQUIPMENT
OTHER INPUT
26
MULTI-CHANNEL CABLE TRANSMISSION
2
1
3
RADIO SIGNAL DECODER(FIG.2B)
40
TV SIGNAL DECODER(FIG.2A)
30
BUFFER/ COMPARA-TOR
8
DECRYPTOR
10
12
CONTROLLER
JACK PORTS TO EXTERNAL EQUIPMENT
OTHER INPUTS
LOCAL OSCILLATOR FREQUENCY SYNCHRONIZER & SWITCH CONTROL
6
CLOCK
18
14
BUFFER/ COMPARATOR
24
AUTO DIALER
PRAM CONTROLLER
ROM
20
21
16
DIGITAL RECORDER
TELEPHONE CONNECTION
22
OTHER INPUTS
TELEPHONE OR OTHER DATA TRANSFER NETWORK
SIGNALS & PROGRAMMING
CONTROL INFORMATION
MONITOR INFORMATION

FIG. 2D

HEADER
EXECUTION SEGMENT
METER-MONITOR SEGMENT
INFORMATION SEGMENT
0 1 0 1 0 0 1 1 0 1 0 0 0 1 0 1 1 0 1 1 1 0 0 0 1 0
COMMAND
PADDING BITS

FIG. 2E

FORMAT FIELD
FIRST OTHER FIELD
SECOND OTHER FIELD
0 1 0 1 1 1 0 1 1 1 1 0 0 1 0 1 0 1 0 0 0 1 1 0 0 0 0 0 1
LENGTH TOKEN
REMAINING BITS OF THE FORMAT FIELD

FIG. 2F

COMMAND
HEADER
EXEC SEG
METER-MONITOR SEG
00 01 01 00 01 0 0 0 0 1 0 01 1 0 1
FIRST BYTE
SECOND BYTE

FIG. 2G

COMMAND
HEADER
EXEC SEG
METER-MONITOR SEG
0 0 0 1 0 1 0 0 0 1 0 0 0 0 1 0 0 1 1 0 1 0 0 0
FIRST BYTE
SECOND BYTE
THIRD BYTE

FIG. 2H

PADDING BITS
COMMAND
INFORMATION SEGMENT
EOF SIGNAL
COMMAND
PADDING BITS
COMMAND
MESSAGE
MESSAGE
MESSAGE

FIG. 2I

HEADER EXEC. SEG

1 0 0 1 0 0 0 0

ONE BYTE

FIG. 2J

MESSAGE
COMMAND
HEADER
EXEC. SEG.
METER-MONITOR SEG.
PADDING BITS
00010100 11001000 11111111 11111111 00000000
1st BYTE
2nd BYTE
3rd BYTE
4th BYTE
5th BYTE

FIG. 2K

215
TELEVISION TUNER
DIVIDER
4
202M
TV MONITOR
205
MICROCOMPUTER
SPAM-CONTROLLER
205C
203
TV SIGNAL DIVIDER (FIG.2A)
SIGNALS ONLY
SIGNALS ONLY
TO OTHER OUTPUTS
OTHER INPUTS
200
MULTI-CHANNEL CABLE TRANSMISSION
2
1
3
40
RADIO SIGNAL DECODER(FIG.2B)
SIG's ONLY
30
TV SIGNAL DECODER(FIG.2A)
SIG's ONLY
8
BUFFER/ COMPARA-TOR
10
DECRYPTOR
12
CONTROLLER
TO OTHER OUTPUTS
OTHER INPUTS
LOCAL OSCILLATOR FREQUENCY SYNCHRONIZER & SWITCH CONTROL
6
18
CLOCK
14
BUFFER/ COMPARATOR
24
AUTO DIALER
PRAM CONTROLLER
ROM
TELEPHONE CONNECTION
20
21
16
22
DIGITAL RECORDER
OTHER INPUTS
TELEPHONE OR OTHER DATA TRANSFER NETWORK
SIGNALS & PROGRAMMING
CONTROL INFORMATION


FIG. 3

38
DIGITAL DETECTOR
34
DIGITAL DETECTOR
37
DIGITAL DETECTOR
BUFFER
39A
RAM
ROM
PROCESSOR FOR ERROR CORRECTION
39B
BUFFER
39C
RAM
ROM
PROCESSOR FOR PROTOCOL CONVERSION
39D
39E
BUFFER
39F
EOFS VALVE
39I
MATRIX SWITCH
39
CONTROL PROCESSOR
RAM
ROM
39J
39K
DECRYPTOR
39G
BUFFER
39H
EOFS VALVE
TO OTHER CONTROLLED APPARATUS
OTHER INPUTS
FROM CONTROLLER, 12, OF SIGNAL PROCESSOR, 200
FROM & TO CONTROLLER, 20, OF SIGNAL PROCESSOR, 200
OTHER OUTPUTS
TO SIG. PROCESSOR, 200 BUFFER/COMPARATOR, 14
TO SIG. PROCESSOR, 200, BUFFER/COMPARATOR, 8
TO MICROPROCESSOR, 205, CPU
TO MICROPROCESSOR, 205, PC-MICROKEY SYSTEM
FIG. 3A

MULTI-CHANNEL CABLE SYSTEM TRANSMISSION
FIG. 4
201
214
222
223
CONVERTER BOX
TUNER
CONVERTER BOX
TUNER
258
MATRIX SWITCH
199
AUDIO
VIDEO
AUDIO
VIDEO
215
TELEVISION TUNER
202M
TV MONITOR
AUDIO
VIDEO
4
DIVIDER
MICROCOMPUTER
205
107
DECRYPTOR
231
DECRYPTOR
230
SIGNAL GENERATOR
DECRYPTOR
224
SIGNAL STRIPPER
229
203
DECODER
SIGNAL PROCESSOR
200
225
LOCAL INPUT
TELEPHONE NETWORK

MULTI-CHANNEL CABLE TRANSMISSION
CONVERTER BOX
201
CONVERTER BOX
222
LASER DISK PLAYER
232
RECORD TURN TABLE
280
MATRIX SWITCH
258
199
OTHER INPUT
252
138
RADIO DECODER
RADIO TUNER & AMPLIFIER
207
OTHER DECODER
TV TUNER
215
TV DECODER
282
OTHER TUNER AND/OR RECORDER/PLAYER
257
OTHER DECODER
283
284
OTHER DECODER
AUDIO RECORDER PLAYER
255
VIDEO RECORDER PLAYER
217
TV DECODER
218
DIVIDER
4
MICRO-COMPUTER
205
203
TV DECODER
SIGNAL PROCESSOR
200
145
TV DECODER
202M
149
TV DECODER
148
150
TV DECODER
SPEAKER SYSTEM
263
285
OTHER DECODER
PRINTER
221
227
OTHER DECODER
OTHER OUTPUT SYSTEM
261
286
OTHER DECODER
—PROGRAMMING ++++MONITOR INFORMATION ——CONTROL INFORMATION

FIG. 5

DISTRIBUTION AMPLIFIERS OUTPUTTING TO SIGNAL PROCESSOR
CABLE SYSTEM HEAD END
51
53
75
VERTICAL LOW NOISE AMPLIFIER
TV RECEIVER
63
MATRIX SWITCH
54
64
50
65
55
SATELLITE EARTH STATION RECEIVER
52
66
56
HORIZONTAL LOW NOISE AMPLIFIER
TV RECEIVER
67
76
58
68
VIDEO RECORDER & PLATER
TELEVISION VIDEO AND AUDIO RECEIVER
69
77
TV SIGNAL DECODER (FIG.2A)
SIGNALS ONLY
70
57
59
78
MICROWAVE RECEIVER SYSTEM
INPUTS FROM DISTRIBUTION AMPLIFIERS
71
79
SIG's
O.
TO FIG. 6B
60
61
SIGNAL PROCESSOR SYSTEM
TV DEMODULATOR
72
SIGNALS
CODE READER
CABLE PROGRAM CONTROLLER & COMPUTER
FIG. 6
(FIG. 2D)
ONLY
62
73
OTHER PROGRAMMING INPUT MEANS
SIGNALS AND PROGRAMMING
CONTROL INFORMATION
TELEPHONE OR OTHER DATA TRANSFER NETWORK
97
TELEPHONE OR OTHER DATA TRANSFER NETWORK
98

CABLE SYSTEM HEAD END
FROM FIG.6A
TV SIGNAL DECODER (FIG.2A)
80
SIGNAL STRIPPER
81
SIGNAL GENERATOR
82
CABLE CHANNEL MODULATOR
83
TV SIGNAL DECODER (FIG.2A)
84
SIGNAL STRIPPER
85
SIGNAL GENERATOR
86
CABLE CHANNEL MODULATOR
87
88
89
90
91
92
CHANNEL COMBINING SYSTEM & MULTIPLEXER
SIGNALS ONLY
94
CABLE FIELD DISTRIBUTION SYSTEM
93
95
SIGNAL PROCESSOR
(FIG.2)
96
SIGNALS ONLY TO EXTERNAL EQUIPMENT
TELEPHONE OR OTHER DATA TRANSFER NETWORK
99
74
LOCAL INPUT
CABLE PROGRAM CONTROLLER & COMPUTER
73
FIG. 6B

MULTI-CHANNEL CABLE SYSTEM
250
EARTH STATION
251
SATELLITE RECEIVER CIRCUITRY
252
201
CABLE CONVERTER BOX
222
CABLE CONVERTER BOX
200
SIGNAL PROCESSOR (FIG.2)
TELEPHONE NETWORK
258
MATRIX SWITCH
225
LOCAL INPUT
209
RADIO
202
TV SET
221
PRINTER
205
MICRO COMPUTER
217
TELEVISION RECORDER/ PLAYER
255
AUDIO RECORDER/ PLAYER
256
COMPUTER MEMORY UNIT
257
224
DECRYPTOR
231
DECRYPTOR
SIGNAL STRIPPER
229
SIGNAL GENERATOR
230
259
MATRIX SWITCH
WINDOW OPENING AND CLOSING MEANS
208
OTHER RECEIVER MEANS
261
SPEAKER SYSTEM
263
FURNACE
206
AIR CON. SYSTEM
207
UTILITIES METER
262
OTHER EQUIPMENT
260
PROGRAMMING
CONTROL INFORMATION
SWITCH CONTROL INSTRUCTIONS


FIG.7

MULTI-CHANNEL CABLE TRANSMISSION
201
CABLE CONVERTER BOX
200
SIGNAL PROCESSOR (FIG. 2)
ONE TV CHANNEL
202
262
205
TV SET
UTILITIES METER
MICRO COMPUTER
TV SIGNAL DECODER (FIG 2A)
203
206
207
208
FURNACE
AIR CONDITIONING SYSTEM
WINDOW OPENING AND CLOSING MEANS
PROGRAMMING
CONTROL INFORMATION

FIG. 7A

TV SET
202
TV SIGNAL DECODER (FIG. 2A)
203
200
SIGNAL PROCESSOR (FIG.2)
TELEPHONE OR OTHER DATA TRANSFER NETWORK
209
213
DIGITAL TUNER
SWITCH
RADIO
RADIO DECODER (FIG. 2B)
210
212
PROGRAM
CONTROL INFORMATION

FIG. 7B

MULTI CHANNEL CABLE TRANSMISSION
200
214
201
222
223
SIGNAL PROCESSOR (FIG. 2)
CABLE CONVERTER BOX
TUNER
TUNER
CABLE CONVERTER BOX
ONE TV CHANNEL
203
ONE DIGITAL DATA CHANNEL
SIGNALS ONLY
215
TV SIGNAL DECODER (FIG. 2A)
TUNER
MICRO COMPUTER
205
202
TV SET
SWITCH
216
TELEPHONE OR OR OTHER DATA TRANSFER NETWORK
CONTROL MEANS
VIDEO RECORDER/ PLAYER
217
PRINTER
220
TV SIGNAL DECODER (FIG. 2A)
221
218
PROGRAMMING
CONTROL INFORMATION

FIG. 7C

RADIO TUNER
209T
DIVIDER
209D
MICROCOMPUTER
205
SPEAKER SYSTEM
263
RADIO DECODER
209D
SIGNALS ONLY


FIG. 7D

202M
TV MONITOR
AUDIO
VIDEO
205
MICROCOMPUTER
SIGNALS ONLY
203
TV DECODER (FIG 2A)
202D
DIVIDER
4
DIVIDER
AUDIO
VIDEO
215
TV TUNER

FIG. 7E

MULTI-CHANNEL CABLE TRANSMISSION
201
CABLE CONVERTER BOX
200
SIGNAL PROCESSOR (FIG. 2)
TELEPHONE NETWORK
215
202
TV SIGNAL DECODER (FIG. 2A)
TV TUNER
TV SET
PROGRAMMING
CONTROL INFORMATION
222
CABLE CONVERTER BOX
223
TUNER
224
DECRYPTOR
225
LOCAL INPUT
226
CONTROL MEANS
221
PRINTER
205
MICROCOMPUTER
OTHER SIGNAL DECODER (FIG. 2C)
227

FIG. 7F

INPUT FROM REMOTE TRANSMISSION STATION VIA SUBSCRIBER STATION APPARATUS
DECODER
30
SIGNALS ONLY
CONTROLLER
12
SIGNAL PROCESSOR EQUIPMENT CASE
PRAM CONTROLLER
20
SWITCH CONTROLLER
20A
STATION SPECIAL EPROM
20B
MATRIX SWITCH
259
TO OTHER STATION APPARATUS
DECODER
203
IBM PC MICRO COMPUTER
205
DECODER
282
CONTROL INFORMATION
SWITCH REQUEST BUS

FIG. 8